# EUROPEAN PATENT APPLICATION

(11) **EP 4 376 583 A2**
(43) Date of publication of application: **29.05.2024**
(21) Application number: 23205921.2
(22) Date of filing: 25.10.2023
(51) Int. Cl.: H10K 85/30, H10K 101/00

(54) **ORGANIC ELECTROLUMINESCENT MATERIALS AND DEVICES**

(30) Priority: 27.10.2022 US 202263419782 P; 02.11.2022 US 202263421804 P; 13.12.2022 US 202263387166 P; 21.12.2022 US 202263434161 P; 07.02.2023 US 202363483647 P; 14.02.2023 US 202363484757 P; 14.02.2023 US 202363484786 P; 27.02.2023 US 202363487055 P; 14.03.2023 US 202363490065 P; 13.04.2023 US 202363459091 P; 17.05.2023 US 202318319182; 20.10.2023 US 202318490978
(71) Applicant: Universal Display Corporation, Ewing, NJ 08618 (US)
(72) Inventor: FLEETHAM, Tyler, Ewing, 08618 (US); FELDMAN, Jerald, Ewing, 08618 (US); MARGULIES, Eric A., Ewing, 08618 (US); HAMZE, Rasha, Ewing, 08618 (US); FUSELLA, Michael, Ewing, 08618 (US); THOMPSON, Nicholas J., Ewing, 08618 (US); SHEINA, Elena, Ewing, 08618 (US)
(74) Representative: Maiwald GmbH

(57) **Abstract**

An OLED is disclosed where the OLED includes, sequentially: an anode; a hole transporting layer; an emissive region; an electron transporting layer; and a cathode; where the emissive region includes a compound S1; and a compound A1. The compound S1 is an organometallic sensitizer that transfers energy to the compound A1, and the compound A1 is an acceptor that is an emitter in the emissive region. The compound S1 has a vertical dipole ratio (VDR) value greater than or equal to 0.2; and the compound A1 has a VDR value less than or equal to 0.2.

## Description

### CROSS-REFERENCE TO RELATED APPLICATIONS

This application is a continuation-in-part of United States patent Application No. 18/319,182, filed on May 17, 2023, and also claims priority under 35 U.S.C. § 119(e) to United States Provisional Applications No. 63/387,166, filed on December 13, 2022, No. 63/419,782, filed on October 27, 2022, No. 63/421,804, filed on November 2, 2022, No. 63/483,647, filed on February 7, 2023, No. 63/487,055, filed on February 27, 2023, No. 63/459,091, filed on April 13, 2023, No. 63/434,161, filed on December 21, 2022, No. 63/484,757, filed on February 14, 2023, No. 63/484,786, filed on February 14, 2023, No. 63/490,065, filed on March 14, 2023, the entire contents of which are incorporated herein by reference.

### FIELD

The present disclosure generally relates to novel device architectures and the OLED devices having those novel architectures and their uses.

### BACKGROUND

Opto-electronic devices that make use of organic materials are becoming increasingly desirable for various reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, organic scintillators, and organic photodetectors. For OLEDs, the organic materials may have performance advantages over conventional materials.

OLEDs make use of thin organic films that emit light when voltage is applied across the device. OLEDs are becoming an increasingly interesting technology for use in applications such as displays, illumination, and backlighting.

One application for emissive molecules is a full color display. Industry standards for such a display call for pixels adapted to emit particular colors, referred to as "saturated" colors. In particular, these standards call for saturated red, green, and blue pixels. Alternatively, the OLED can be designed to emit white light. In conventional liquid crystal displays emission from a white backlight is filtered using absorption filters to produce red, green and blue emission. The same technique can also be used with OLEDs. The white OLED can be either a single emissive layer (EML) device or a stack structure. Color may be measured using CIE coordinates, which are well known to the art.

### SUMMARY

An OLED is disclosed where the OLED comprises, sequentially: an anode; a hole transporting layer; an emissive region; an electron transporting layer; and a cathode; where the emissive region comprises: a compound S1; and a compound A1. The compound S1 is an organometallic sensitizer that transfers energy to the compound A1, and the compound A1 is an acceptor that is an emitter in the emissive region. The compound S1 has a vertical dipole ratio (VDR) value greater than or equal to 0.2; and the compound A1 has a VDR value less than or equal to 0.2.

### BRIEF DESCRIPTION OF THE DRAWINGS

FIG. 1 shows an organic light emitting device.
FIG. 2 shows an inverted organic light emitting device that does not have a separate electron transport layer.
FIG. 3 shows a graph of modeled P-polarized photoluminescence as a function of angle for emitters with different vertical dipole ratio (VDR) values.
FIG. 4 is an energy level diagram showing the various pathways of excited state energy transfer in a phosphorescent-sensitized plasmonic OLED.
FIG. 5 is an energy level diagram showing the various pathways of excited state energy transfer in a TADF-sensitized plasmonic OLED.

### DETAILED DESCRIPTION

### A. Terminology

Unless otherwise specified, the below terms used herein are defined as follows:

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processable" means capable of being dissolved, dispersed, or transported in and/or deposited from a liquid medium, either in solution or suspension form.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

The terms "halo," "halogen," and "halide" are used interchangeably and refer to fluorine, chlorine, bromine, and iodine.

The term "acyl" refers to a substituted carbonyl group (-C(O)-Rₛ).

The term "ester" refers to a substituted oxycarbonyl (-O-C(O)-Rₛ or -C(O)-O-Rₛ) group.

The term "ether" refers to an -ORₛ group.

The terms "sulfanyl" or "thio-ether" are used interchangeably and refer to a -SRₛ group.

The term "selenyl" refers to a -SeRₛ group.

The term "sulfinyl" refers to a -S(O)-Rₛ group.

The term "sulfonyl" refers to a -SO₂-Rₛ group.

The term "phosphino" refers to a group containing at least one phosphorus atom used to be bonded to the relevant molecule, common examples such as, but not limited to, a -P(Rₛ)₂ group or a -PO(Rₛ)₂ group, wherein each Rₛ can be same or different.

The term "silyl" refers to a group containing at least one silicon atom used to be bonded to the relevant molecule, common examples such as, but not limited to, a -Si(Rₛ)₃ group, wherein each Rₛ can be same or different.

The term "germyl" refers to a group containing at least one germanium atom used to be bonded to the relevant molecule, common examples such as, but not limited to, a -Ge(Rₛ)₃ group, wherein each Rₛ can be same or different.

The term "boryl" refers to a group containing at least one boron atom used to be bonded to the relevant molecule, common examples such as, but not limited to, a -B(Rₛ)₂ group or its Lewis adduct -B(Rₛ)₃ group, wherein Rₛ can be same or different.

In each of the above, Rₛ can be hydrogen, or the general substituents as defined in this application. Preferred Rₛ is selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, and combination thereof. More preferably Rₛ is selected from the group consisting of alkyl, cycloalkyl, aryl, heteroaryl, and combination thereof.

The term "alkyl" refers to and includes both straight and branched chain alkyl groups. Preferred alkyl groups are those containing from one to fifteen carbon atoms, preferably one to nine carbon atoms, and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group can be further substituted.

The term "cycloalkyl" refers to and includes monocyclic, polycyclic, and spiro alkyl groups. Preferred cycloalkyl groups are those containing 3 to 12 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group can be further substituted.

The terms "heteroalkyl" or "heterocycloalkyl" refer to an alkyl or a cycloalkyl group, respectively, having at least one carbon atom replaced by a heteroatom. Optionally the at least one heteroatom is selected from O, S, N, P, B, Si, Ge and Se, preferably, O, S or N. Additionally, the heteroalkyl or heterocycloalkyl group can be further substituted.

The term "alkenyl" refers to and includes both straight and branched chain alkene groups. Alkenyl groups are essentially alkyl groups that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl group having at least one carbon atom replaced by a heteroatom. Optionally the at least one heteroatom is selected from O, S, N, P, B, Si, Ge, and Se, preferably, O, S, or N. Preferred alkenyl, cycloalkenyl, or heteroalkenyl groups are those containing two to fifteen carbon atoms. Additionally, the alkenyl, cycloalkenyl, or heteroalkenyl group can be further substituted.

The term "alkynyl" refers to and includes both straight and branched chain alkyne groups. Alkynyl groups are essentially alkyl groups that include at least one carbon-carbon triple bond in the alkyl chain. Preferred alkynyl groups are those containing two to fifteen carbon atoms. Additionally, the alkynyl group can be further substituted.

The terms "aralkyl" or "arylalkyl" are used interchangeably and refer to an alkyl group that is substituted with an aryl group. Additionally, the aralkyl group can be further substituted.

The term "heterocyclic group" refers to and includes aromatic and non-aromatic cyclic groups containing at least one heteroatom. Optionally the at least one heteroatom is selected from O, S, Se, N, P, B, Si, Ge, and Se, preferably, O, S, N, or B. Hetero-aromatic cyclic groups may be used interchangeably with heteroaryl. Preferred hetero-non-aromatic cyclic groups are those containing 3 to 10 ring atoms, preferably those containing 3 to 7 ring atoms, which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group can be further substituted or fused.

The term "aryl" refers to and includes both single-ring and polycyclic aromatic hydrocarbyl groups. The polycyclic rings may have two or more rings in which two carbons are common to two adjoining rings (the rings are "fused"). Preferred aryl groups are those containing six to thirty carbon atoms, preferably six to twenty-four carbon atoms, six to eighteen carbon atoms, and more preferably six to twelve carbon atoms. Especially preferred is an aryl group having six carbons, ten carbons, twelve carbons, fourteen carbons, or eighteen carbons. Suitable aryl groups include phenyl, biphenyl, triphenyl, triphenylene, tetraphenylene, naphthalene, anthracene, phenalene, phenanthrene, pyrene, chrysene, perylene, and azulene, preferably phenyl, biphenyl, triphenyl, triphenylene, and naphthalene. Additionally, the aryl group can be further substituted or fused, such as, but not limited to, fluorene.

The term "heteroaryl" refers to and includes both single-ring aromatic groups and polycyclic aromatic ring systems that include at least one heteroatom. The heteroatoms include, but are not limited to O, S, Se, N, P, B, Si, Ge, and Se. In many instances, O, S, N, or B are the preferred heteroatoms. Hetero-single ring aromatic systems are preferably single rings with 5 or 6 ring atoms, and the ring can have from one to six heteroatoms. The hetero-polycyclic ring systems can have two or more aromatic rings in which two atoms are common to two adjoining rings (the rings are "fused") wherein at least one of the rings is a heteroaryl. The hetero-polycyclic aromatic ring systems can have from one to six heteroatoms per ring of the polycyclic aromatic ring system. Preferred heteroaryl groups are those containing three to thirty carbon atoms, preferably three to twenty-four carbon atoms, three to eighteen carbon atoms, and more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group can be further substituted or fused.

Of the aryl and heteroaryl groups listed above, the groups of triphenylene, naphthalene, anthracene, dibenzothiophene, dibenzofuran, dibenzoselenophene, carbazole, indolocarbazole, imidazole, pyridine, pyrazine, pyrimidine, triazine, and benzimidazole, and the respective aza-analogs of each thereof are of particular interest.

In many instances, the general substituents are selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof.

In some instances, the preferred general substituents are selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some instances, the more preferred general substituents are selected from the group consisting of deuterium, fluorine, alkyl, cycloalkyl, alkoxy, aryloxy, amino, silyl, aryl, heteroaryl, nitrile, sulfanyl, and combinations thereof.

In some instances, the more preferred general substituents are selected from the group consisting of deuterium, fluorine, alkyl, cycloalkyl, silyl, aryl, heteroaryl, nitrile, and combinations thereof.

In yet other instances, the most preferred general substituents are selected from the group consisting of deuterium, alkyl, cycloalkyl, aryl, heteroaryl, and combinations thereof.

The terms "substituted", and "substitution" refer to a substituent other than H that is bonded to the relevant position, e.g., a carbon or nitrogen. For example, when R¹ represents mono-substitution, then one R¹ must be other than H (i.e., a substitution). Similarly, when R¹ represents di-substitution, then two of R¹ must be other than H. Similarly, when R¹ represents zero or no substitution, R¹, for example, can be a hydrogen for available valencies of ring atoms, as in carbon atoms for benzene and the nitrogen atom in pyrrole, or simply represents nothing for ring atoms with fully filled valencies, e.g., the nitrogen atom in pyridine. The maximum number of substitutions possible in a ring structure will depend on the total number of available valencies in the ring atoms.

As used herein, "combinations thereof' indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include up to forty atoms that are not hydrogen or deuterium, or those that include up to thirty atoms that are not hydrogen or deuterium. In many instances, a preferred combination of substituent groups will include up to twenty atoms that are not hydrogen or deuterium.

The "aza" designation in the fragments described herein, i.e., aza-dibenzofuran, aza-dibenzothiophene, etc. means that one or more of the C-H groups in the respective aromatic ring can be replaced by a nitrogen atom, for example, but not limited to, azatriphenylene encompasses both dibenzo[*f*,*h*]quinoxaline and dibenzo[*f*,*h*]quinoline. One of ordinary skill in the art can readily envision other nitrogen analogs of the aza-derivatives described above, and all such analogs are intended to be encompassed by the terms as set forth herein.

As used herein, "deuterium" refers to an isotope of hydrogen. Deuterated compounds can be readily prepared using methods known in the art. For example, U.S. Pat. No. 8,557,400, Patent Pub. No. WO 2006/095951, and U.S. Pat. Application Pub. No. US 2011/0037057, which are hereby incorporated by reference in their entireties, describe the making of deuterium-substituted organometallic complexes. Further reference is made to Ming Yan, et al., Tetrahedron 2015, 71, 1425-30 and Atzrodt et al., Angew. Chem. Int. Ed. (Reviews) 2007, 46, 7744-65, which are incorporated by reference in their entireties, describe the deuteration of the methylene hydrogens in benzyl amines and efficient pathways to replace aromatic ring hydrogens with deuterium, respectively.

As used herein, any specifically listed substituent, such as, but not limited to, methyl, phenyl, pyridyl, etc. includes undeuterated, partially deuterated, and fully deuterated versions thereof. Similarly, classes of substituents such as, but not limited to, alkyl, aryl, cycloalkyl, heteroaryl, etc. also include undeuterated, partially deuterated, and fully deuterated versions thereof. A chemical structure without further specified H or D should be considered to include undeuterated, partially deuterated, and fully deuterated versions thereof. Some common smallest partially or fully deuterated group such as, but not limited to, CD₃, CD₂C(CH₃)₃, C(CD₃)₃, and C₆D₅.

It is to be understood that when a molecular fragment is described as being a substituent or otherwise attached to another moiety, its name may be written as if it were a fragment (e.g., phenyl, phenylene, naphthyl, dibenzofuryl) or as if it were the whole molecule (e.g., benzene, naphthalene, dibenzofuran). As used herein, these different ways of designating a substituent or attached fragment are considered to be equivalent.

In some instances, a pair of substituents in the molecule can be optionally joined or fused into a ring. The preferred ring is a five to nine-membered carbocyclic or heterocyclic ring, includes both instances where the portion of the ring formed by the pair of substituents is saturated and where the portion of the ring formed by the pair of substituents is unsaturated. In yet other instances, a pair of adjacent substituents can be optionally joined or fused into a ring. As used herein, "adjacent" means that the two substituents involved can be on the same ring next to each other, or on two neighboring rings having the two closest available substitutable positions, such as 2, 2' positions in a biphenyl, or 1, 8 position in a naphthalene.

Layers, materials, regions, and devices may be described herein in reference to the color of light they emit. In general, as used herein, an emissive region that is described as producing a specific color of light may include one or more emissive layers disposed over each other in a stack.

As used herein, a "red" layer, material, region, or device refers to one that emits light in the range of about 580-700nm or having a highest peak in its emission spectrum in that region. Similarly, a "green" layer, material, region, or device refers to one that emits or has an emission spectrum with a peak wavelength in the range of about 500-600nm; a "blue" layer, material, or device refers to one that emits or has an emission spectrum with a peak wavelength in the range of about 400-500nm; and a "yellow" layer, material, region, or device refers to one that has an emission spectrum with a peak wavelength in the range of about 540-600nm. In some arrangements, separate regions, layers, materials, regions, or devices may provide separate "deep blue" and a "light blue" light. As used herein, in arrangements that provide separate "light blue" and "deep blue", the "deep blue" component refers to one having a peak emission wavelength that is at least about 4nm less than the peak emission wavelength of the "light blue" component. Typically, a "light blue" component has a peak emission wavelength in the range of about 465-500nm, and a "deep blue" component has a peak emission wavelength in the range of about 400-470nm, though these ranges may vary for some configurations. Similarly, a color altering layer refers to a layer that converts or modifies another color of light to light having a wavelength as specified for that color. For example, a "red" color filter refers to a filter that results in light having a wavelength in the range of about 580-700nm. In general, there are two classes of color altering layers: color filters that modify a spectrum by removing unwanted wavelengths of light, and color changing layers that convert photons of higher energy to lower energy. A component "of a color" refers to a component that, when activated or used, produces or otherwise emits light having a particular color as previously described. For example, a "first emissive region of a first color" and a "second emissive region of a second color different than the first color" describes two emissive regions that, when activated within a device, emit two different colors as previously described.

As used herein, emissive materials, layers, and regions may be distinguished from one another and from other structures based upon light initially generated by the material, layer or region, as opposed to light eventually emitted by the same or a different structure. The initial light generation typically is the result of an energy level change resulting in emission of a photon. For example, an organic emissive material may initially generate blue light, which may be converted by a color filter, quantum dot or other structure to red or green light, such that a complete emissive stack or sub-pixel emits the red or green light. In this case the initial emissive material or layer may be referred to as a "blue" component, even though the sub-pixel is a "red" or "green" component.

In some cases, it may be preferable to describe the color of a component such as an emissive region, sub-pixel, color altering layer, or the like, in terms of 1931 CIE coordinates. For example, a yellow emissive material may have multiple peak emission wavelengths, one in or near an edge of the "green" region, and one within or near an edge of the "red" region as previously described. Accordingly, as used herein, each color term also corresponds to a shape in the 1931 CIE coordinate color space. The shape in 1931 CIE color space is constructed by following the locus between two color points and any additional interior points. For example, interior shape parameters for red, green, blue, and yellow may be defined as shown below:

| **Color** | **CIE Shape Parameters** |
|---|---|
| Central Red | Locus: [0.6270,0.3725];[0.7347,0.2653]; |
| | Interior: [0.5086,0.2657] |
| Central Green | Locus: [0.0326,0.3530];[0.3731,0.6245]; |
| | Interior: [0.2268,0.3321 |
| Central Blue | Locus: [0.1746,0.0052];[0.0326,0.3530]; |
| | Interior: [0.2268,0.3321] |
| Central Yellow | Locus: [0.373 l,0.6245];[0.6270,0.3725]; |
| | Interior: [0.3 700,0.4087];[0.2886,0.4572] |

More details on OLEDs, and the definitions described above, can be found in US Pat. No. 7,279,704, which is incorporated herein by reference in its entirety.

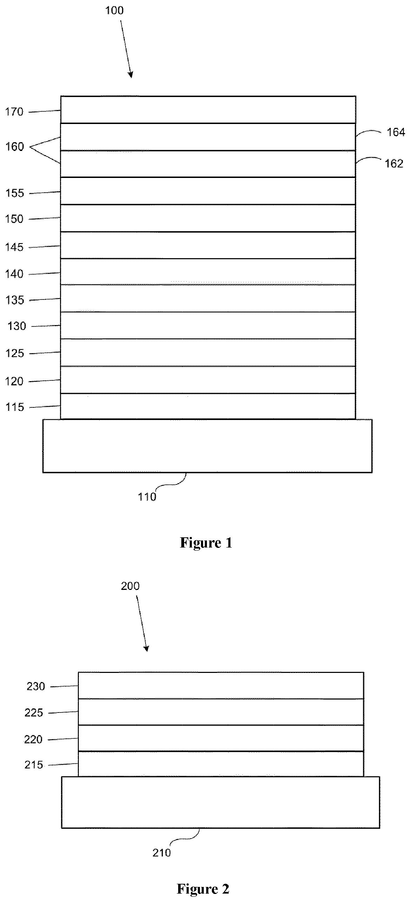

As disclosed herein, emissive layers or materials, such as emissive layer 135 and emissive layer 220 shown in FIGS. 1-2, respectively, may include quantum dots. An "emissive layer" or "emissive material" as disclosed herein may include an organic emissive material and/or an emissive material that contains quantum dots or equivalent structures, unless indicated to the contrary explicitly or by context according to the understanding of one of skill in the art. In general, an emissive layer includes emissive material within a host matrix. Such an emissive layer may include only a quantum dot material which converts light emitted by a separate emissive material or other emitter, or it may also include the separate emissive material or other emitter, or it may emit light itself directly from the application of an electric current. Similarly, a color altering layer, color filter, upconversion, or downconversion layer or structure may include a material containing quantum dots, though such layer may not be considered an "emissive layer" as disclosed herein. In general, an "emissive layer" or material is one that emits an initial light based on an injected electrical charge, where the initial light may be altered by another layer such as a color filter or other color altering layer that does not itself emit an initial light within the device, but may re-emit altered light of a different spectra content based upon absorption of the initial light emitted by the emissive layer and downconversion to a lower energy light emission. In some embodiments disclosed herein, the color altering layer, color filter, upconversion, and/or downconversion layer may be disposed outside of an OLED device, such as above or below an electrode of the OLED device.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP, also referred to as organic vapor jet deposition (OVJD)), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, which are incorporated by reference in their entireties, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present disclosure may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

It is believed that the internal quantum efficiency (IQE) of fluorescent OLEDs can exceed the 25% spin statistics limit through delayed fluorescence. As used herein, there are two types of delayed fluorescence, i.e., P-type delayed fluorescence and E-type delayed fluorescence. P-type delayed fluorescence is generated from triplet-triplet annihilation (TTA).

On the other hand, E-type delayed fluorescence does not rely on the collision of two triplets, but rather on the thermal population between the triplet states and the singlet excited states. Compounds that are capable of generating E-type delayed fluorescence are required to have very small singlet-triplet gaps. Thermal energy can activate the transition from the triplet state back to the singlet state. This type of delayed fluorescence is also known as thermally activated delayed fluorescence (TADF). A distinctive feature of TADF is that the delayed component increases as temperature rises due to the increased thermal energy. If the reverse intersystem crossing rate is fast enough to minimize the non-radiative decay from the triplet state, the fraction of back populated singlet excited states can potentially reach 75%. The total singlet fraction can be 100%, far exceeding the spin statistics limit for electrically generated excitons.

E-type delayed fluorescence characteristics can be found in an exciplex system or in a single compound. Without being bound by theory, it is believed that E-type delayed fluorescence requires the luminescent material to have a small singlet-triplet energy gap (ΔES-T). Organic, non-metal containing, donor-acceptor luminescent materials may be able to achieve this. The emission in these materials is often characterized as a donor-acceptor charge-transfer (CT) type emission. The spatial separation of the HOMO and LUMO in these donor-acceptor type compounds often results in small ΔES-T. These states may involve CT states. Often, donor-acceptor luminescent materials are constructed by connecting an electron donor moiety such as amino- or carbazole-derivatives and an electron acceptor moiety such as N-containing six-membered aromatic ring.

Devices fabricated in accordance with embodiments of the disclosure can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video walls comprising multiple displays tiled together, a theater or stadium screen, and a sign. Various control mechanisms may be used to control devices fabricated in accordance with the present disclosure, including passive matrix and active matrix. Many of the devices are intended for use in a temperature range comfortable to humans, such as 18 C to 30 C, and more preferably at room temperature (20-25 C), but could be used outside this temperature range, for example, from -40 C to 80 C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In general parlance in the art, a "sub-pixel" may refer to the emissive region, which may be a single-layer EML, a stacked device, or the like, in conjunction with any color altering layer that is used to modify the color emitted by the emissive region.

As used herein, the "emissive region" of a sub-pixel refers to any and all emissive layers, regions, and devices that are used initially to generate light for the sub-pixel. A sub-pixel also may include additional layers disposed in a stack with the emissive region that affect the color ultimately produced by the sub-pixel, such as color altering layers disclosed herein, though such color altering layers typically are not considered "emissive layers" as disclosed herein. An unfiltered sub-pixel is one that excludes a color modifying component such as a color altering layer, but may include one or more emissive regions, layers, or devices.

In some configurations, an "emissive region" may include emissive materials that emit light of multiple colors. For example, a yellow emissive region may include multiple materials that emit red and green light when each material is used in an OLED device alone. When used in a yellow device, the individual materials typically are not arranged such that they can be individually activated or addressed. That is, the "yellow" OLED stack containing the materials cannot be driven to produce red, green, or yellow light; rather, the stack can be driven as a whole to produce yellow light. Such an emissive region may be referred to as a yellow emissive region even though, at the level of individual emitters, the stack does not directly produce yellow light. As described in further detail below, the individual emissive materials used in an emissive region (if more than one), may be placed in the same emissive layer within the device, or in multiple emissive layers within an OLED device comprising an emissive region. As described in further detail below, embodiments disclosed herein may allow for OLED devices such as displays that include a limited number of colors of emissive regions, while including more colors of sub-pixels or other OLED devices than the number of colors of emissive regions. For example, a device as disclosed herein may include only blue and yellow emissive regions. Additional colors of sub-pixels may be achieved by the use of color altering layers, such as color altering layers disposed in a stack with yellow or blue emissive regions, or more generally through the use of color altering layers, electrodes or other structures that form a microcavity as disclosed herein, or any other suitable configuration. In some cases, the general color provided by a sub-pixel may be the same as the color provided by the emissive region in the stack that defines the sub-pixel, such as where a deep blue color altering layer is disposed in a stack with a light blue emissive region to produce a deep blue sub-pixel. Similarly, the color provided by a sub-pixel may be different than the color provided by an emissive region in the stack that defines the sub-pixel, such as where a green color altering layer is disposed in a stack with a yellow emissive region to product a green sub-pixel.

In some configurations, emissive regions and/or emissive layers may span multiple sub-pixels, such as where additional layers and circuitry are fabricated to allow portions of an emissive region or layer to be separately addressable.

An emissive region as disclosed herein may be distinguished from an emissive "layer" as typically referred to in the art and as used herein. In some cases, a single emissive region may include multiple layers, such as where a yellow emissive region is fabricated by sequentially red and green emissive layers to form the yellow emissive region. As previously described, when such layers occur in an emissive region as disclosed herein, the layers are not individually addressable within a single emissive stack; rather, the layers are activated or driven concurrently to produce the desired color of light for the emissive region. In other configurations, an emissive region may include a single emissive layer of a single color, or multiple emissive layers of the same color, in which case the color of such an emissive layer will be the same as, or in the same region of the spectrum as, the color of the emissive region in which the emissive layer is disposed.

### B. The OLEDs and the Devices of the Present Disclosure

Disclosed herein are combinations of phosphorescent compounds (with non-ideally aligned transition dipole moments) and fluorescent emitters (with preferentially oriented transition dipole moment vectors), for use in the emissive regions of OLEDs, where the phosphorescent compounds function as sensitizers for the fluorescent emitters. In particular, combinations of phosphorescent sensitizers with fluorophores having horizontally aligned transition dipole moments can improve outcoupling efficiency. In another application, preferential coupling to the plasmonic modes with fluorescent acceptor having vertically aligned transition dipole moments can improve the efficiency when incorporated into a device comprising outcoupling layers for the energy in the plasmonic modes. The selection of phosphorescent compounds with optimized chemical stability, thermal properties, and photoluminescent quantum yield to pair with preferentially aligned fluorescent emitters, where the phosphorescent compounds function as sensitizers to the fluorescent emitters as acceptors can afford the best balance of lifetime and efficiency in OLED devices. Such a strategy can be used to enhance light outcoupling in OLEDs without sacrificing thermal or chemical stability.

To optimize performance of OLED devices, phosphorescent sensitizers need to be designed for color, lifetime, charge to exciton formation efficiency, and EQE (including VDR) in addition to thermal and synthetic considerations. Often times the design criteria for low VDR run counter to the design for other properties such as thermal stability. Furthermore, consideration of VDR may make certain families with other good properties unusable for alignment reasons. This is especially important for green and blue phosphorescent materials, where the phosphorescent materials which have non-horizontally aligned VDRs can serve as sensitizers for fluorescent acceptors with very low VDR. As such, the sensitizers can be designed to optimize PLQY, lifetime, charge to exciton conversion efficiency, thermal stability, or synthetic considerations, whereas the fluorescent acceptors can be designed for fine tuning of the emission spectrum and VDR for increasing the efficiency of the final OLED device.

According to an aspect, an OLED according to the present disclosure comprises, sequentially: an anode; a hole transporting layer; an emissive region; an electron transporting layer; and a cathode; where the emissive region comprises: a compound S 1; and a compound A1. The compound S 1 is an organometallic sensitizer that transfers energy to the compound A1, and the compound A1 is an acceptor that is an emitter in the emissive region. The compound S1 has a vertical dipole ratio (VDR) value greater than or equal to 0.2; and the compound A1 has a VDR value less than or equal to 0.2. In some embodiments, if the compound S 1 is a tris-homoleptic Ir complex, then the compound S 1 comprises at least three Ir-N bonds. In some embodiments, if the compound S 1 is a Pt complex, then the compound S1 does not comprise both a carbene and a carbazole. In all embodiments of the OLED, the compound S1 is not

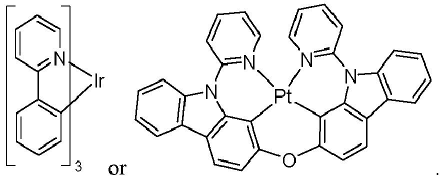

In some embodiments of the OLED, the emissive region comprises a compound H1 that is a first host and at least one of the compound S 1 and the compound A 1 is doped in the first host. In some embodiments, at least one of the compounds S 1, A1, and H 1 comprises at least one deuterium. In some embodiments, the compound H 1 comprises a moiety selected from biscarbazole, bicarbazole, indolocarbazole, 1-N indolocarbazole, triazine, pyrimidine, boryl, aza-dibenzoselenophene, aza-dibenzofuran, aza-dibenzothiophene, and triphenylene.

In some embodiments, at least one of the compound S1 and compound A1 comprises at least one deuterium.

In some embodiments, the compound S 1 comprises at least one moiety selected from the group consisting of dibenzofuran, dibenzothiophene, dibenzoselenophene, carbazole, aza-dibenzofuran, aza-dibenzothiophene, and aza-dibenzoselenophene. In some embodiments, the compound A1 comprises a fused ring system containing five or more 5-membered or 6-membered carbocyclic or heterocyclic rings. In some embodiment, the at least one moiety selected from the group consisting of dibenzofuran, dibenzothiophene, dibenzoselenophene, carbazole, aza-dibenzofuran, aza-dibenzothiophene, and aza-dibenzoselenophene comprises a CN or F group.

In some embodiments, the compound S 1 has an emission transient in a thin film of S 1 doped in PMMA at approx. 1 wt. % at room temperature of > 3 µs. As used herein, room temperature refers to a temperature range of about 20 - 25 deg. C. In some embodiments, the compound S 1 has an emission transient measured in the same way of < 100 µs. Preferably, the compound S1 has an emission transient measured in the same way of < 20 µs. The thin film samples were fabricated by dropcasting prepared PMMA solutions (approximately 0.2 mL) onto a Quartz substrate (25mm x 25mm in size). The PMMA solutions were made at a concentration of 50 mg of PMMA per mL of Toluene and the emitter was doped at a concentration of approximately 1 wt. % with respect to PMMA. The emission transients are measured at room temperature under continuous nitrogen purging on a Horiba Fluorolog-3 using a 340nm SpecraLED excitation source. The thin films had a thickness of 50 to 1000 Å.

In some embodiments, the compound S 1 comprises a first ligand that contains four or more carbocyclic or heterocyclic rings. In some embodiments, the compound S 1 can be an Ir complex. In some embodiments, the compound S 1 can be a Pt complex. In some embodiments, the compound S 1 can be a Pd complex.

In some embodiments, the compound S 1 in room temperature 2-MeTHF solution has an emission onset to 10 % of the emission maximum of ≥ 490 nm. In some embodiments, the compound S1 in room temperature 2-MeTHF solution has an emission onset to 10 % of the emission maximum of ≥ 495 nm. In some embodiments, the compound S 1 in room temperature 2-MeTHF solution has an emission onset to 10 % of the emission maximum of ≥ 500 nm. In some embodiments, the compound S 1 in room temperature 2-MeTHF solution has an emission onset to 10 % of the emission maximum of ≥ 505 nm. In some embodiments, the compound S 1 in room temperature 2-MeTHF solution has an emission onset to 10 % of the emission maximum of ≥ 510 nm. The lower limit of 490 nm maybe desired for green emitting sensitized devices to avoid too much excess energy, i.e., if the ultimate emission is ~520 nm, having an emission onset to 10 % of the emission maximum below 490 would represent a large loss in energy. Additionally, excited states at higher energies have more potential to overcome the activation barriers for detrimental degradation pathways.

In some embodiments, the compound A1 has an emission full width half maximum (FWHM) of ≤ 30 nm. The upper limit for FWHM of 30 nm maybe desired because narrow emission has better ability to have sufficient spectral overlap with the acceptor for efficient Förster resonance energy transfer (FRET) while not requiring a large loss in energy/spectral shift. In some embodiments, the stokes shift for the compound A1 is less than 20 nm. A smaller stokes shift minimizes the excess energy required to have good spectral overlap between S 1 and A1.

In some embodiments, S₁-T₁ gap of the compound A1 is ≤ 0.3eV. The upper limit of 0.3 eV for S₁-T₁ gap maybe desired because TADF character is potentially important for cycling T₁ energy from Dexter events back up to the S₁ energy level for fluorescent emission.

In some embodiments, the compound S 1 has a HOMO level, **E_{HS},** and the compound A1 has a HOMO level, **E_{HA},** and **E_{HS}** > **E_{HA}.** This inequality maybe desired to prevent charge trapping on the acceptor.

In some embodiments, the compound A1 has a LUMO level, **E_{LA},** and wherein the compound H1 has a LUMO level, **E_{LH},** and **E_{LH}** < **E_{LA}.** This inequality maybe desired to prevent charge trapping on the acceptor.

In some embodiments, the compound S 1 in a room temperature 2-MeTHF solution has an emission peak maximum, **λ_{maxS}.** and the compound A1 in a room temperature 2-MeTHF solution has an emission peak maximum, **λ_{maxA},** and **λ_{maxS}** - **λ_{maxA}** < 20 nm. It may be desirable to keep this difference < 20 nm because smaller difference helps with avoiding the energy loss.

In some embodiments, the compound S 1 comprises a platinum-oxygen bond. In some embodiments, the compound S1 comprises a deuterated alkyl group. In some embodiments, S 1 comprises at least one metal to carbene bond. In some embodiments, S1 comprises at least one electron-withdrawing group. In some such embodiments, the electron-withdrawing groups commonly comprise one or more highly electronegative elements including but not limited to fluorine, oxygen, sulfur, nitrogen, chlorine, and bromine. In some such embodiments, the electron-withdrawing group has a Hammett constant larger than 0. In some such embodiments, the electron-withdrawing group has a Hammett constant equal or larger than 0.1, 0.2, 0.3, 0.4, 0.5, 0.6, 0.7, 0.8, 0.9, 1.0, or 1.1.

In some such embodiments, the electron-withdrawn group is selected from the group consisting of the following structures (LIST EWG 1): F, CF₃, CN, COCH₃, CHO, COCF₃, COOMe, COOCF₃, NO₂, SF₃, SiF₃, PF₄, SF₅, OCF₃, SCF₃, SeCF₃, SOCF₃, SeOCF₃, SO₂F, SO₂CF₃, SeO₂CF₃, OSeO₂CF₃, OCN, SCN, SeCN, NC, ⁺N(R^{k2})₃, (R^{k2})₂CCN, (R^{k2})₂CCF₃, CNC(CF₃)₂, BR^{k3}R^{k2}, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridoxine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated alkyl, partially and fully fluorinated aryl, partially and fully fluorinated heteroaryl, cyano-containing alkyl, cyano-containing aryl, cyano-containing heteroaryl, isocyanate, 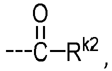 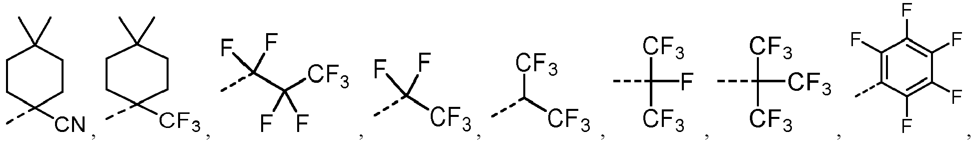 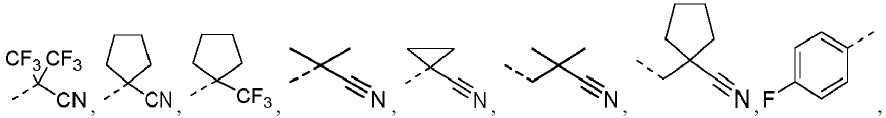 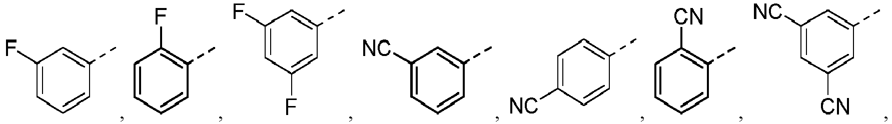 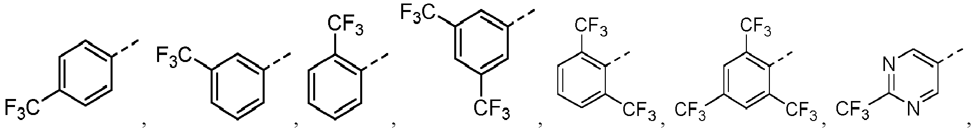 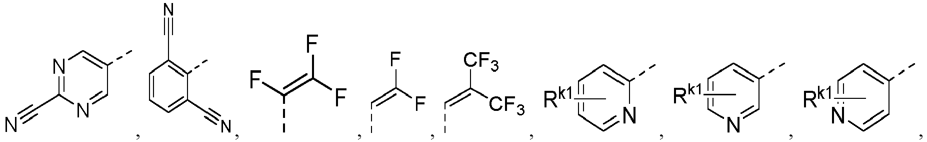 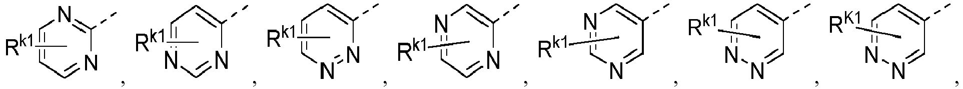 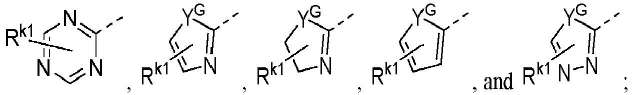
wherein Y^{G} is selected from the group consisting of BRₑ, NRₑ, PRₑ, O, S, Se, C=O, S=O, SO₂, CRₑR_{f}, SiRₑR_{f}, and GeRₑR_{f}; and
R^{k1} each independently represents mono to the maximum allowable substitutions, or no substitution;
wherein each of R^{k1}, R^{k2}, R^{k3}, Rₑ, and R_{f} is independently a hydrogen, or a substituent selected from the group consisting of the General Substituents defined herein.

In some such embodiments, the electron-withdrawing group may be CN or F.

In some embodiments of the OLED, the compound A1 comprises a boryl group.

In some embodiments of the OLED whose emissive region comprises a compound H1, the compound H1 comprises a boryl group.

In some embodiments of the OLED whose emissive region comprises a compound H1, the emissive region further comprises a compound H2 as a second host, where the compound H2 has a HOMO, **E_{HH2},** and **E_{HA}** - **E_{HH2}** < 0.25. It should be understood that it is preferable for the acceptor HOMO level to be close to or deeper than the host HOMO level to avoid strong charge trapping on the acceptor which can lead to undesirable direct charge recombination on the acceptor.

In some embodiments of the OLED, the VDR value of the compound S 1 is > 0.25, more preferably > 0.3, and most preferably > 0.35.

In some embodiments of the OLED, the VDR value of the compound A1 is < 0.15, more preferably < 0.1.

The effect of the compound S 1 on VDR value of the compound A1 -
A first thin film that contains only the compound S 1 and the compound A1 has a lower VDR than a second thin film that contains the compound A1 doped in Reference Host Compound A, wherein the compound A1 is the only emitter in the first thin film and the second thin film, wherein the Reference Host Compound A is

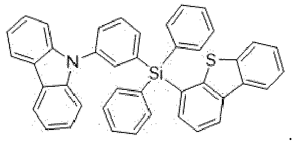

In some embodiments, the compound S 1 is a metal complex comprising a metal M selected from Ir, Pt, Pd, Zn, Au, Ag, and Cu. In some embodiments, the metal M is Ir, Pt, or Pd and the compound S 1 has the formula of M(L¹)ₓ(L²)_{y}(L³)_{z};
wherein L¹, L², and L³ can be the same or different;
wherein x is 1, 2, or 3;
wherein y is 0, 1, or 2;
wherein z is 0, 1, or 2;
wherein x+y+z is the oxidation state of the metal M;
wherein L¹ is selected from the group consisting of the structures of the following LIGAND LIST: 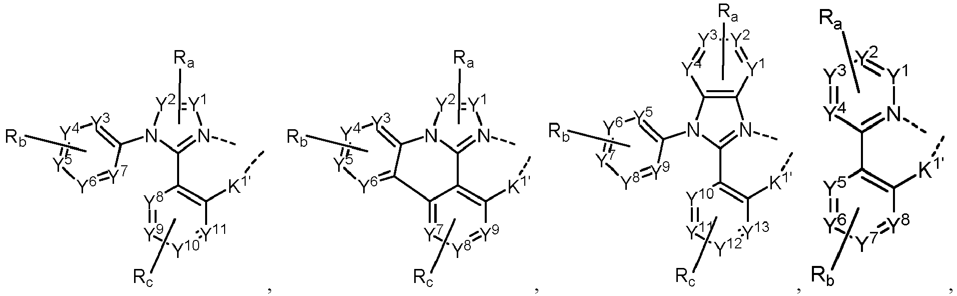 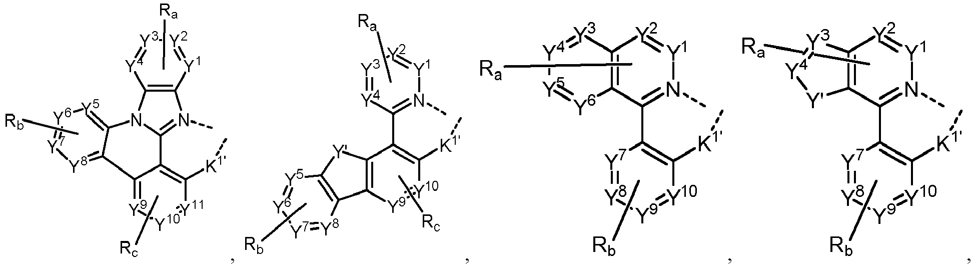 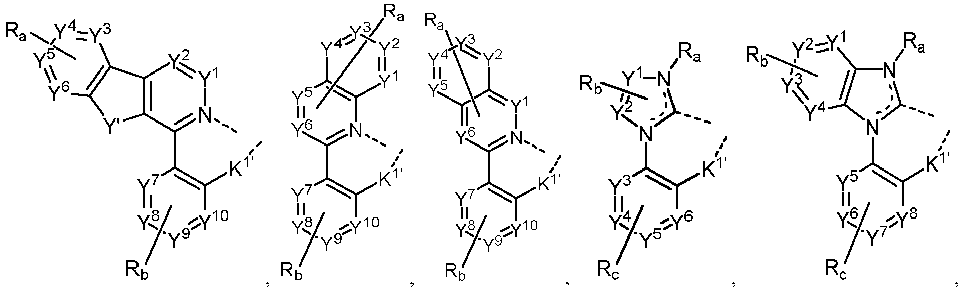 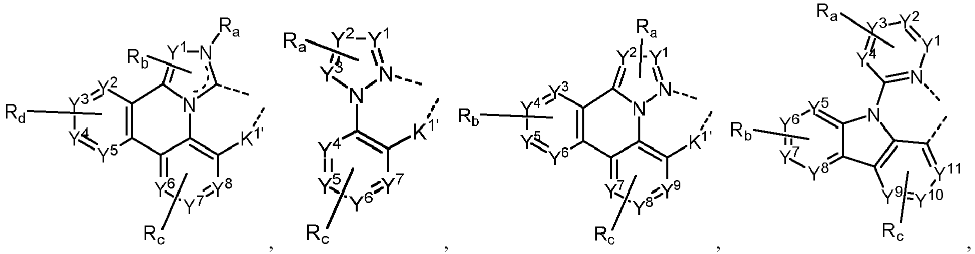 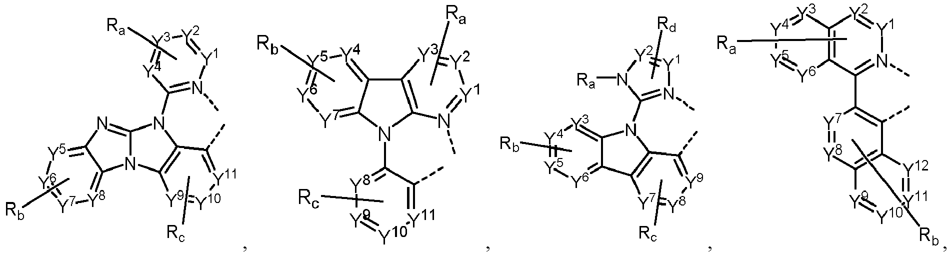 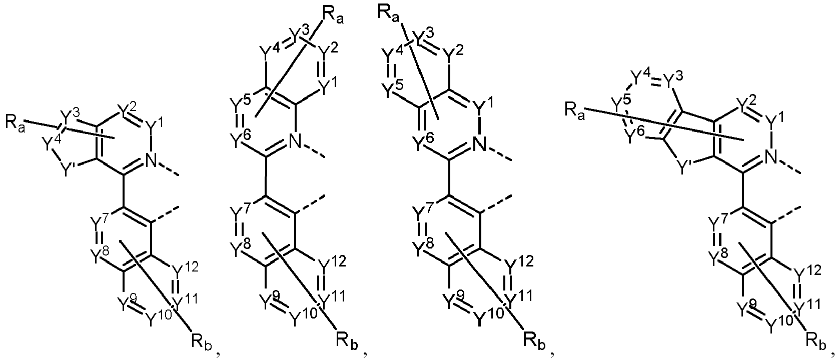 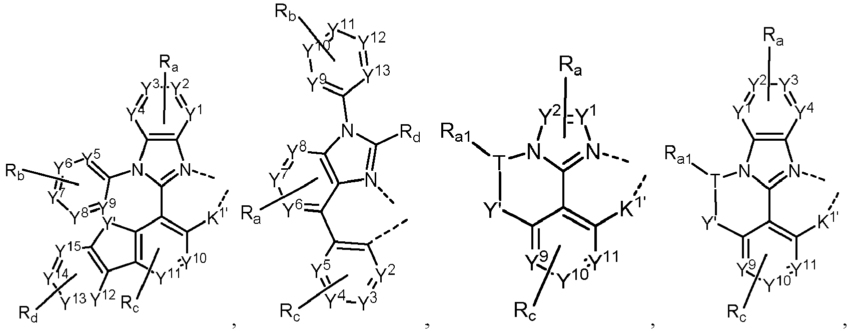 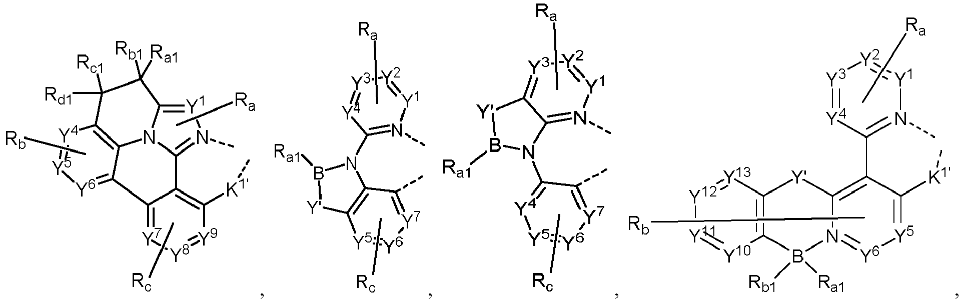 and

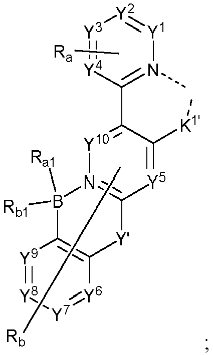

wherein L² and L³ are independently selected from the group consisting of 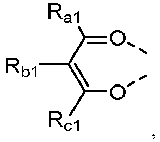 and the structures of the LIGAND LIST; wherein:
   T is selected from the group consisting of B, Al, Ga, and In;
   K^{1'} is a direct bond or is selected from the group consisting of NRₑ, PRₑ, O, S, and Se;
   each Y¹ to Y¹³ are independently selected from the group consisting of carbon and nitrogen;
   Y' is selected from the group consisting of BRₑ, NRₑ, PRₑ, O, S, Se, C=O, S=O, SO₂, CRₑR_{f}, SiRₑR_{f}, and GeRₑR_{f};
   Rₑ and R_{f} can be fused or joined to form a ring;
   each Rₐ, R_{b}, R_{c}, and R_{d} can independently represent from mono to the maximum possible number of substitutions, or no substitution;
   each Rₐ₁, R_{b1}, R_{c1}, R_{d1}, Rₐ, R_{b}, R_{c}, R_{d}, Rₑ, and R_{f} is independently a hydrogen or a substituent selected from the group consisting of the General Substituents as defined herein; and
wherein any two of Rₐ₁, R_{b1}, R_{c1}, R_{d1}, Rₐ, R_{b}, R_{c}, and R_{d} can be fused or joined to form a ring or form a multidentate ligand.

In some embodiments of the OLED of the present disclosure, the compound S 1 has a formula selected from the group consisting of the structures in the following SENSITIZER LIST2: 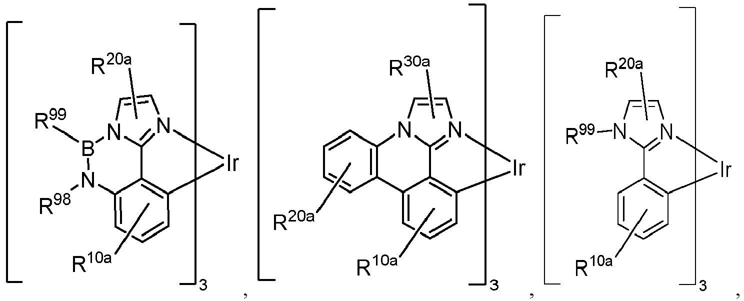 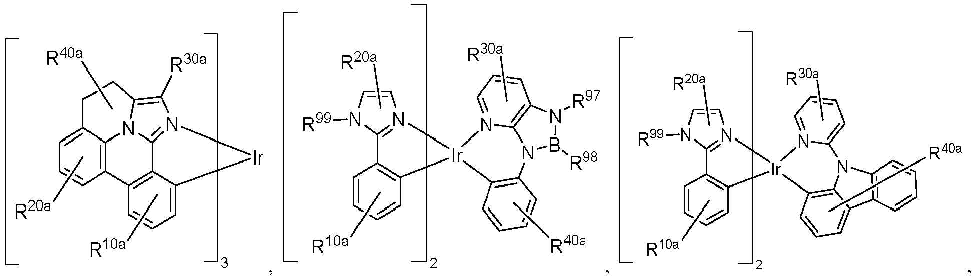 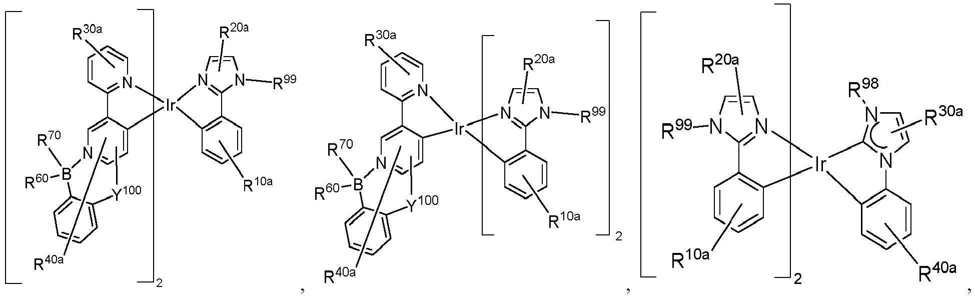 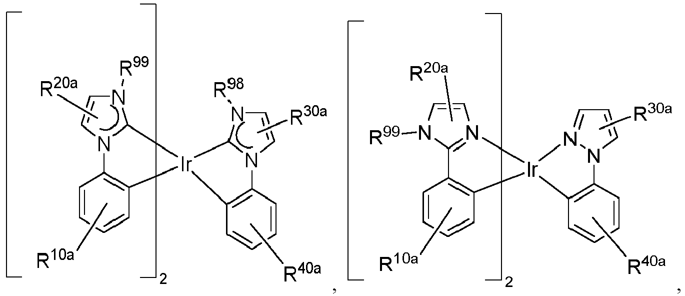 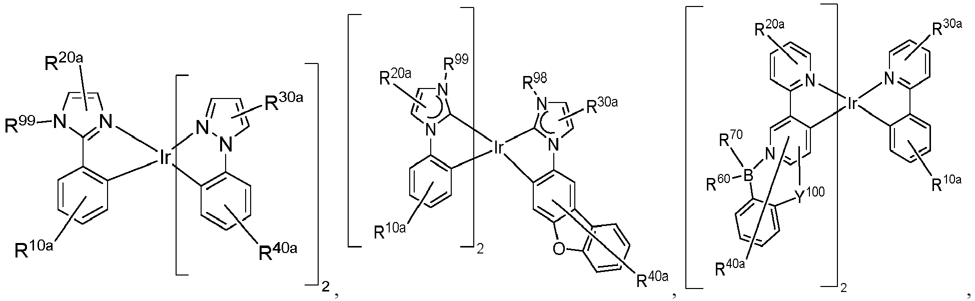 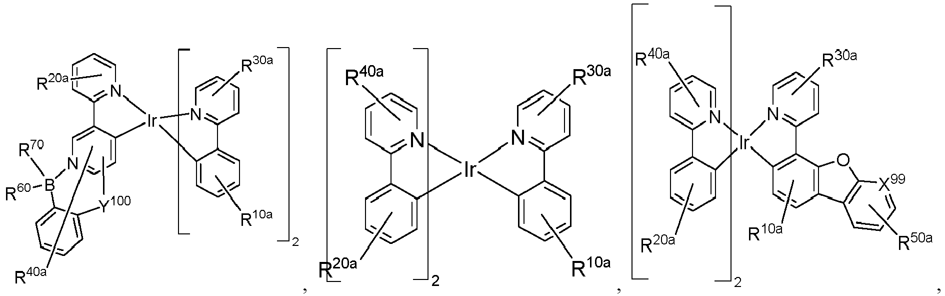 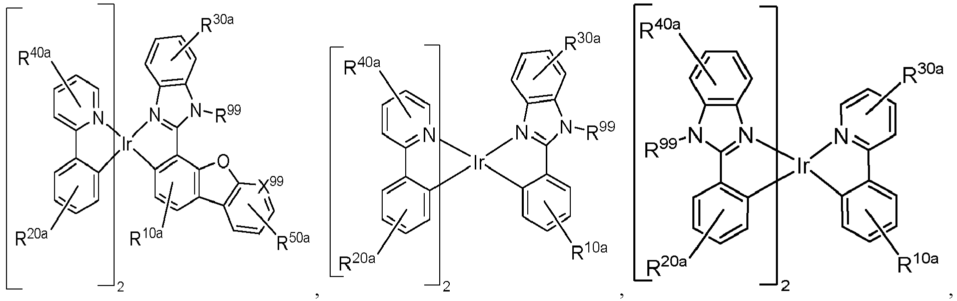 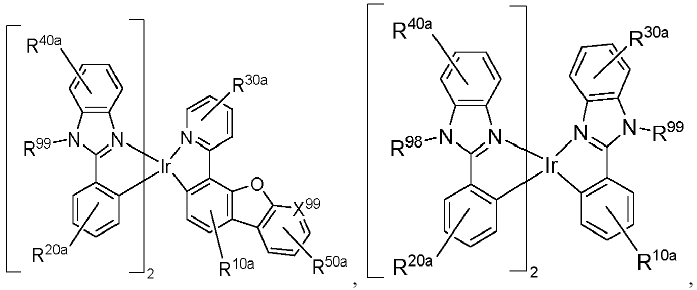 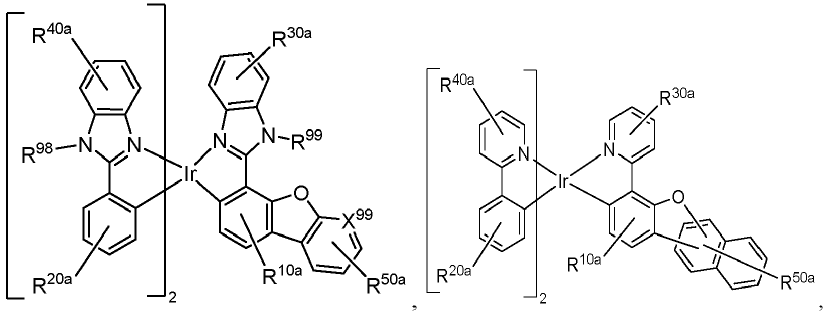 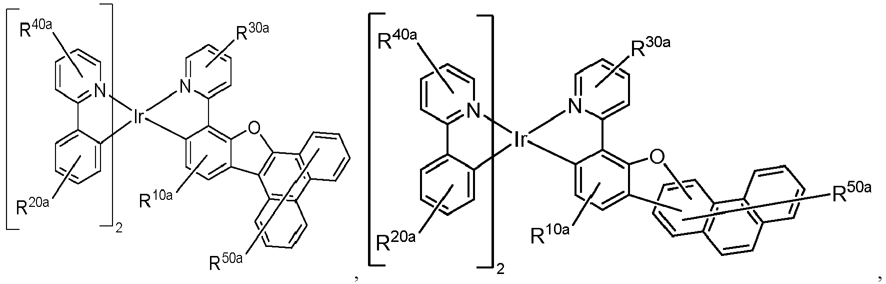 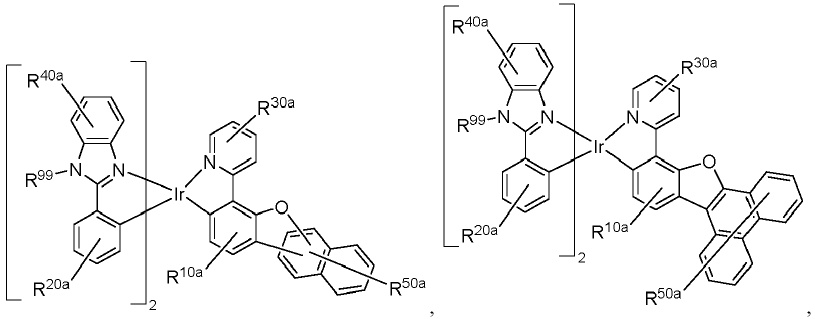 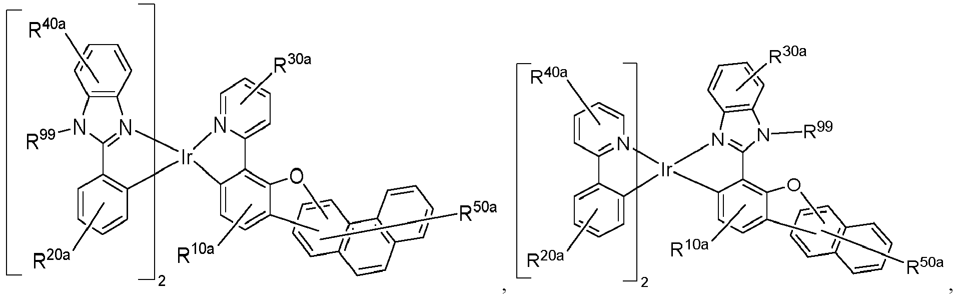 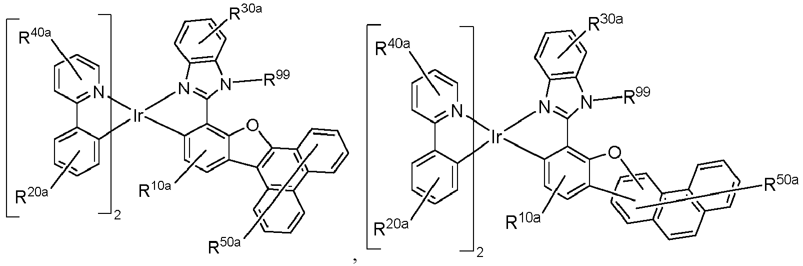 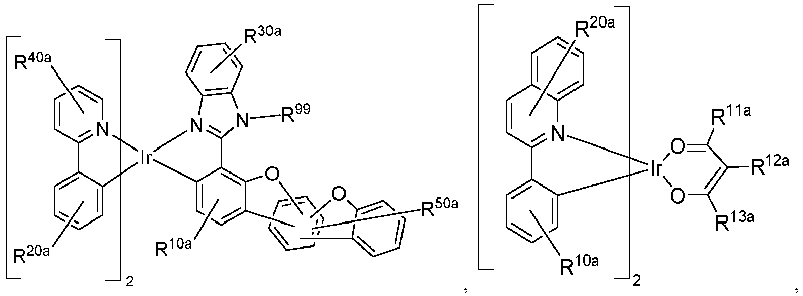 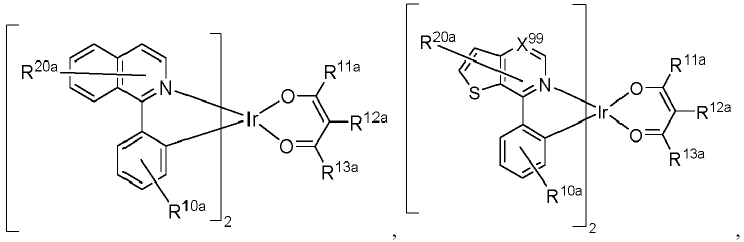 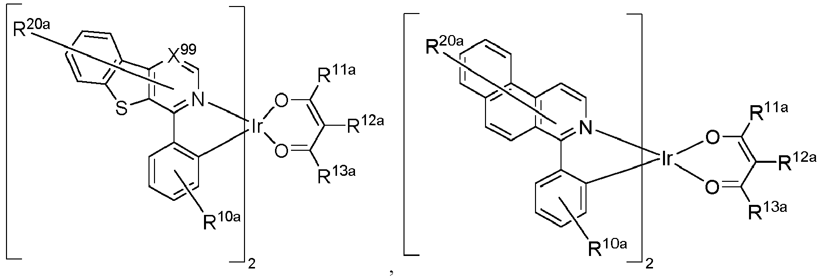 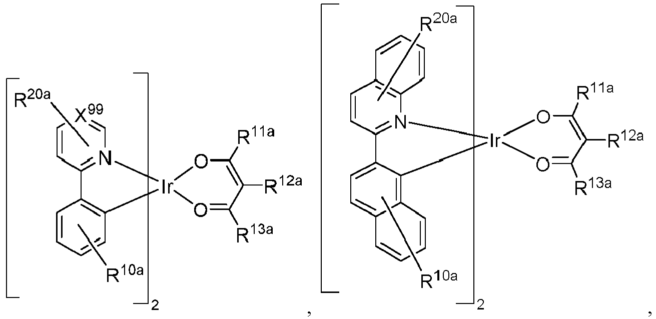 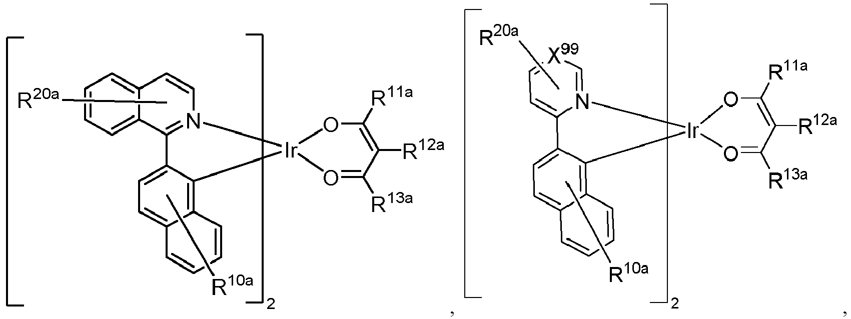 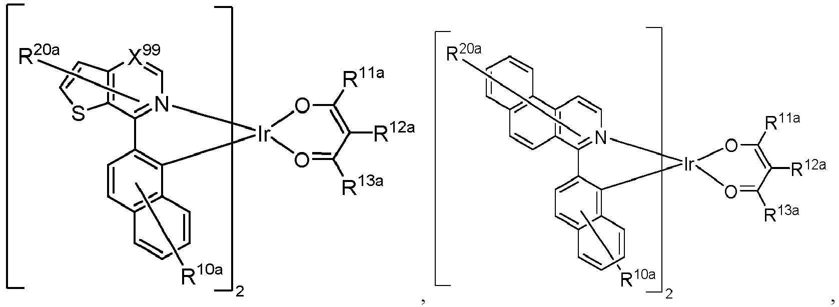 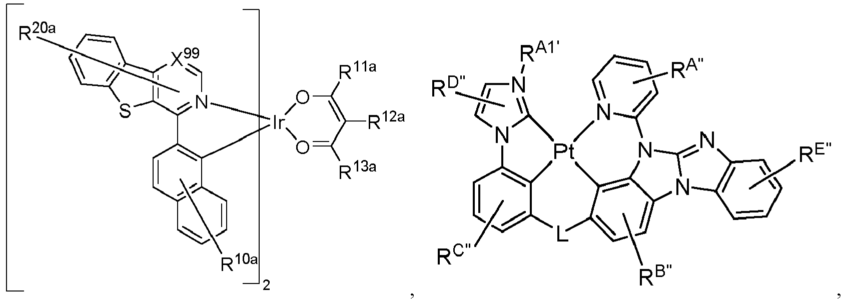 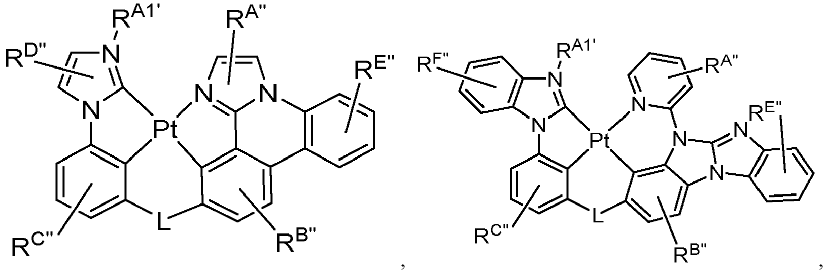 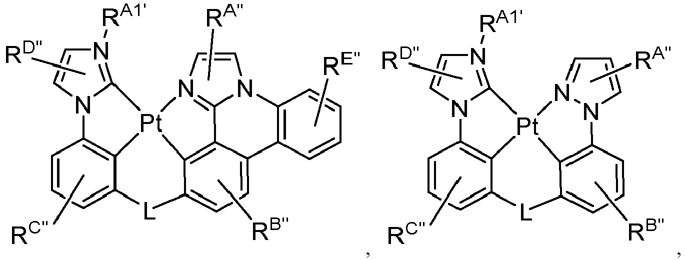 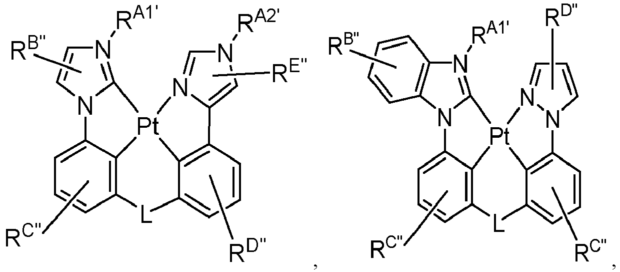 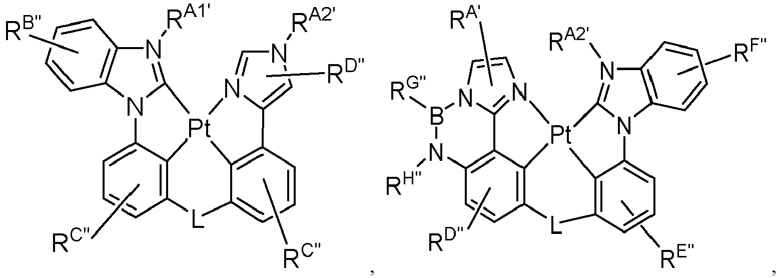 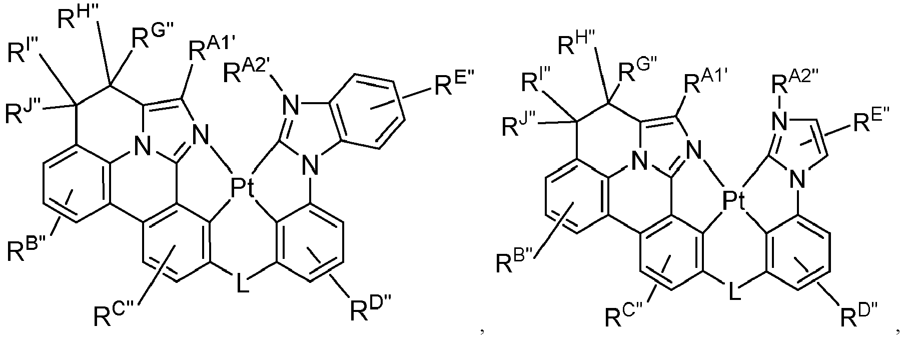 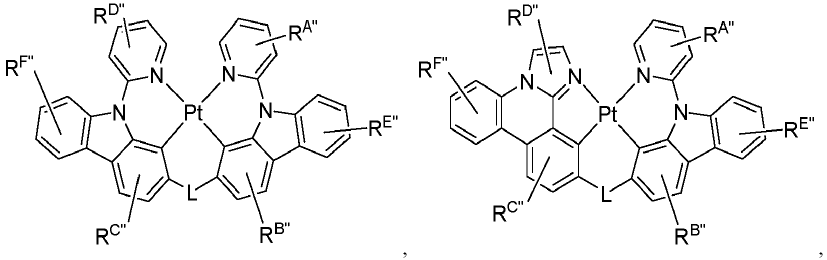 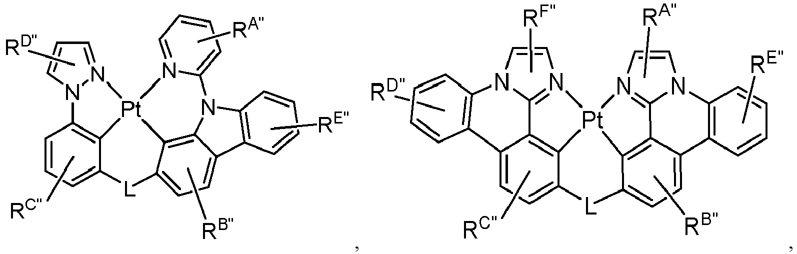 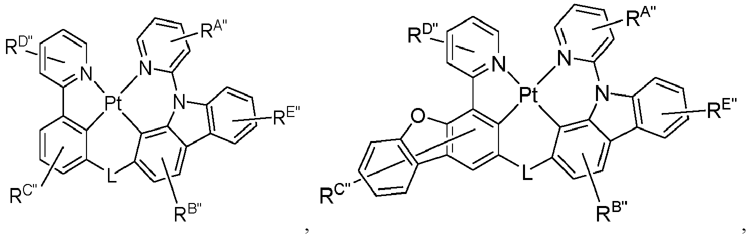 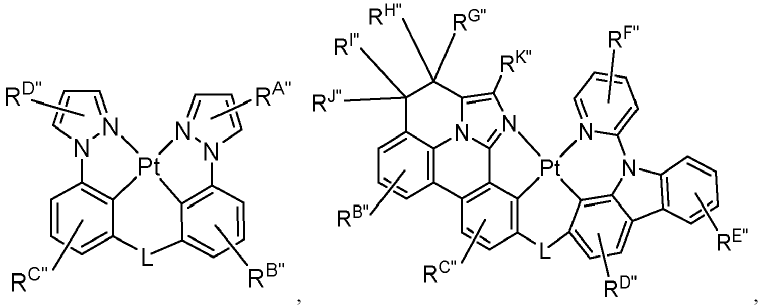 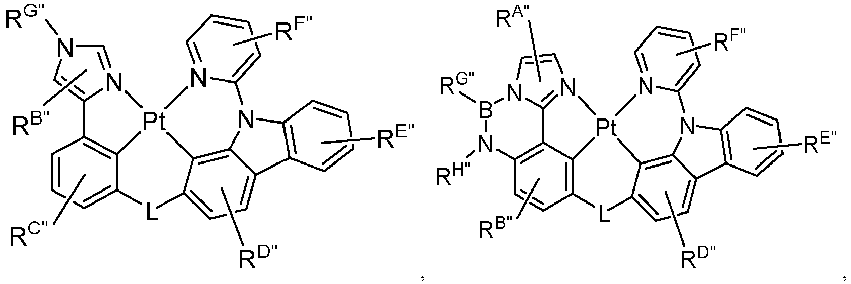 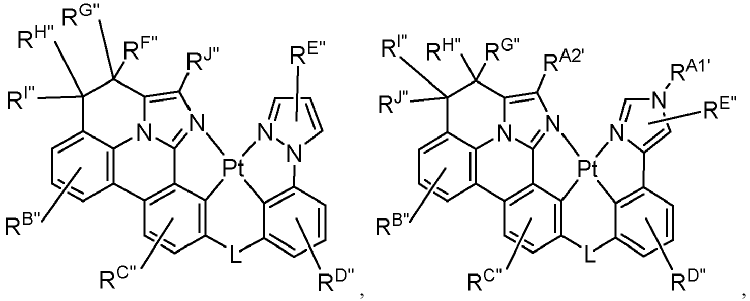 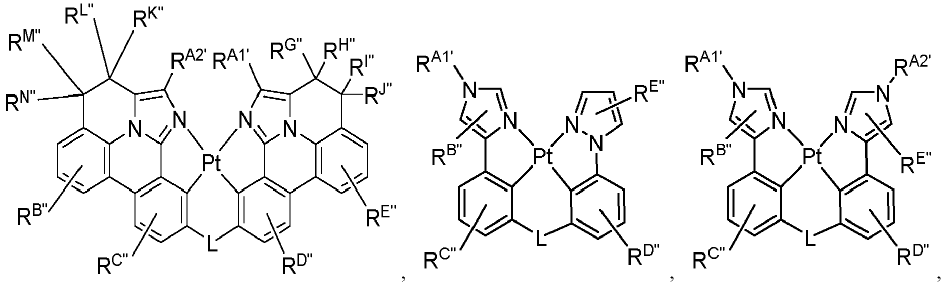 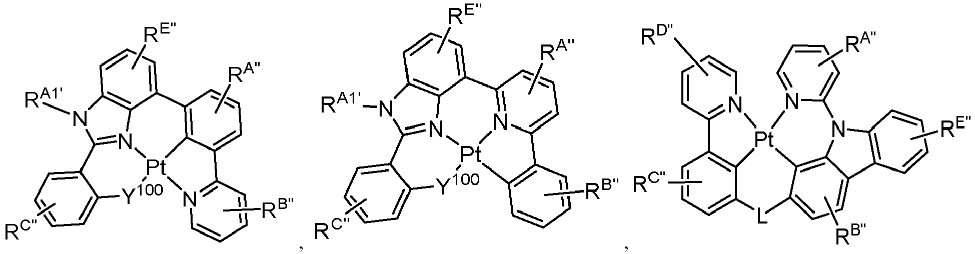 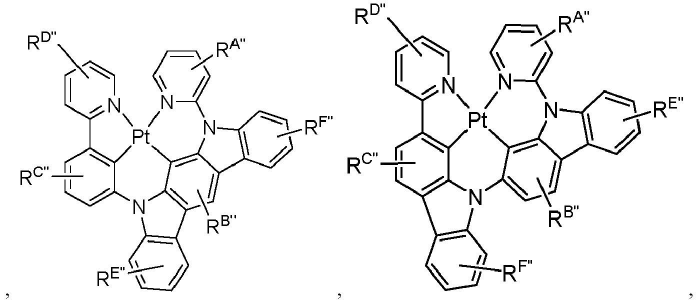 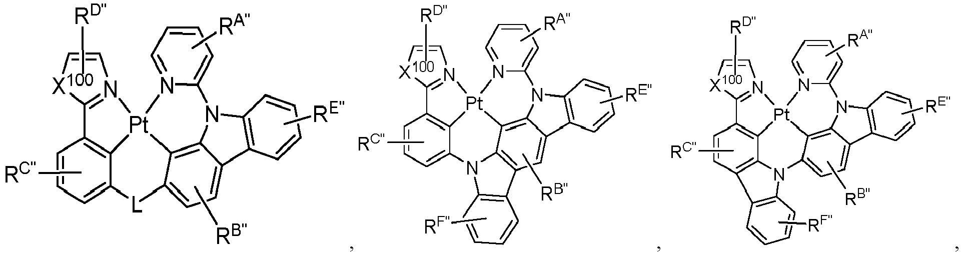 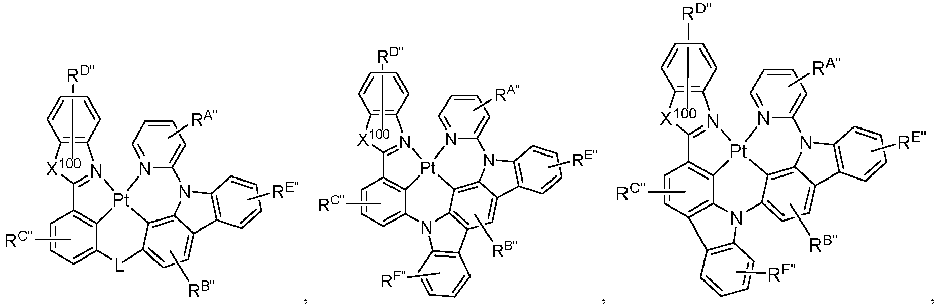 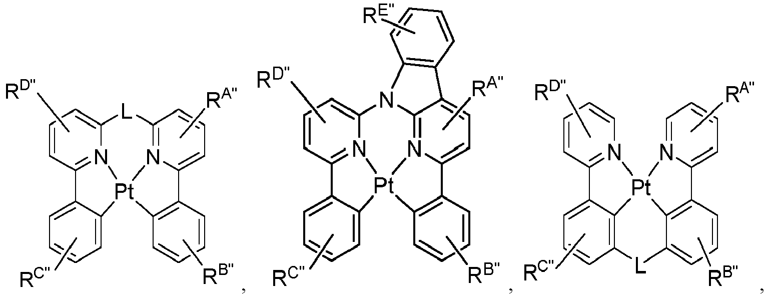 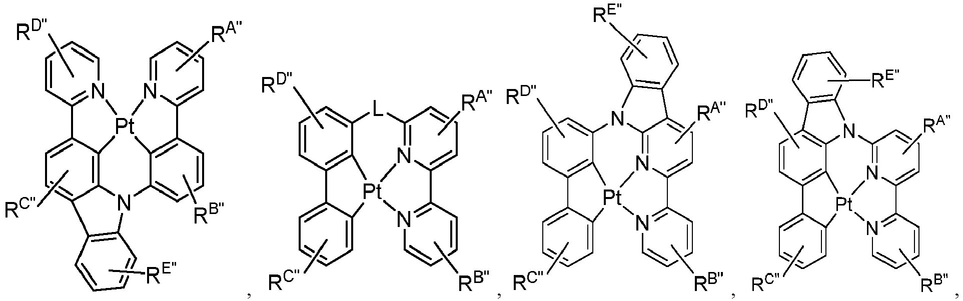 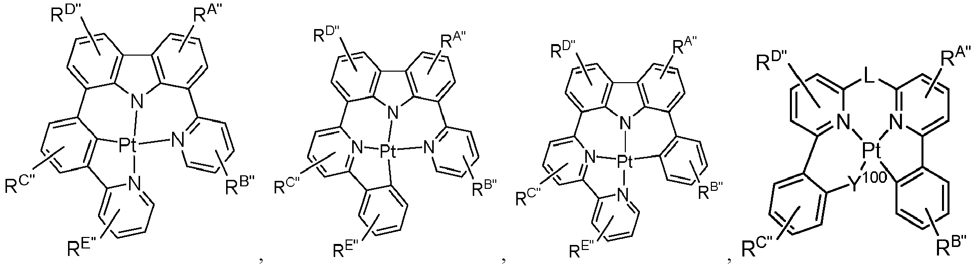 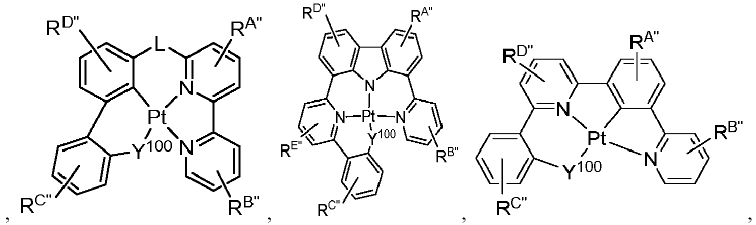 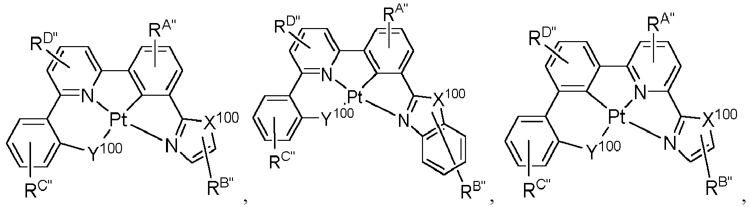 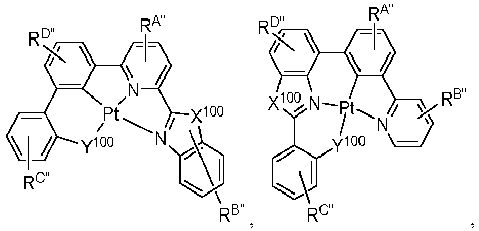 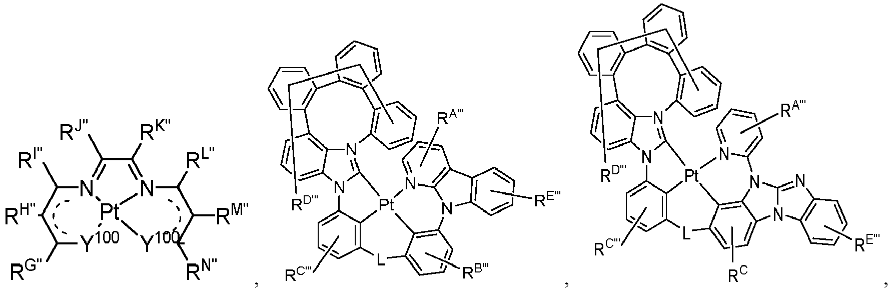 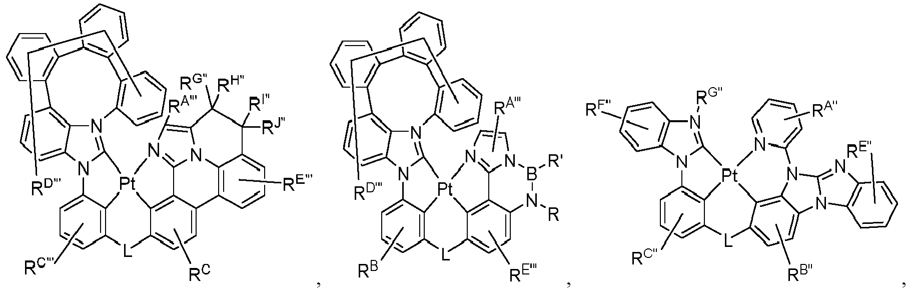 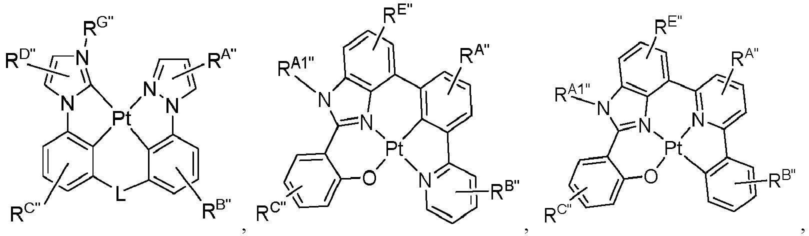 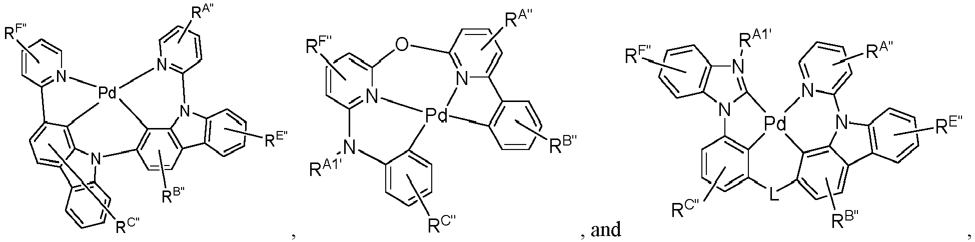 wherein:
X⁹⁹ is CorN;
each Y¹⁰⁰ is independently selected from the group consisting of a NR", O, S, and Se;
L is independently selected from the group consisting of a direct bond, BR", BR"R‴, NR", PR", O, S, Se, C=O, C=S, C=Se, C=NR", C=CR"R‴, S=O, SOz, CR", CR"R‴, SiR"R‴, GeR"R‴, alkyl, cycloalkyl, aryl, heteroaryl, and combinations thereof;
X¹⁰⁰ for each occurrence is selected from the group consisting of O, S, Se, NR", and CR"R‴;
each R^{10a}, R^{20a}, R^{30a}, R^{40a}, and R^{50a}, R^{A"}, R^{B"}, R^{C"}, R^{D"}, R^{E"}, and R^{F"} independently represents mono-, up to the maximum substitutions, or no substitutions;
each of R, R', R", R‴, R^{10a}, R^{11a}, R^{12a}, R^{13a}, R^{20a}, R^{30a}, R^{40a}, R^{50a}, R⁶⁰, R⁷⁰, R⁹⁷, R⁹⁸, R⁹⁹, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of the general substituents as defined herein; wherein any two substituents can be fused or joined to form into a ring.

It should be understood that the metal Pt of each of those compounds in the SENSITIZER LIST 2 can be replaced by Pd, and those derived Pd compounds are also intended to be specifically covered.

In some embodiments, the compound S1 has a formula selected from the group consisting of the structures in the following SENSITIZER LIST3:

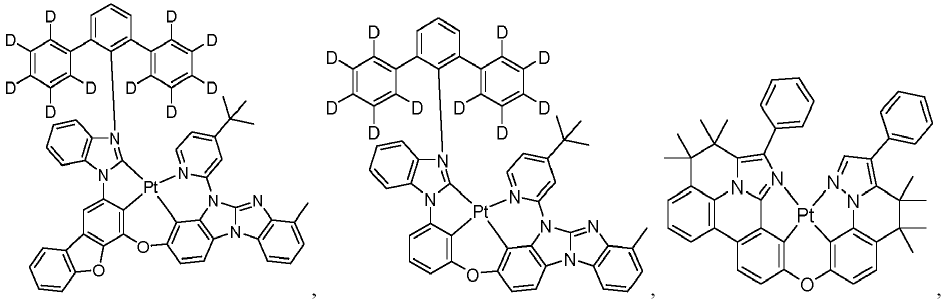

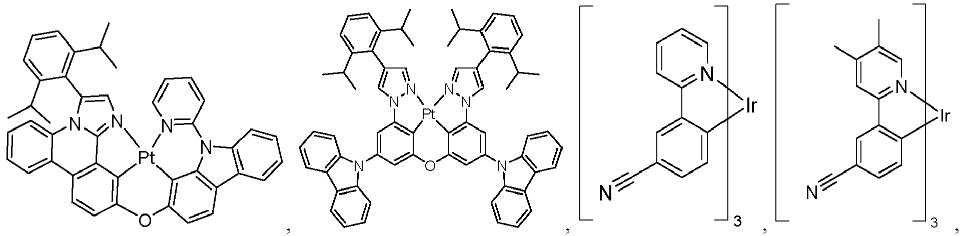

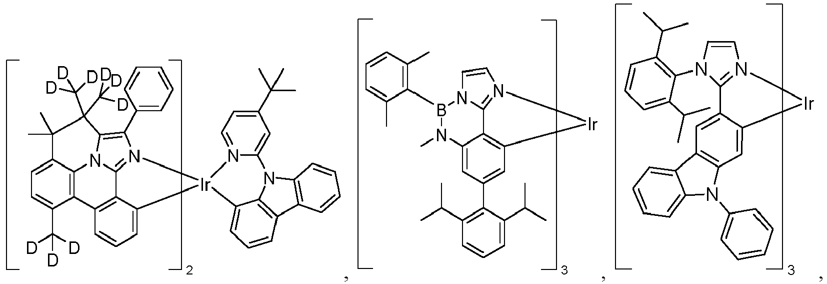

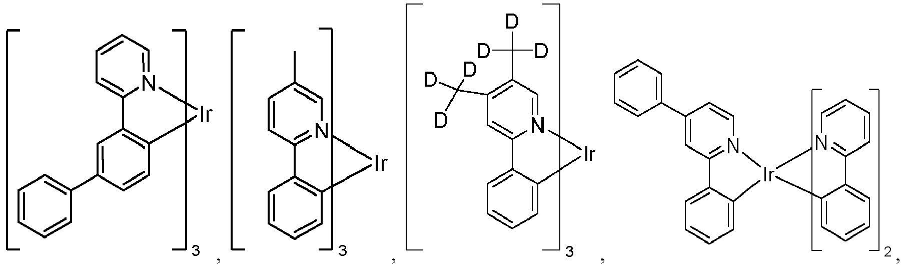

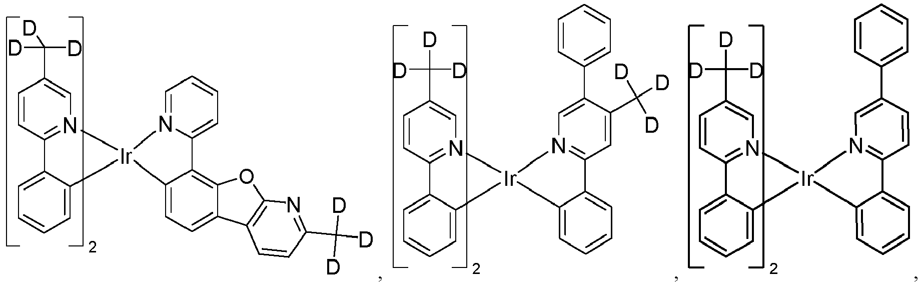

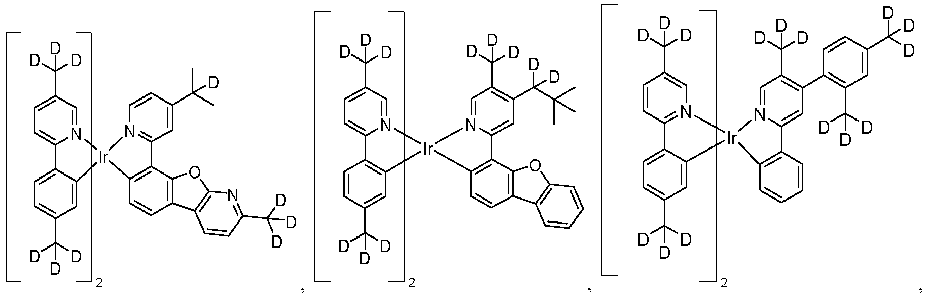

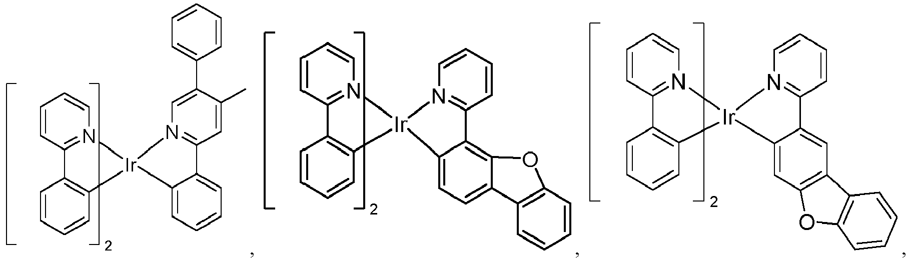

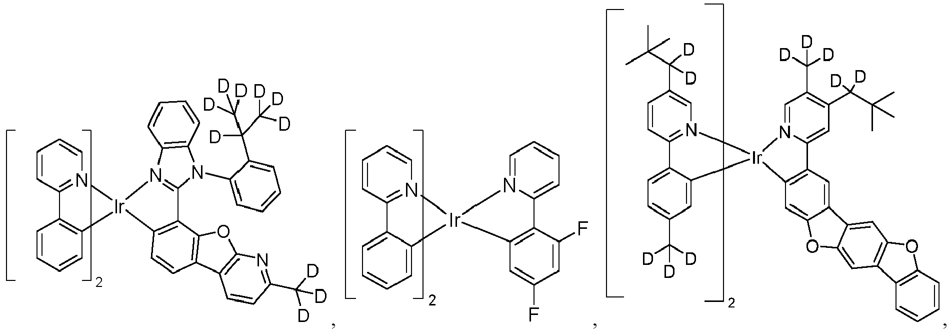

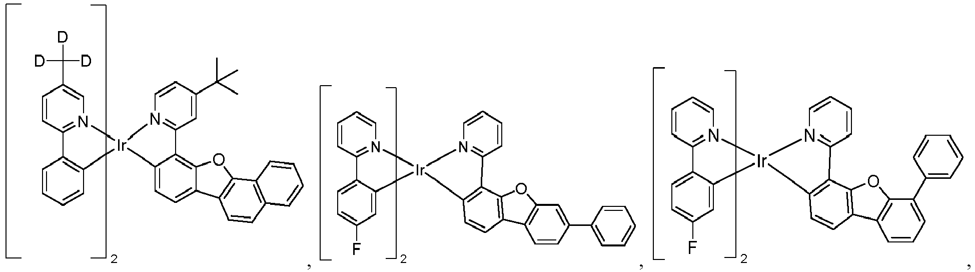

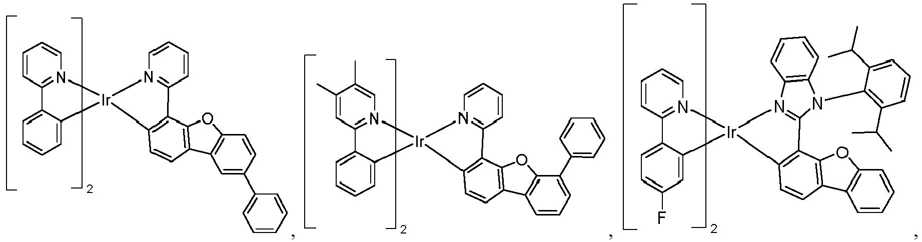

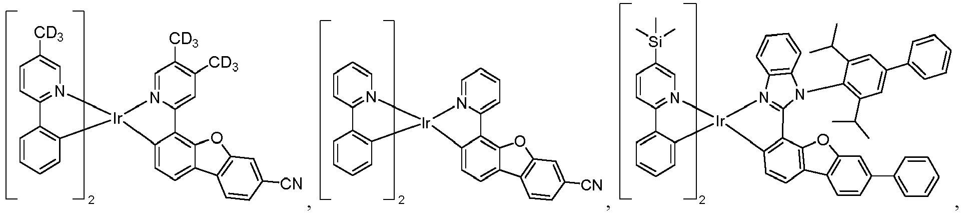

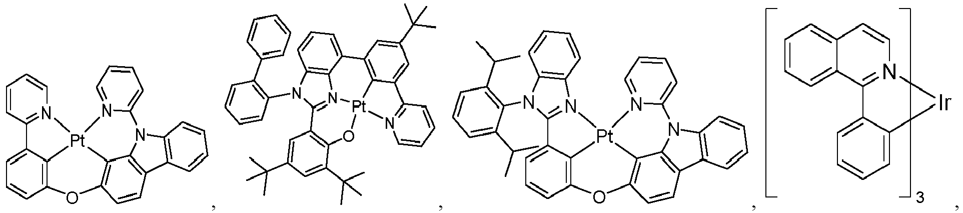

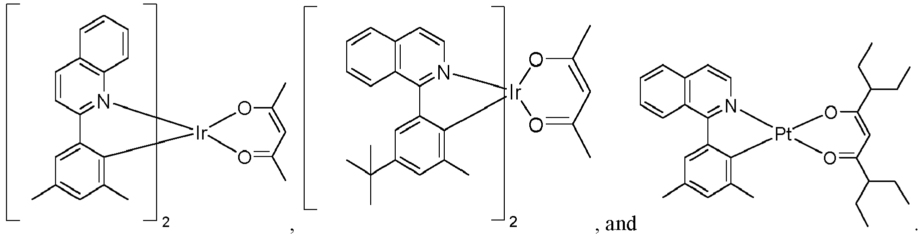

According to another aspect, a novel composition is disclosed. The composition comprises: a compound S1; and a compound A1; where when the composition is formed into an emissive layer of an organic electroluminescent device, the compound S 1 functions as an organometallic sensitizer that transfers energy to the compound A1 and the compound A1 is an acceptor that is an emitter; wherein the compound A1 has a VDR value ≥ 0.33. Preferably, the VDR value of the compound A1 is ≥ 0.4. More preferably, the VDR value of the compound A1 is ≥ 0.5.

According to another aspect, an OLED is disclosed where the OLED comprises: a substrate; a first electrode; an organic emissive layer comprising an organic emissive material disposed over the electrode; where the emissive material comprises any of the novel compositions referenced above.

### [Enhancement layer]

In some embodiments of the OLED that includes the emissive material comprising any of the novel compositions, the device further comprises: an enhancement layer, comprising a plasmonic material exhibiting surface plasmon resonance that non-radiatively couples to the organic emissive material and transfers excited state energy from the organic emissive material to non-radiative mode energy of surface plasmon polaritons, disposed over the organic emissive layer opposite from the first electrode; where the enhancement layer is provided no more than a threshold distance away from the organic emissive layer; where the organic emissive material has a total non-radiative decay rate constant and a total radiative decay rate constant due to the presence of the enhancement layer, and the "threshold distance" is defined as where the total non-radiative decay rate constant is equal to the total radiative decay rate constant. Such OLED can also include an outcoupling layer disposed over the enhancement layer, where the outcoupling layer scatters the non-radiative mode energy of the surface plasmon polaritons as photons to free space.

In some embodiments, an OLED is disclosed that comprises:
a substrate;
a first electrode;
an organic emissive region disposed over the first electrode;
an enhancement layer disposed over the organic emissive region opposite from the first electrode;
wherein the emissive region comprises:
   a compound S1; and
   a compound A1;
wherein the compound S 1 is a sensitizer that transfers energy to the compound A1, and the compound A1 is an acceptor that is an emitter, wherein the enhancement layer comprises a plasmonic material exhibiting surface plasmon resonance that non-radiatively couples to the compound A1, compound S 1, or both compounds A1 and S1, and transfers excited state energy from the compound A1, compound S1, or from both compounds A1 and S1, to non-radiative mode energy of surface plasmon polaritons.

In some embodiments of the OLED having an enhancement layer, the enhancement layer is provided no more than a threshold distance away from the organic emissive region, where the compound A1 has a total non-radiative decay rate constant and a total radiative decay rate constant due to the presence of the enhancement layer. In some embodiments of the OLED having an enhancement layer, the enhancement layer comprises one or more of Ag, Al, Au, Ir, Pt, Ni, Cu, W, Ta, Fe, Cr, Mg, Ga, Rh, Ti, Ru, Pd, In, Bi, Ca, alloys or mixtures of these metals.

In some embodiments of the OLED having an enhancement layer, the enhancement layer is provided no more than a threshold distance away from the organic emissive region, where the compound S 1 has a total non-radiative decay rate constant and a total radiative decay rate constant due to the presence of the enhancement layer.

In some embodiments of the OLED having an enhancement layer, the enhancement layer is provided no more than a threshold distance away from the organic emissive region, where the organic emissive region has a total non-radiative decay rate constant and a total radiative decay rate constant due to the presence of the enhancement layer.

In some embodiments of the OLED having an enhancement layer, the OLED can further include an outcoupling layer disposed over the enhancement layer, wherein the outcoupling layer scatters the non-radiative mode energy of the surface plasmon polaritons as photons to free space.

In some embodiments of the OLED having an enhancement layer, the emission from the compound A1, has a smaller FWHM than emission from the compound S 1. In some embodiments, the emission peak maximum of the emission from the compound A1 is higher energy than the emission peak maximum of the emission from the compound S 1.

In some embodiments of the OLED having an enhancement layer, the VDR of the compound A1 is > VDR of the compound S 1.

In some embodiments of the OLED having an enhancement layer, the photoluminescence quantum yield (PLQY) of the compound A1 is > PLQY of the compound S1.

In some embodiments of the OLED having an enhancement layer, the doping concentration level profiles of the sensitizer compound S 1 and/or the emitter compound A1 in the organic emissive region are not uniform. The doping concentration level profiles are defined across the thickness of the organic emissive region.

In some embodiments of the OLED having an enhancement layer, the doping concentration levels of the compound S 1 and/or the compound A1 are in a gradient across the thickness of the organic emissive region. In some embodiments, the gradient is low-to-high. In some embodiments, the gradient is high-to-low.

In some embodiments of the OLED having an enhancement layer, the organic emissive region is a single layer. In some embodiments of the OLED having an enhancement layer, the organic emissive region comprises multiple layers.

In some embodiments of the OLED having an enhancement layer, the OLED further comprises a hole transport layer (HTL) between the first electrode and the organic emissive region, where the compound S 1 is a phosphorescent sensitizer and the compound A1 is a fluorescent acceptor, and doping concentration of the compound A1 in the emissive region increases toward the HTL, i.e., the concentration of the compound A1 increases closer to the HTL.

In some embodiments of the OLED having an enhancement layer, the OLED further comprises an electron transport layer (ETL) between the second electrode and the organic emissive region, where the compound A1 is a fluorescent acceptor, and doping concentration of the compound A1 in the emissive region increases toward the ETL.

In some embodiments of the OLED having an enhancement layer, the compound S 1 is capable of phosphorescent emission or TADF emission at room temperature.

In some embodiments of the OLED having an enhancement layer, emission contribution from the compound S 1 is ≤ 45% of total electroluminescence spectrum of the OLED. In some embodiments of the OLED having an enhancement layer, the compound S 1 does not emit light.

In some embodiments of the OLED having an enhancement layer, the compound S 1 is fully or partially deuterated. In some embodiments of the OLED having an enhancement layer, the compound A1 is fully or partially deuterated.

In some embodiments of the OLED having an enhancement layer, the VDR of the compound S 1 is ≥ 0.25. In some embodiments, the VDR of the compound S 1 is ≥ 0.3. In some embodiments, the VDR of the compound S 1 is ≥ 0.35. In some embodiments, the VDR of the compound S1 is ≥ 0.40. In some embodiments, the VDR of the compound S1 is ≥ 0.45. In some embodiments, the VDR of the compound S1 is ≥ 0.50. In some embodiments, the VDR of the compound S 1 is ≥ 0.55. In some embodiments, the VDR of the compound S 1 is ≥ 0.60.

In some embodiments of the OLED having an enhancement layer, the VDR of the compound A1 is ≤ 0.33. In some embodiments, the VDR of the compound A1 is ≤ 0.30. In some embodiments, the VDR of the compound A1 is ≤ 0.25. In some embodiments, the VDR of the compound A1 is ≤ 0.20. In some embodiments, the VDR of the compound A1 is ≤ 0.15. In some embodiments, the VDR of the compound A1 is ≤ 0.10.

In some embodiments of the OLED having an enhancement layer, both the compound S 1 and the compound A1 have a VDR ≥ 0.33. In some embodiments, the compounds S 1 and A1 both have a VDR ≥ 0.40. In some embodiments, the compounds S 1 and A1 both have a VDR ≥ 0.45. In some embodiments, the compounds S1 and A1 both have a VDR ≥ 0.50. In some embodiments, the compounds S 1 and A1 both have a VDR ≥ 0.55. In some embodiments, the compounds S1 and A1 both have a VDR ≥ 0.60. In some embodiments of the OLED having an enhancement layer, the compound S 1 has a VDR less than 0.33 and the compound A1 has a VDR ≥ 0.33.

In some embodiments of the OLED having an enhancement layer, the emissive region comprises a compound H1 that is a first host and at least one of the compound S 1 and the compound A1 is doped in the first host. In some embodiments, at least one of the compound S 1 and compound A 1 comprises at least one deuterium. In some embodiments, at least one of the compounds S1, A1, and H1 comprises at least one deuterium.

In any of the disclosed embodiments of the OLED having an enhancement layer, the compound S 1 can comprise at least one moiety selected from the group consisting of dibenzofuran, dibenzothiophene, dibenzoselenophene, carbazole, aza-dibenzofuran, aza-dibenzothiophene, and aza-dibenzoselenophene.

In any of the disclosed embodiments of the OLED having an enhancement layer, the compound A1 can comprise a fused ring system containing five or more 5-membered or 6-membered carbocyclic or heterocyclic rings.

In some embodiments of the OLED having an enhancement layer, the compound H1 comprises a moiety selected from biscarbazole, bicarbazole, indolocarbazole, 1-N indolocarbazole, triazine, pyrimidine, boryl, aza-dibenzoselenophene, aza-dibenzofuran, aza-dibenzothiophene, and triphenylene.

In any of the disclosed embodiments of the OLED having an enhancement layer, the compound S 1 can have an emission transient in a thin film of S 1 doped in PMMA at 1% by weight at room temperature of > 3 µs.

In any of the disclosed embodiments of the OLED having an enhancement layer, the compound S 1 can comprise a first ligand that contains four or more carbocyclic or heterocyclic rings.

In any of the disclosed embodiments of the OLED having an enhancement layer, the compound S 1 can be an Ir complex. In some embodiments of the OLED having an enhancement layer, the compound S 1 is a Pt complex.

In some disclosed embodiments of the OLED having an enhancement layer, the compound S 1 in room temperature 2-MeTHF solution has an emission onset to 10% of the emission maximum of ≥ 490 nm.

In some disclosed embodiments of the OLED having an enhancement layer, the compound A1 has a FWHM of ≤ 30 nm.

In some disclosed embodiments of the OLED having an enhancement layer, S₁-T₁ of the compound A1 is ≤ 0.3eV.

In some disclosed embodiments of the OLED having an enhancement layer, the compound S 1 has a HOMO level, E_{HS}, and the compound A1 has a HOMO level, E_{HA}, and E_{HS} > E_{HA}. In some disclosed embodiments of the OLED having an enhancement layer, the compound A1 has a LUMO level, E_{LA}, and wherein the compound H1 has a LUMO level, E_{LH}, and E_{LH} < E_{LA}.

In some disclosed embodiments of the OLED having an enhancement layer, the compound S 1 in a room temperature 2-MeTHF solution has an emission peak maximum, λ_{maxS}, and the compound A1 in a room temperature 2-MeTHF solution has an emission peak maximum, λ_{maxA}, and λ_{maxS} - λ_{maxA} < 20 nm.

In some disclosed embodiments of the OLED having an enhancement layer, the compound S 1 comprises a platinum-oxygen bond.

In some disclosed embodiments of the OLED having an enhancement layer, the compound S 1 comprises a deuterated alkyl group.

In some disclosed embodiments of the OLED having an enhancement layer, the compound H1 comprises a boryl group.

In some disclosed embodiments of the OLED having an enhancement layer, the compound A1 comprises a boryl group.

In some disclosed embodiments of the OLED having an enhancement layer, the emissive region further comprises a compound H2 as a second host, where the compound H2 has a HOMO, E_{HH2}, and E_{HA} - E_{HH2} < 0.25.

In some disclosed embodiments of the OLED having an enhancement layer, the VDR value of the compound S 1 is > 0.25.

In some disclosed embodiments of the OLED having an enhancement layer, the VDR value of the compound A1 is < 0.15.

In some disclosed embodiments of the OLED having an enhancement layer, a first thin film that contains only the compound S 1 and the compound A1 has a lower VDR than a second thin film that contains the compound A1 doped in Reference Host Compound A, wherein the compound A1 is the only emitter in the first thin film and the second thin film, wherein the Reference Host Compound A is

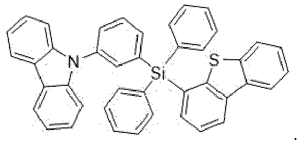

In some disclosed embodiments of the OLED having an enhancement layer, the compound S1 is a metal complex comprising a metal selected from Ir, Pt, Pd, Au, Ag, and Cu.

In some disclosed embodiments of the OLED having an enhancement layer, the metal M is Ir, Pt, or Pd and the compound S 1 has the formula of M(L¹)ₓ(L²)_{y}(L³)_{z};
wherein L¹, L², and L³ can be the same or different;
wherein x is 1, 2, or 3;
wherein y is 0, 1, or 2;
wherein z is 0, 1, or 2;
wherein x+y+z is the oxidation state of the metal M;
wherein L¹ is selected from the group consisting of the structures of the LIGAND LIST defined herein; and
wherein L² and L³ are independently selected from the group consisting of 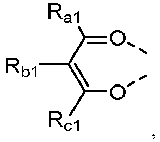 and the structures of the LIGAND LIST.

In some disclosed embodiments of the OLED having an enhancement layer, the compound S 1 has a formula selected from the group consisting of the structures in the SENSITIZER LIST2 defined herein.

In some disclosed embodiments of the OLED having an enhancement layer, the compound S 1 has a formula selected from the group consisting of the structures in the SENSITIZER LIST3 defined herein.

In another aspect, the present disclosure provides plasmonic OLEDs and the device properties that optimize the advantages of both plasmonic and sensitized OLEDs.

Organic light emitting devices (OLEDs) that intentionally couple excited state energy into the plasmon mode of a nearby metal have demonstrated improved operational stability and the potential for higher efficiencies than what is achievable in conventional OLED device design. Additionally, sensitized OLEDs quickly remove excited state energy from the sensitized dopant and transfer it to an emitter that has other desirable properties which could include increased efficiency or stability or more saturated color.

In some embodiments, plasmonic OLEDs are designed such that the recombination zone is located within a threshold distance of the enhancement layer, usually, but not limited to, a metal cathode. The threshold distance is defined as the distance at which a total non-radiative decay rate constant is equal to a total radiative decay rate constant. By quickly quenching the emitter energy into the plasmon mode of a nearby enhancement layer, the excited state lifetime of the emitter is reduced, thereby lowering the steady state exciton density and increasing device stability. Moreover, plasmonic OLEDs incorporating efficient plasmon outcoupling mechanisms are utilized to exceed the efficiencies of conventional OLEDs.

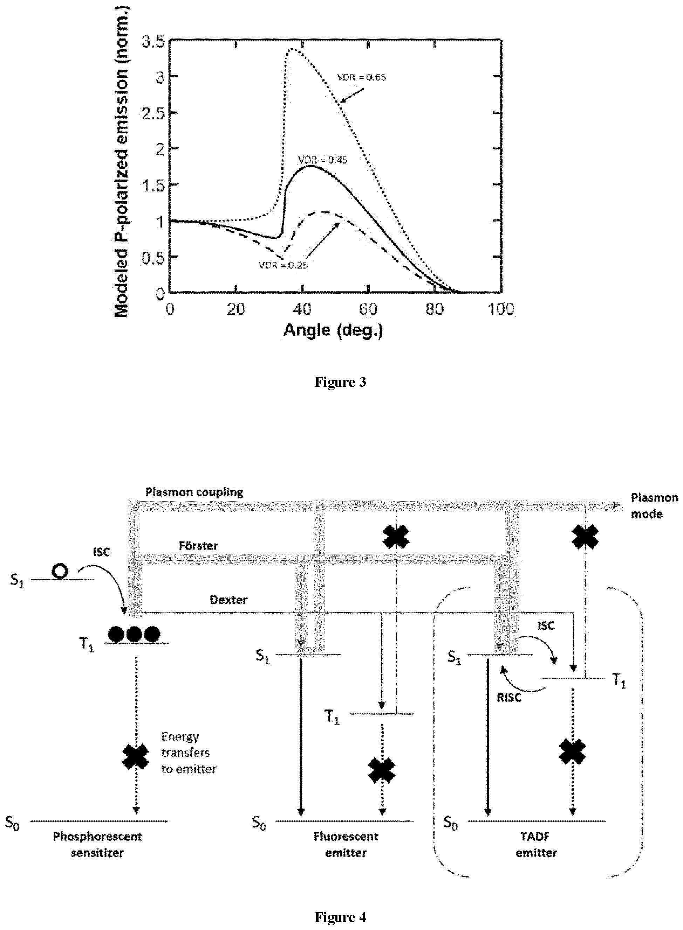

In some embodiments, a phosphorescent-sensitized plasmonic OLED is disclosed such as shown in FIG. 4.

FIG. 4 illustrates an energy level diagram showing the various pathways of excited state energy transfer in a phosphorescent-sensitized plasmonic OLED. The figure includes energy levels for either a fluorescent or TADF emitter. In these embodiments, the energy transfer pathways result in plasmon mode coupling.

It should be understood that because coupling to the plasmon mode requires an appreciable transition dipole moment to exist between the excited and ground states, not all excited states will exhibit plasmon mode coupling. Assuming that the rate of intersystem crossing from the first singlet excited state (S1) of the phosphor sensitizer to its first triplet excited state (T1) is much faster than the rate of coupling to the plasmon mode (i.e., *k_{ISC}* >> *k_{P}*), then the electrically injected excitons will all exist in the T1 state before plasmon coupling occurs. Plasmon coupling is possible from T1 of the phosphor sensitizer due to the ability of phosphorescent emitters to radiatively decay from T1 to the ground state (S0). In addition to the plasmon mode coupling, the phosphor's T1 excitons will also transfer via Förster resonance energy transfer (FRET) to S 1 of the emitter.

In some embodiments, the emitter is a fluorophore and coupling from S1 of the fluorophore to the plasmon mode is also possible. It should, however, be understood that any triplet excitons that transferred to T1 of the fluorophore via Dexter energy transfer would be unable to couple to the plasmon mode (or be allowed to radiatively decay). In some embodiments, the emitter is a thermally activated delayed fluorescence (TADF) emitter that is able to harness any triplets Dexter transferred to T1 through reverse intersystem crossing to S 1. However, only S1, and not T1, can couple to the plasmon mode for a TADF emitter because T1 does not have an appreciable dipole moment.

Without being bound by any theory, it's believed that the excited state lifetime, τ, consists of the radiative (*k_{R}*), non-radiative (*k_{NR}*), and plasmon (*k_{P}*) decay rates in the following relationship: $τ = \frac{1}{{k}_{e , R}} + \frac{1}{{k}_{e , NR}} + \frac{1}{{k}_{e , P}} + \frac{1}{{k}_{s , R}} + \frac{1}{{k}_{s , NR}} + \frac{1}{{k}_{s , P}}$ wherein the emitter is designated as subscript "e" and sensitizer as subscript "s".

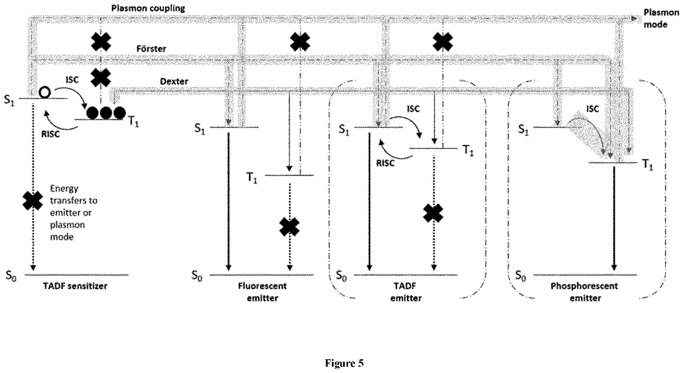

In some embodiments, a TADF-sensitized plasmonic OLED is disclosed such as shown in FIG. 5. FIG. 5 illustrates an energy level diagram showing the various pathways of excited state energy transfer in a TADF-sensitized plasmonic OLED. The figure includes energy levels for either a fluorescent, TADF, or phosphorescent emitter. In these embodiments, the energy transfer pathways result in plasmon mode.

In some embodiments, the plasmonic OLED is sensitized by a TADF-sensitizer (Figure 5). If the emitter is a phosphor, triplets on the sensitizer may Dexter transfer to the triplet state of the phosphor emitter where they may couple into the plasmon mode (or, less preferably, emit to the ground state). Singlets on the sensitizer may couple directly to the plasmon mode, or may transfer via FRET to the singlet excited state of the emitter, be it either a fluorophore, phosphor, or TADF emitter. In the case of the fluorophore or TADF emitter, direct coupling to the plasmon mode may occur. In the case of the phosphor, the singlets will almost certainly first undergo intersystem crossing to the triplet state before plasmon coupling occurs due to the femtosecond rate of intersystem crossing in a phosphor outcompeting the rate of plasmon coupling.

In some embodiments, the excitons transfer off the TADF sensitizer occurs before direct coupling to the plasmon. This is because the longest-lived excited state in a TADF molecule, i.e., the triplet state, has no appreciable dipole moment and therefore cannot couple directly to the plasmon mode. This means that plasmon coupling will likely not realize any increase in device stability in devices with direct coupling of the TADF sensitizer to the plasmon mode. However, such devices may still realize the efficiency gains of plasmonic OLEDs over conventional OLEDs. In some embodiments, the pathway is to transfer the excitons off the TADF sensitizer to the emitter and subsequently couple that energy into the plasmon mode.

In some embodiments, the plasmonic OLED involves only a single sensitizer and a single emitter. In some embodiments, the plasmonic OLED incorporates multiple sensitizers and/or emitters. In some embodiments, the plasmonic OLED incorporates stacks of multiple sensitized plasmonic OLEDs, including cases wherein some components of the stack may be sensitized, and other components may not be sensitized.

In figures 4 and 5, S 1 of the emitter is usually lower than S 1 of the sensitizer, but T 1 of the sensitizer could be higher or lower energy than S 1 of the emitter. It should be noted that the relationship between the energy levels of the sensitizer and emitter should not be taken strictly relative to each other as illustrated in the figures. They are primarily for reference only. It should also be noted that coupling to the plasmon mode can be a bidirectional process, i.e., the sensitizer or emitter pumps the plasmon, and/or the plasmon pumps the sensitizer or emitter. These processes can happen simultaneously.

It is believed a sensitized plasmonic OLED can achieve several benefits. These benefits include but not limited to the following:
(1) Transfer of the triplets on the phosphor sensitizer to S 1 or T 1 of the emitter will reduce the excited state lifetime of the phosphor, and additional coupling to the plasmon mode, introduced in the above equation, will shorten it even further, likely adding more stability to the device. Plus, the coupling efficiency to the plasmon mode, and the resulting Purcell enhancement, should be unperturbed by (i.e., occur in addition to) sensitization.
(2) Plasmonic OLEDs achieve external quantum efficiencies (EQE) beyond what is possible with conventional OLED device design. While sensitized OLEDs may achieve higher EQEs than conventional OLEDs due to the horizontal emitting dipole of the fluorophore or TADF emitter, the potential of plasmonic OLEDs to achieve greater than 40% EQE, possibly greater than 60% EQE, is still higher.
(3) A fluorophore or TADF emitter typically has narrower emission (as defined by full width half max of the electroluminescent spectrum) than a phosphor. This narrow emission could be beneficial as it could be designed to better align with the resonance of the plasmon out-coupling scheme. It is believed that a narrow emitter emitting at the peak of the plasmon out-coupling resonance should outperform a broad emitter emitting at the same peak wavelength.
(4) If the transition dipole moment of the emitter is oriented to be preferentially more vertically aligned than an isotropic emitter, the coupling efficiency to the plasmon mode will be enhanced. Thus, emitters designed to have more vertically-oriented transition dipole moments will have added stability and efficiency benefits in sensitized plasmonic OLEDs.

In some of the above embodiments, when both the sensitizer and the emitter are aligned with vertical transition dipole moments, dipole-dipole energy transfer is optimized. This is particularly advantageous for sensitized plasmonic PHOLEDs since vertically-aligned dipoles couple more efficiently to the plasmon mode than horizontally-aligned dipoles. Moreover, in conventional OLED design, vertically-aligned dipoles are undesirable due to low photon extraction efficiency.

In some of the above embodiments, even if one of either the sensitizer or the emitter has a transition dipole that is more vertically aligned that energy transfer is enhanced. It's believed to be the case unless the transition dipole of the other species is more horizontally aligned than an isotropic dipole. Even if the emitter is horizontally aligned, plasmonic devices may be designed to incorporate elements to improve coupling to the plasmon mode, such as surface roughness of the enhancement layer. In another embodiment, plasmonic devices may be designed to directly couple energy from the emitter to the out-coupling structure, which may consist of nanoparticles that are either metallic or dielectric (or combinations of both). In these structures, a more horizontally-aligned transition dipole may be preferred to enhance energy transfer to the out-coupling structure.

In some of the above embodiments, If the emitter forms an exciplex with another material, which may be the host or another component of the emissive layer but could also form across a layer interface with an adjacent blocking layer or transport layer, the dipole moment of that exciplex may be designed to be more vertically oriented and thus enhance plasmon coupling efficiency.

In some embodiments, the outcoupling structure may consist of a nanoparticle layer separated from the enhancement layer by a dielectric spacer. In some embodiments, the spacer layer may not be required. In some embodiments, the nanoparticles may be metal, dielectric, or contain stacks/alloys and/or core/shell structures of either or both. In some embodiments, the OLED may include an emissive material disposed over the enhancement layer on the side opposite the electrically-pumped emissive layer of the device. In some embodiments, the emissive material is a down-conversion material possessing a small Stokes shift and narrow emission linewidth. In some such embodiments, nanoparticles may or may not be present, and the emissive material may be either directly adjacent or spaced away from the enhancement layer.

A consumer product is also disclosed that comprises any of the disclosed embodiments of an OLED. The consumer product is selected from the group consisting of a flat panel display, a computer monitor, a medical monitor, a television, a billboard, a light for interior or exterior illumination and/or signaling, a heads-up display, a fully or partially transparent display, a flexible display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video wall comprising multiple displays tiled together, a theater or stadium screen, a light therapy device, and a sign.

In some embodiments, an OLED of the present disclosure comprises an emissive region disposed between the anode and the cathode; wherein the emissive region comprises a sensitizer compound and an acceptor compound; wherein the sensitizer transfers energy to the acceptor compound that is an emitter. In some embodiments, the sensitizer compound is capable of emitting light from a triplet excited state to a ground singlet state in an OLED at room temperature. In some embodiments, the sensitizer compound is capable of functioning as a phosphorescent emitter, a TADF emitter, or a doublet emitter in an OLED at room temperature. In some embodiments, the acceptor compound is selected from the group consisting of: a delayed-fluorescent compound functioning as a TADF emitter in the OLED at room temperature, a fluorescent compound functioning as a fluorescent emitter in the OLED at room temperature. In some embodiments, the fluorescent emitter can be a singlet or doublet emitters. In some of such embodiments, the singlet emitter can also include a TADF emitter, furthermore, a multi-resonant MR-TADF emitter. Description of the delayed fluorescence as used herein can be found in U.S. application publication US20200373510A1, at paragraphs 0083-0084, the entire contents of which are incorporated herein by reference.

In some embodiments of the OLED, the sensitizer and acceptor compounds are in separate layers within the emissive region.

In some embodiments, the sensitizer and the acceptor compounds are present as a mixture in one or more layers in the emissive region. It should be understood that the mixture in a given layer can be a homogeneous mixture or the compounds in the mixture can be in graded concentrations through the thickness of the given layer. The concentration grading can be linear, non-linear, sinusoidal, etc. When there are more than one layer in the emissive region having a mixture of the sensitizer and the acceptor compounds, the type of mixture (i.e., homogeneous or graded concentration) and the concentration levels of the compounds in the mixture in each of the more than one layer can be the same or different. In addition to the sensitizer and the acceptor compounds, there can be one or more other functional compounds such as, but not limit to, hosts also mixed into the mixture.

In some embodiments, the acceptor compound can be in two or more layers with the same or different concentration. In some embodiments, when two or more layers contain the acceptor compound, the concentration of the acceptor compound in at least two of the two or more layers are different. In some embodiments, the concentration of sensitizer compound in the layer containing the sensitizer compound is in the range of 1 to 50 %, 10 to 20 %, or 12-15 % by weight. In some embodiments, the concentration of the acceptor compound in the layer containing the acceptor compound is in the range of 0. 1 to 10 %, 0.5 to 5 %, or 1 to 3 % by weight.

In some embodiments, the emissive region contains *N* layers where *N* > 2. In some embodiments, the sensitizer compound is present in each of the *N* layers, and the acceptor compound is contained in fewer than or equal to *N*-1 layers. In some embodiments, the sensitizer compound is present in each of the *N* layers, and the acceptor compound is contained in fewer than or equal to *N*/2 layers. In some embodiments, the acceptor compound is present in each of the *N* layers, and the sensitizer compound is contained in fewer than or equal to *N*-1 layers. In some embodiments, the acceptor compound is present in each of the *N* layers, and the sensitizer compound is contained in fewer than or equal to *N*/2 layers.

In some embodiments, the OLED emits a luminescent emission comprising an emission component from the S₁ energy (the first singlet energy) of the acceptor compound when a voltage is applied across the OLED. In some embodiments, at least 65%, 75%, 85%, or 95% of the emission from the OLED is produced from the acceptor compound with a luminance of at least 10 cd/m². In some embodiments, S₁ energy of the acceptor compound is lower than that of the sensitizer compound.

In some embodiments, a T₁ energy (the first triplet energy) of the host compound is higher than the T₁ energies of the sensitizer compound and the acceptor compound. In some embodiments, S₁-T₁ energy gap of the sensitizer compound and/or acceptor compound is less than 400, 300, 250, 200, 150, 100, or 50 meV.

In some embodiments where the sensitizer compound provides unicolored sensitization (i.e., minimal loss in energy upon energy transfer to the acceptor compound), the acceptor compound has a Stokes shift of 30, 25, 20, 15, or 10 nm or less. An example would be a broad blue phosphor sensitizing a narrow blue emitting acceptor

In some embodiments where the sensitizer compound provides a down conversion process (e.g., a blue emitter being used to sensitize a green emitter, or a green emitter being used to sensitize a red emitter), the acceptor compound has a Stokes shift of 30, 40, 60, 80, or 100 nm or more.

One way to quantify the qualitative relationship between a sensitizer compound (a compound to be used as the sensitizer in the emissive region of the OLED of the present disclosure) and an acceptor compound (a compound to be used as the acceptor in the emissive region of the OLED of the present disclosure) is by determining a value Δλ = λₘₐₓ₁ - λₘₐₓ₂, where λₘₐₓ₁ and λₘₐₓ₂ are defined as follows. λₘₐₓ₁ is the emission maximum of the sensitizer compound at room temperature when the sensitizer compound is used as the sole emitter in a first monochromic OLED (an OLED that emits only one color) that has a first host. λₘₐₓ₂ is the emission maximum of the acceptor compound at room temperature when the acceptor compound is used as the sole emitter in a second monochromic OLED that has the same first host.

In some embodiments of the OLED of the present disclosure where the sensitizer compound provides unicolored sensitization (i.e., minimal loss in energy upon energy transfer to the acceptor compound), Δλ (determined as described above) is equal to or less than the number selected from the group consisting of 15, 12, 10, 8, 6, 4, 2, 0, -2, -4, -6, -8, and -10 nm.

In some embodiments where the emission of the acceptor is redshifted by the sensitization, Δλ is equal to or greater than the number selected from the group consisting of 20, 30, 40, 60, 80, 100 nm.

In the embodiments, the sensitizer compound is capable of functioning as a phosphorescent emitter in an OLED at room temperature, and the sensitizer compound can be a metal coordination complex having a metal-carbon bond, a metal-nitrogen bond, or a metal-oxygen bond. In some embodiments, the metal is selected from the group consisting of Ir, Rh, Re, Ru, Os, Pt, Pd, Zn, Au, Ag, and Cu. In some embodiments, the metal is Ir. In some embodiments, the metal is Pt. In some embodiments, the sensitizer compound has the formula of M(L¹)ₓ(L²)_{y}(L³)_{z};
wherein L¹, L², and L³ can be the same or different;
wherein x is 1, 2, or 3;
wherein y is 0, 1, or 2;
wherein z is 0, 1, or 2;
wherein x+y+z is the oxidation state of the metal M;
wherein L¹ is selected from the group consisting of the structures of LIGAND LIST:

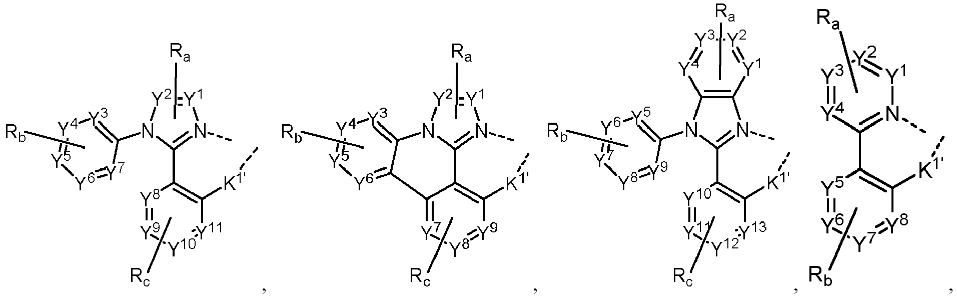

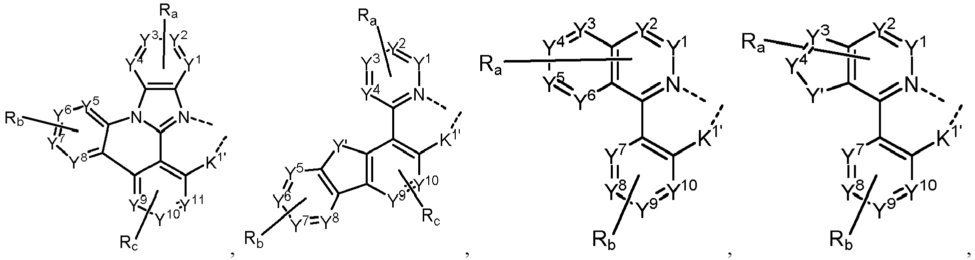

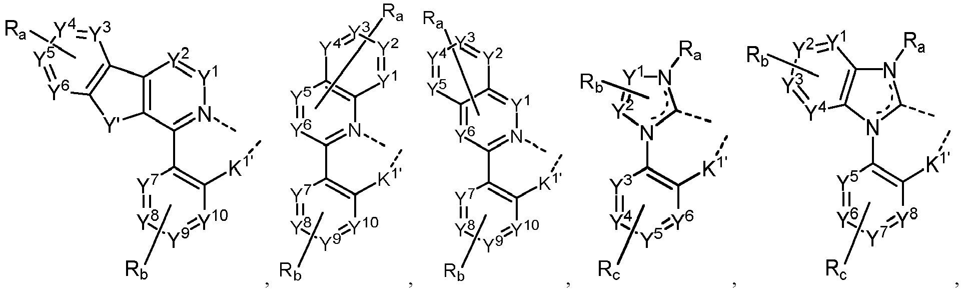

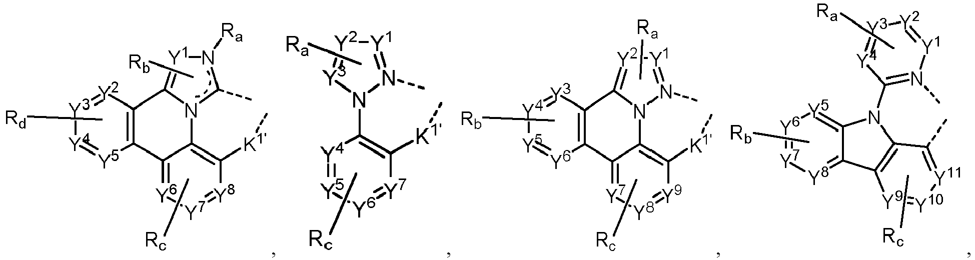

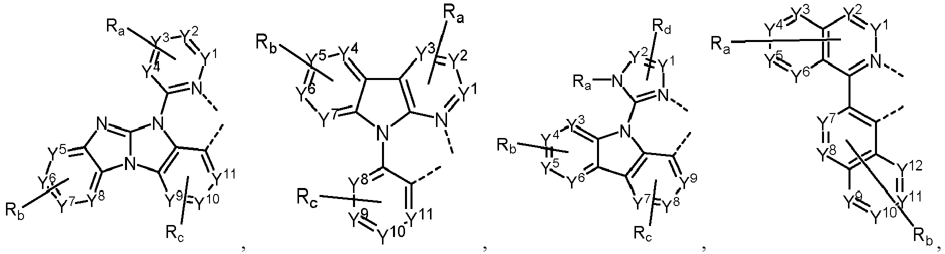

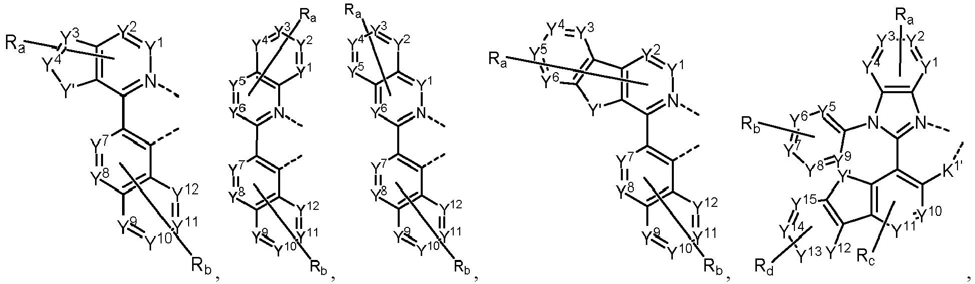

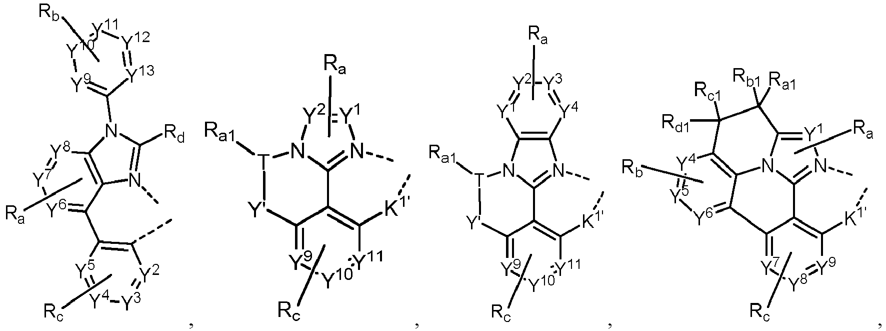

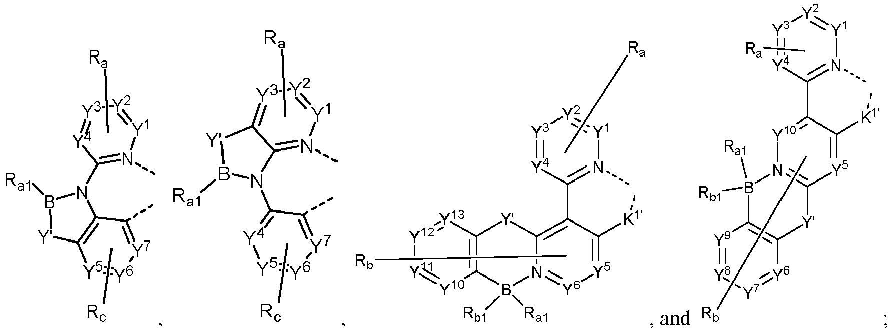

wherein L² and L³ are independently selected from the group consisting of 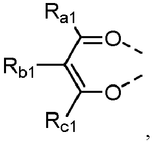 and the structures of LIGAND LIST; wherein:
   T is selected from the group consisting of B, Al, Ga, and In;
   K^{1'} is a direct bond or is selected from the group consisting of NRₑ, PRₑ, O, S, and Se;
   each Y¹ to Y¹³ are independently selected from the group consisting of carbon and nitrogen;
   Y' is selected from the group consisting of BRₑ, NRₑ, PRₑ, O, S, Se, C=O, S=O, SO₂, CRₑR_{f}, SiRₑR_{f}, and GeRₑR_{f};
   Rₑ and R_{f} can be fused or joined to form a ring;
   each Rₐ, R_{b}, R_{c}, and R_{d} can independently represent from mono to the maximum possible number of substitutions, or no substitution;
   each Rₐ₁, R_{b1}, R_{c1}, R_{d1}, Rₐ, R_{b}, R_{c}, R_{d}, Rₑ, and R_{f} is independently a hydrogen or a substituent selected from the group consisting of the General Substituents as defined herein; and
wherein any two of Rₐ₁, R_{b1}, R_{c1}, R_{d1}, Rₐ, R_{b}, R_{c}, and R_{d} can be fused or joined to form a ring or form a multidentate ligand.

In some embodiments, the metal in formula M(L¹)ₓ(L²)_{y}(L³)_{z} is selected from the group consisting of Cu, Ag, or Au.

In some embodiments of the OLED, the sensitizer compound has a formula selected from the group consisting of Ir(L_{A})₃, Ir(L_{A})(L_{B})₂, Ir(L_{A})₂(L_{B}), Ir(L_{A})₂(L_{C}), Ir(L_{A})(L_{B})(L_{C}), and Pt(L_{A})(L_{B});
wherein L_{A}, L_{B}, and L_{C} are different from each other in the Ir compounds;
wherein L_{A} and L_{B} can be the same or different in the Pt compounds; and
wherein L_{A} and L_{B} can be connected to form a tetradentate ligand in the Pt compounds.

In some embodiments of the OLED, the sensitizer compound is selected from the group consisting of the compounds in the following SENSITIZER LIST: 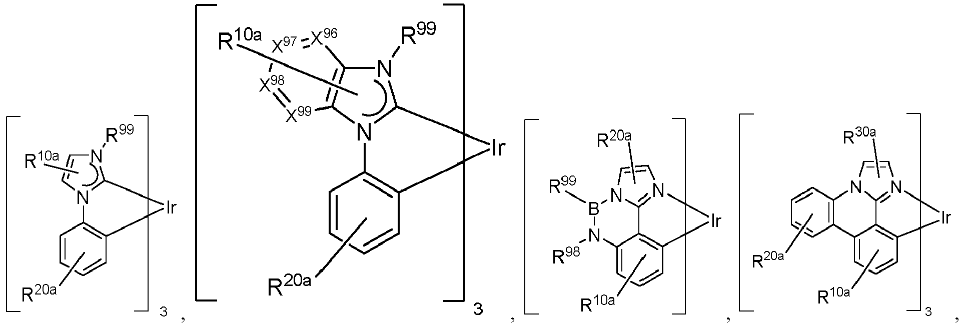 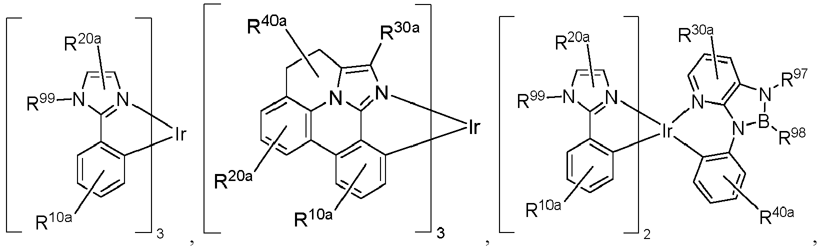 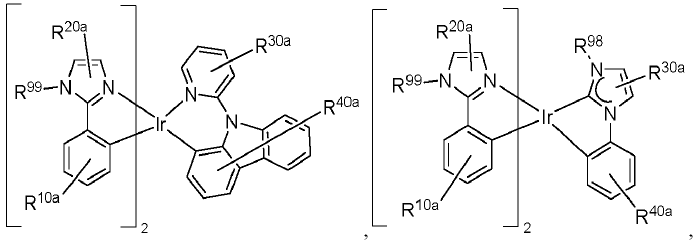 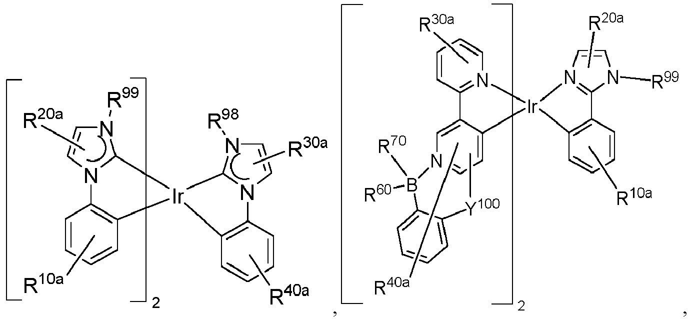 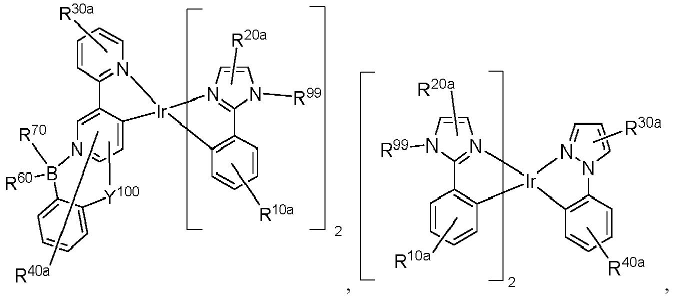 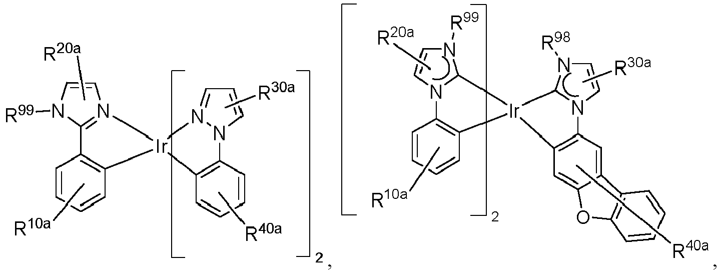 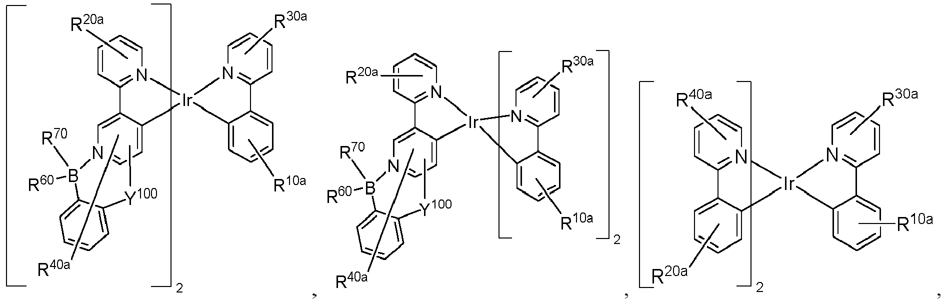 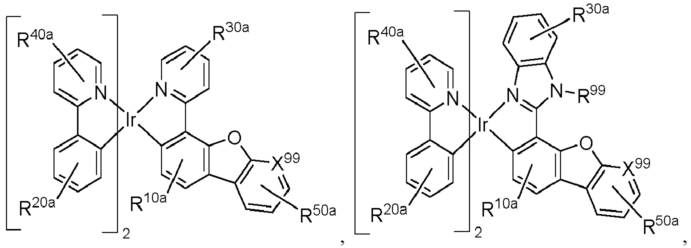 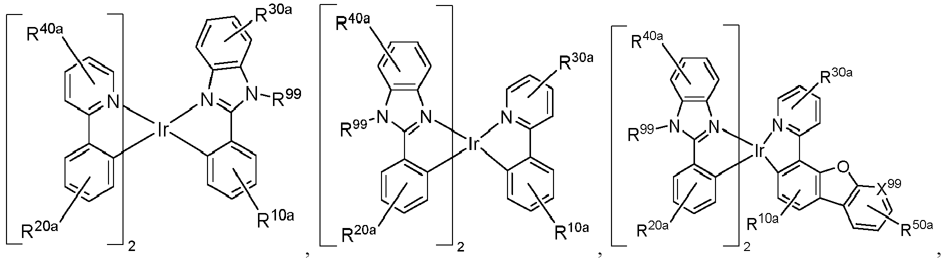 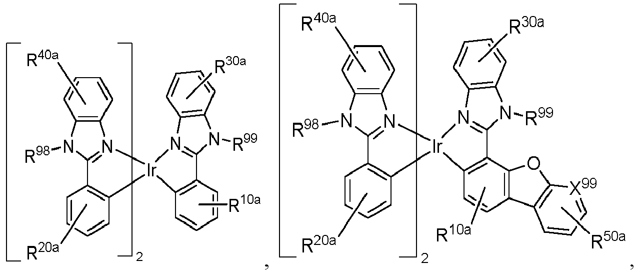 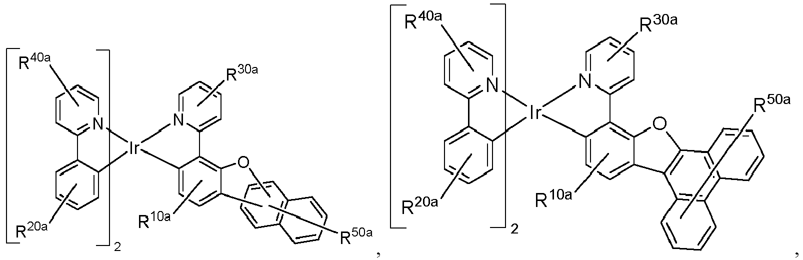 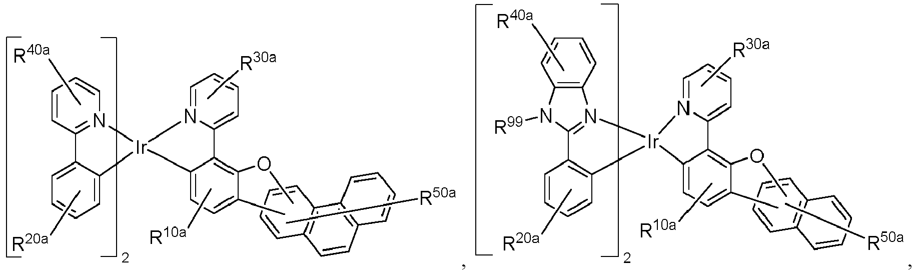 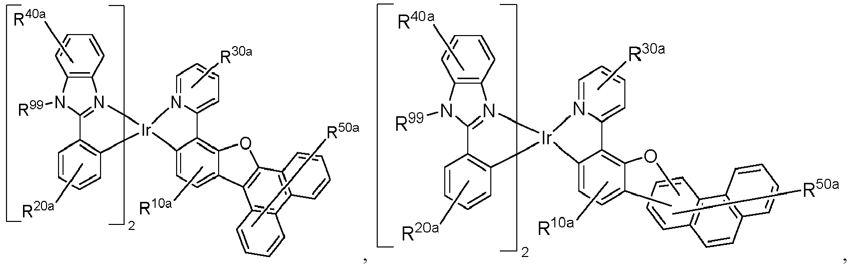 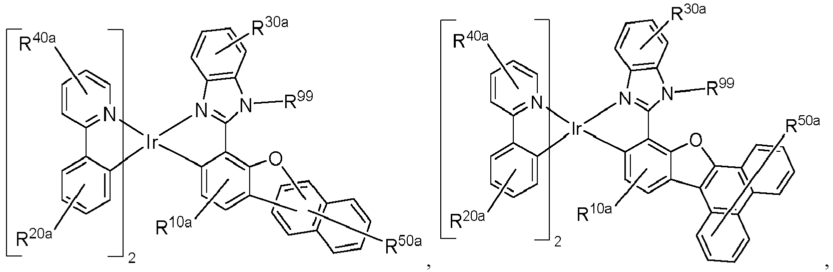 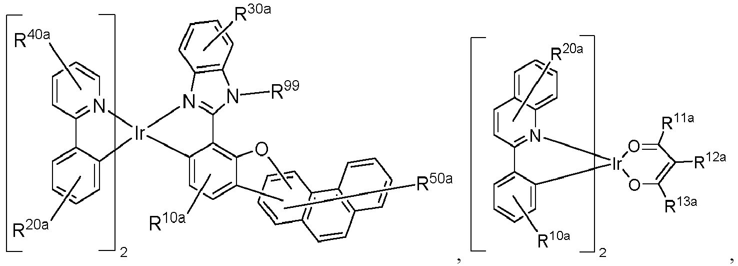 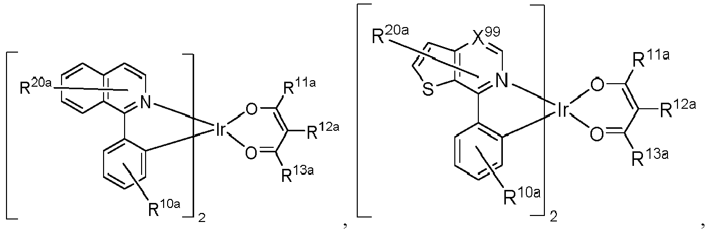 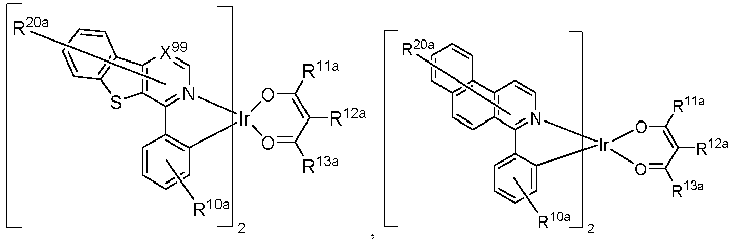 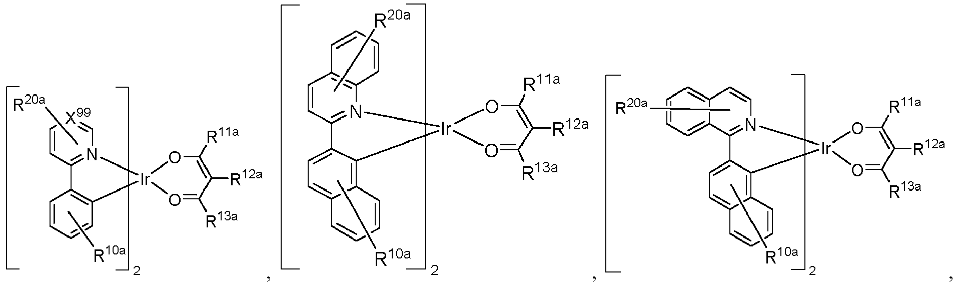 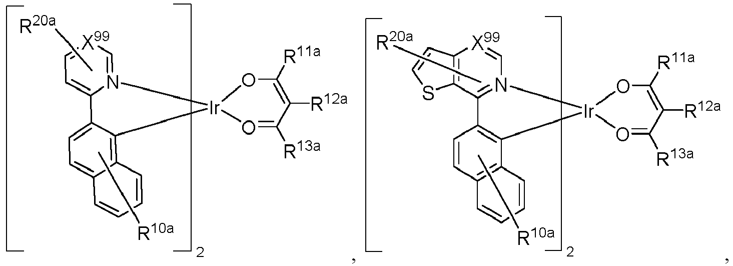 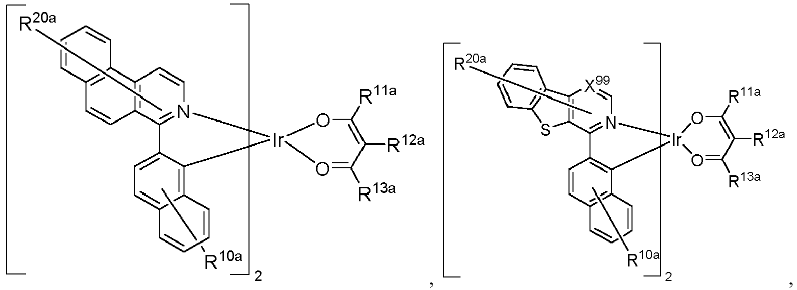 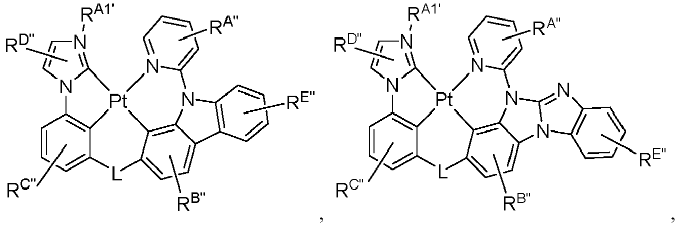 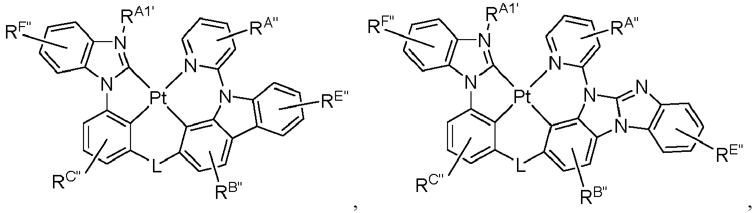 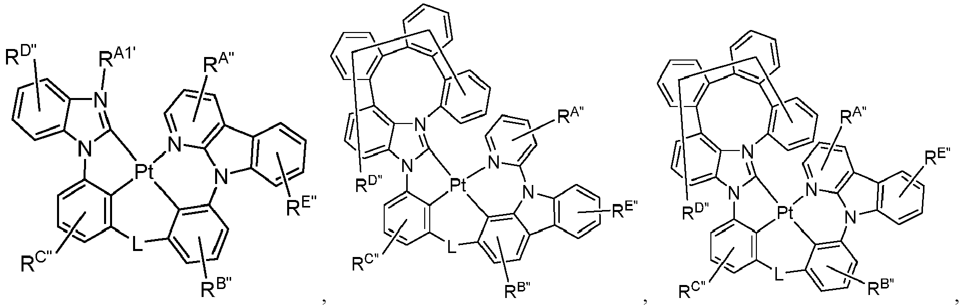 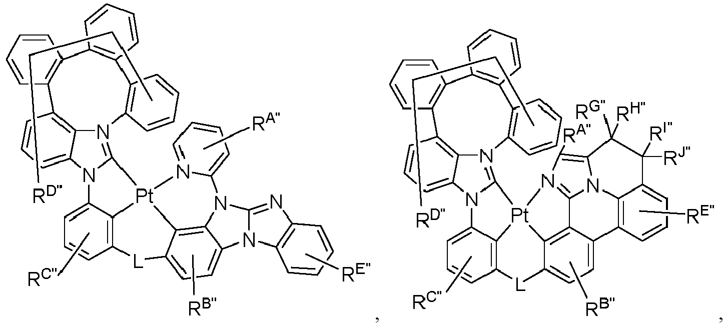 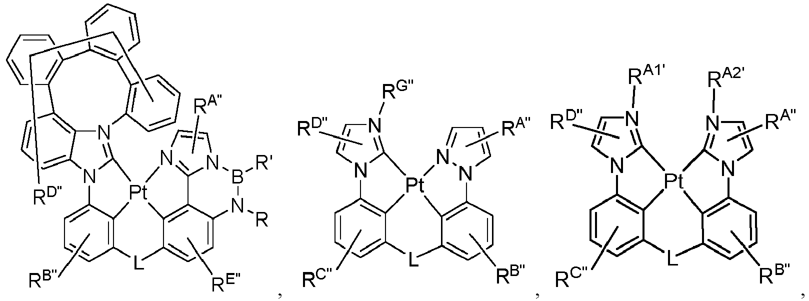 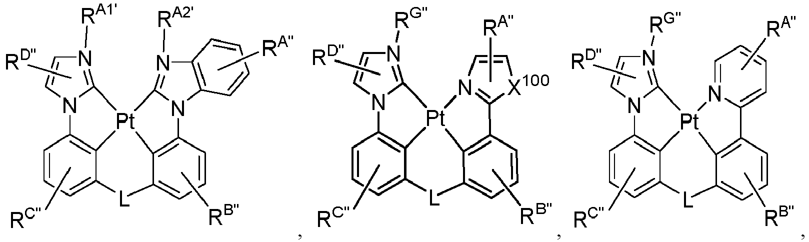 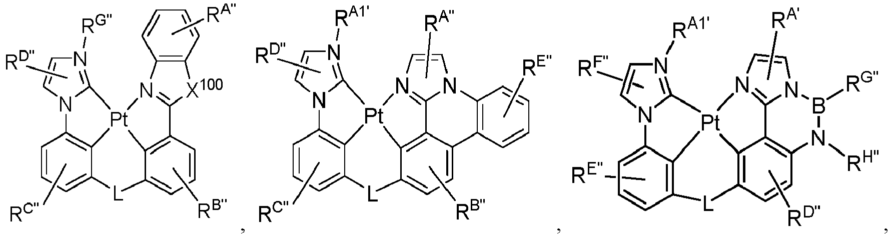 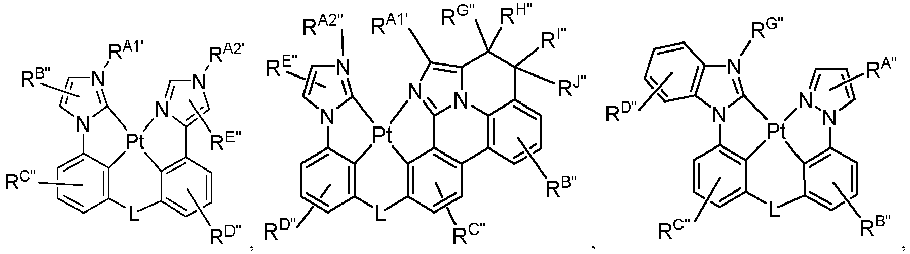 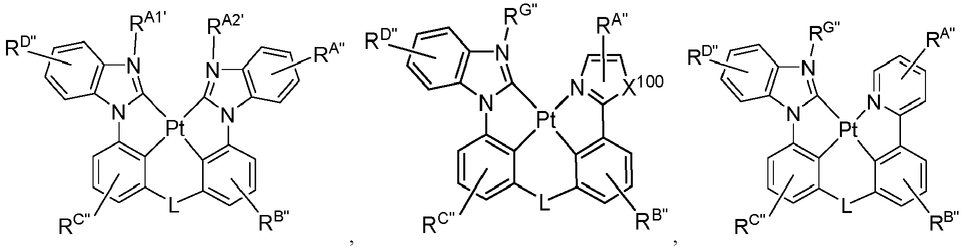 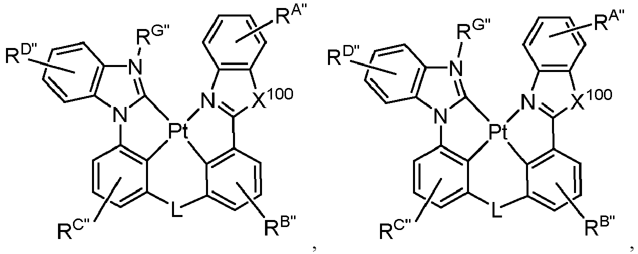 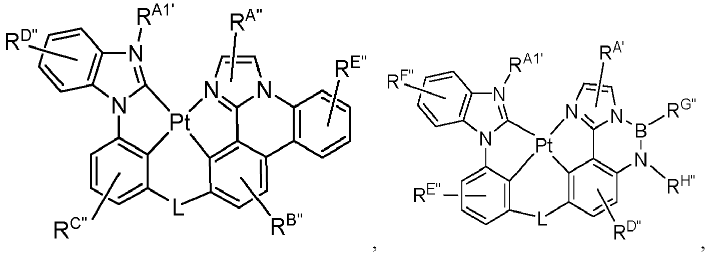 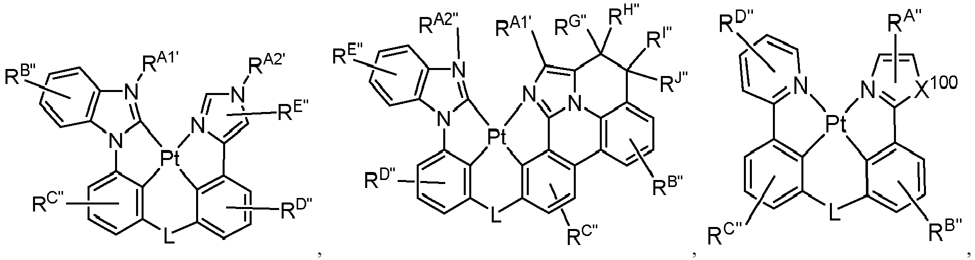 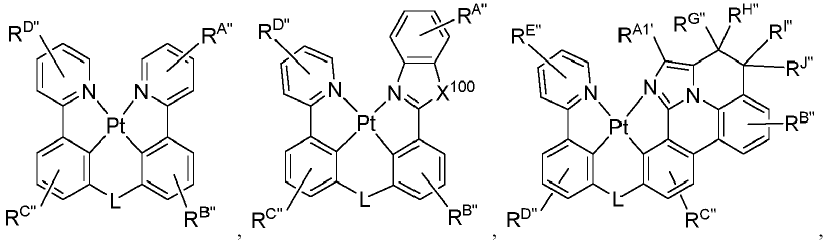 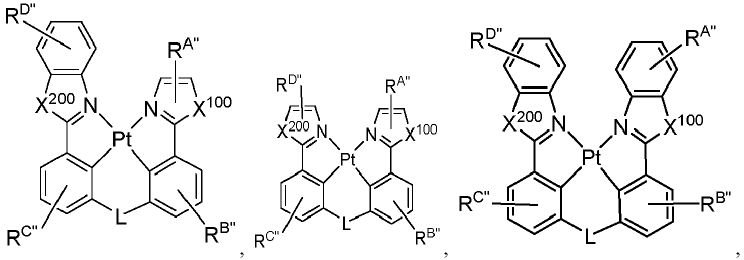 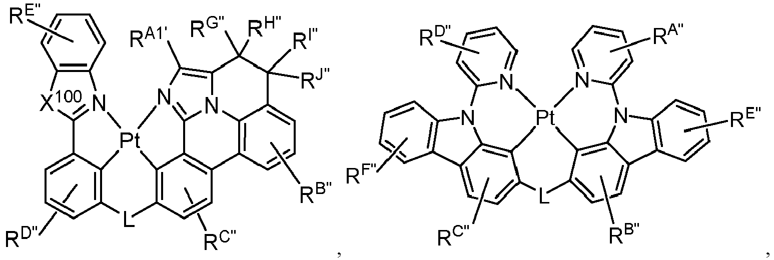 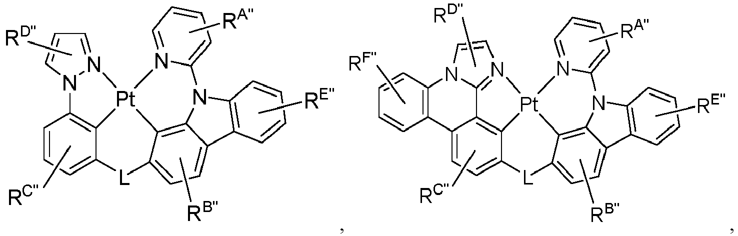 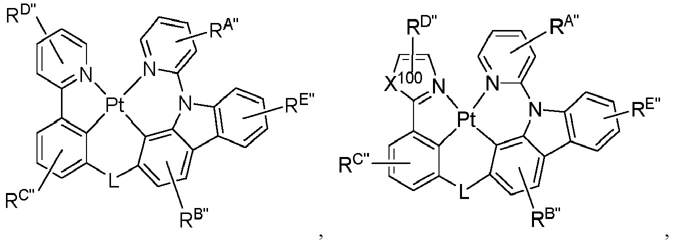 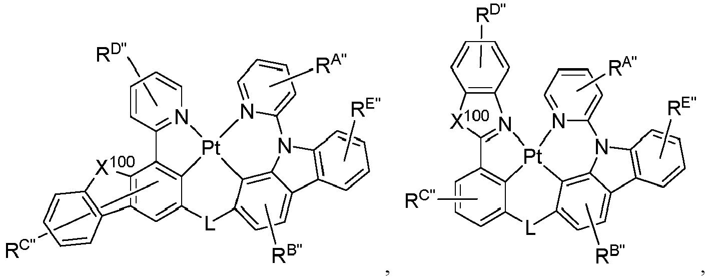 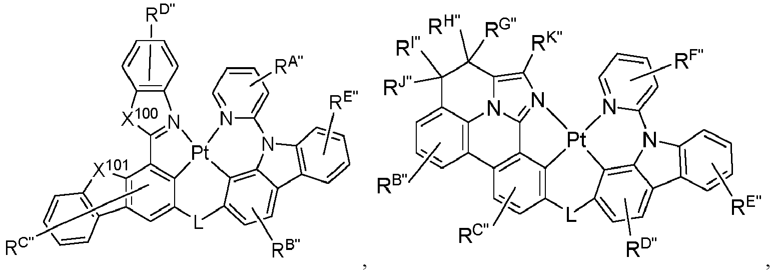 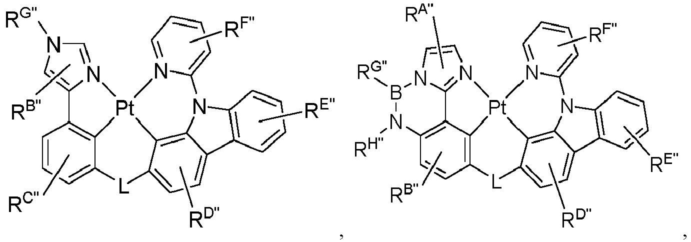 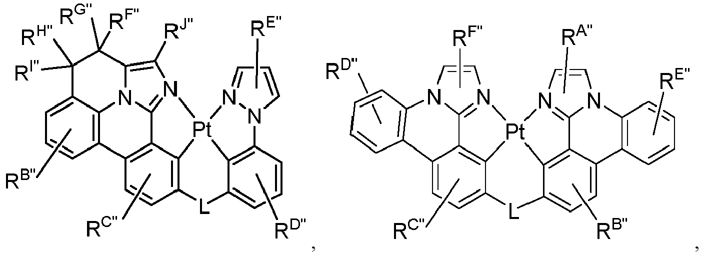 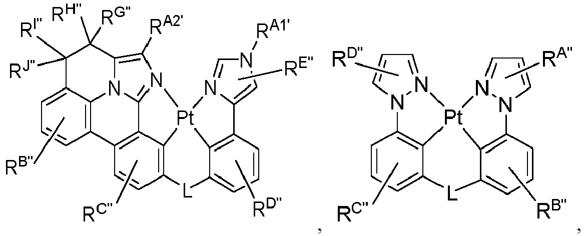 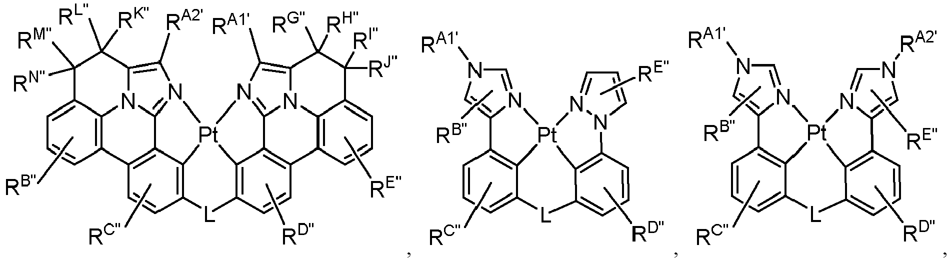 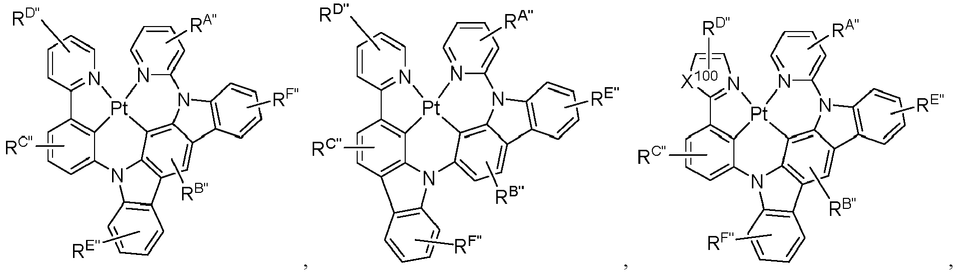 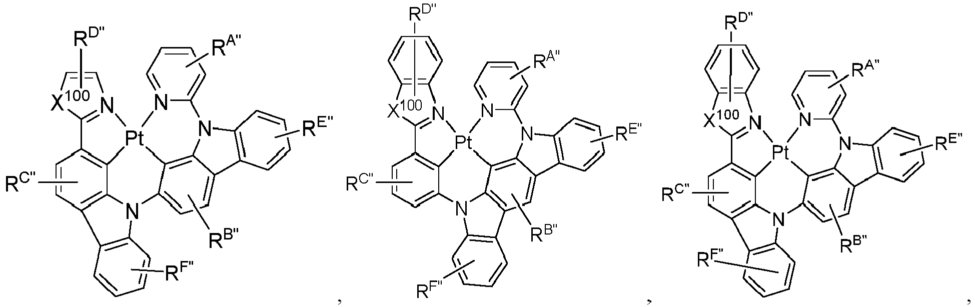 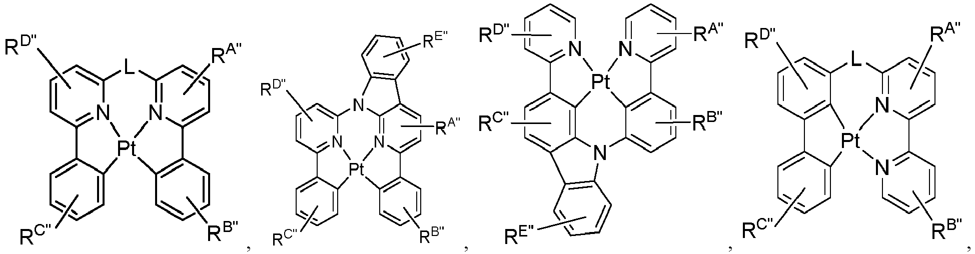 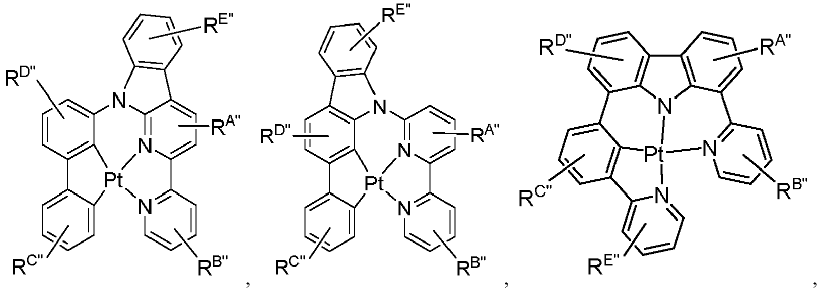 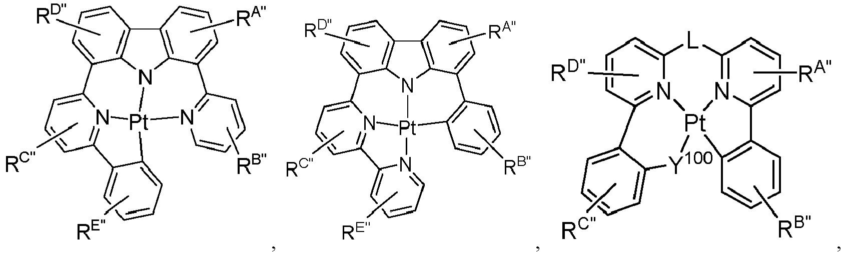 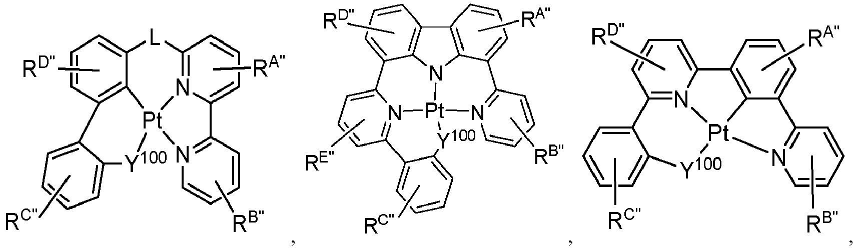 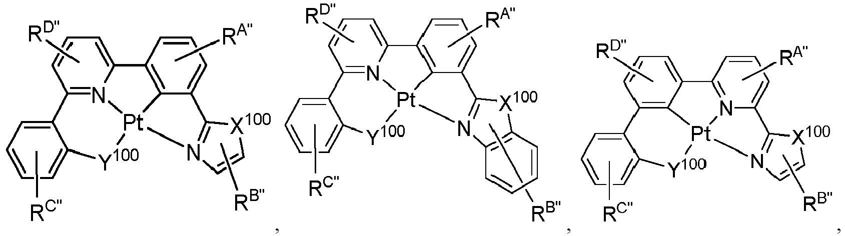 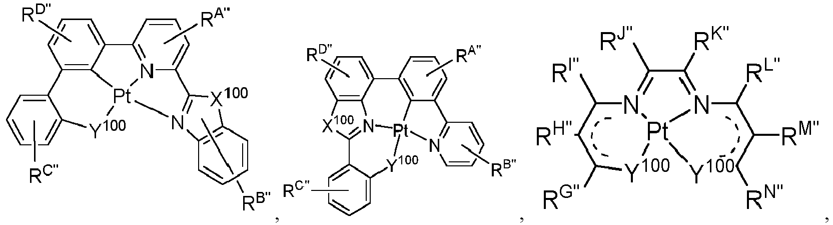 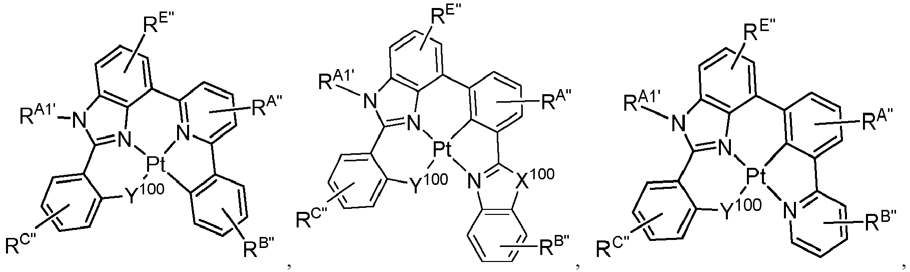 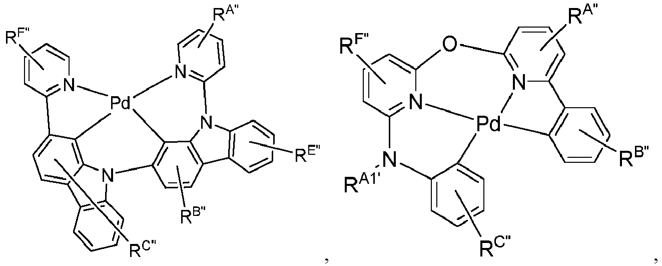 and 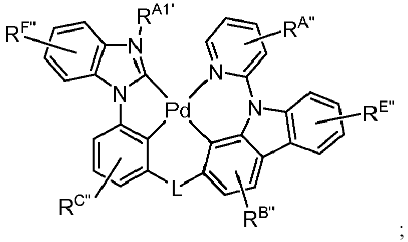 wherein:
each of X⁹⁶ to X⁹⁹ is independently C or N;
each Y¹⁰⁰ is independently selected from the group consisting of a NR", O, S, and Se;
L is independently selected from the group consisting of a direct bond, BR", BR"R‴, NR", PR", O, S, Se, C=O, C=S, C=Se, C=NR", C=CR"R‴, S=O, SO₂, CR", CR"R‴, SiR"R‴, GeR"R‴, alkyl, cycloalkyl, aryl, heteroaryl, and combinations thereof;
X¹⁰⁰ for each occurrence is selected from the group consisting of O, S, Se, NR", and CR"R‴;
each R^{10a}, R^{20a}, R^{30a}, R^{40a}, and R^{50a}, R^{A"}, R^{B"}, R^{C"}, R^{D"}, R^{E"}, and R^{F"} independently represents mono-, up to the maximum substitutions, or no substitutions;
each of R, R', R", R‴, R^{10a}, R^{11a}, R^{12a}, R^{13a}, R^{20a}, R^{30a}, R^{40a}, R^{50a}, R⁶⁰, R⁷⁰, R⁹⁷, R⁹⁸, R⁹⁹, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of the general substituents as defined herein; wherein any two substituents can be fused or joined to form into a ring.

In some embodiments of the OLED where the sensitizer is selected from the group consisting of the structures in the SENSITIZER LIST, one or more of R, R', R", R‴, R^{10a}, R^{11a}, R^{12a}, R^{13a}, R^{20a}, R^{30a}, R^{40a}, R^{50a}, R⁶⁰, R⁷⁰, R⁹⁷, R⁹⁸, R⁹⁹, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} comprises a moiety selected from the group consisting of fully or partially deuterated aryl, fully or partially deuterated alkyl, boryl, silyl, germyl, 2,6-terphenyl, 2-biphenyl, 2-(tert-butyl)phenyl, tetraphenylene, tetrahydronaphthalene, and combinations thereof.

It should be understood that the metal Pt of each of those compounds in the SENSITIZER LIST can be replaced by Pd, and those derived Pd compounds are also intended to be specifically covered.

In some embodiments, the sensitizer is capable of functioning as a phosphorescent emitter, a TADF emitter, or a doublet emitter in an OLED at room temperature. In some embodiments, the acceptor is selected from the group consisting of a delayed-fluorescent compound functioning as a TADF emitter in the OLED at room temperature, a fluorescent compound functioning as a fluorescent emitter in the OLED at room temperature. In some embodiments, the fluorescent emitter can be a singlet or doublet emitters. In some of such embodiments, the singlet emitter can also include a TADF emitter, furthermore, a multi-resonant MR-TADF emitter. Description of the delayed fluorescence as used herein can be found in U.S. application publication US20200373510A1, at paragraphs 0083-0084, the entire contents of which are incorporated herein by reference.

In some embodiments of the OLED, the sensitizer and the acceptor are in separate layers within the emissive region.

In some embodiments, the sensitizer and the acceptor are present as a mixture in one or more layers in the emissive region. It should be understood that the mixture in a given layer can be a homogeneous mixture or the compounds in the mixture can be in graded concentrations through the thickness of the given layer. The concentration grading can be linear, non-linear, sinusoidal, etc. When there are more than one layer in the emissive region having a mixture of the sensitizer and the acceptor compounds, the type of mixture (i.e., homogeneous or graded concentration) and the concentration levels of the compounds in the mixture in each of the more than one layer can be the same or different. In addition to the sensitizer and the acceptor compounds, there can be one or more other functional compounds such as, but not limit to, hosts also mixed into the mixture.

In some embodiments, the acceptor can be in two or more layers with the same or different concentration. In some embodiments, when two or more layers contain the acceptor, the concentration of the acceptor in at least two of the two or more layers are different. In some embodiments, the concentration of the sensitizer in the layer containing the sensitizer is in the range of 1 to 50 %, 10 to 20 %, or 12-15 % by weight. In some embodiments, the concentration of the acceptor in the layer containing the acceptor is in the range of 0.1 to 10 %, 0.5 to 5 %, or 1 to 3 % by weight.

In some embodiments, the emissive region contains *N* layers where *N* > 2. In some embodiments, the sensitizer is present in each of the *N* layers, and the acceptor is contained in fewer than or equal to *N*-1 layers. In some embodiments, the sensitizer is present in each of the N layers, and the acceptor is contained in fewer than or equal to *N*/2 layers. In some embodiments, the acceptor is present in each of the *N* layers, and the sensitizer is contained in fewer than or equal to *N*-1 layers. In some embodiments, the acceptor is present in each of the *N* layers, and the sensitizer is contained in fewer than or equal to *N*/2 layers.

In some embodiments, the OLED emits a luminescent emission comprising an emission component from the S₁ energy (the first singlet energy) of the acceptor when a voltage is applied across the OLED. In some embodiments, at least 65%, 75%, 85%, or 95% of the emission from the OLED is produced from the acceptor with a luminance of at least 10 cd/m². In some embodiments, S₁ energy of the acceptor is lower than that of the sensitizer.

In some embodiments, a T₁ energy (the first triplet energy) of the host compound is greater than or equal to the T₁ energies of the sensitizer and the acceptor, and the T₁ energy of the sensitizer is greater than or equal to the S₁ energy (the first singlet energy) of the acceptor. In some embodiments, S₁-T₁ energy gap of the sensitizer, and/or the acceptor, and/or first host compound, and/or second host compound is less than 400, 300, 250, 200, 150, 100, or 50 meV. In some embodiments, the absolute energy difference between the HOMO of the sensitizer and the HOMO of the acceptor is less than 0.6, 0.5, 0.4, 0.3, or 0.2 eV. In some embodiments, the absolute energy difference between the LUMO of the sensitizer and the LUMO of the acceptor is less than 0.6, 0.5, 0.4, 0.3, or 0.2 eV.

In some embodiments where the sensitizer provides unicolored sensitization (i.e., minimal loss in energy upon energy transfer to the acceptor), the acceptor has a Stokes shift of 30, 25, 20, 15, or 10 nm or less. An example would be a broad blue phosphor sensitizing a narrow blue emitting acceptor.

In some embodiments where the sensitizer provides a down conversion process (e.g., a blue emitter being used to sensitize a green emitter, or a green emitter being used to sensitize a red emitter), the acceptor has a Stokes shift of 30, 40, 60, 80, or 100 nm or more.

In some embodiments, the difference between λmax of the emission spectrum of the sensitizer and λmax of the absorption spectrum of the acceptor is 50, 40, 30, or 20 nm or less. In some embodiments, the spectral overlap of the light absorbing area of the acceptor and the light emitting area of the sensitizer relative to the light emitting area of the sensitizer, is greater than 5%, 10%, 15%, 20%, 30%, 40%, 50%, or more.

One way to quantify the qualitative relationship between a sensitizer compound (a compound to be used as the sensitizer in the emissive region of the OLED of the present disclosure) and an acceptor compound (a compound to be used as the acceptor in the emissive region of the OLED of the present disclosure) is by determining a value Δλ = λₘₐₓ₁ - λₘₐₓ₂, where λₘₐₓ₁ and λₘₐₓ₂ are defined as follows. λₘₐₓ₁ is the emission maximum of the sensitizer compound at room temperature when the sensitizer compound is used as the sole emitter in a first monochromic OLED (an OLED that emits only one color) that has a first host. λₘₐₓ₂ is the emission maximum of the acceptor compound at room temperature when the acceptor compound is used as the sole emitter in a second monochromic OLED that has the same first host.

In some embodiments of the OLED of the present disclosure where the sensitizer provides unicolored sensitization (i.e., minimal loss in energy upon energy transfer to the acceptor), Δλ (determined as described above) is equal to or less than the number selected from the group consisting of 15, 12, 10, 8, 6, 4, 2, 0, -2, -4, -6, -8, and - 10 nm.

In some embodiments, a spectral overlap integral of the sensitizer and the acceptor is at least 10¹⁴ nm⁴*L/cm*mol. In some embodiments, a spectral overlap integral of the sensitizer and the acceptor is at least 5 x 10¹⁴ nm⁴*L/cm*mol. In some embodiments, a spectral overlap integral of the sensitizer and the acceptor is at least 10¹⁵ nm⁴*L/cm*mol.

As used herein, "spectral overlap integral" is determined by multiplying the acceptor extinction spectrum by the sensitizer emission spectrum normalized with respect to the area under the curve. The higher the spectral overlap, the better the Förster Resonance Energy Transfer (FRET) efficiency. The rate of FRET is proportional to the spectral overlap integral. Therefore, a high spectral overlap can help improve the FRET efficiency and reduce the exciton lifetime in an OLED.

In some embodiments, the acceptor and the sensitizer are selected in order to increase the spectral overlap. Increasing the spectral overlap can be achieved in several ways, for example, increasing the oscillator strength of the acceptor, minimizing the distance between the sensitizer peak emission intensity and the acceptor absorption peak, and narrowing the line shape of the sensitizer emission or the acceptor absorption. In some embodiments, the oscillator strength of the acceptor is greater than or equal to 0.1.

In some embodiments where the emission of the acceptor is redshifted by the sensitization, the absolute value of Δλ is equal to or greater than the number selected from the group consisting of 20, 30, 40, 60, 80, 100 nm.

In some embodiments, the sensitizer and/or the acceptor can be a phosphorescent or fluorescent emitter. Phosphorescence generally refers to emission of a photon with a change in electron spin quantum number, i.e., the initial and final states of the emission have different electron spin quantum numbers, such as from T1 to S0 state. Ir and Pt complexes currently widely used in the OLED belong to phosphorescent emitters. In some embodiments, if an exciplex formation involves a triplet emitter, such exciplex can also emit phosphorescent light. On the other hand, fluorescent emitters generally refer to emission of a photon without a change in electron spin quantum number, such as from S 1 to S0 state, or from D 1 to D0 state. Fluorescent emitters can be delayed fluorescent or nondelayed fluorescent emitters. Depending on the spin state, fluorescent emitter can be a singlet emitter or a doublet emitter, or other multiplet emitter. It is believed that the internal quantum efficiency (IQE) of fluorescent OLEDs can exceed the 25% spin statistics limit through delayed fluorescence. There are two types of delayed fluorescence, i.e., P-type and E-type delayed fluorescence. P-type delayed fluorescence is generated from triplet-triplet annihilation (TTA). On the other hand, E-type delayed fluorescence does not rely on the collision of two triplets, but rather on the thermal population between the triplet states and the singlet excited states. Thermal energy can activate the transition from the triplet state back to the singlet state. This type of delayed fluorescence is also known as thermally activated delayed fluorescence (TADF). E-type delayed fluorescence characteristics can be found in an exciplex system or in a single compound. Without being bound by theory, it is believed that TADF requires a compound or an exciplex having a small singlet-triplet energy gap (ΔE_{S-T}) less than or equal to 400, 350, 300, 250, 200, 150, 100, or 50 meV. There are two major types of TADF emitters, one is called donor-acceptor type TADF, the other one is called multiple resonance (MR) TADF. Often, donor-acceptor single compounds are constructed by connecting an electron donor moiety such as amino- or carbazole-derivatives and an electron acceptor moiety such as N-containing six-membered aromatic rings or cyano-substituted aromatic rings. Donor-acceptor exciplex can be formed between a hole transporting compound and an electron transporting compound. The examples for MR-TADF include highly conjugated fused ring systems. In some embodiments, MR-TADF materials comprising boron, carbon, and nitrogen atoms. They may comprise other atoms as well, for example oxygen. In some embodiments, the reverse intersystem crossing time from T1 to S 1 of the delayed fluorescent emission at 293K is less than or equal to 10 microseconds. In some embodiments, such time can be greater than 10 microseconds and less than 100 microseconds.

In some embodiments of the OLED, at least one of the following conditions is true:
(1) the sensitizer compound is capable of functioning as a TADF emitter in an OLED at room temperature;
(2) the acceptor compound is a delayed-fluorescent compound functioning as a TADF emitter in the OLED at room temperature.

In some embodiments of the OLED, the TADF emitter comprises at least one donor group and at least one acceptor group. In some embodiments, the TADF emitter is a metal complex. In some embodiments, the TADF emitter is a non-metal complex. In some embodiments, the TADF emitter is a boron-containing compound. In some embodiments, the TADF emitter is a Cu, Ag, or Au complex.

In some embodiments of the OLED, the TADF emitter has the formula of M(L⁵)(L⁶), wherein M is Cu, Ag, or Au, L⁵ and L⁶ are different, and L⁵ and L⁶ are independently selected from the group consisting of: 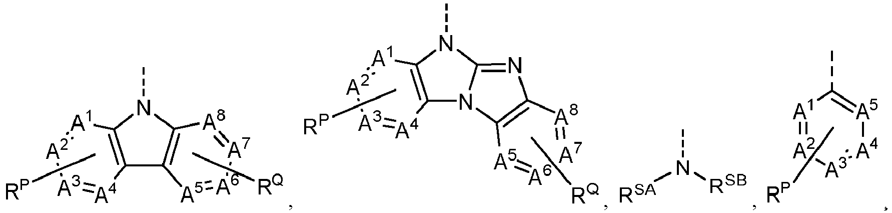 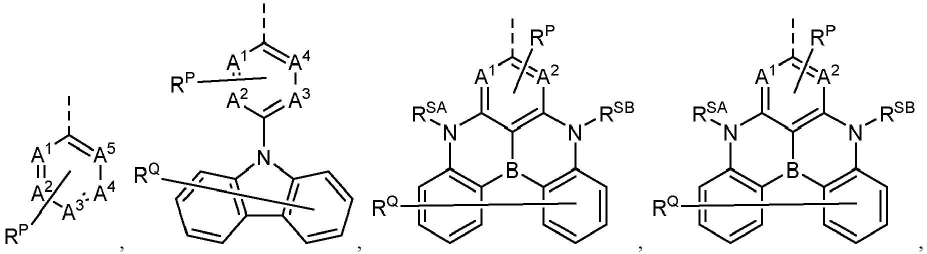 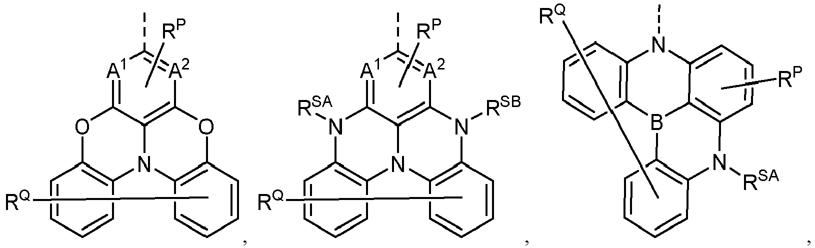 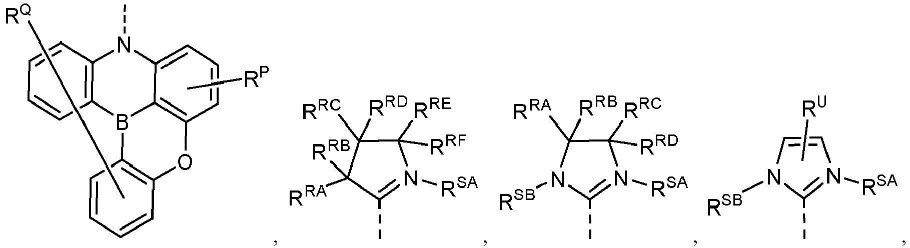 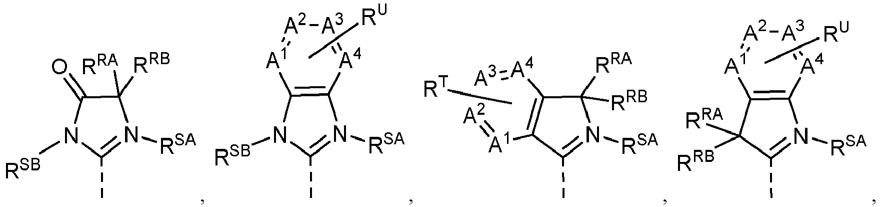 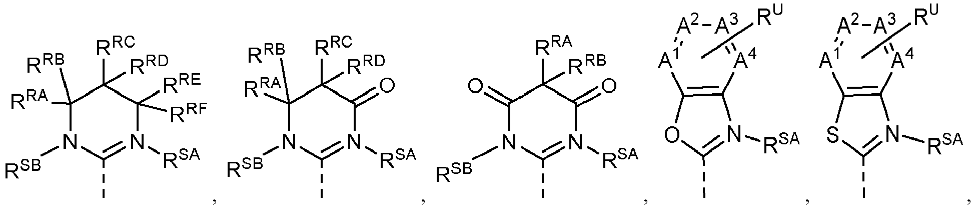 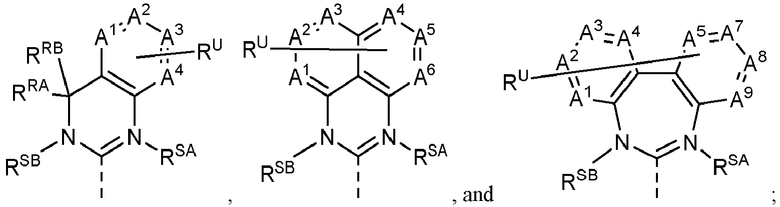
wherein A¹ - A⁹ are each independently selected from C or N;
each R^{P}, R^{Q}, and R^{U} independently represents mono-, up to the maximum substitutions, or no substitutions; wherein each R^{P}, R^{P}, R^{U}, R^{SA}, R^{SB}, R^{RA}, R^{RB}, R^{RC}, R^{RD}, R^{RE}, and R^{RF} is independently a hydrogen or a substituent selected from the group consisting of the general substituents as defined herein; any two substituents can be joined or fused to form a ring.

In some embodiments of the OLED, the TADF emitter may be one of the following: 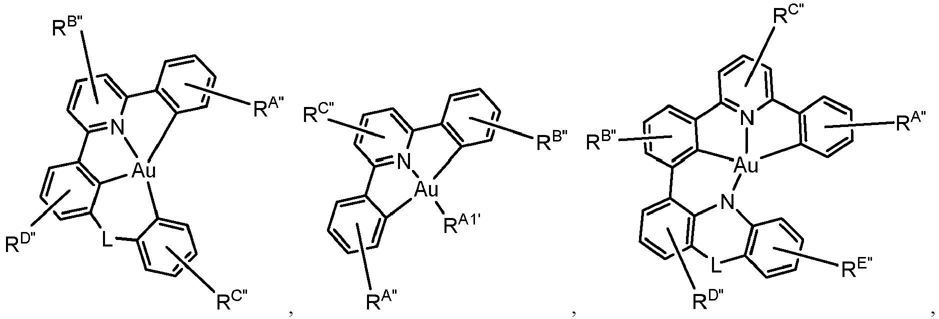 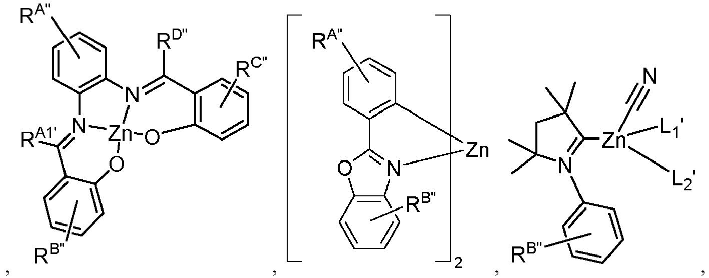 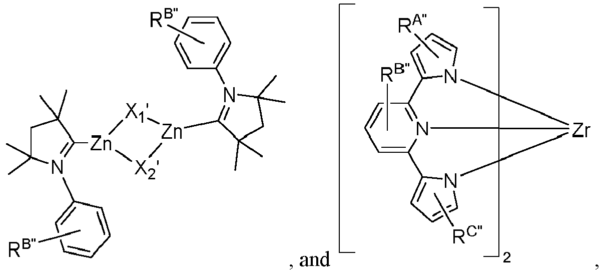
wherein each R^{A"}, R^{B"}, R^{C"}, R^{D"}, R^{E"}, and R^{F"} can independently represent from mono to the maximum possible number of substitutions, or no substitution;
each R", R‴, R^{A1}, R^{A"}, R^{B"}, R^{C"}, R^{D"}, R^{E"}, and R^{F"} is independently a hydrogen or a substituent selected from the group consisting of the general substituents as defined herein; wherein any two substituents can be fused or joined to form into a ring.
wherein L is independently selected from the group consisting of a direct bond, BR", BR"R‴, NR", PR", O, S, Se, C=O, C=S, C=Se, C=NR", C=CR"R‴, S=O, SO₂, CR", CR"R‴, SiR"R‴, GeR"R‴, alkyl, cycloalkyl, aryl, heteroaryl, and combinations thereof;
wherein each of L₁^{'} and L₂^{'} is a monodentate anionic ligand,
wherein each of X₁' and X₂' is a halide; and
wherein any two substituents can be fused or joined to form a ring.

In some embodiments of the OLED, the TADF emitter is selected from the group consisting of the structures in the following TADF LIST:

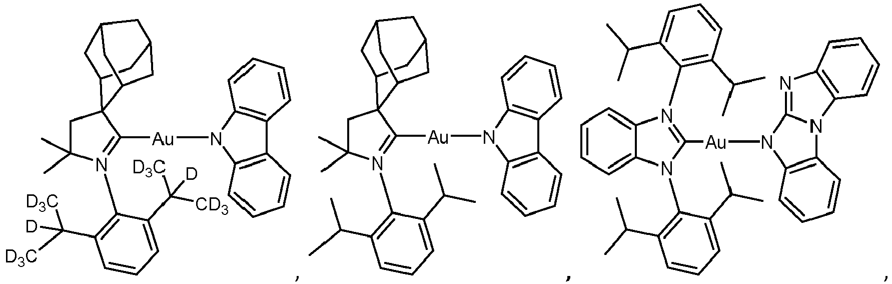

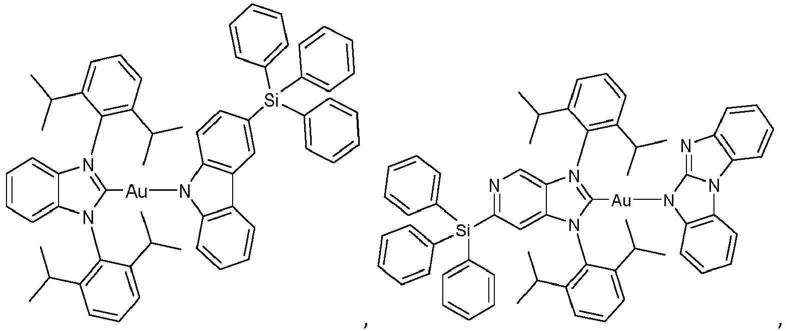

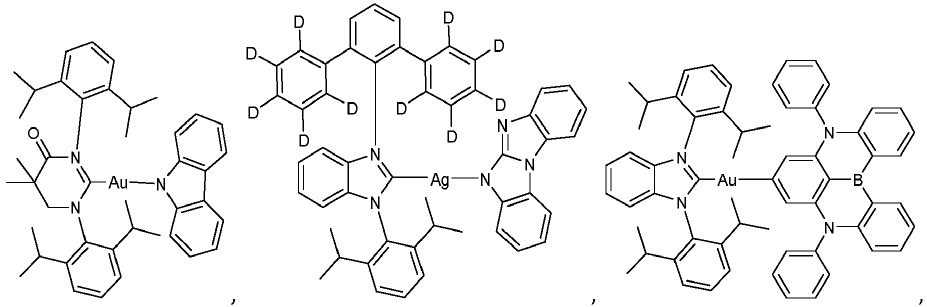

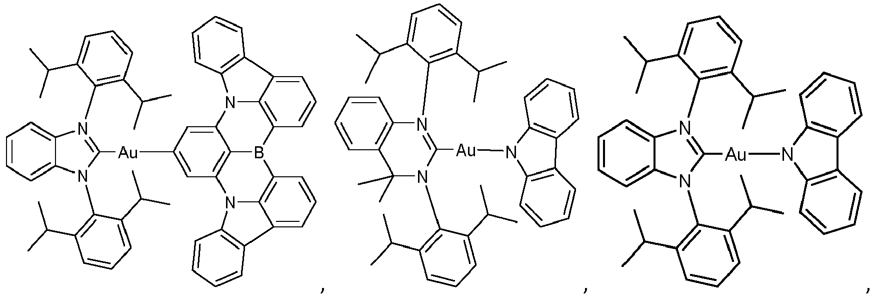

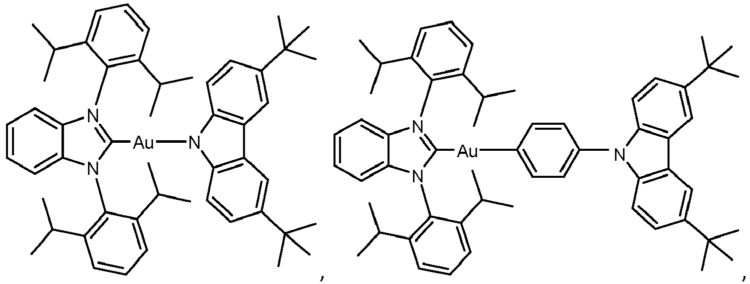

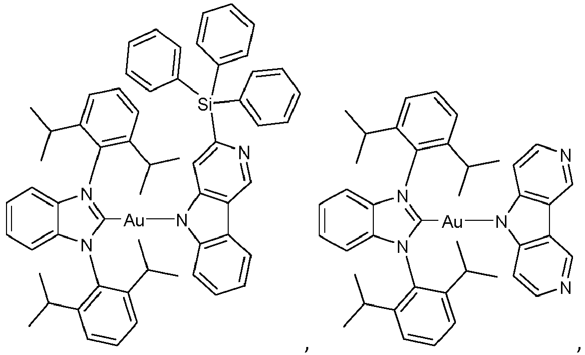

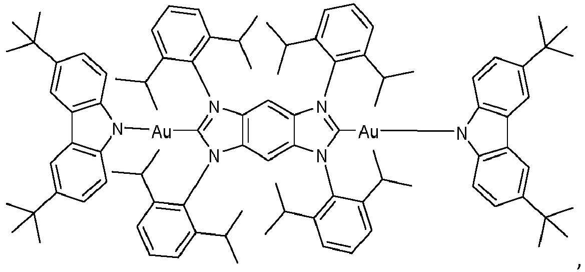

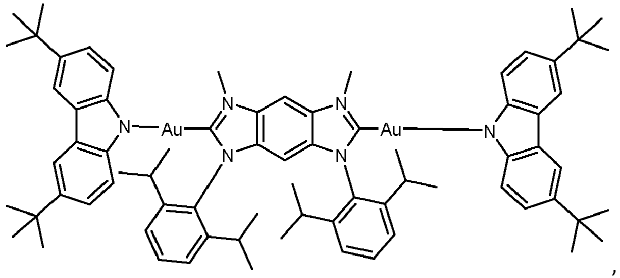

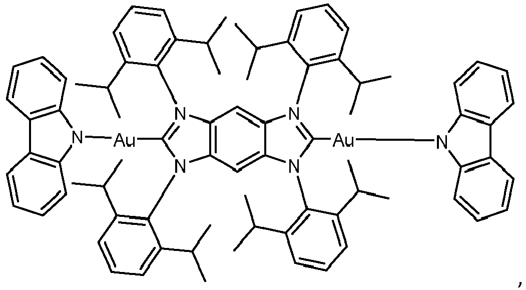

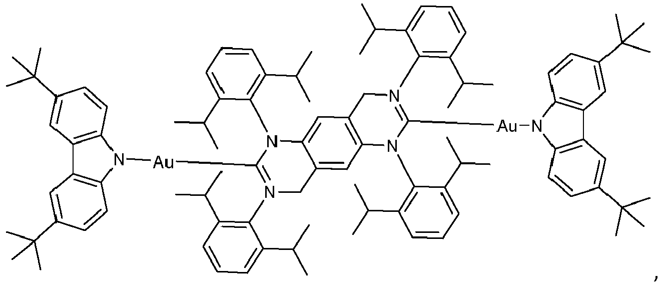

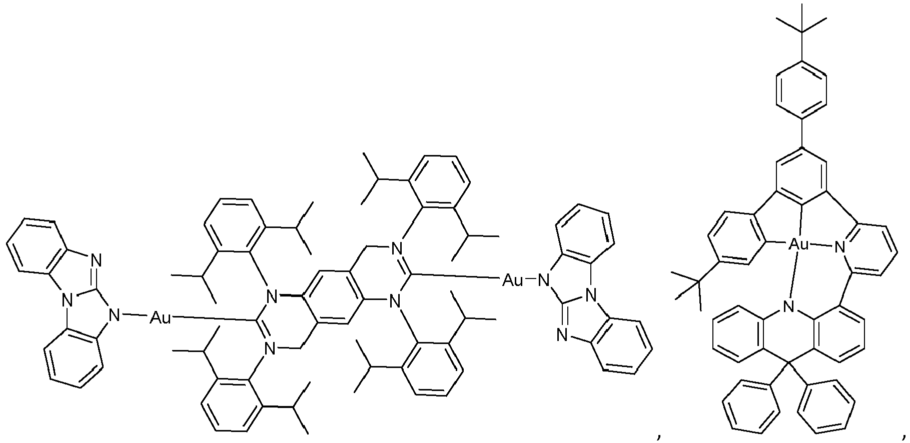

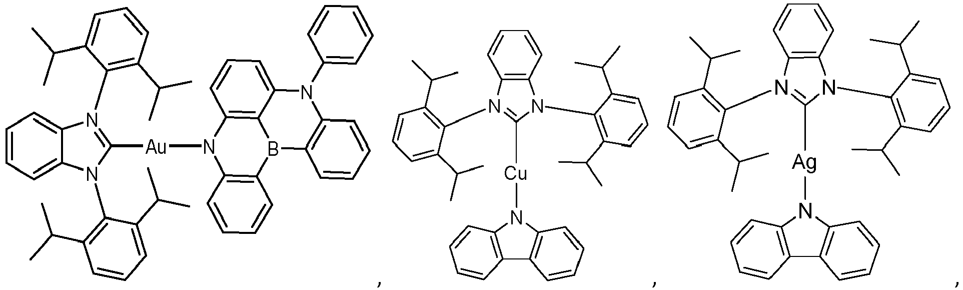

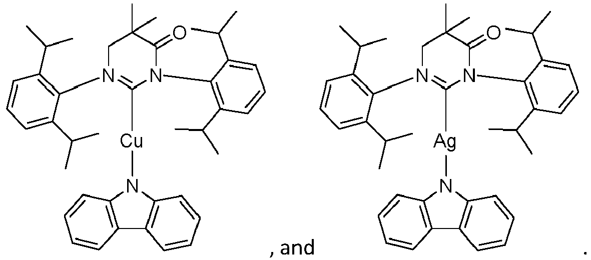

In some embodiments of the OLED, the TADF emitter comprises a boron atom. In some embodiments of the OLED, the TADF emitter comprises at least one of the chemical moieties selected from the group consisting of: 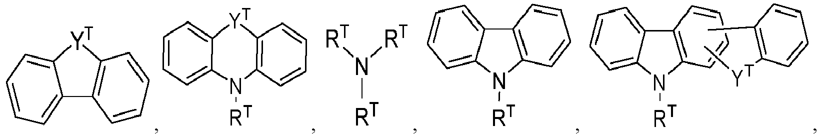 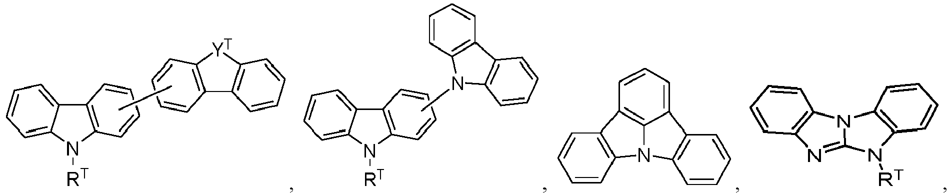 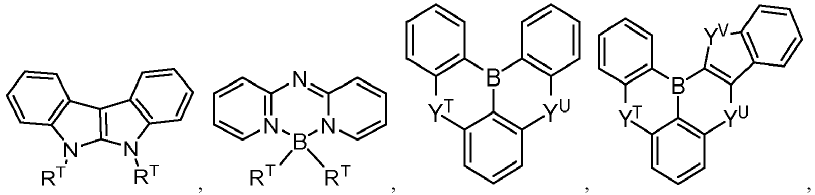 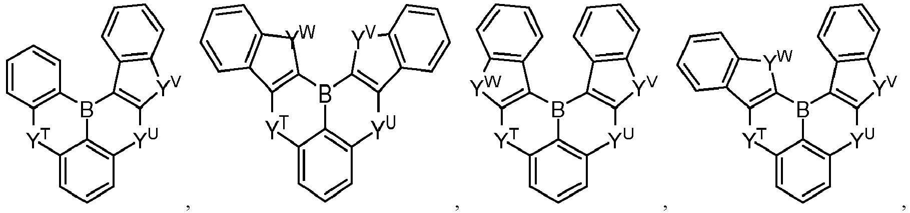 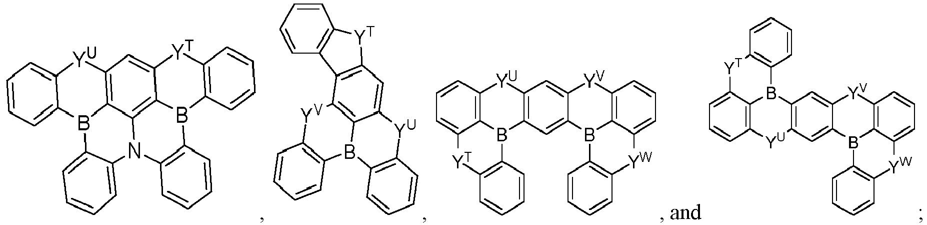
wherein Y^{T}, Y^{U}, Y^{V}, and Y^{W} are each independently selected from the group consisting of BR, NR, PR, O, S, Se, C=O, S=O, SO₂, BRR', CRR', SiRR', and GeRR';
wherein each R^{T} can be the same or different and each R^{T} is independently a donor, an acceptor group, an organic linker bonded to a donor, an organic linker bonded to an acceptor group, or a terminal group selected from the group consisting of alkyl, cycloalkyl, heteroalkyl, heterocycloalkyl, arylalkyl, aryl, heteroaryl, and combinations thereof; and
R, and R' are each independently a hydrogen or a substituent selected from the group consisting of the general substituents as defined herein.

In some of the above embodiments, any carbon ring atoms up to maximum of a total number of three, together with their substituents, in each phenyl ring of any of above structures can be replaced with N.

In some embodiments, the TADF emitter comprises at least one of the acceptor moieties selected from the group consisting of nitrile, isonitrile, borane, fluoride, pyridine, pyrimidine, pyrazine, triazine, aza-carbazole, aza-dibenzothiophene, aza-dibenzofuran, aza-dibenzoselenophene, aza-triphenylene, imidazole, pyrazole, oxazole, thiazole, isoxazole, isothiazole, triazole, thiadiazole, and oxadiazole. In some embodiments, the acceptor moieties and the donor moieties as described herein can be connected directly, through a conjugated linker, or a nonconjugated linker, such as a sp3 carbon or silicon atom.

In some embodiments, the acceptor is a fluorescent compound functioning as an emitter in the OLED at room temperature. In some embodiments, the fluorescent compound comprises at least one of the chemical moieties selected from the group consisting of: 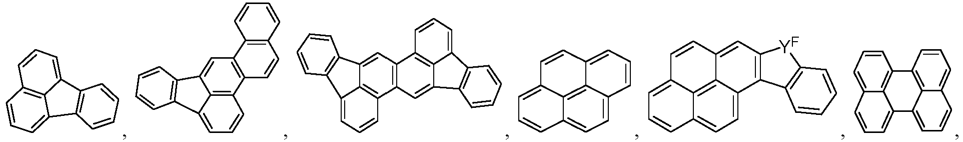 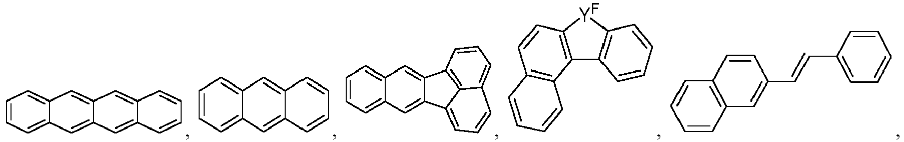 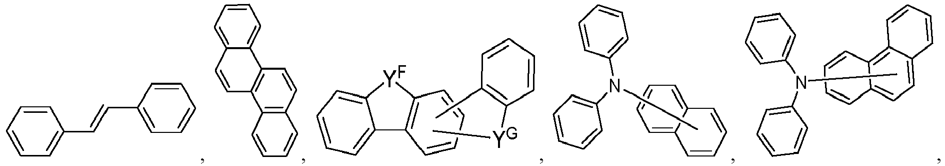 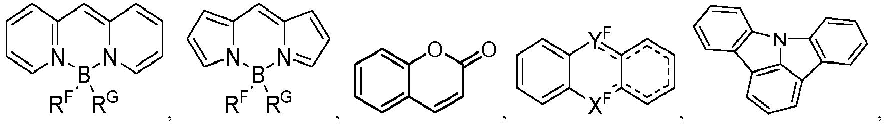 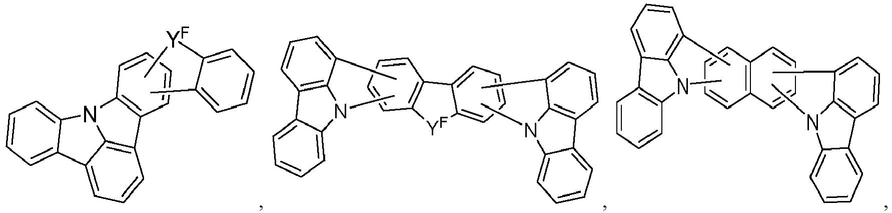 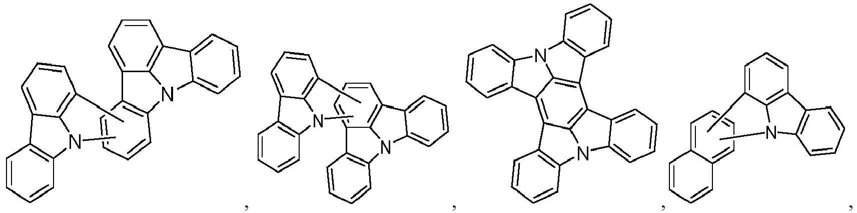 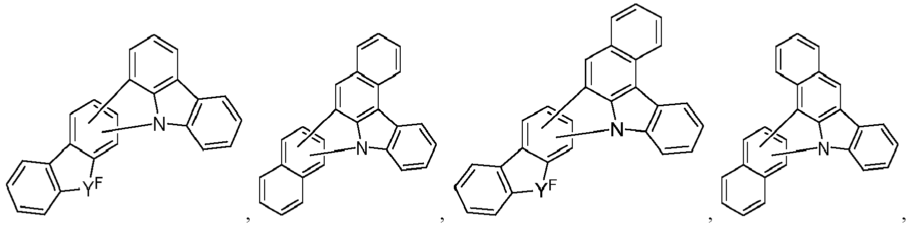 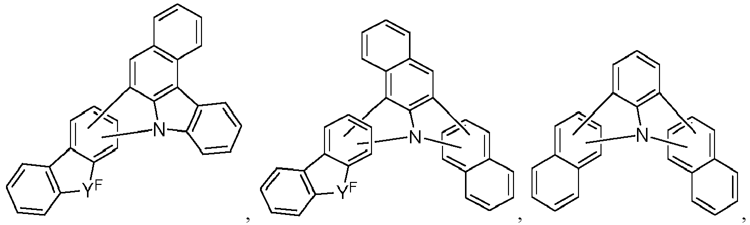 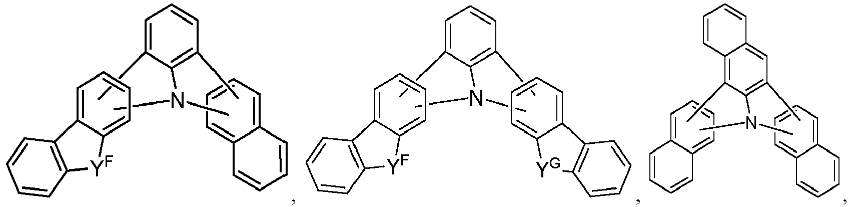 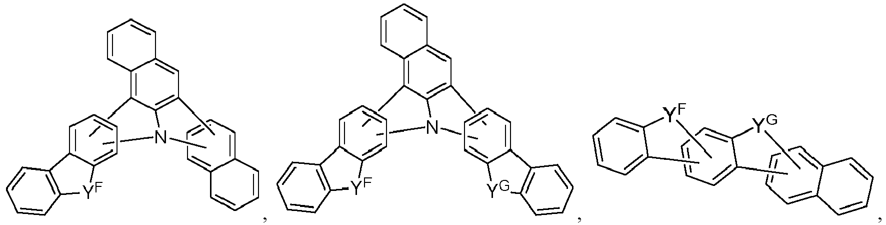 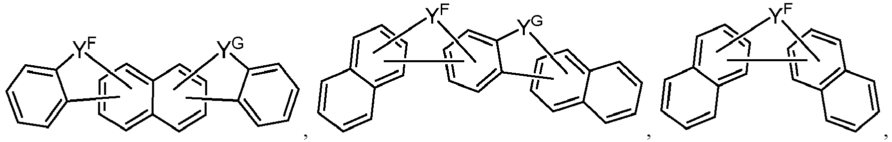 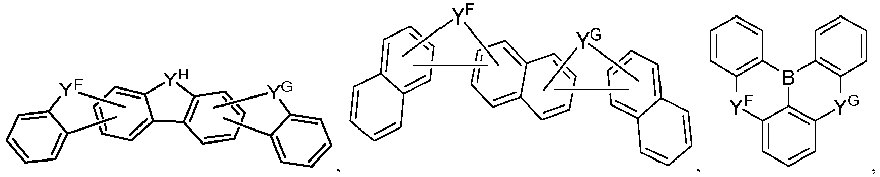 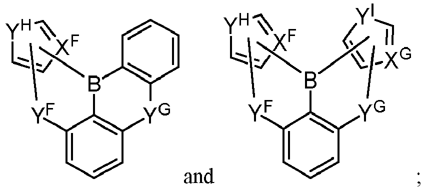
wherein Y^{F}, Y^{G}, Y^{H}, and Y^{I} are each independently selected from the group consisting of BR, NR, PR, O, S, Se, C=O, S=O, SO₂, BRR', CRR', SiRR', and GeRR';
wherein X^{F} and X^{G} are each independently selected from the group consisting of C and N; and wherein R^{F}, R^{G}, R, and R' are each independently a hydrogen or a substituent selected from the group consisting of the General Substituents as defined herein.
In some of the above embodiments, any carbon ring atoms up to maximum of a total number of three, together with their substituents, in each phenyl ring of any of above structures can be replaced with N.

In some embodiments of the OLED, the fluorescent compound is selected from the group consisting of: 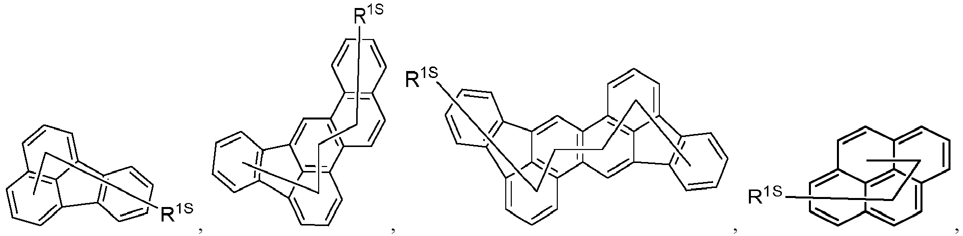 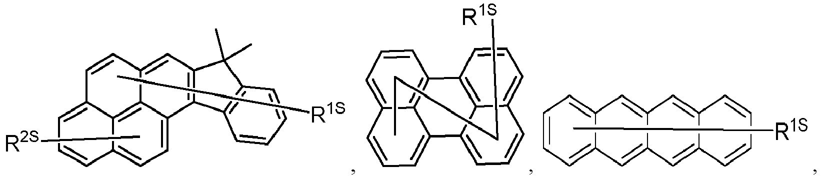 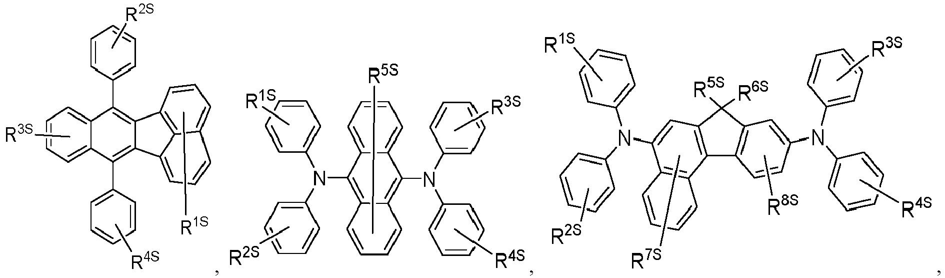 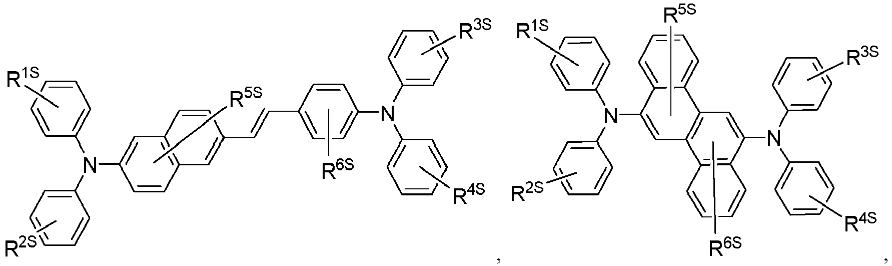 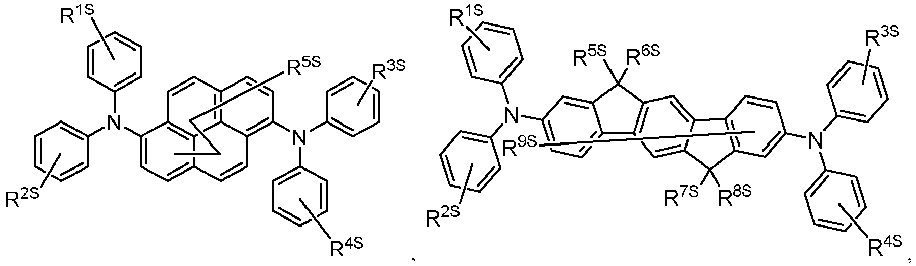 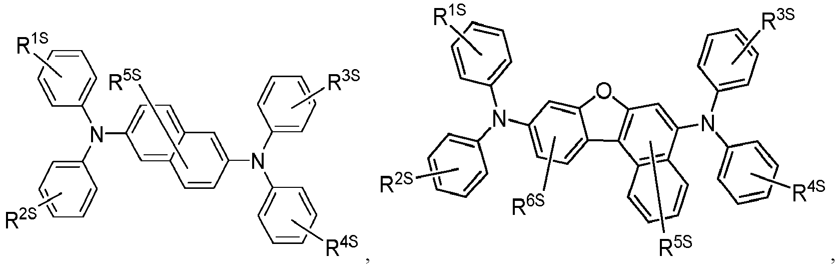 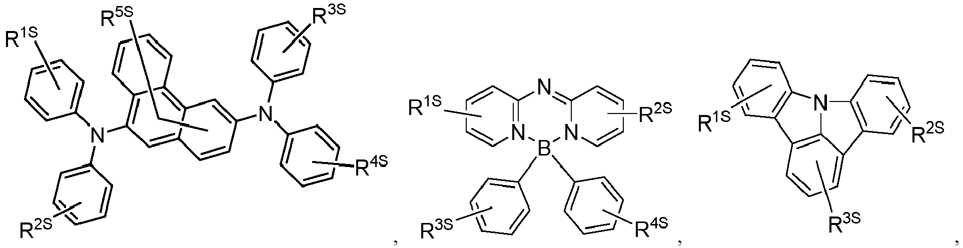 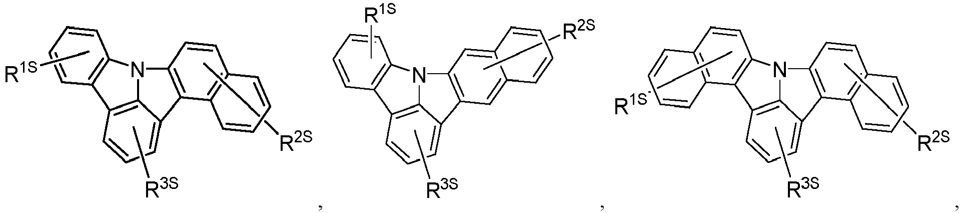 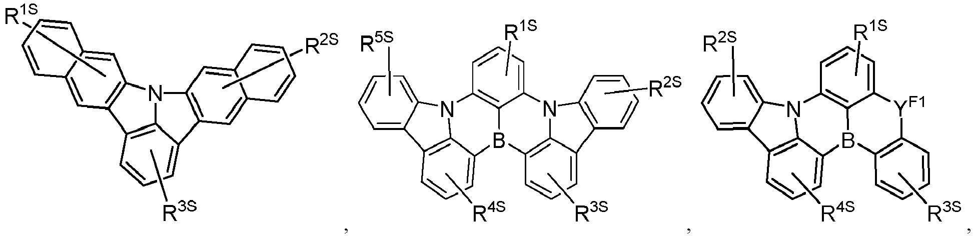 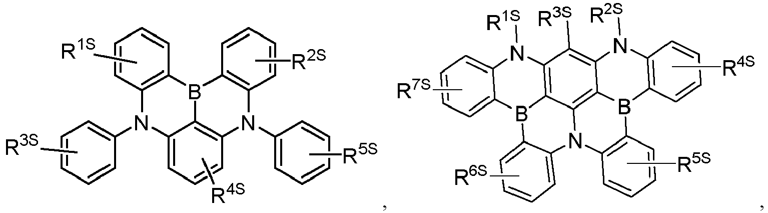 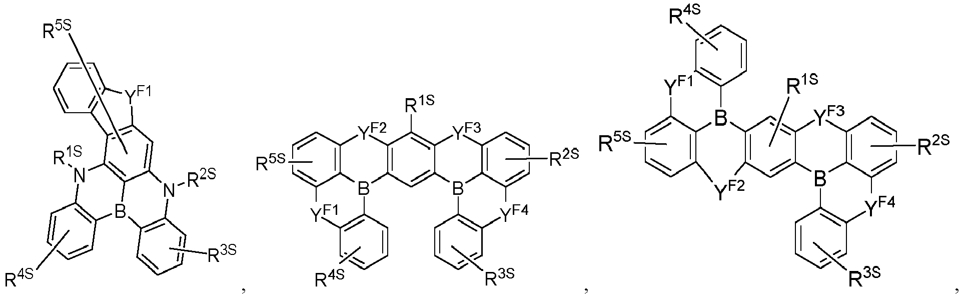 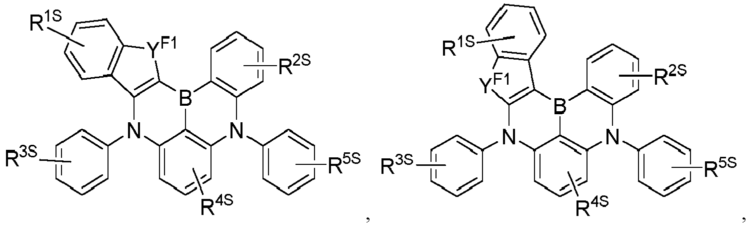 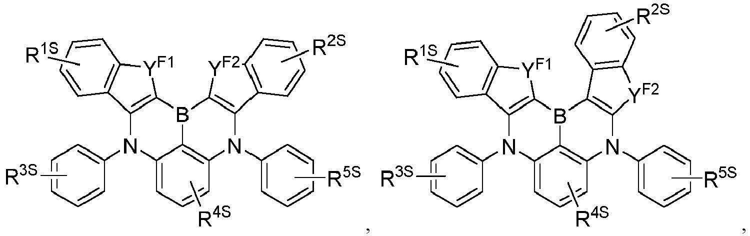 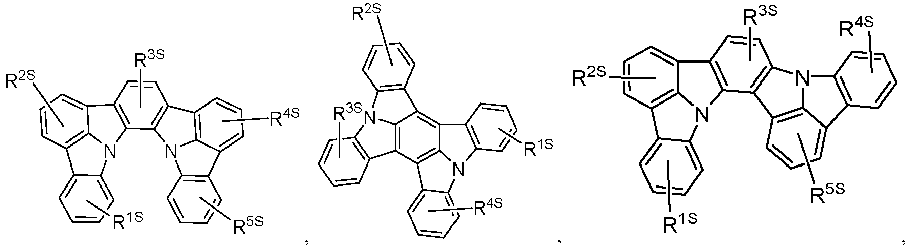 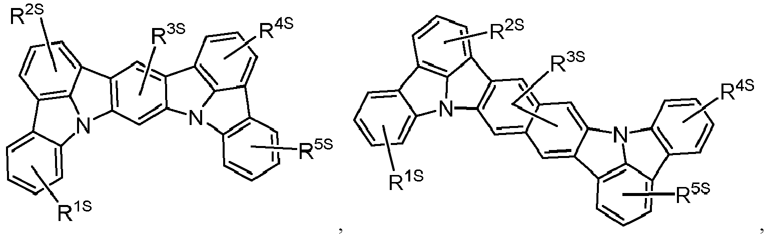 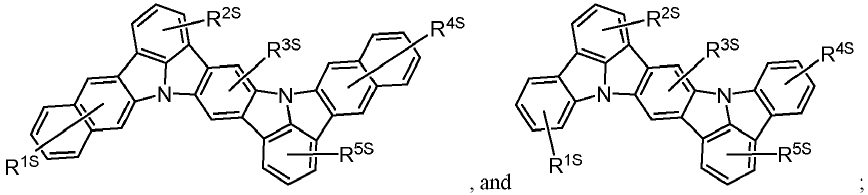
wherein Y^{F1} to Y^{F4} are each independently selected from O, S, and NR^{F1};
wherein R^{F1} and R¹ to R⁹ each independently represents from mono to maximum possible number of substitutions, or no substitution; and
wherein R^{F1} and R¹ to R⁹ are each independently a hydrogen or a substituent selected from the group consisting of the general substituents as defined herein, and any two substituents can be joined or fused to form a ring.

In some embodiments, the acceptor compound is selected from the group consisting of the structures of the following ACCEPTOR LIST: 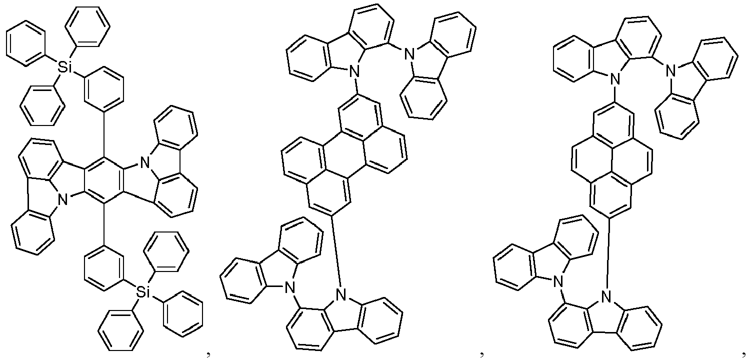 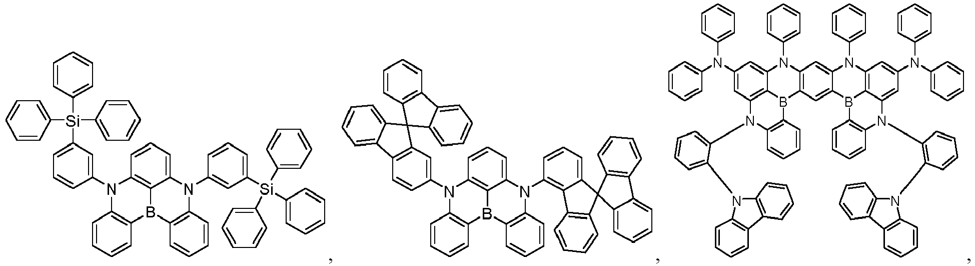 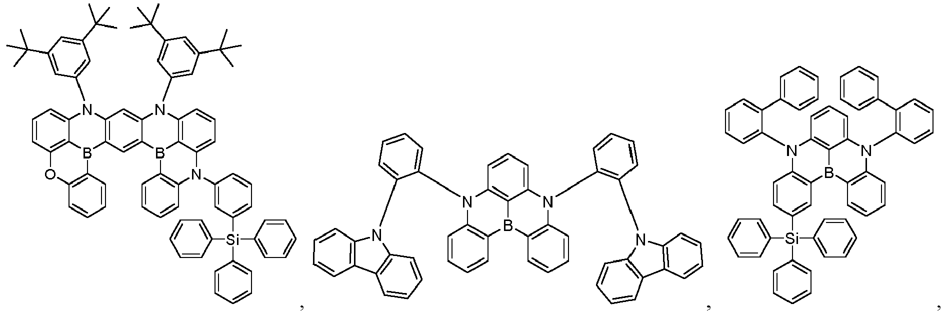 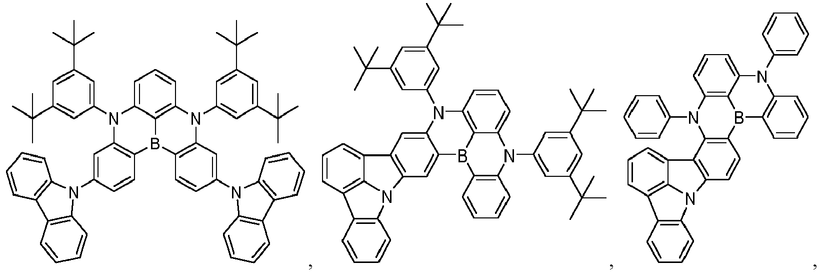 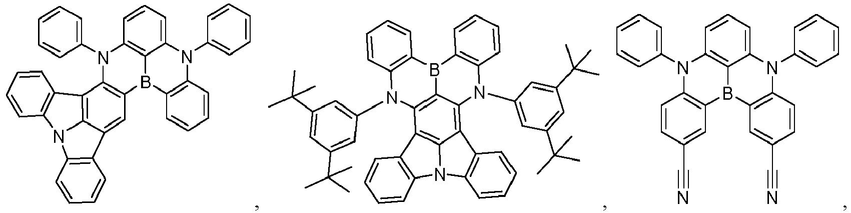 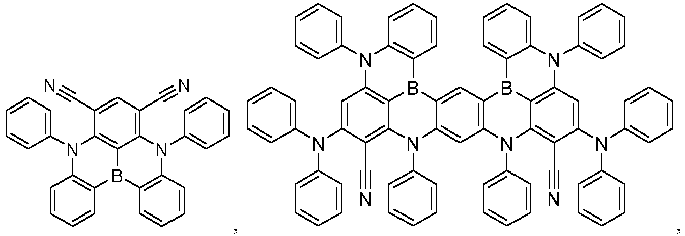 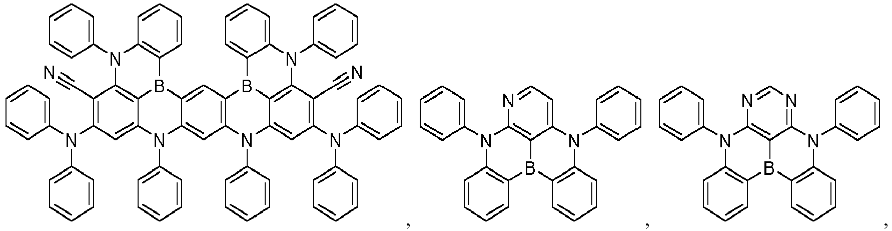 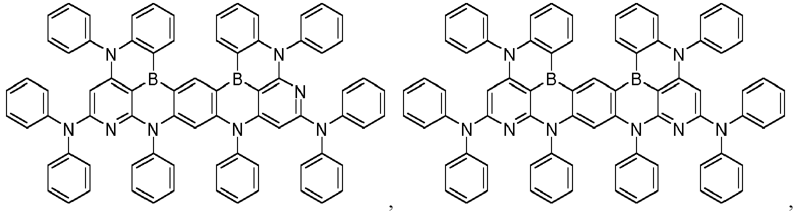 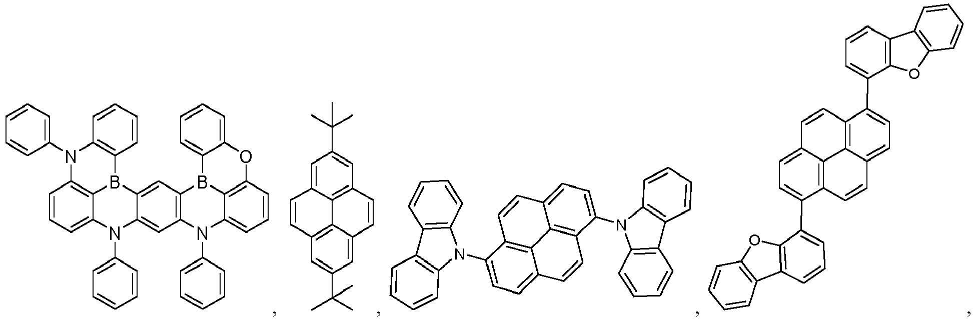 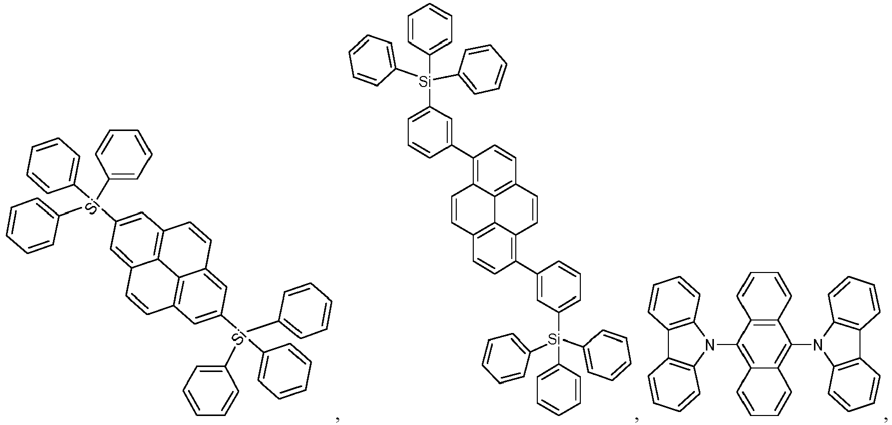 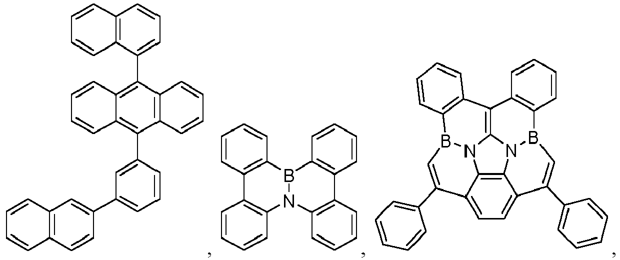 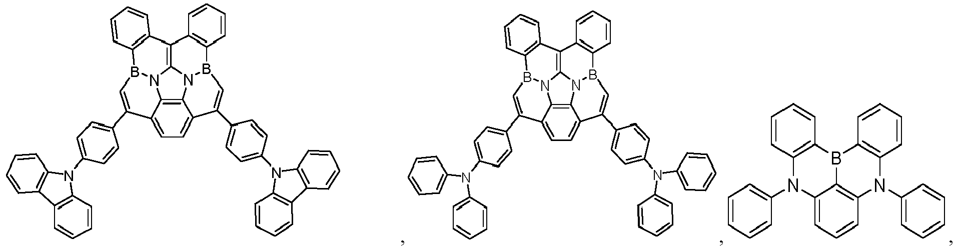 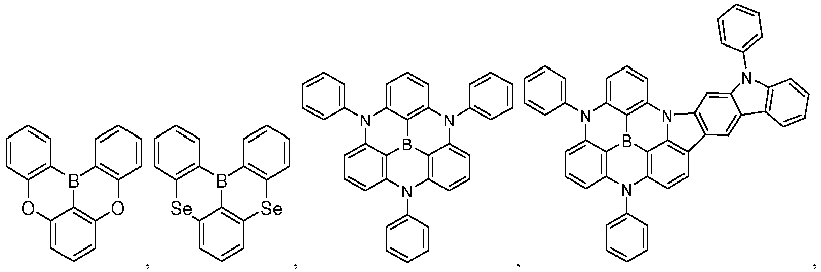 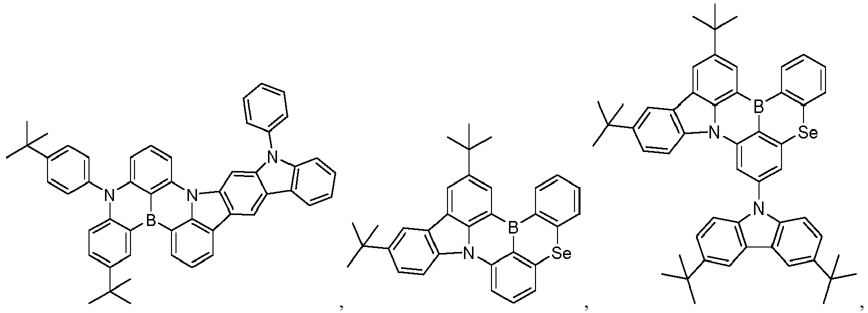 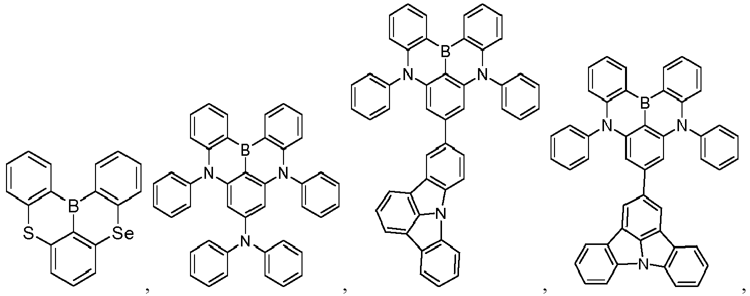 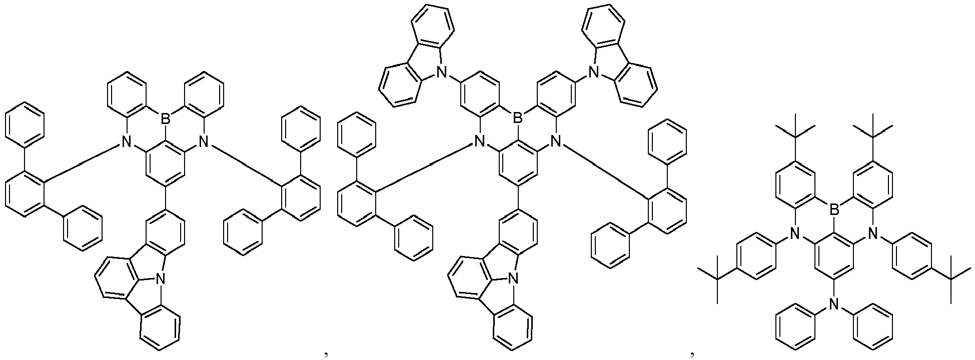 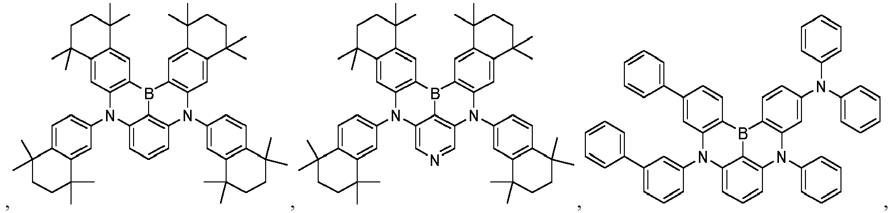 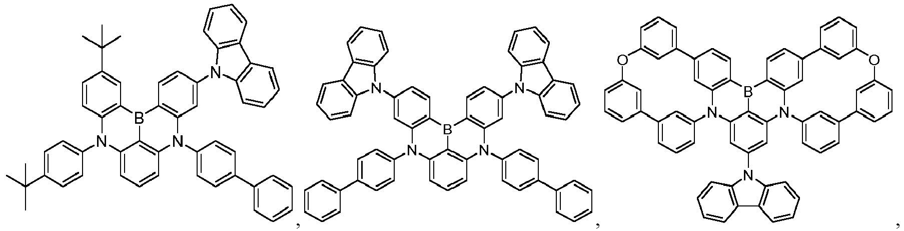 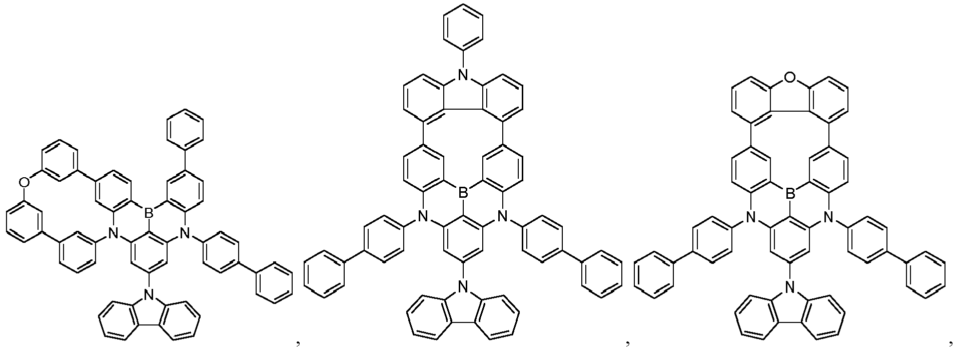 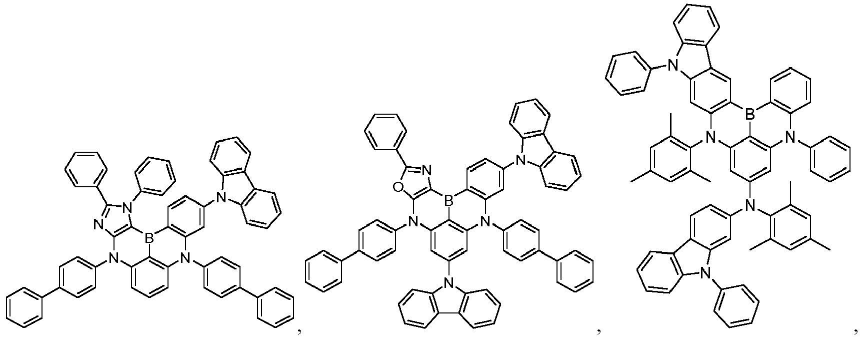 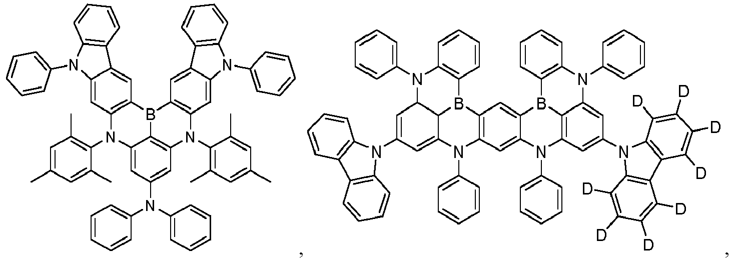 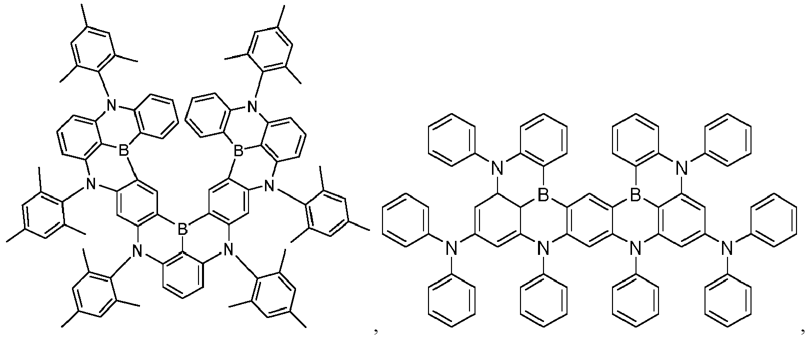 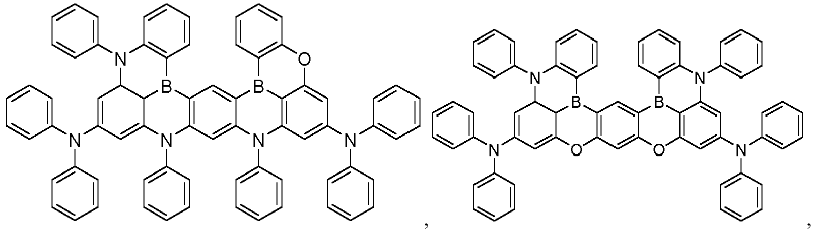 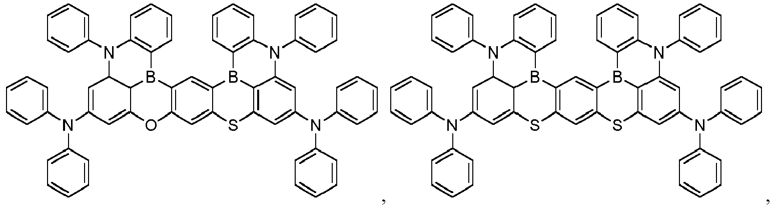 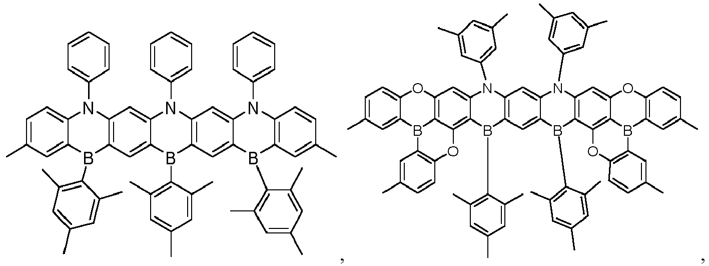 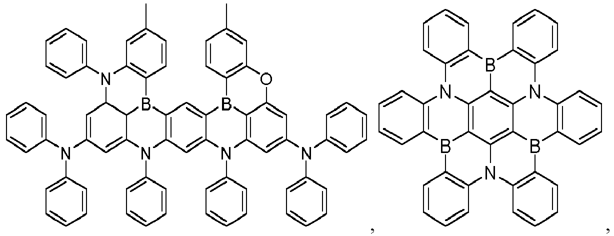 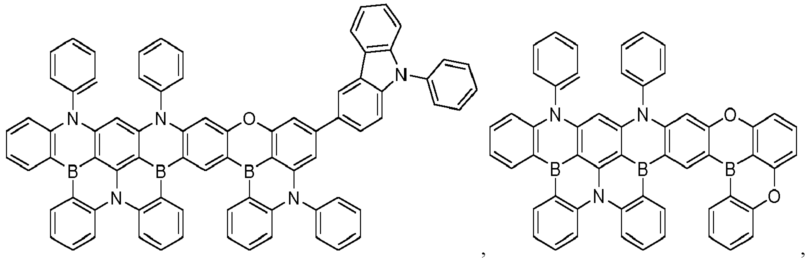 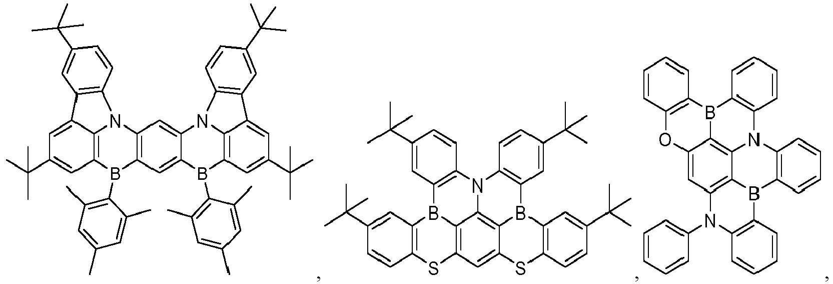 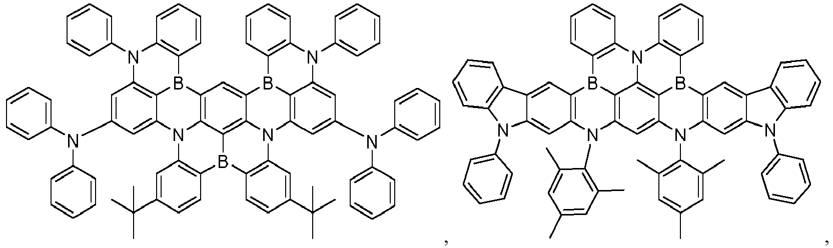 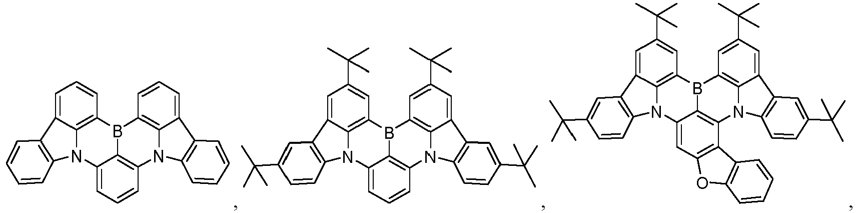 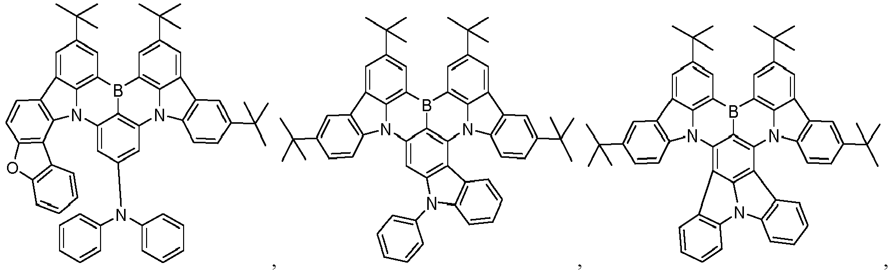 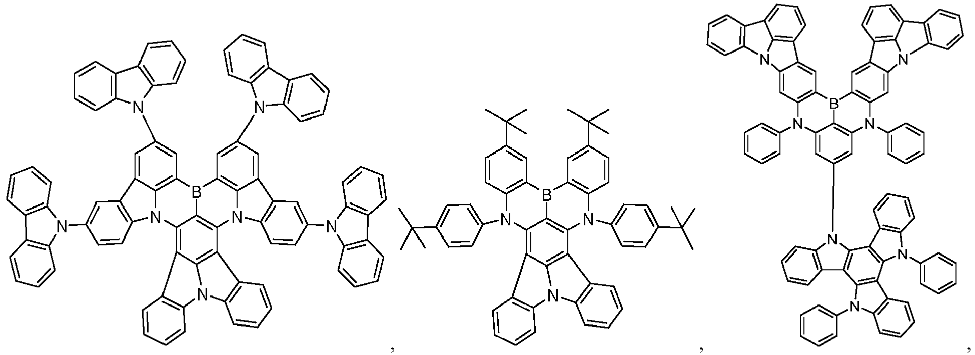 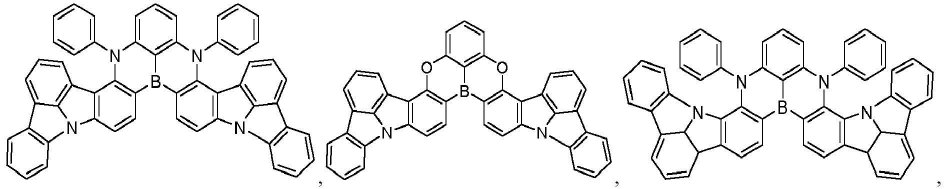 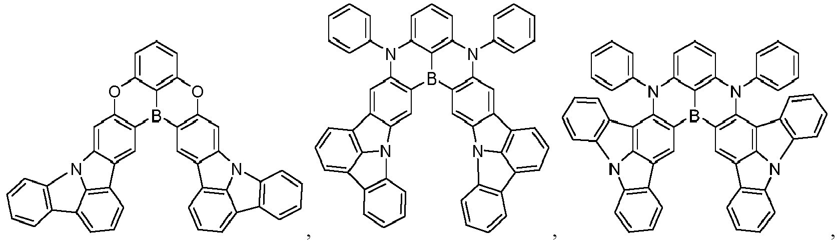 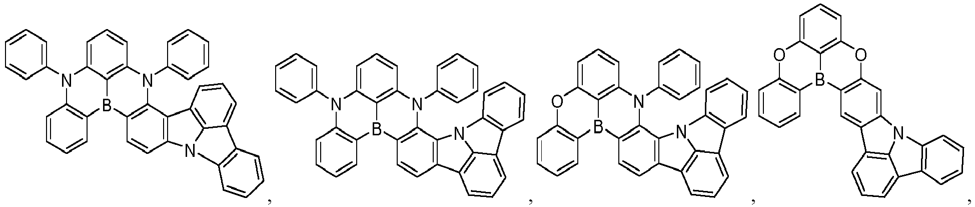 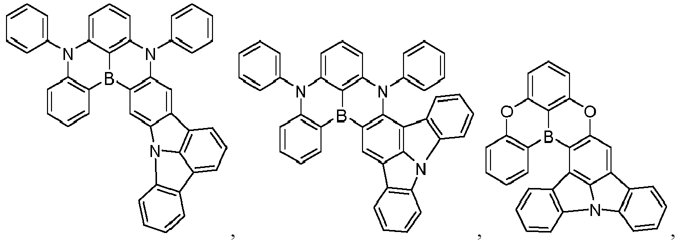 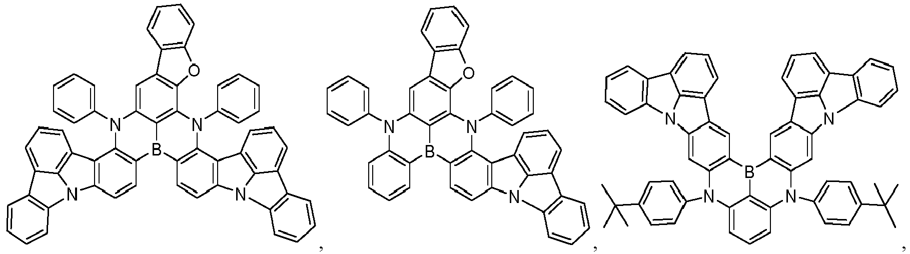 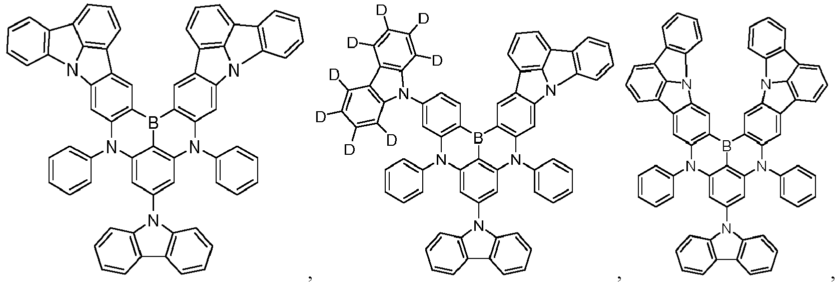 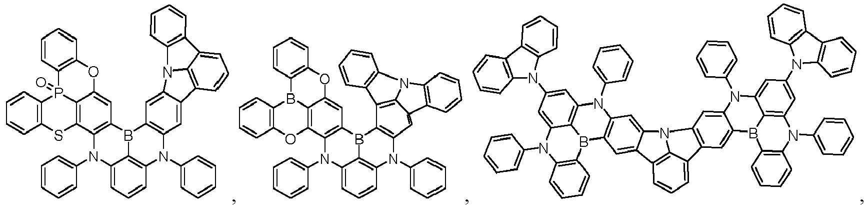 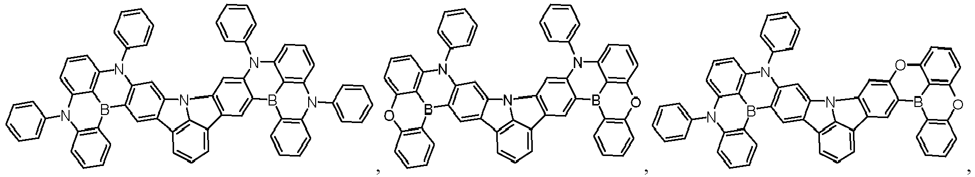 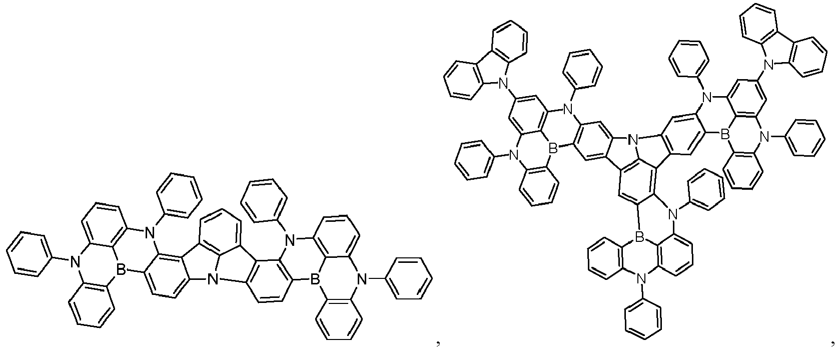 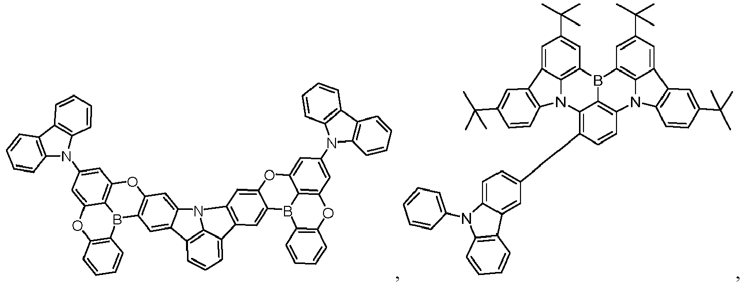 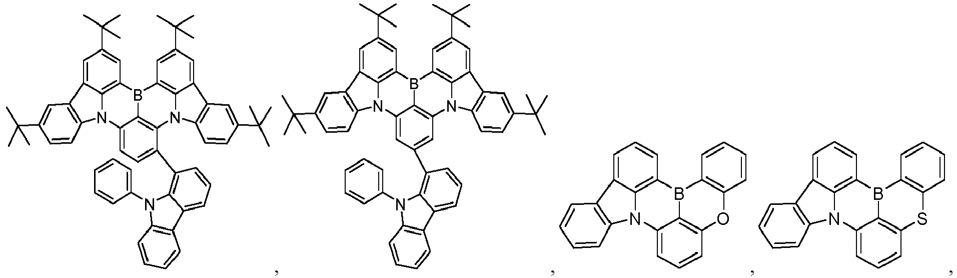 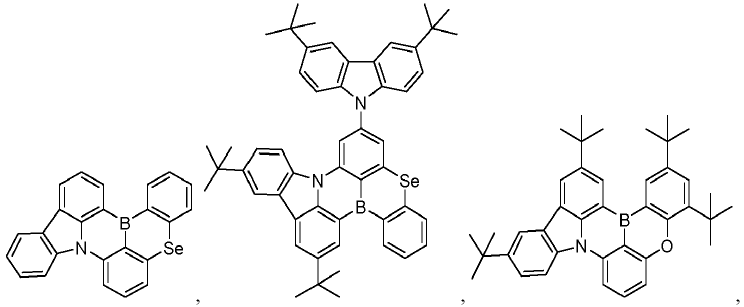 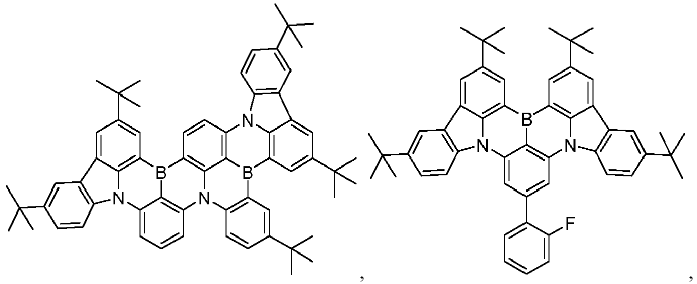 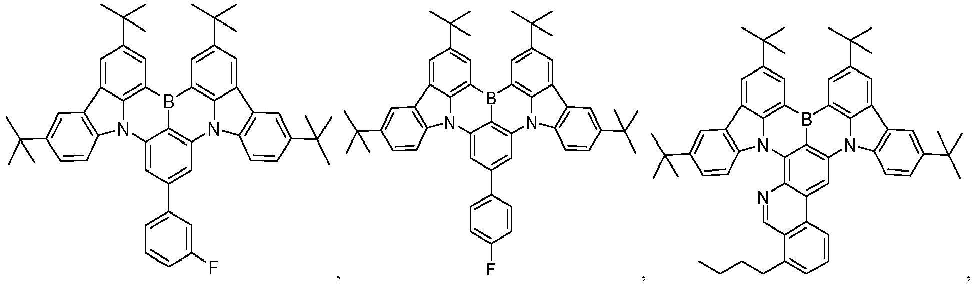 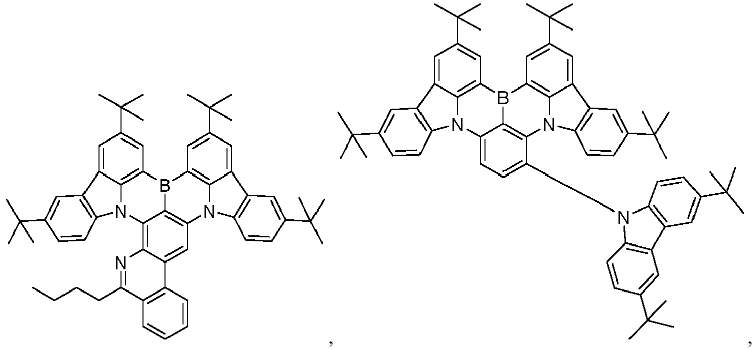 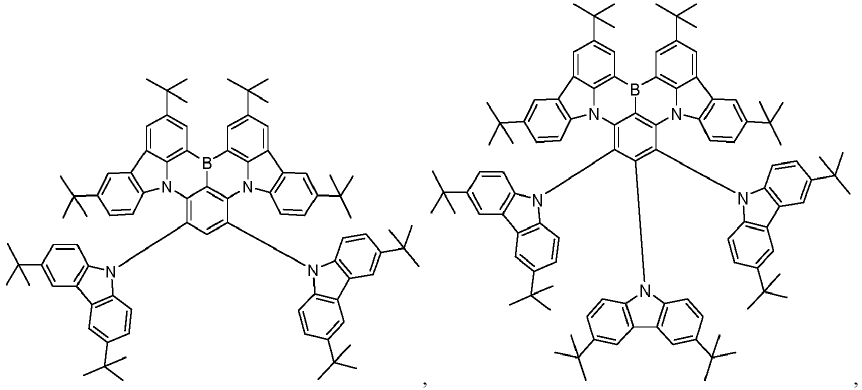 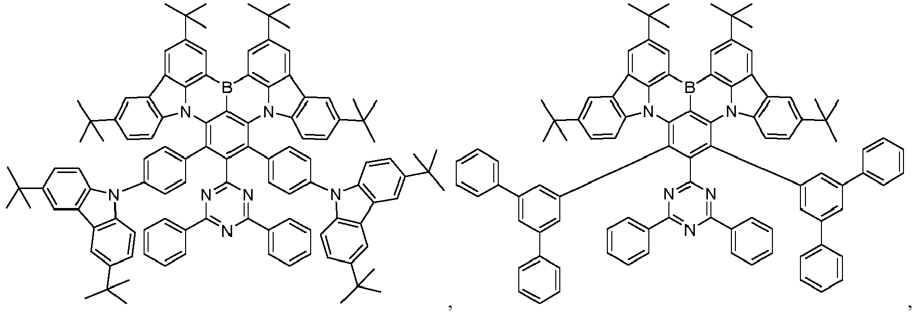 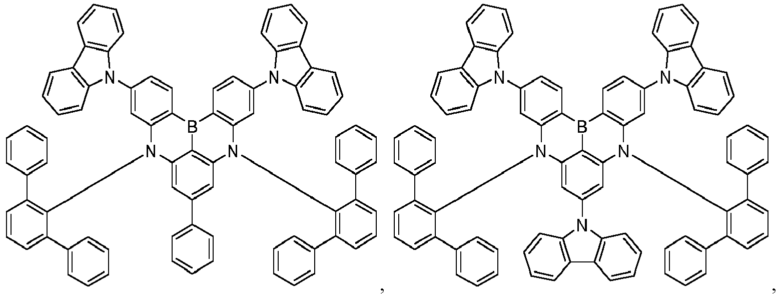 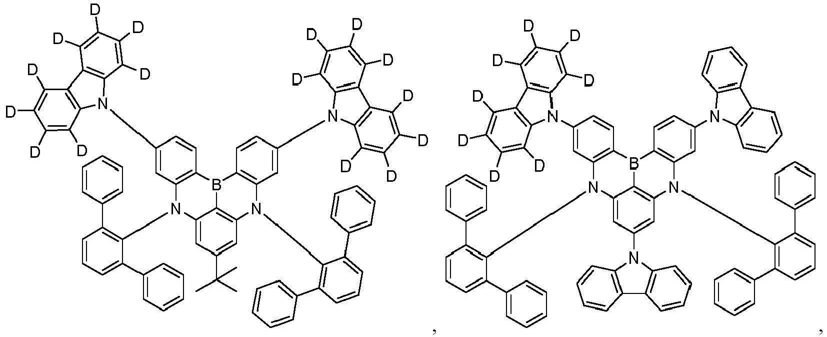 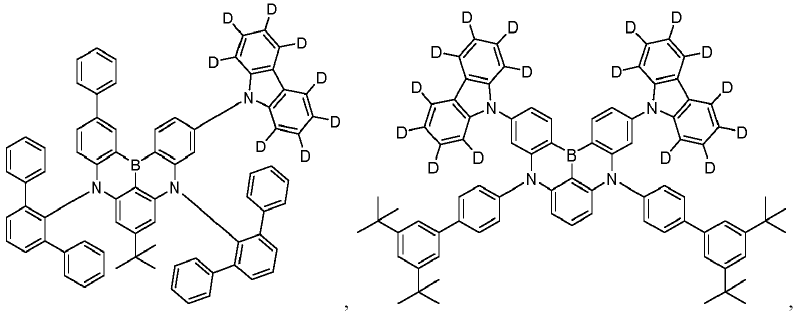 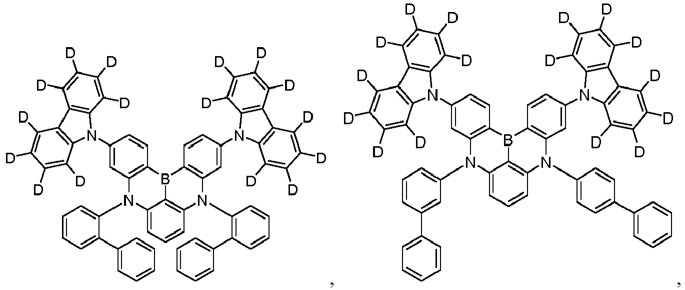 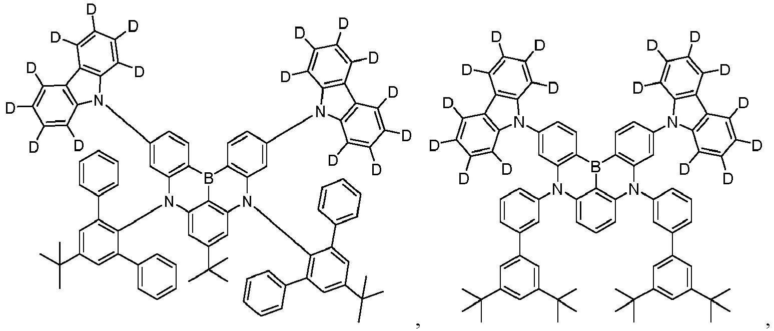 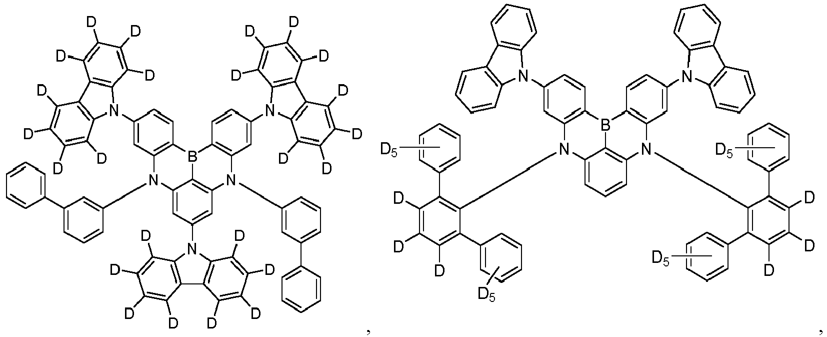 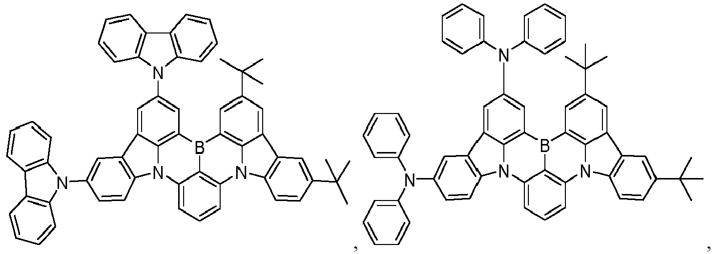 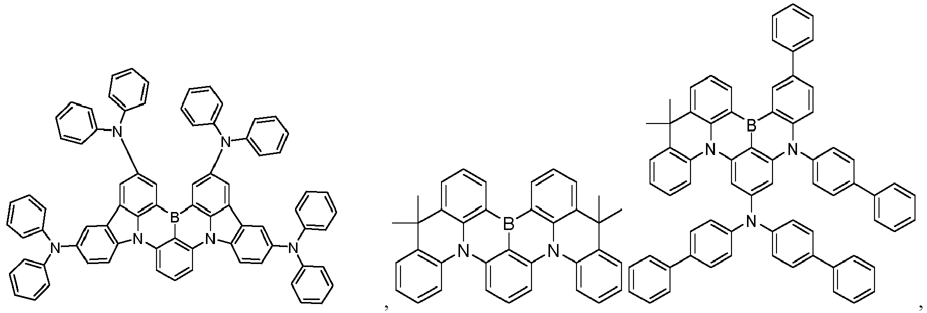 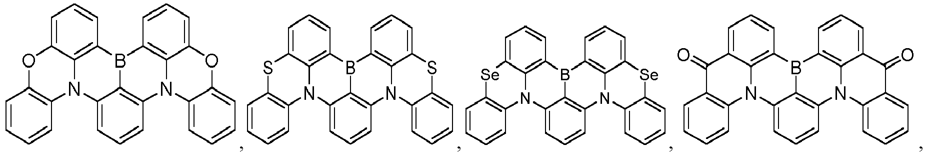 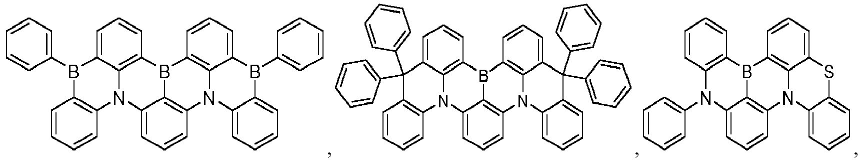 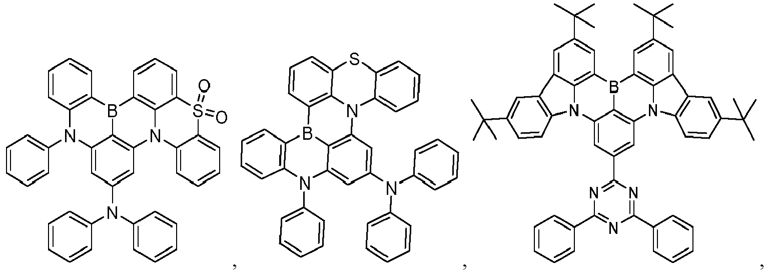 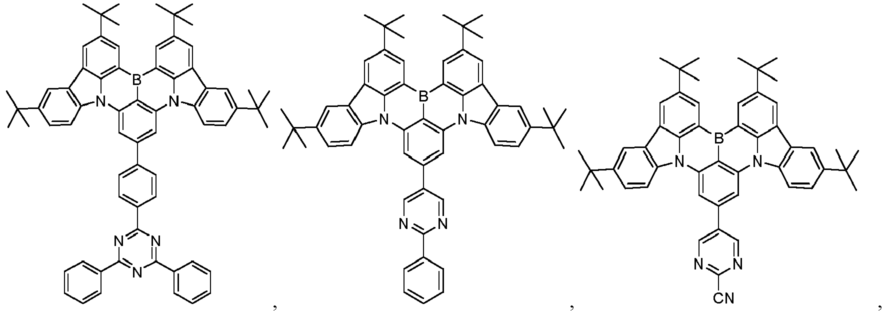 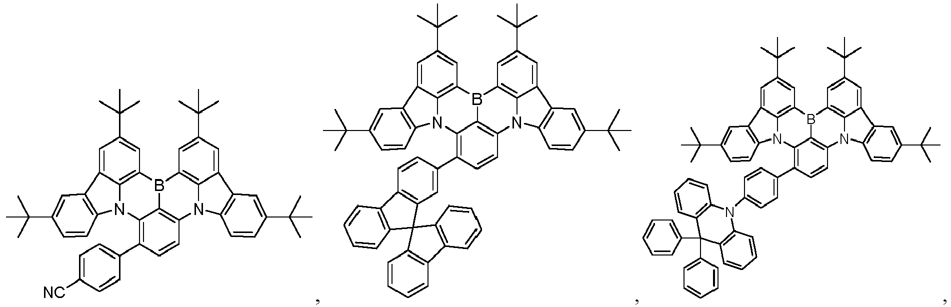 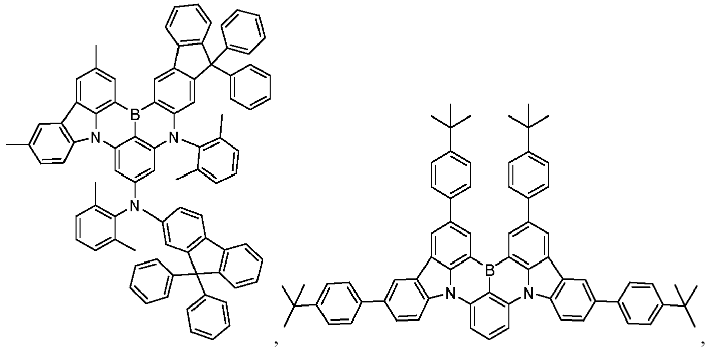 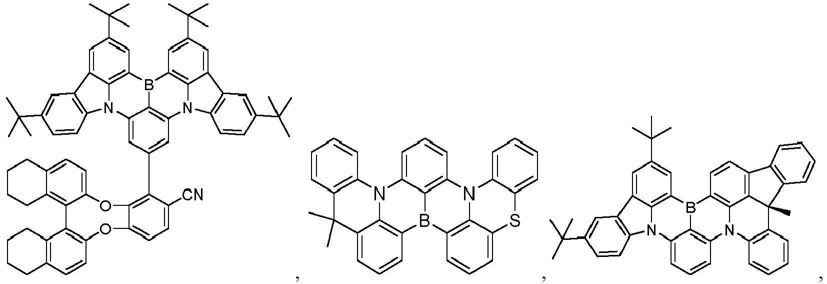 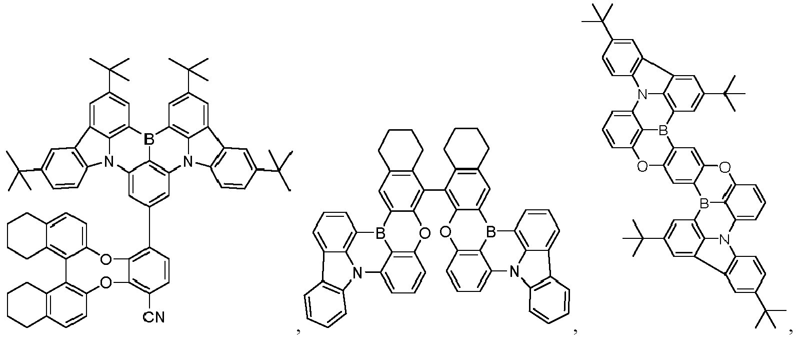 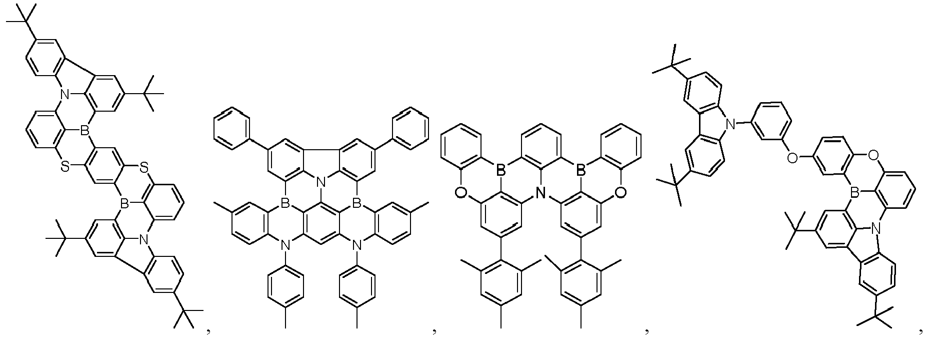 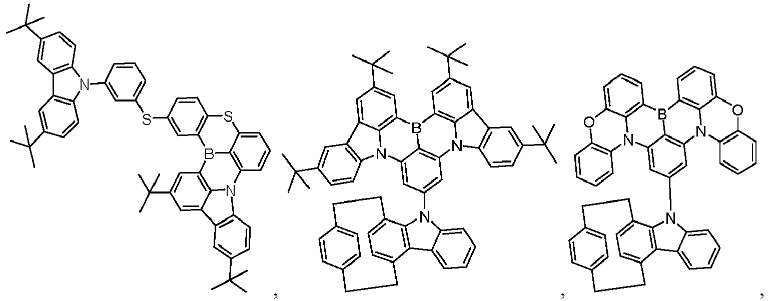 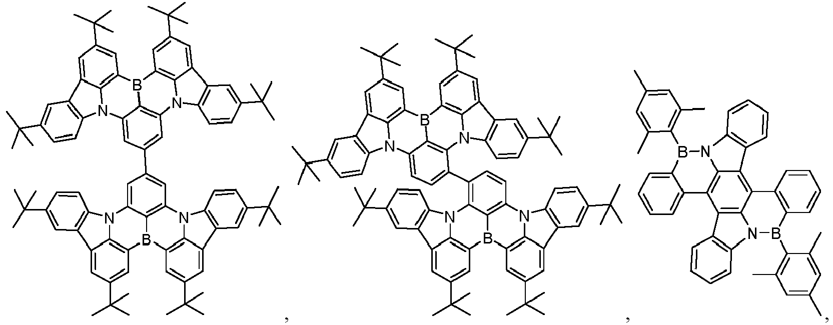 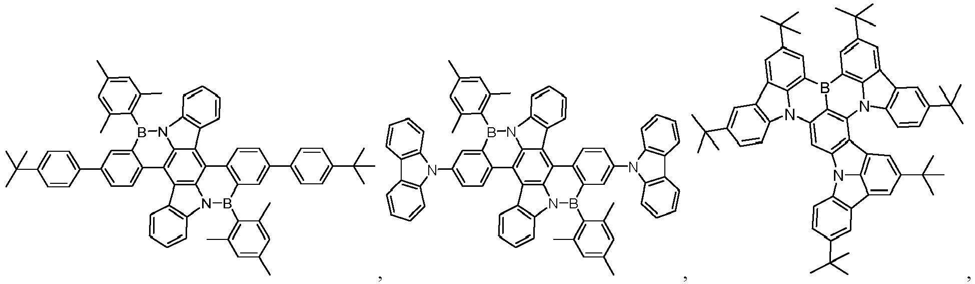 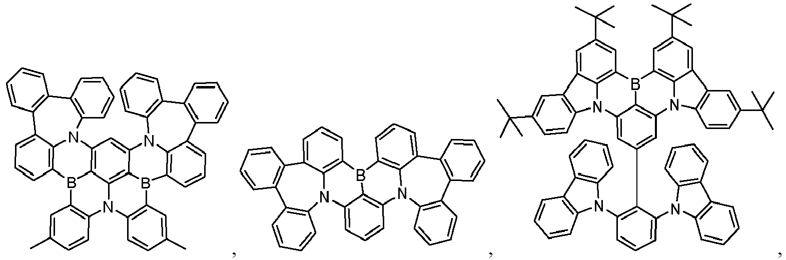 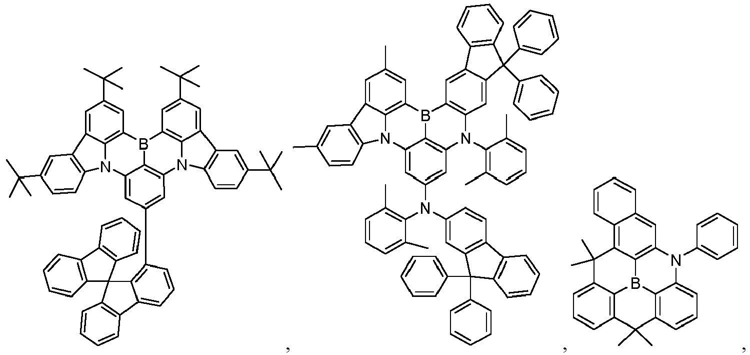 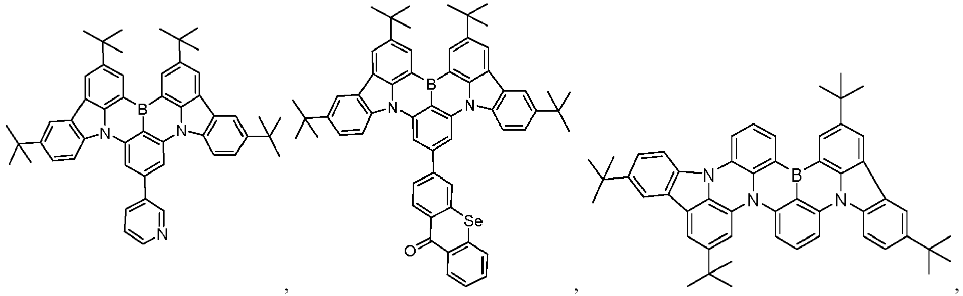 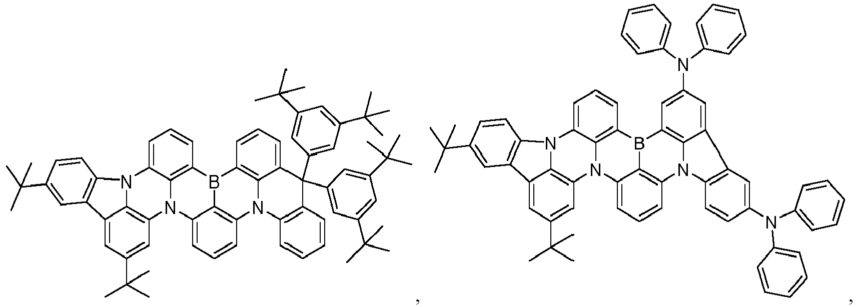 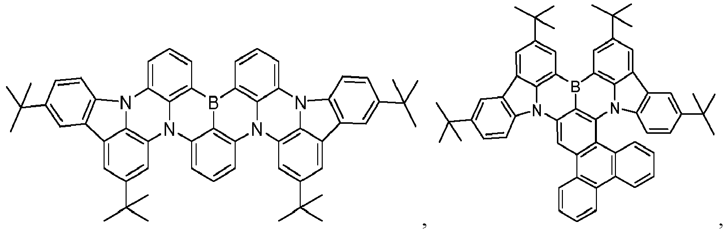 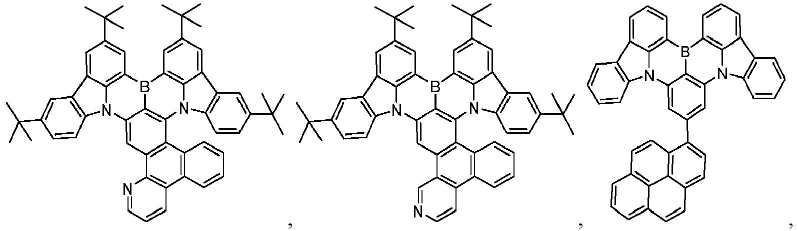 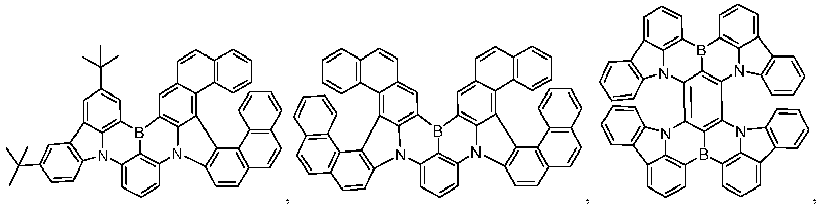 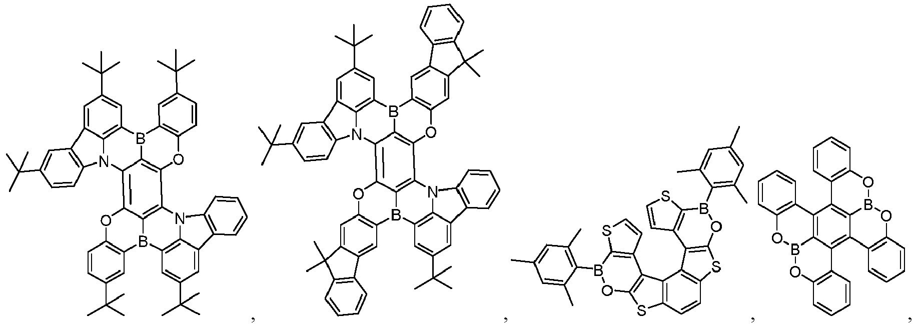 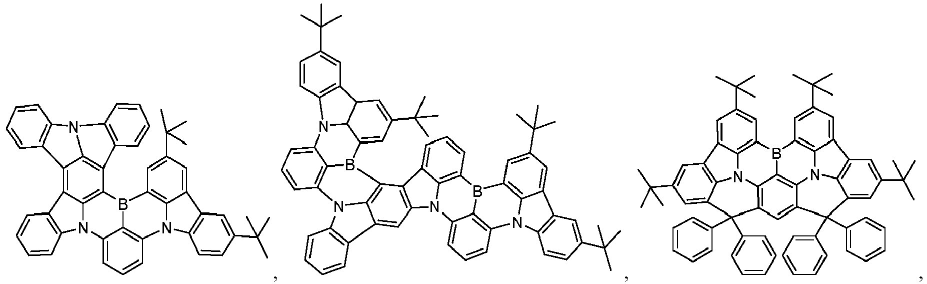 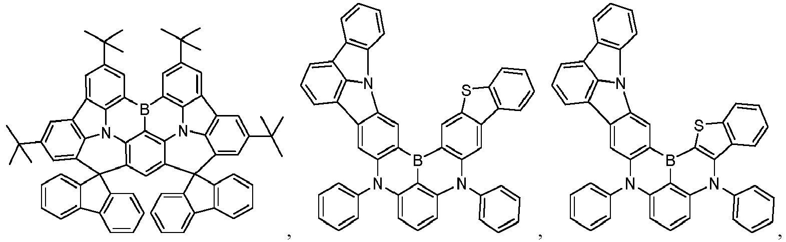 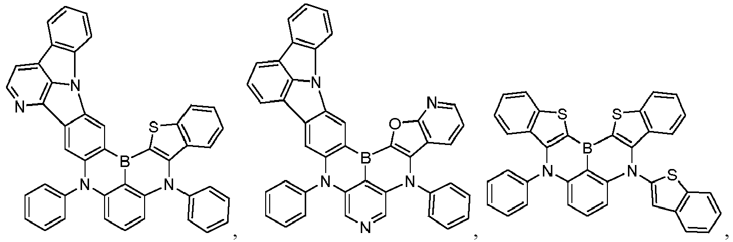 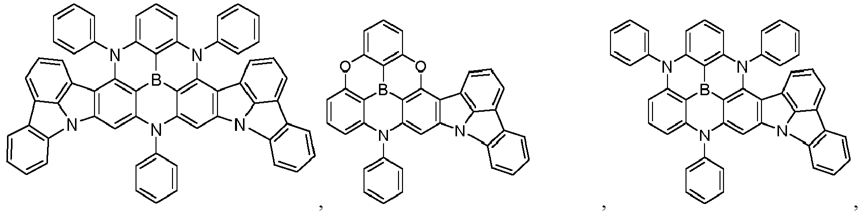 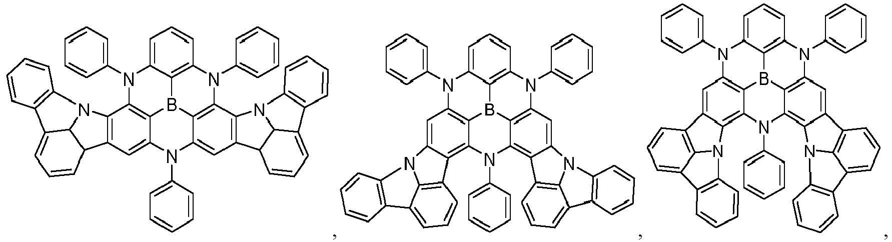 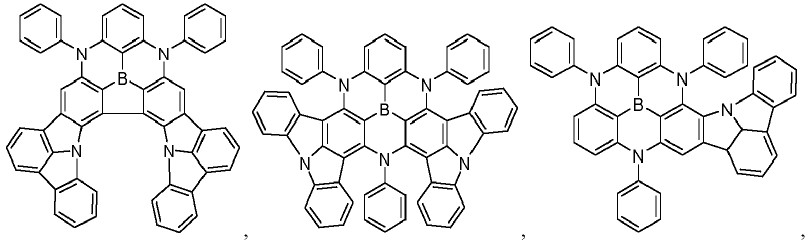 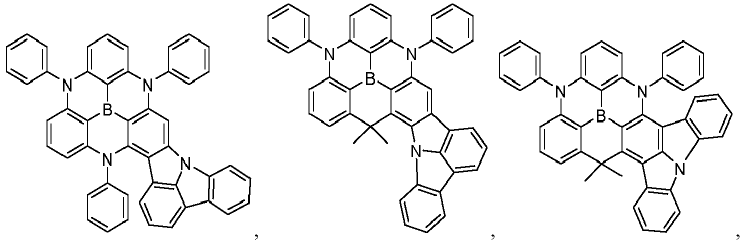 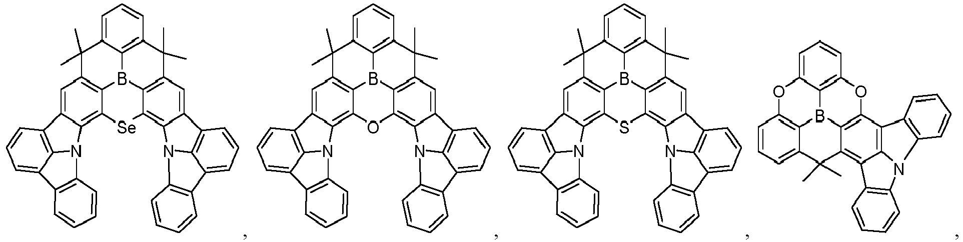 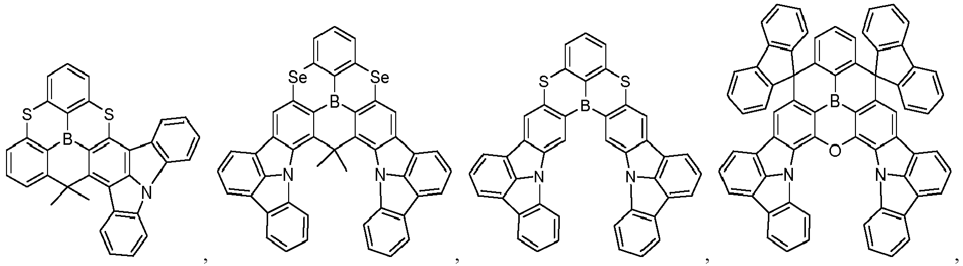 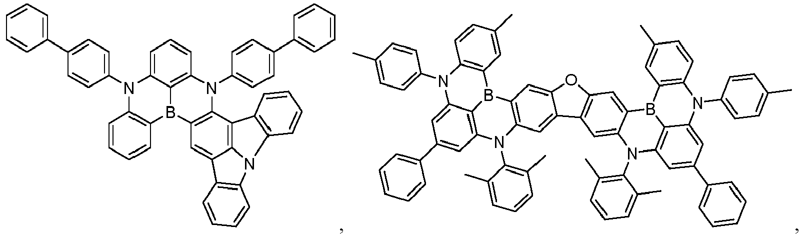 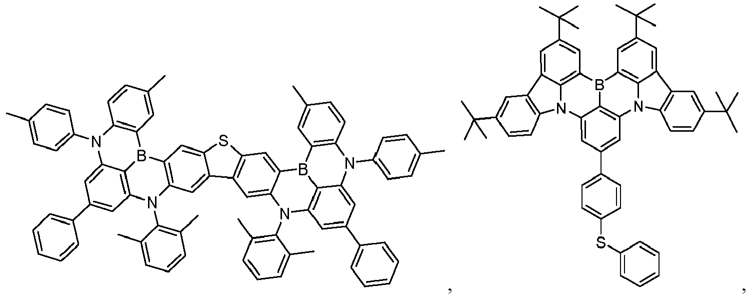 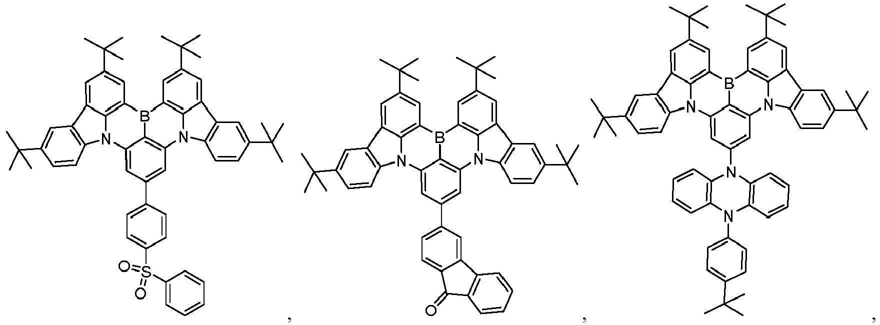 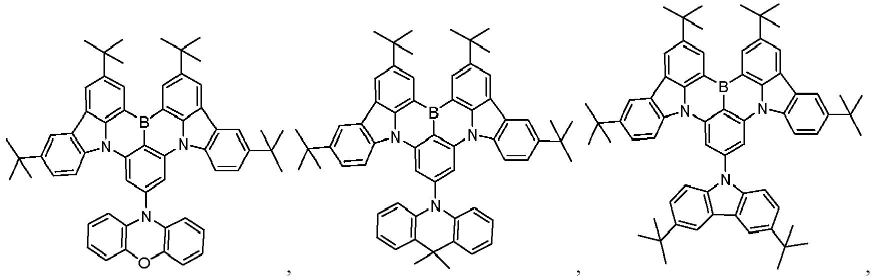 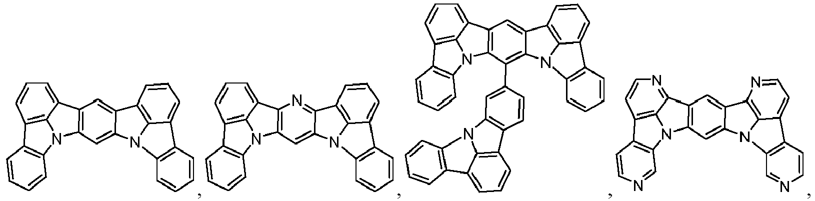 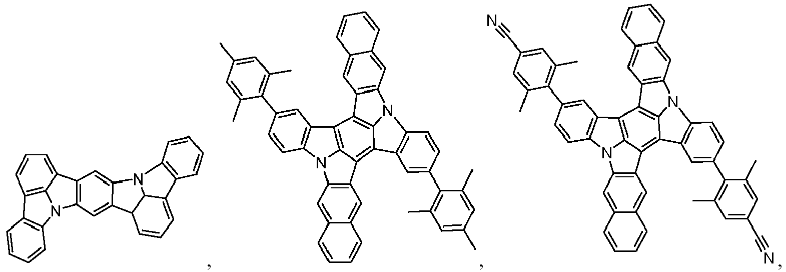 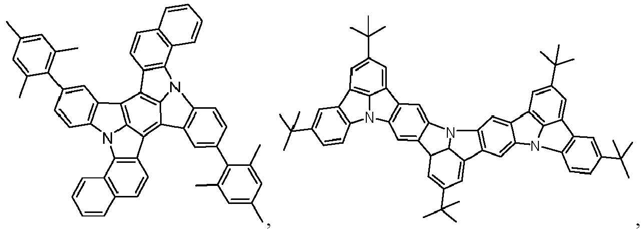 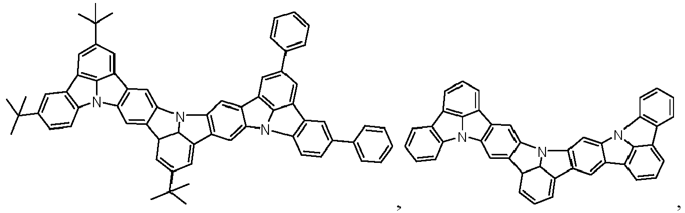 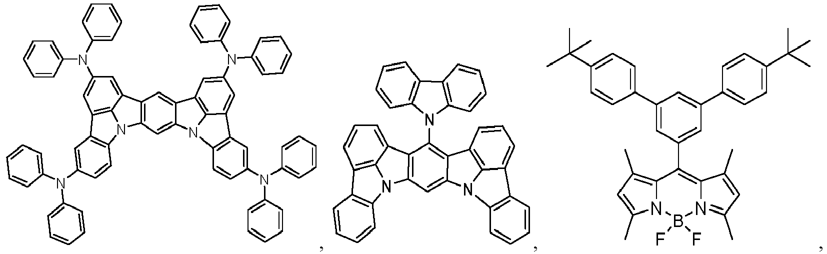 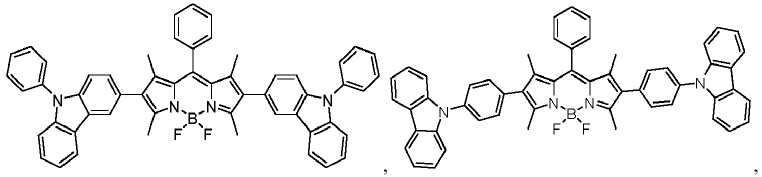 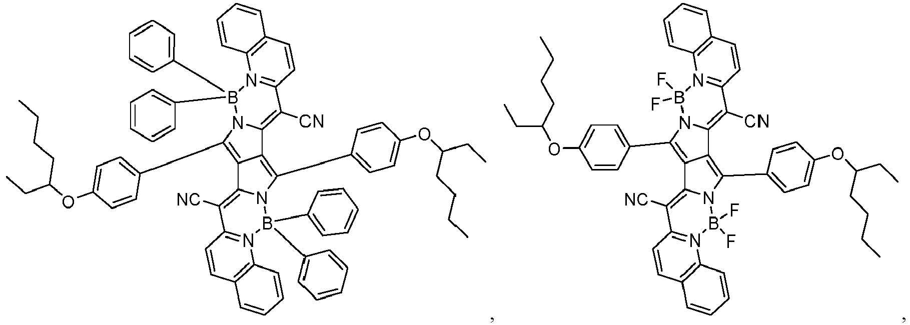 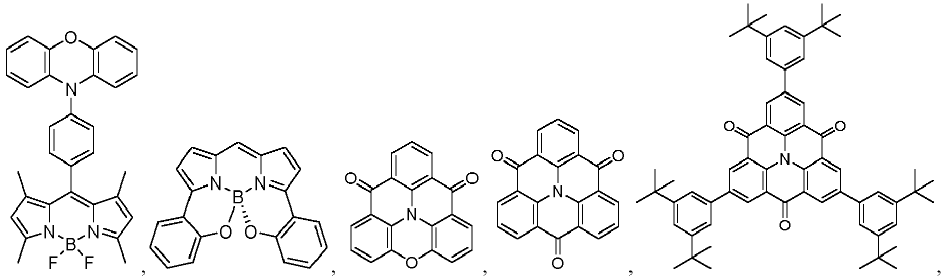 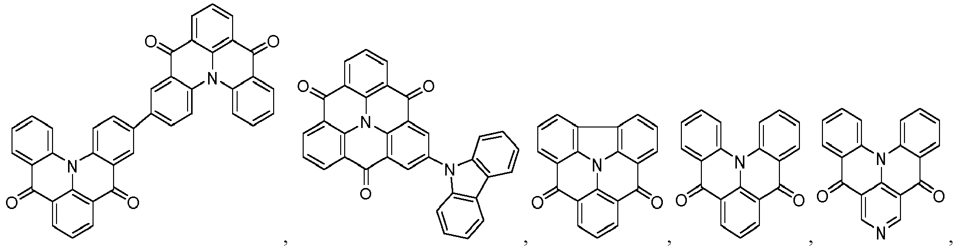 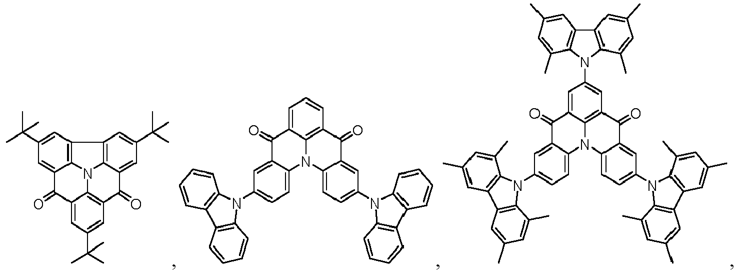 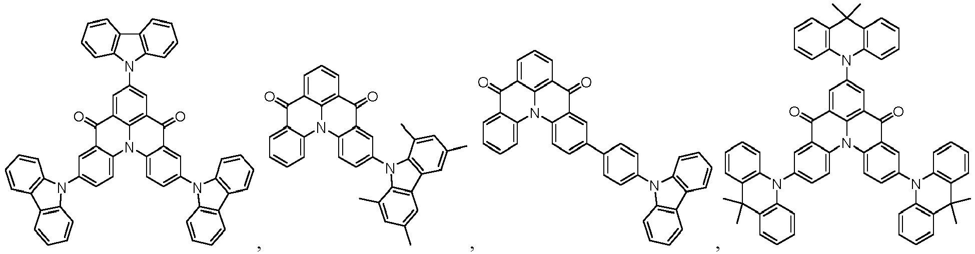 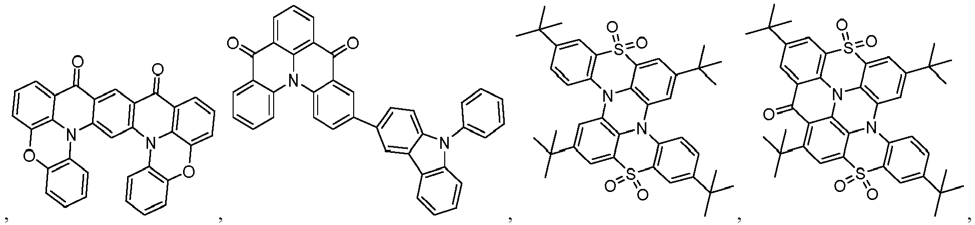 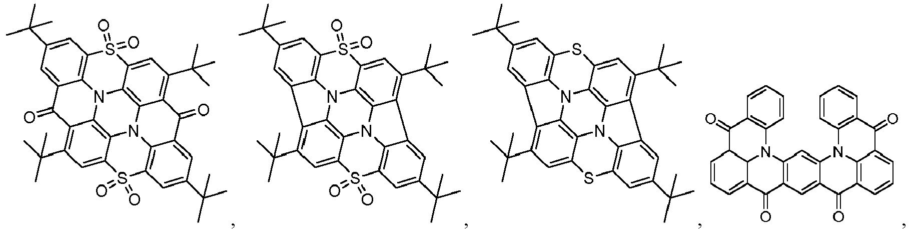 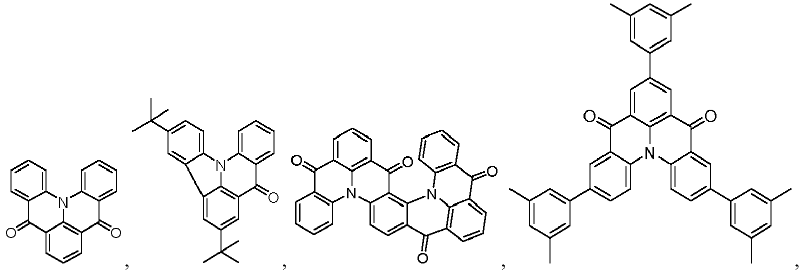 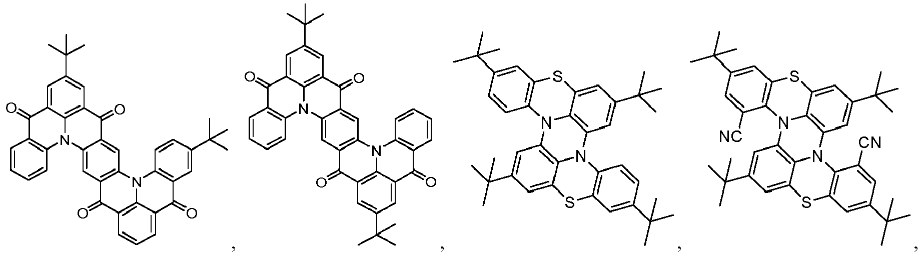 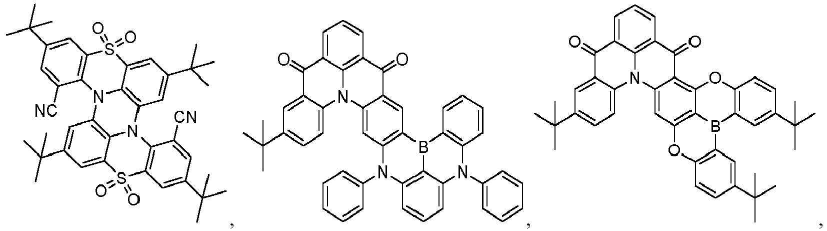 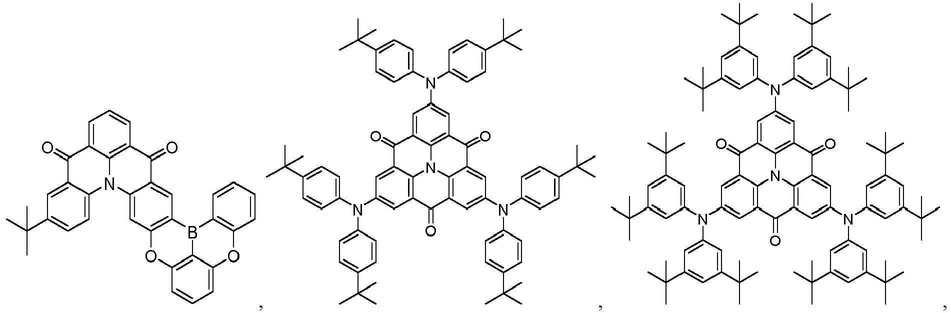 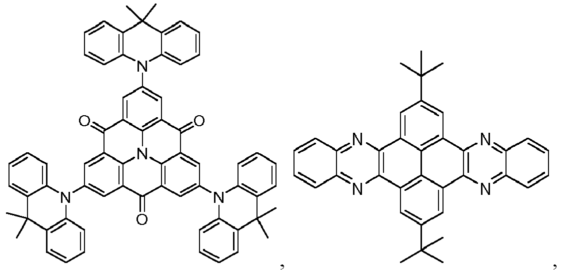 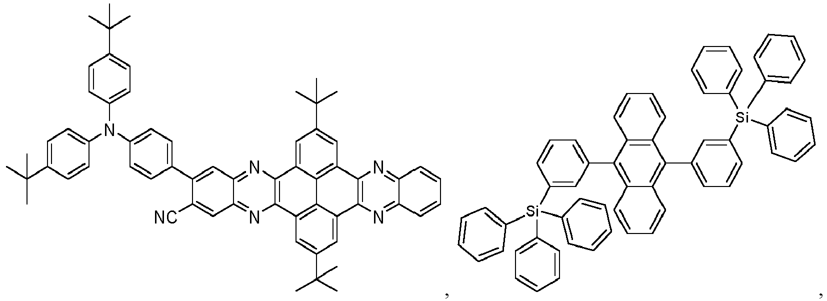 aza-substituted variants thereof, fully or partially deuterated variants thereof, and combinations thereof.

In some of the above embodiments, any carbon ring atoms up to maximum of a total number of three, together with their substituents, in each phenyl ring of any of above structures can be replaced with N.

In some embodiments, the acceptor compound comprises a fused ring system having at least five to fifteen 5-membered and/or 6-membered aromatic rings. In some embodiments, the acceptor compound has a first group and a second group with the first group not overlapping with the second group; wherein at least 80% of the singlet excited state population of the lowest singlet excitation state are localized in the first group; and wherein at least 80%, 85%, 90%, or 95% of the triplet excited state population of the lowest triplet excitation state are localized in the second group.

In some embodiments, the emissive region further comprises a first host. In some embodiments, the sensitizer compound forms an exciplex with the first host in the OLED at room temperature. In some embodiments, the first host has a LUMO energy that is lower than the LUMO energies of the sensitizer compound and the acceptor compound in the emissive region. In some embodiments, the first host has a HOMO energy that is lower than the HOMO energies of the sensitizer compound and the acceptor compound in the emissive region. In some embodiments, the first host has a HOMO energy that is higher than the HOMO energies of the sensitizer compound and the acceptor compound in the emissive region. In some embodiments, the first host has a HOMO energy that is higher than the HOMO energy of at least one of the sensitizer compound and the acceptor compound in the emissive region.

In some embodiments, the emissive region further comprises a second host. In some embodiments, the first host forms an exciplex with the second host in the OLED at room temperature. In some embodiments, the concentrations of the first and second hosts in the layer or layers containing the first and second host are greater than the concentrations of the sensitizer compound and the acceptor compound in the layer or layers containing the sensitizer compound and the acceptor compound. In some embodiments, the concentrations of the first and second hosts in the layer or layers containing the first and second host are greater than the concentrations of the acceptor compound in the layer or layers containing the sensitizer compound and the acceptor compound.

In some embodiments, the S₁ energy of the first host is greater than that of the acceptor compound. In some embodiments, T₁ energy of the first host is greater than that of the sensitizer compound. In some embodiments, the sensitizer compound has a HOMO energy that is greater than that of the acceptor compound. In some embodiments, the second host has a HOMO level that is shallower than that of the acceptor compound. In some embodiments, the HOMO level of the acceptor compound is deeper than at least one selected from the sensitizer compound and the first host.

In some embodiments, the first host and/or the second host comprises at least one chemical group selected from the group consisting of triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, triazine, boryl, silyl, aza-triphenylene, aza-carbazole, aza-indolocarbazole, aza-dibenzothiophene, aza-dibenzofuran, aza-dibenzoselenophene, aza-5λ²-benzo[d]benzo[4,5]imidazo[3,2-a]imidazole, and aza-(5,9-dioxa-13b-boranaphtho[3,2,1-de]anthracene).

In some embodiments, the sensitizer forms an exciplex with the first host in the OLED at room temperature. In some embodiments, the first host has a LUMO energy that is lower than the LUMO energies of the sensitizer compound and the acceptor compound (the second compound) in the emissive region. In some embodiments, the first host has a HOMO energy that is lower than the HOMO energies of the sensitizer compound and the acceptor compound in the emissive region. In some embodiments, the first host has a HOMO energy that is higher than the HOMO energies of the sensitizer compound and the acceptor compound in the emissive region. In some embodiments, the first host has a HOMO energy that is higher than the HOMO energy of at least one of the sensitizer and the acceptor in the emissive region.

In some embodiments, the emissive region further comprises a second host. In some embodiments, the first host forms an exciplex with the second host in the OLED at room temperature. In some embodiments, the S₁-T₁ energy gap in the exciplex formed by the first host and the second host is less than 0.4, 0.3, 0.2, or 0.1 eV. In some embodiments, the T₁ energy of exciplex is greater than 2.5, 2.6, 2.7, or 2.8 eV. In some embodiments, the concentrations of the first and second hosts in the layer or layers containing the first and second host are greater than the concentrations of the sensitizer compound and the acceptor compound in the layer or layers containing the sensitizer compound and the acceptor compound. In some embodiments, the concentrations of the first and second hosts in the layer or layers containing the first and second host are greater than the concentrations of the acceptor compound in the layer or layers containing the sensitizer compound and the acceptor compound.

In some embodiments, the S₁ energy of the first host is greater than that of the acceptor compound. In some embodiments, T₁ energy of the first host is greater than that of the sensitizer compound. In some embodiments, the sensitizer compound has a HOMO energy that is greater than that of the acceptor compound. In some embodiments, the second host has a HOMO level that is shallower than that of the acceptor compound. In some embodiments, the HOMO level of the acceptor compound is deeper than at least one selected from the sensitizer compound and the first host.

In some embodiments, the first host and/or the second host comprises at least one chemical group selected from the group consisting of triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, triazine, boryl, silyl, nitrile, aza-triphenylene, aza-carbazole, aza-indolocarbazole, aza-dibenzothiophene, aza-dibenzofuran, aza-dibenzoselenophene, aza-5λ²-benzo[d]benzo[4,5]imidazo[3,2-a]imidazole, and aza-(5,9-dioxa-13b-boranaphtho[3,2,1-de]anthracene). In some embodiments the first host and the second host are both organic compounds. In some embodiments, at least one of the first host and the second host is a metal complex.

In some embodiments, each of the first host and/or the second host is independently selected from the group consisting of: 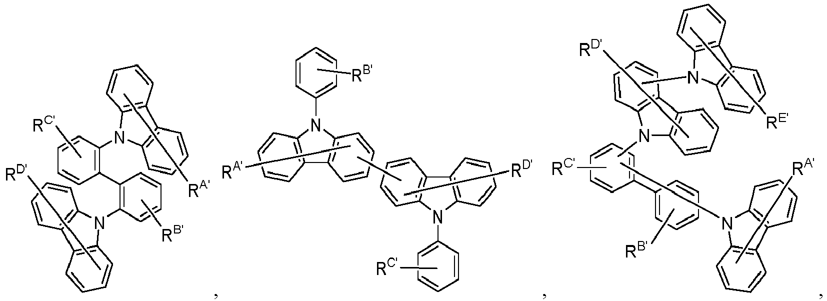 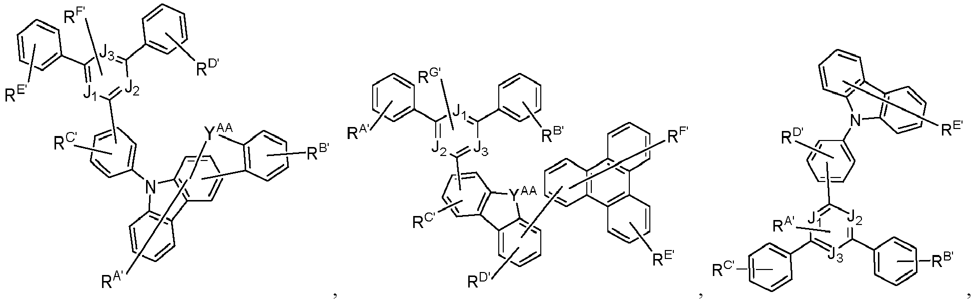 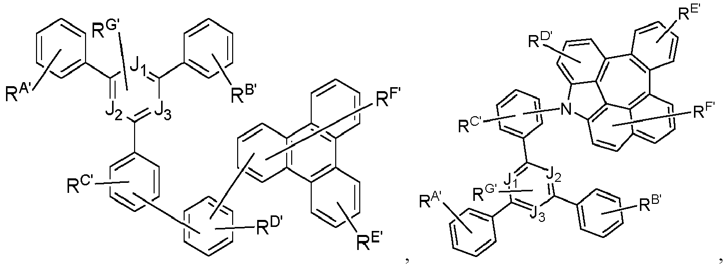 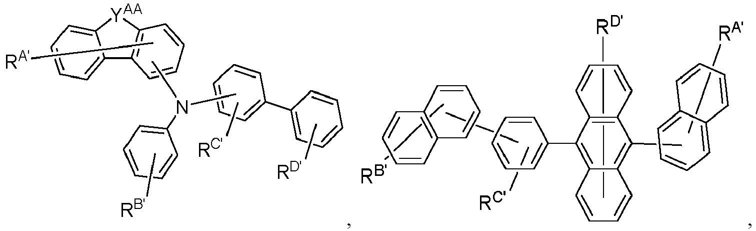 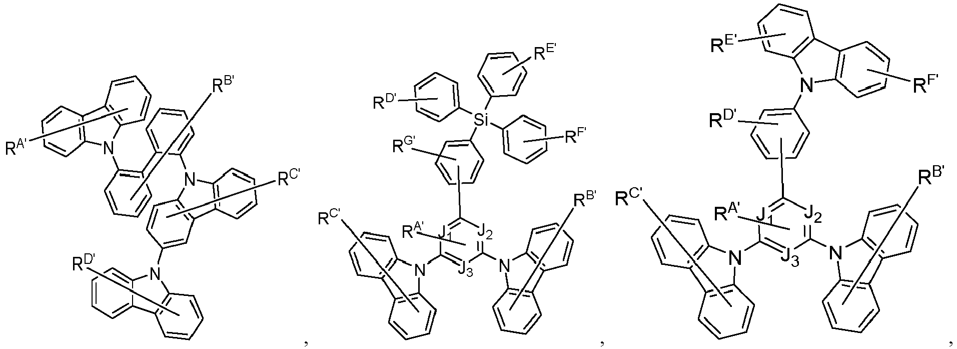 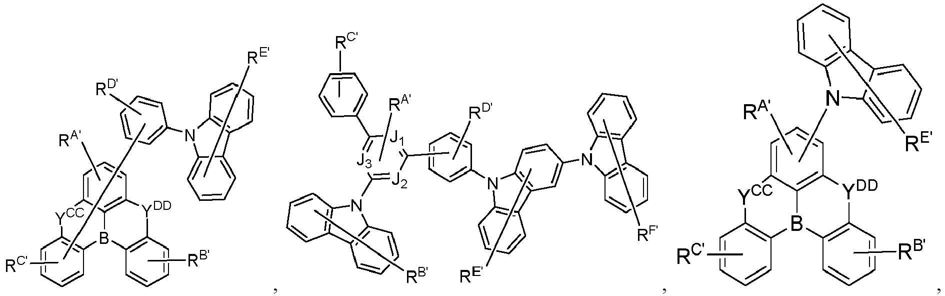 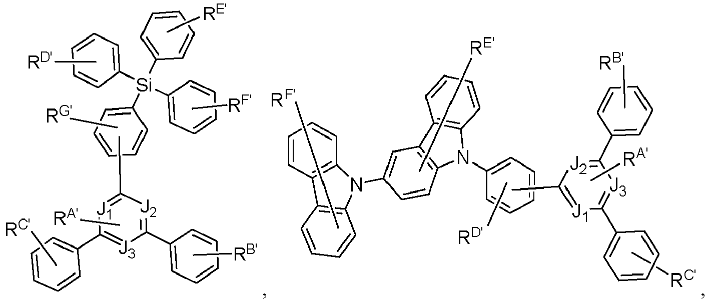 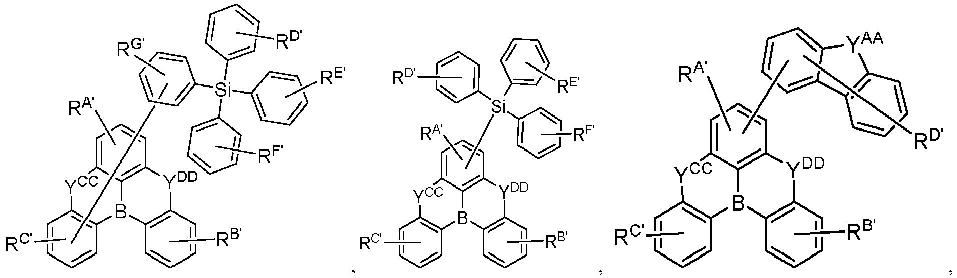 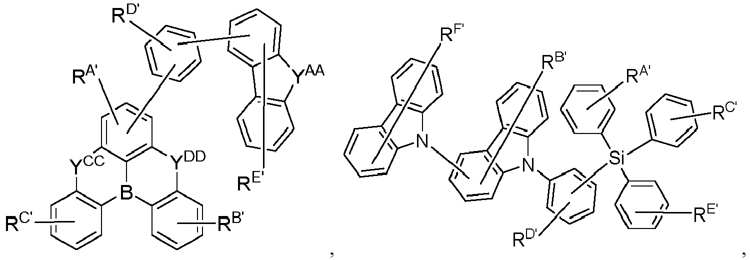 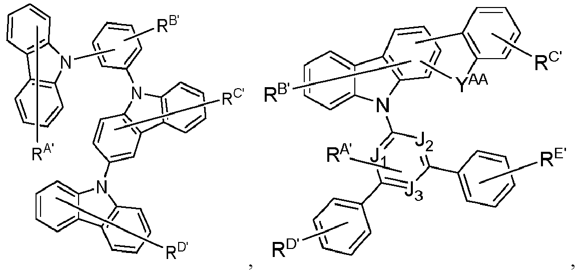 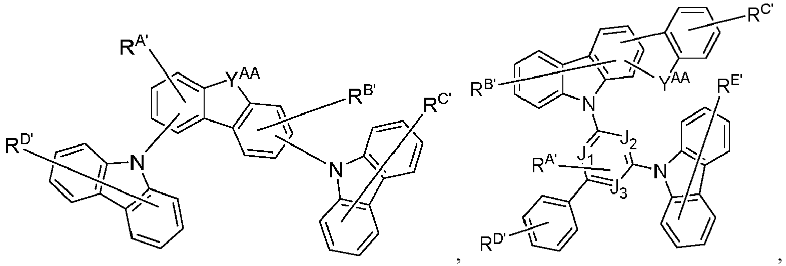 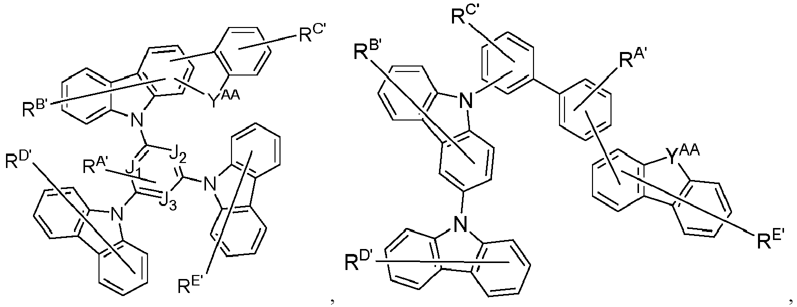 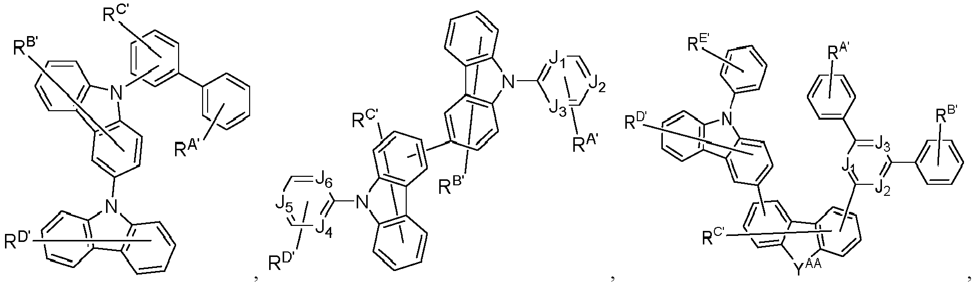 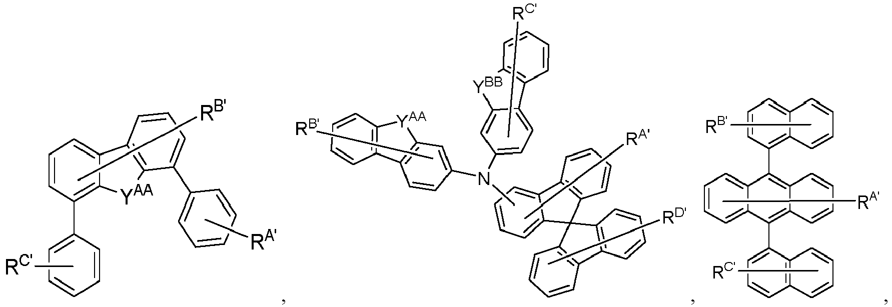 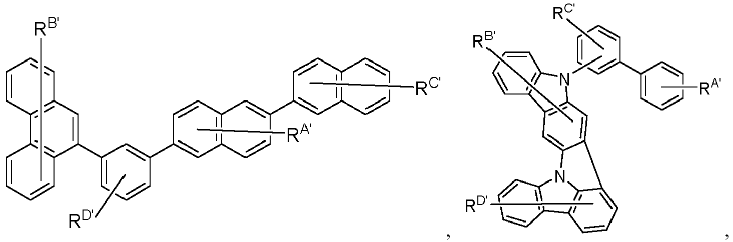 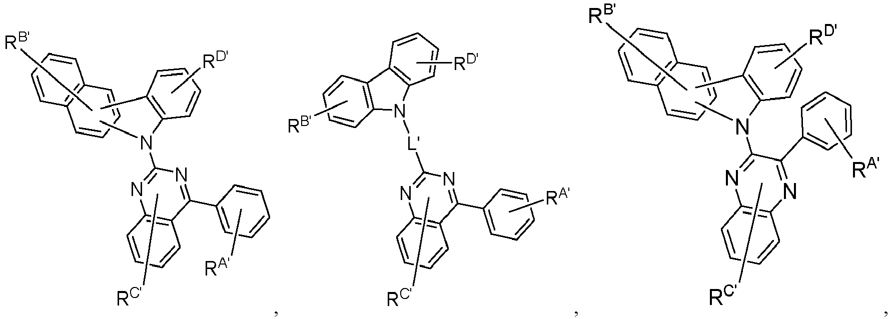 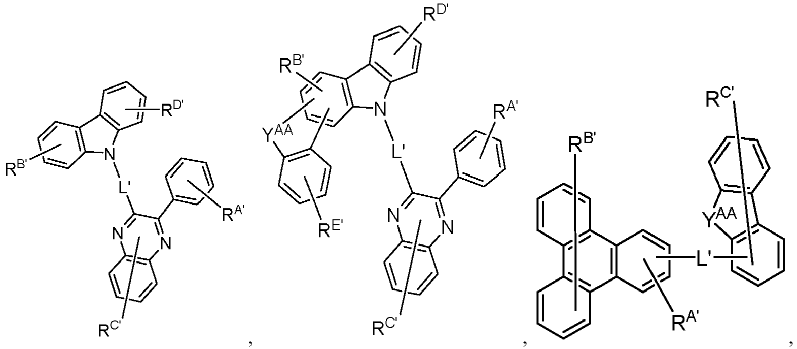 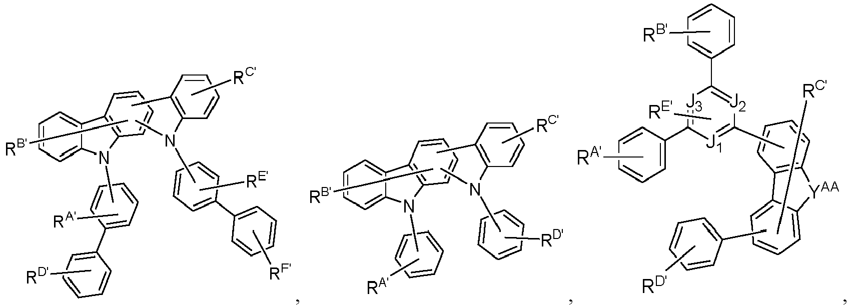 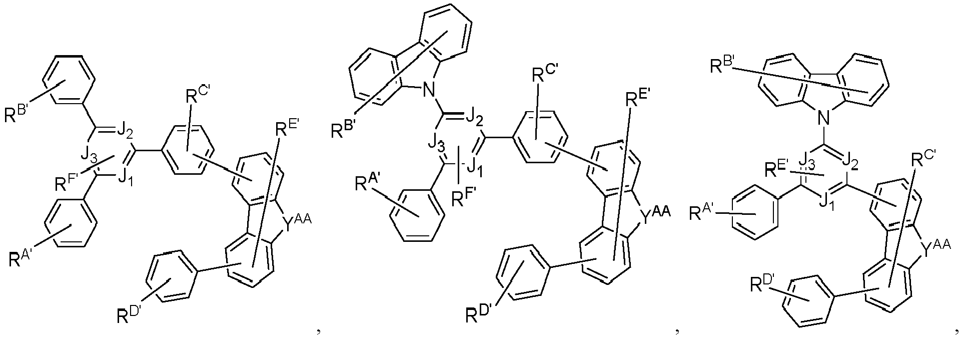 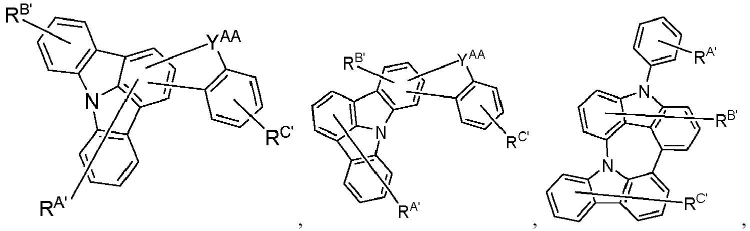 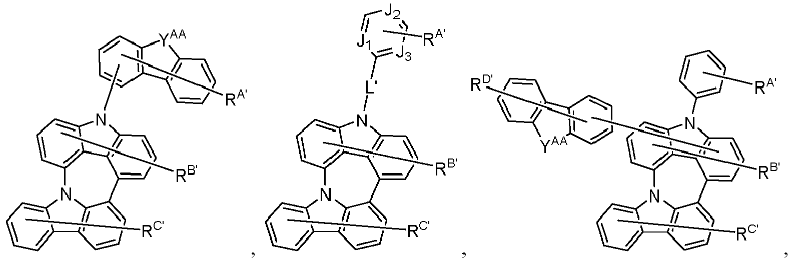 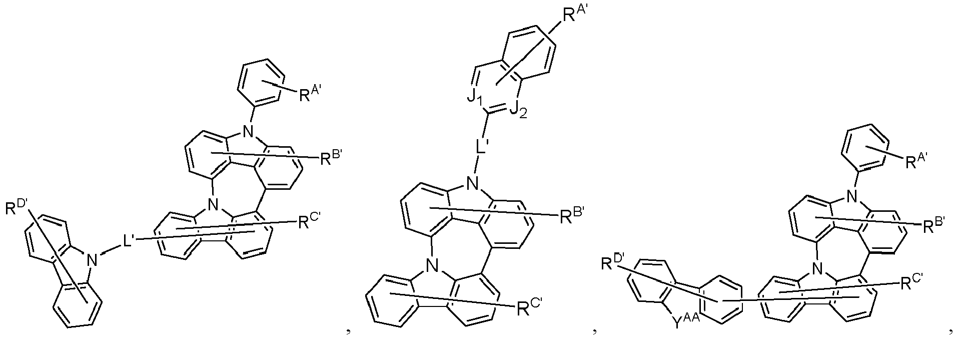 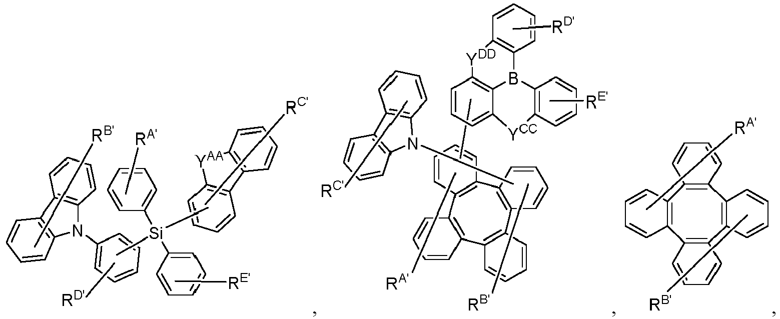 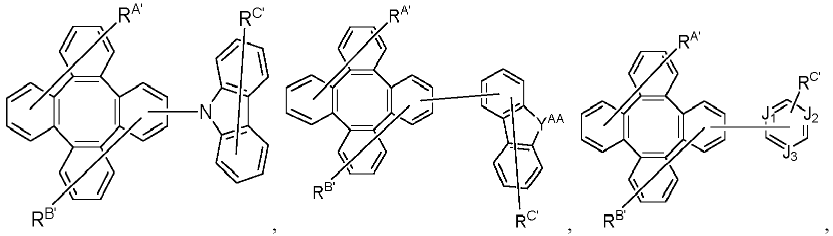 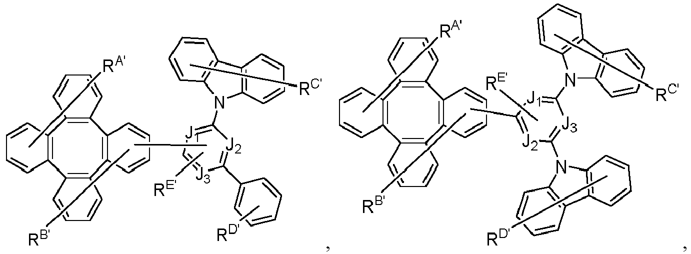 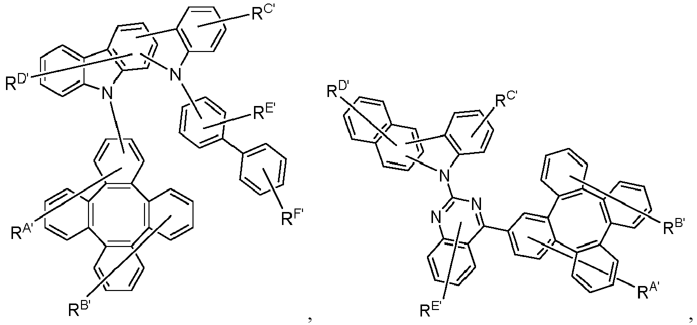 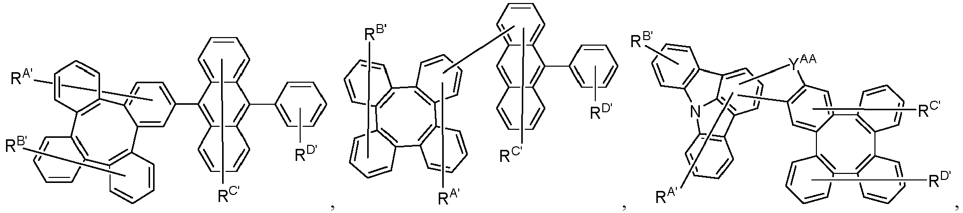 and 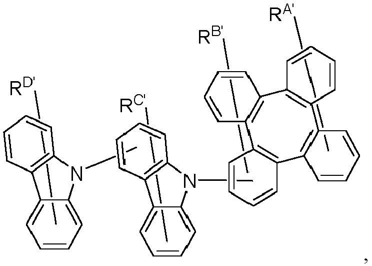 wherein:
each of J₁ to J₆ is independently C or N;
L' is a direct bond or an organic linker;
each Y^{AA}, Y^{BB}, Y^{CC}, and Y^{DD} is independently selected from the group consisting of absent a bond, direct bond, O, S, Se, CRR', SiRR', GeRR', NR, BR, BRR';
each of R^{A'}, R^{B'}, R^{C'}, R^{D'}, R^{E'}, R^{F'}, and R^{G'} independently represents mono, up to the maximum substitutions, or no substitutions;
each R, R', R^{A'}, R^{B'}, R^{C'}, R^{D'}, R^{E'}, R^{F'}, and R^{G'} is independently a hydrogen or a substituent selected from the group consisting of the general substituents as defined herein; any two substituents can be joined or fused to form a ring;
and where possible, each unsubstituted aromatic carbon atom is optionally replaced with N to form an aza-substituted ring.

In some embodiments, at least one of J₁ to J₃ is N. In some embodiments, at least two of J₁ to J₃ are N, In some embodiments, all three of J₁ to J₃ are N. In some embodiments, each Y^{CC} and Y^{DD} are preferably O, S, and SiRR', more preferably O, or S. In some embodiments, at least one unsubstituted aromatic carbon atom is replaced with N to form an aza-ring.

To reduce the amount of Dexter energy transfer between the sensitizer compound and the acceptor compound, it would be preferable to have a large distance between the center of mass of the sensitizer compound and the center of mass of the closest neighboring acceptor compound in the emissive region. Therefore, in some embodiments, the distance between the center of mass of the acceptor compound and the center of mass of the sensitizer compound is at least 2, 1.5, 1.0, or 0.75 nm.

Preferred acceptor/sensitizer VDR combination (A): In some embodiments, it is preferable for the VDR of the acceptor to be less than 0.33 in order to reduce the coupling of the transition dipole moment of the emitting acceptor to the plasmon modes, compared to an isotropic emitter, in order to achieve a higher outcoupling efficiency. In some cases, when the VDR of the acceptor is less than 0.33, it would be preferable for the VDR of the sensitizer to be less than 0.33 in order to improve the coupling of the transition dipole moments of the sensitizer and acceptor to optimize the Forster energy transfer rate. Accordingly, in some embodiments of the inventive OLED, the acceptor compound in the inventive OLED exhibits a VDR value equal to or less than 0.33, 0.30, 0.25, 0.2, 0.15, 0.10, 0.08, or 0.05 when the VDR is measured with an emissive thin film test sample that has the acceptor compound as the only emitter; and the sensitizer compound in the inventive OLED exhibits a VDR value equal to or less than 0.33, 0.30, 0.25, 0.2, 0.15, 0.10, 0.08, or 0.05 when the VDR is measured with an emissive thin film test sample that has the sensitizer compound as the only emitter.

Preferred acceptor/sensitizer VDR combination (B): In some embodiments, it is preferable for the VDR of the acceptor to be less than 0.33 in order to reduce the coupling of the transition dipole moment of the emitting acceptor to the plasmon modes compared to an isotropic emitter in order to achieve a higher outcoupling efficiency. In some cases, when the VDR of the acceptor is less than 0.33, it would be preferable to minimize the intermolecular interactions between the sensitizer and acceptor to decrease the degree of Dexter quenching. By changing the molecular geometry of the sensitizer to reduce the intermolecular interactions, it may be preferable to have a sensitizer with a VDR greater than 0.33. Accordingly, in some embodiments of the inventive OLED, the acceptor compound in the inventive OLED exhibits a VDR value equal to or less than 0.33, 0.30, 0.25, 0.2, 0.15, 0.10, 0.08, or 0.05 when the VDR is measured with an emissive thin film test sample that has the acceptor compound as the only emitter; and the sensitizer compound in the inventive OLED exhibits a VDR value larger than 0.33, 0.4, 0.5, 0.6, or 0.7 when the VDR is measured with an emissive thin film test sample that has the sensitizer compound as the only emitter.

Preferred acceptor/sensitizer VDR combination (C): In some embodiments, it is preferable for the VDR of the acceptor to be greater than 0.33 in order to increase the coupling of the transition dipole moment of the acceptor to the plasmon modes compared to an isotropic emitter in order to decrease the transient lifetime of the excited states in the emissive layer. In some cases, the increased coupling to the plasmon modes can be paired with an enhancement layer in a plasmonic OLED device to improve efficiency and extend operational lifetime. In some cases, when the VDR of the acceptor is greater than 0.33, it would be preferable to minimize the intermolecular interactions between the sensitizer and acceptor to decrease the degree of Dexter quenching. By changing the molecular geometry of the sensitizer to reduce the intermolecular interactions, it may be preferable to have a sensitizer with a VDR less than 0.33. Accordingly, in some embodiments of the inventive OLED, the acceptor compound in the inventive OLED exhibits a VDR value larger than 0.33, 0.4, 0.5, 0.6, or 0.7 when the VDR is measured with an emissive thin film test sample that has the acceptor compound as the only emitter; and the sensitizer compound in the inventive OLED exhibits a VDR value equal to or less than 0.33, 0.30, 0.25, 0.2, 0.15, 0.10, 0.08, or 0.05 when the VDR is measured with an emissive thin film test sample that has the sensitizer compound as the only emitter.

Preferred acceptor/sensitizer VDR combination (D): In some embodiments, it is preferable for the VDR of the acceptor to be greater than 0.33 in order to increase the coupling of the transition dipole moment of the acceptor to the plasmon modes compared to an isotropic emitter in order to decrease the transient lifetime of the excited states in the emissive layer. In some cases, the increased coupling to the plasmon modes can be paired with an enhancement layer in a plasmonic OLED device to improve efficiency and extend operational lifetime. In some cases, when the VDR of the acceptor is greater than 0.33, it would be preferable for the VDR of the sensitizer to be greater than 0.33 in order to improve the coupling of the transition dipole moments of the sensitizer and acceptor to optimize the Forster energy transfer rate. Accordingly, in some embodiments of the inventive OLED, the acceptor compound in the inventive OLED exhibits a VDR value larger than 0.33, 0.4, 0.5, 0.6, or 0.7 when the VDR is measured with an emissive thin film test sample that has the acceptor compound as the only emitter; and the sensitizer compound in the inventive OLED exhibits a VDR value larger than 0.33, 0.4, 0.5, 0.6, or 0.7 when the VDR is measured with an emissive thin film test sample that has the sensitizer compound as the only emitter.

VDR is the ensemble average fraction of vertically oriented molecular dipoles of the light-emitting compound in a thin film sample of an emissive layer, where the orientation "vertical" is relative to the plane of the surface of the substrate (i.e., normal to the surface of the substrate plane) on which the thin film sample is formed. A similar concept is horizontal dipole ratio (HDR) which is the ensemble average fraction of horizontally oriented molecular dipoles of the light-emitting compound in a thin film sample of an emissive layer, where the orientation "horizontal" is relative to the plane of the surface of the substrate (i.e., parallel to the surface of the substrate plane) on which the thin film sample is formed. By definition, VDR+HDR = 1. VDR can be measured by angle dependent, polarization dependent, photoluminescence measurements. By comparing the measured emission pattern of a photo-excited thin film test sample, as a function of polarization, to the computationally modeled pattern, one can determine VDR of the thin film test sample emission layer. For example, a modelled data of p-polarized emission is shown in FIG. 3. The modelled p-polarized angle photoluminescence (PL) is plotted for emitters with different VDRs. A peak in the modelled PL is observed in the p-polarized PL around the angle of 45 degrees with the peak PL being greater when the VDR of the emitter is higher.

To measure VDR values of the thin film test samples, a thin film test sample can be formed with the acceptor compound or the sensitizer compound (depending on whether the VDR of the acceptor compound or the sensitizer compound is being measured) as the only emitter in the thin film and a Reference Host Compound A as the host. Preferably, the Reference Host Compound A is 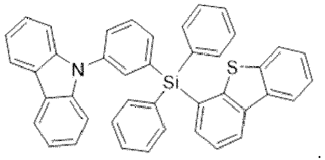 The thin film test sample is formed by thermally evaporating the emitter compound and the host compound on a substrate. For example, the emitter compound and the host compound can be co-evaporated. In some embodiments, the doping level of the emitter compounds in the host can be from 0.1 wt. % to 50 wt. %. In some embodiments, the doping level of the emitter compounds in the host can be from 3 wt. % to 20 wt. % for blue emitters. In some embodiments, the doping level of the emitter compounds in the host can be from 1 wt. % to 15 wt. % for red and green emitters. The thickness of the thermally evaporated thin film test sample can have a thickness of from 50 to 1000 Å.

In some embodiments, the OLED of the present disclosure can comprise a sensitizer, an acceptor, and one or more hosts in the emissive region, and the preferred acceptor/sensitizer VDR combinations (A) - (D) mentioned above are still applicable. In these embodiments, the VDR values for the acceptor compound can be measured with a thin film test sample formed of the one or more hosts and the acceptor, where the acceptor is the only emitter in the thin film test sample. Similarly, the VDR values for the sensitizer compound can be measured with a thin film test sample formed of the one or more hosts and the sensitizer, where the sensitizer is the only emitter in the thin film test sample.

In the example used to generate FIG. 3, a 30 nm thick film of material with a refractive index of 1.75 and the emission is monitored in a semi-infinite medium with a refractive index of 1.75. Each curve is normalized to a photoluminescence intensity of 1 at an angle of zero degrees, which is perpendicular to the surface of the film. As the VDR of the emitter is varied, the peak around 45 degrees increases greatly. When using a software to fit the VDR of experimental data, the modeled VDR would be varied until the difference between the modeled data and the experimental data is minimized.

Because the VDR represents the average dipole orientation of the light-emitting compound in the thin film sample, even if there are additional emission capable compounds in the emissive layer, if they are not contributing to the light emission, the VDR measurement does not reflect their VDR. Further, by inclusion of a host material that interacts with the light-emitting compound, the VDR of the light-emitting compound can be modified. Thus, a light-emitting compound in a thin film sample with host material A will exhibit one measured VDR value and that same light-emitting compound in a thin film sample with host material B will exhibit a different measured VDR value. Further, in some embodiments, exciplex or excimers are desirable which form emissive states between two neighboring molecules. These emissive states may have a VDR that is different than that if only one of the components of the exciplex or excimer were emitting or present in the sample.

In some embodiments, the OLED is a plasmonic OLED. In some embodiments, the OLED is a wave-guided OLED.

In some embodiments, the emissive region can further include a second host. In some embodiments, the second host comprises a moiety selected from the group consisting of bicarbazole, indolocarbazole, triazine, pyrimidine, pyridine, and boryl. In some embodiments, the second host has a HOMO level that is shallower than that of the acceptor compound.

In some embodiments, the OLED emits a white light at room temperature when a voltage is applied across the device.

In some embodiments, the OLED emits a luminescent radiation at room temperature when a voltage is applied across the device; wherein the luminescent first radiation component contributed from the acceptor compound with an emission λₘₐₓ₁ being independently selected from the group consisting of larger than 340 nm to equal or less than 500 nm, larger than 500 nm to equal or less than 600 nm, and larger than 600 nm to equal or less than 900 nm. In some embodiments, the first radiation component has FWHM of 50, 40, 35, 30, 25, 20, 15, 10, or 5 nm or less. In some embodiments, the first radiation component has a 10% onset of the emission peak is less than 465, 460, 455, or 450 nm.

In some embodiments, the sensitizer compound is partially or fully deuterated. In some embodiments, the acceptor compound is partially or fully deuterated. In some embodiments, the first host is partially or fully deuterated. In some embodiments, the second host is partially or fully deuterated.

In some embodiments, compound S1 and/or compound A1 each independently comprises at least one substituent having a spherocity greater than or equal to 0.45, 0.55, 0.65, 0.75, or 0.80. The spherocity is a measurement of the three-dimensionality of bulky groups. Spherocity is defined as the ratio between the principal moments of inertia (PMI). Specifically, spherocity is the ratio of three times PMI1 over the sum of PMI1, PMI2, and PMI3, where PMI1 is the smallest principal moment of inertia, PMI2 is the second smallest principal moment of inertia, and PMI3 is the largest principal moment of inertia. The spherocity of the lowest energy conformer of a structure after optimization of the ground state with density functional theory may be calculated. More detailed information can be found in paragraphs [0054] to [0059] of US application No. 18/062,110 filed December 6, 2022, the contents of which are incorporated herein by reference. In some embodiments, compound S1 and/or compound A1 each independently comprises at least one substituent having a Van der Waals volume greater than 153, 206, 259, 290, or 329 Å³. In some embodiments, compound S1 and/or compound A1 each independently comprises at least one substituent having a molecular weight greater than 167, 187, 259, 303, or 305 amu.

In some embodiments, one of the first and second hosts is a hole transporting host, the other one of the first and second host is an electron transporting host. In some embodiments, the first host is a hole transporting host; and wherein the first host comprises at least one chemical group selected from the group consisting of amino, carbazole, indolocarbazole, dibenzothiophene, dibenzofuran, dibenzoselenophene, and 5λ²-benzo[d]benzo[4,5]imidazo[3,2-a]imidazole. In some embodiments, the first host is an electron transporting host; and wherein the first host comprises at least one chemical group selected from the group consisting of pyridine, pyrimidine, pyrazine, pyridazine, triazine, imidazole, aza-triphenylene, aza-carbazole, aza-dibenzothiophene, aza-dibenzofuran, aza-dibenzoselenophene, 5,9-dioxa-13b-boranaphtho[3,2,1-de]anthracene, boryl, aza-5λ²-benzo[d]benzo[4,5]imidazo[3,2-a]imidazole, and aza-(5,9-dioxa-13b-boranaphtho[3,2,1-de]anthracene). In some embodiments, one of the first and second hosts is a bipolar host comprising both hole transporting and electron transporting moieties.

In some embodiments, the OLED further comprises a color conversion layer or a color filter.

In some embodiments, a formulation can comprises at least two different compounds of the following compounds: a sensitizer compound, an acceptor compound and a host.

In some embodiments, a chemical structure selected from the group consisting of a monomer, a polymer, a macromolecule, and a supramolecule, wherein the chemical structure comprises at least two of the following components: a sensitizer compound, an acceptor compound and a host.

In some embodiments, a premixed co-evaporation source that is a mixture of a first compound and a second compound; wherein the co-evaporation source is a co-evaporation source for vacuum deposition process or OVJP process; wherein the first compound and the second compound are differently selected from the group 1 consisting of: a sensitizer compound, an acceptor compound, a first host compound; and a second host compound; wherein the first compound has an evaporation temperature T1 of 150 to 350 °C; wherein the second compound has an evaporation temperature T2 of 150 to 350 °C; wherein absolute value of T1-T2 is less than 20 °C; wherein the first compound has a concentration C1 in said mixture and a concentration C2 in a test film formed by evaporating the mixture in a vacuum deposition tool at a constant pressure between 1×10⁻⁶ Torr to 1×10⁻⁹ Torr, at a 2Å/sec deposition rate on a surface positioned at a predefined distance away from the mixture being evaporated; and wherein the absolute value of (C1-C2)/C1 is less than 5%. In some embodiments, the mixture further comprises a third compound; wherein the third compound is different from the first and the second compound, and is selected from the same group 1; wherein the third compound has an evaporation temperature T3 of 150 to 350 °C, and wherein absolute value of T1-T3 is less than 20 °C.

In some embodiments, the first compound has evaporation temperature T1 of 200 to 350 °C and the second compound has evaporation temperature T2 of 200 to 350 °C. In some embodiments, the absolute value of (C₁-C₂)/C₁ is less than 3%. In some embodiments, the first compound has a vapor pressure of P₁ at T1 at 1 atm, and the second compound has a vapor pressure of P₂ at T2 at 1 atm; and wherein the ratio of P₁/P₂ is within the range of 0.90:1 to 1.10:1. In some embodiments, the first compound has a first mass loss rate and the second compound has a second mass loss rate, wherein the ratio between the first mass loss rate and the second mass loss rate is within the range of 0.90:1 to 1.10:1, 0.95:1 to 1.05:1, or 0.97:1 to 1.03:1. In some embodiments, the first compound and the second compound each has a purity in excess of 99 % as determined by high pressure liquid chromatography. In some embodiments, the composition is in liquid form at a temperature less than the lesser of T1 and T2.

In some embodiments, a method for fabricating an organic light emitting device can comprises: providing a substrate having a first electrode disposed thereon; depositing a first organic layer over the first electrode by evaporating a pre-mixed co-evaporation source that is a mixture of a first compound and a second compound described above in a high vacuum deposition tool with a chamber base pressure between 1×10⁻⁶ Torr to 1×10⁻⁹ Torr; and depositing a second electrode over the first organic layer.

It should be understood that embodiments of all the compounds and devices described herein may be interchangeable if those embodiments are also applicable under different aspects of the entire disclosure.

In some embodiments, each of the sensitizer compound S1, the acceptor compound A1, the host compound H1, described herein can be at least 10% deuterated, at least 20% deuterated, at least 30% deuterated, at least 40% deuterated, at least 50% deuterated, at least 60% deuterated, at least 70% deuterated, at least 80% deuterated, at least 90% deuterated, at least 95% deuterated, at least 99% deuterated, or 100% deuterated. As used herein, percent deuteration has its ordinary meaning and includes the percent of possible hydrogen atoms (e.g., positions that are hydrogen or deuterium) that are replaced by deuterium atoms.

### C. Other Aspects of the OLEDs of the Present Disclosure

In some embodiments, the OLED may further comprise an additional host, wherein the additional host comprises a triphenylene containing benzo-fused thiophene or benzo-fused furan, wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡CCₙH₂ₙ₊₁, Ar₁, Ar₁-Ar₂, CₙH₂ₙ-Ar₁, or no substitution, wherein n is an integer from 1 to 10; and wherein Ar₁ and Ar₂ are independently selected from the group consisting of benzene, biphenyl, naphthalene, triphenylene, carbazole, and heteroaromatic analogs thereof.

In some embodiments, the additional host comprises at least one chemical group selected from the group consisting of triphenylene, carbazole, indolocarbazole, dibenzothiophene, dibenzofuran, dibenzoselenophene, 5λ2-benzo[d]benzo[4,5]imidazo[3,2-a]imidazole, 5,9-dioxa-13b-boranaphtho[3,2,1-de]anthracene, triazine, boryl, silyl, aza-triphenylene, aza-carbazole, aza-indolocarbazole, aza-dibenzothiophene, aza-dibenzofuran, aza-dibenzoselenophene, aza-5λ2-benzo[d]benzo[4,5]imidazo[3,2-a]imidazole, and aza-(5,9-dioxa-13b-boranaphtho[3,2,1-de]anthracene).

In some embodiments, the additional host may be selected from the group consisting of: 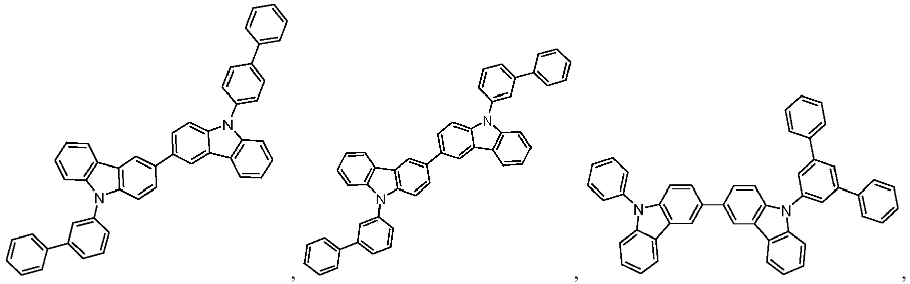 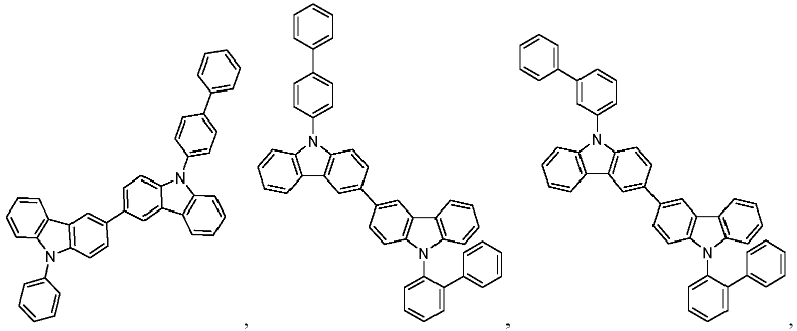 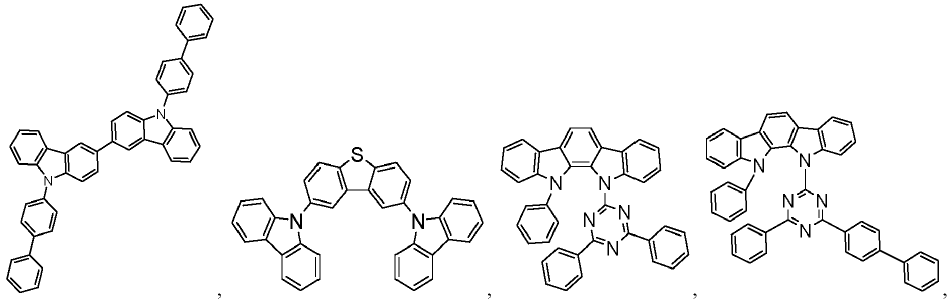 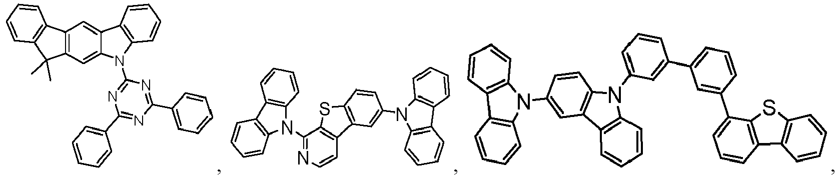 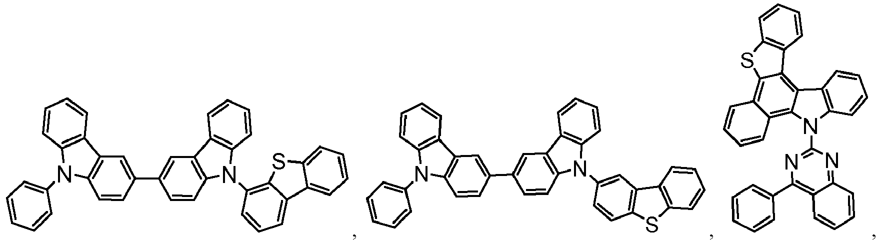 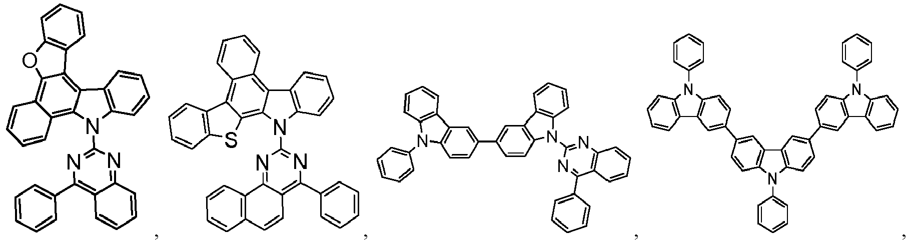 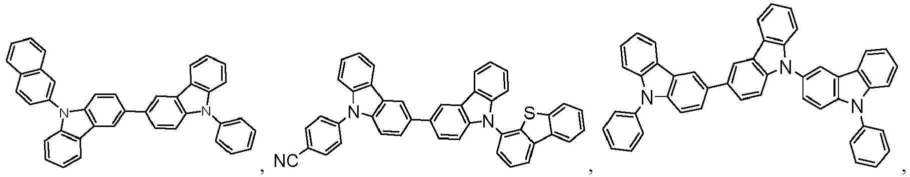 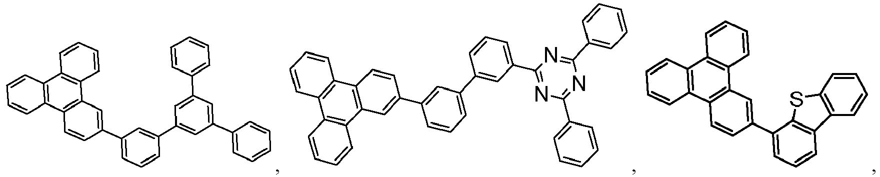 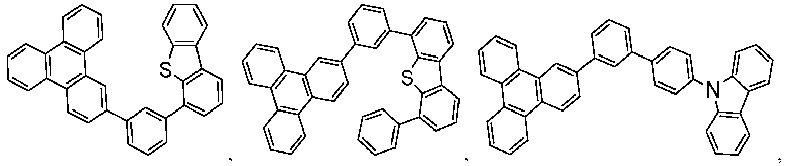 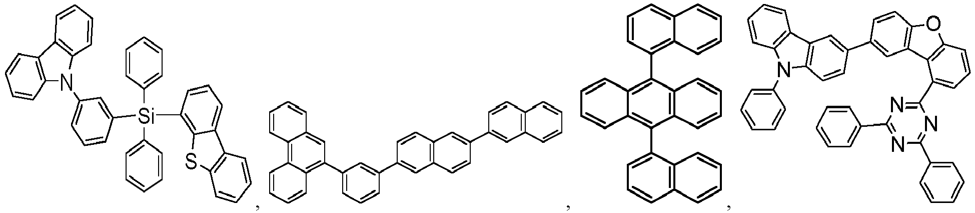 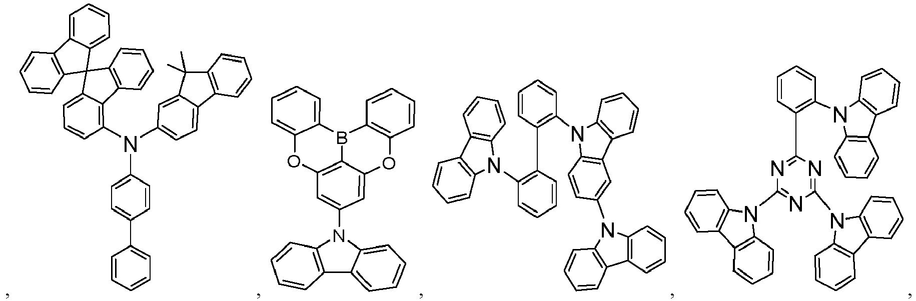 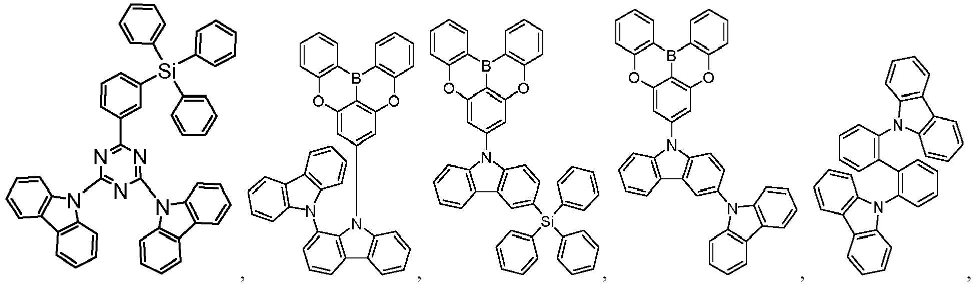 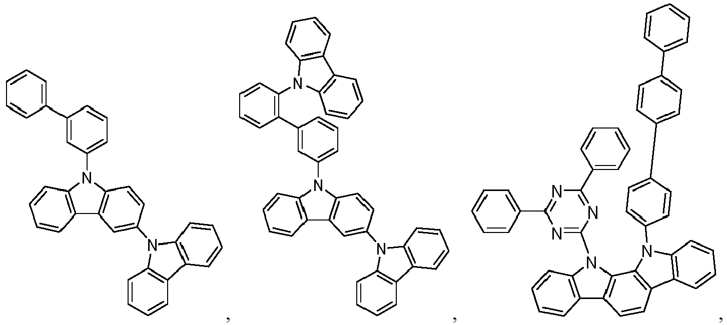 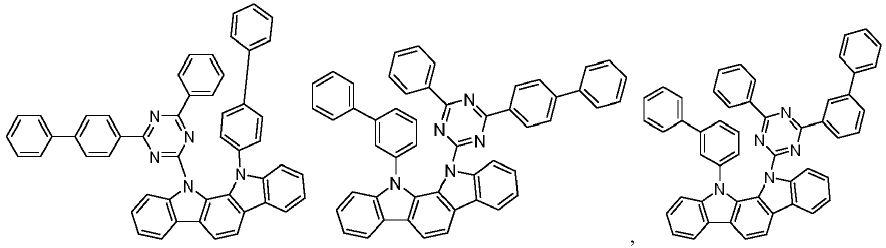 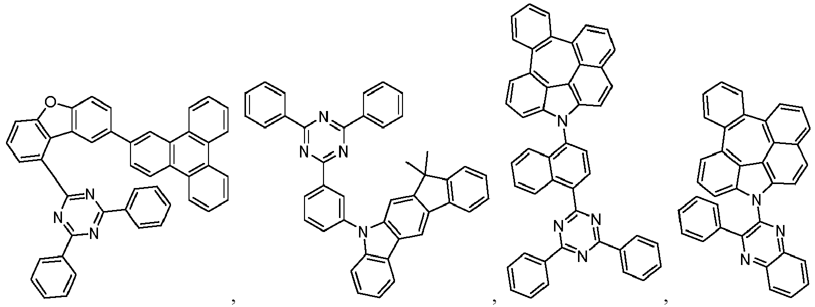 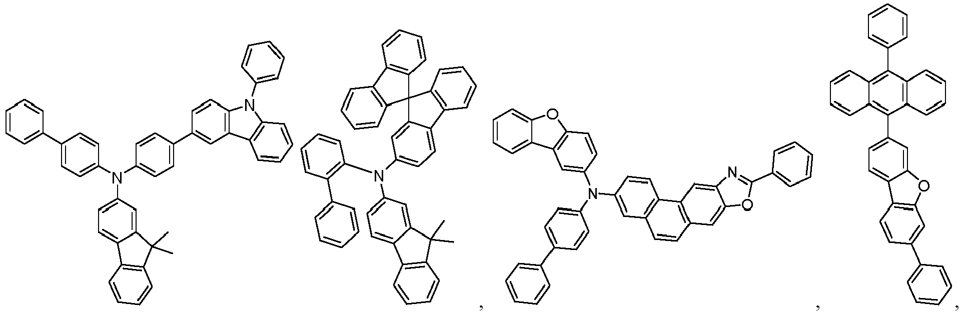 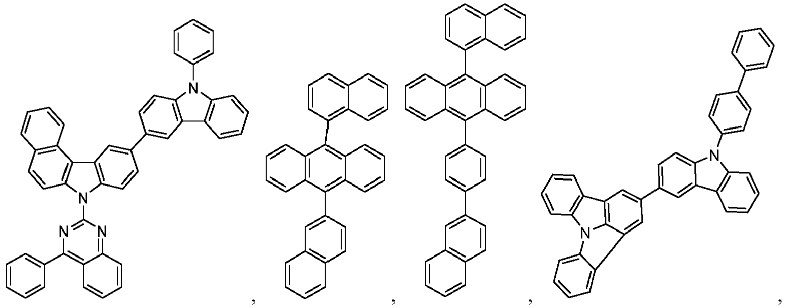 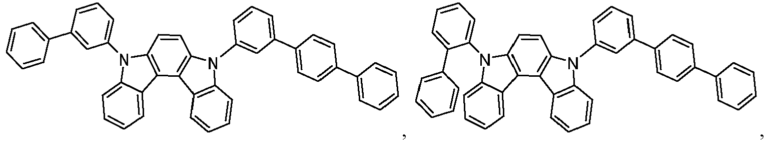 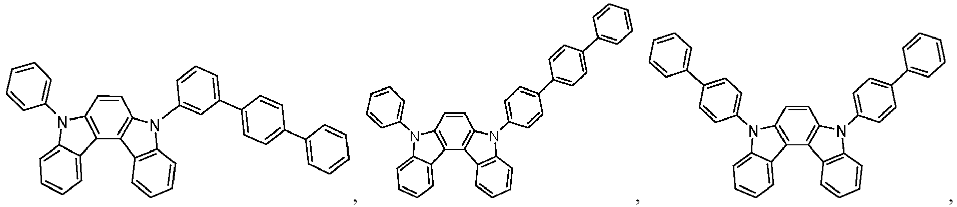 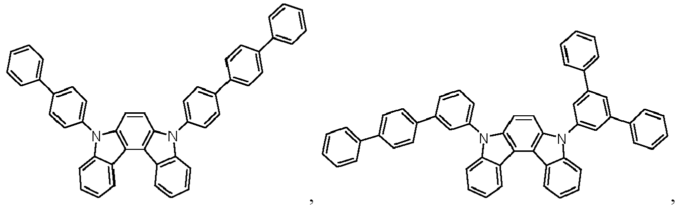 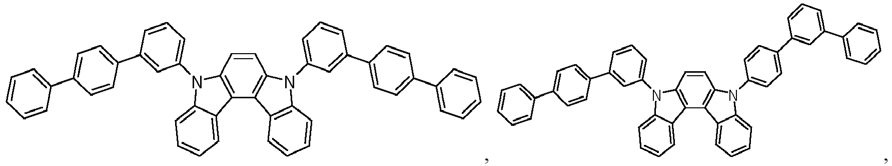 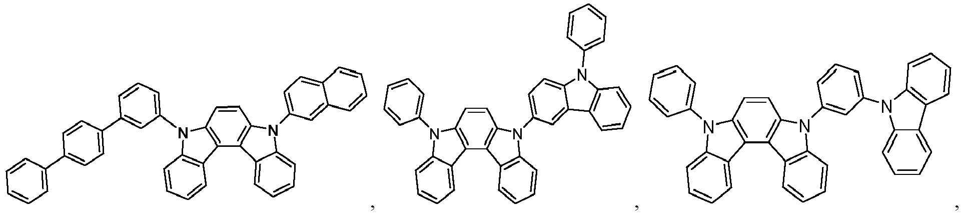 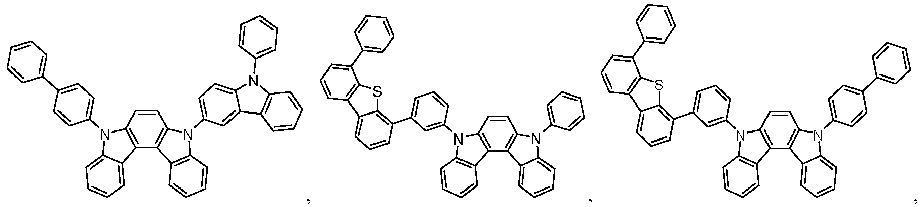 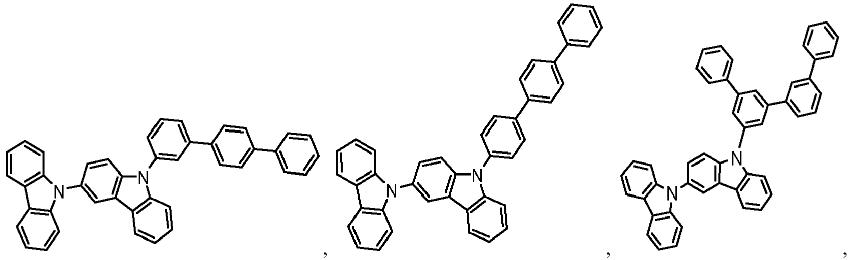 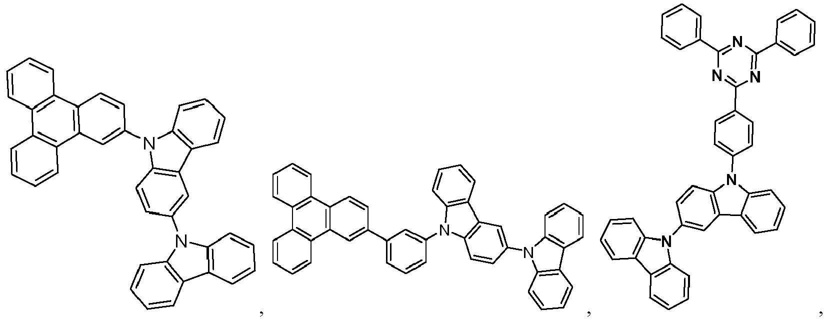 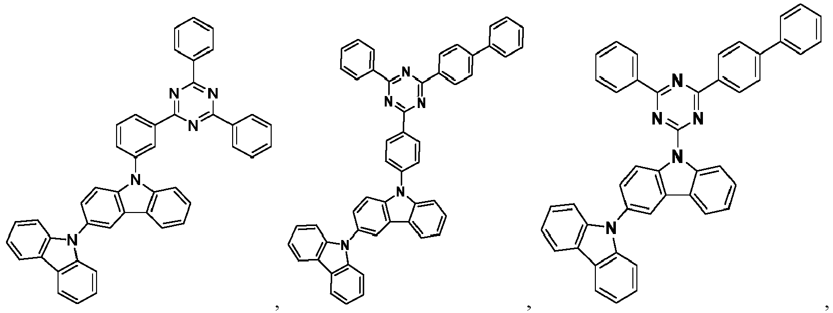 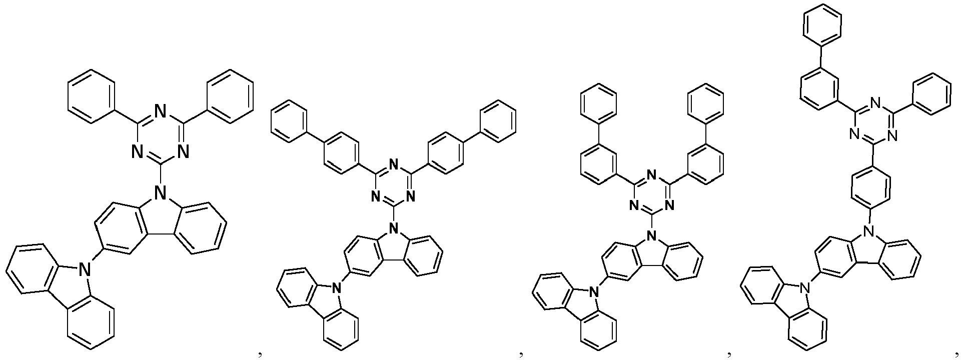 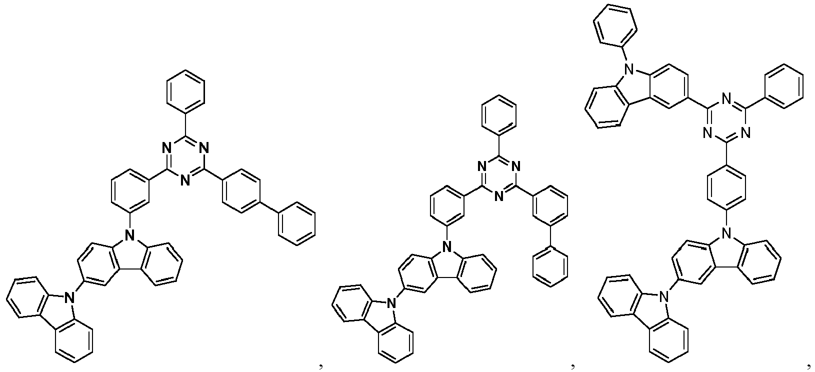 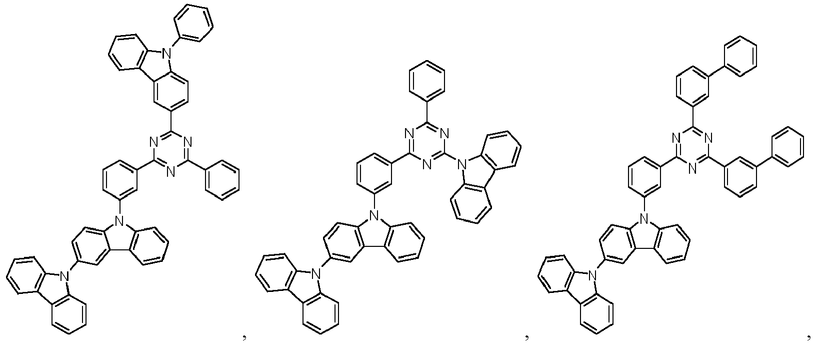 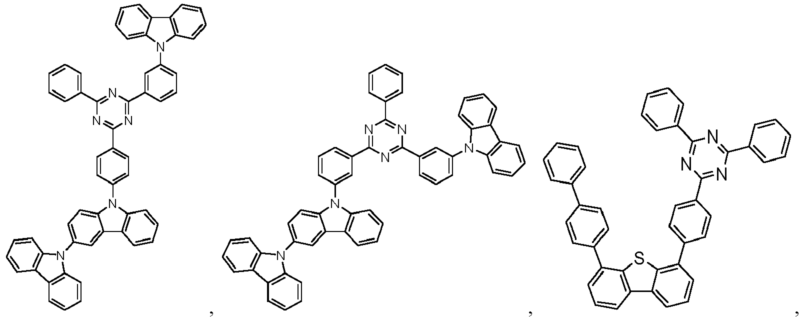 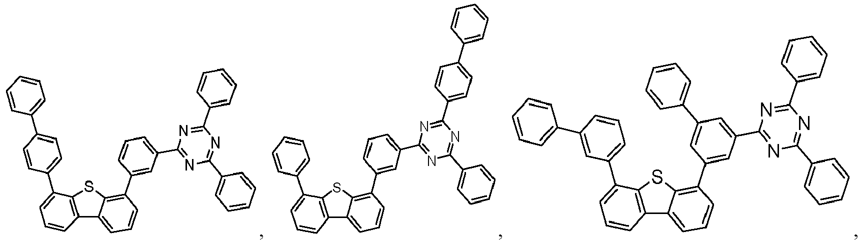 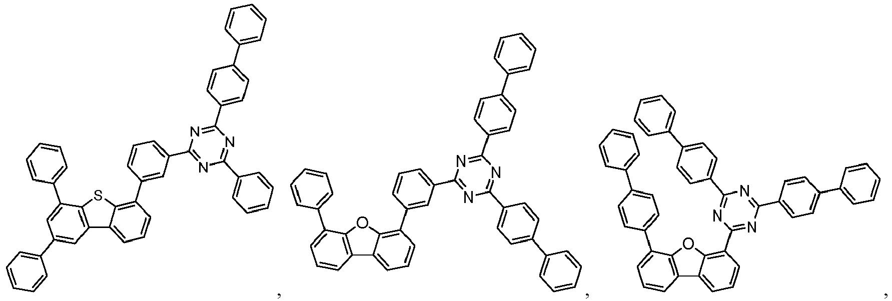 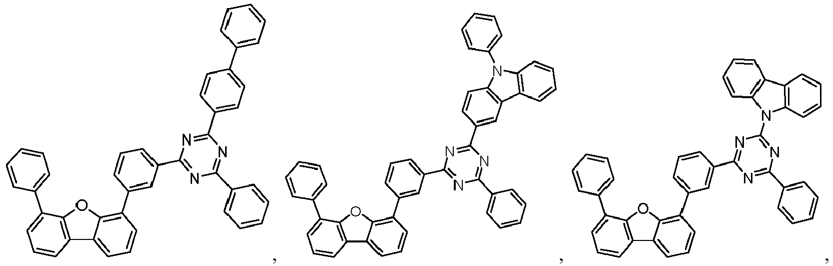 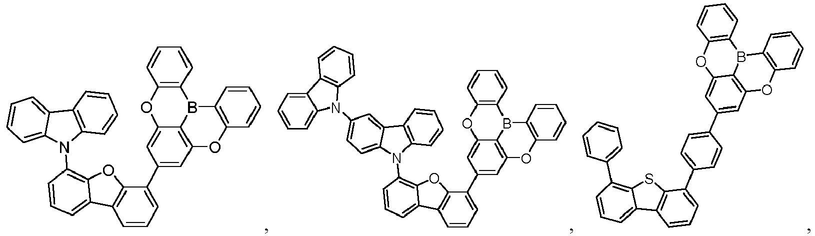 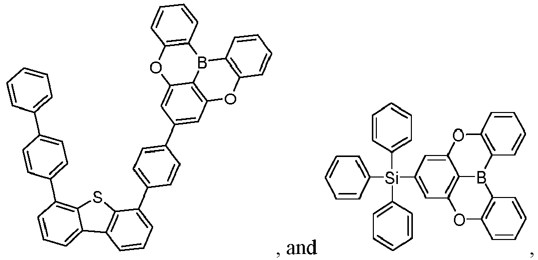 aza-substituted variants thereof, fully or partially deuterated variants thereof, and combinations thereof.

In some embodiments, the additional host comprises a metal complex.

In yet another aspect, the OLED of the present disclosure may also comprise an emissive region containing a formulation as disclosed in the above compounds section of the present disclosure.

In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. The enhancement layer is provided no more than a threshold distance away from the organic emissive layer, wherein the emitter material has a total non-radiative decay rate constant and a total radiative decay rate constant due to the presence of the enhancement layer and the threshold distance is where the total non-radiative decay rate constant is equal to the total radiative decay rate constant. In some embodiments, the OLED further comprises an outcoupling layer. In some embodiments, the outcoupling layer is disposed over the enhancement layer on the opposite side of the organic emissive layer. In some embodiments, the outcoupling layer is disposed on opposite side of the emissive layer from the enhancement layer but still outcouples energy from the surface plasmon mode of the enhancement layer. The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. If energy is scattered to the non-free space mode of the OLED other outcoupling schemes could be incorporated to extract that energy to free space. In some embodiments, one or more intervening layer can be disposed between the enhancement layer and the outcoupling layer. The examples for intervening layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line-shape, a change in emission intensity with angle, a change in the stability of the emitter material, a change in the efficiency of the OLED, and reduced efficiency roll-off of the OLED device. Placement of the enhancement layer on the cathode side, anode side, or on both sides results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

The enhancement layer can be comprised of plasmonic materials, optically active metamaterials, or hyperbolic metamaterials. As used herein, a plasmonic material is a material in which the real part of the dielectric constant crosses zero in the visible or ultraviolet region of the electromagnetic spectrum. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, Ca alloys or mixtures of these materials, and stacks of these materials. In general, a metamaterial is a medium composed of different materials where the medium as a whole acts differently than the sum of its material parts. In particular, we define optically active metamaterials as materials which have both negative permittivity and negative permeability. Hyperbolic metamaterials, on the other hand, are anisotropic media in which the permittivity or permeability are of different sign for different spatial directions. Optically active metamaterials and hyperbolic metamaterials are strictly distinguished from many other photonic structures such as Distributed Bragg Reflectors ("DBRs") in that the medium should appear uniform in the direction of propagation on the length scale of the wavelength of light. Using terminology that one skilled in the art can understand: the dielectric constant of the metamaterials in the direction of propagation can be described with the effective medium approximation. Plasmonic materials and metamaterials provide methods for controlling the propagation of light that can enhance OLED performance in a number of ways.

In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly. In some embodiments, the wavelength-sized features and the sub-wavelength-sized features have sharp edges.

In some embodiments, the outcoupling layer has wavelength-sized features that are arranged periodically, quasi-periodically, or randomly, or sub-wavelength-sized features that are arranged periodically, quasi-periodically, or randomly. In some embodiments, the outcoupling layer may be composed of a plurality of nanoparticles and in other embodiments the outcoupling layer is composed of a plurality of nanoparticles disposed over a material. In these embodiments the outcoupling may be tunable by at least one of varying a size of the plurality of nanoparticles, varying a shape of the plurality of nanoparticles, changing a material of the plurality of nanoparticles, adjusting a thickness of the material, changing the refractive index of the material or an additional layer disposed on the plurality of nanoparticles, varying a thickness of the enhancement layer, and/or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, Ca, alloys or mixtures of these materials, and stacks of these materials. The plurality of nanoparticles may have additional layer disposed over them. In some embodiments, the polarization of the emission can be tuned using the outcoupling layer. Varying the dimensionality and periodicity of the outcoupling layer can select a type of polarization that is preferentially outcoupled to air. In some embodiments the outcoupling layer also acts as an electrode of the device.

In yet another aspect, the present disclosure also provides a consumer product comprising an organic light-emitting device (OLED) having an anode; a cathode; and an organic layer disposed between the anode and the cathode, wherein the organic layer may comprise a compound as disclosed in the above compounds section of the present disclosure.

In some embodiments, the consumer product comprises an OLED having an anode; a cathode; and an organic layer disposed between the anode and the cathode, wherein the organic layer may comprise a formulation as described herein.

In some embodiments, the consumer product can be one of a flat panel display, a computer monitor, a medical monitor, a television, a billboard, a light for interior or exterior illumination and/or signaling, a heads-up display, a fully or partially transparent display, a flexible display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video wall comprising multiple displays tiled together, a theater or stadium screen, a light therapy device, and a sign.

Generally, an OLED comprises at least one organic layer disposed between and electrically connected to an anode and a cathode. When a current is applied, the anode injects holes, and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

Several OLED materials and configurations are described in U.S. Pat. Nos. 5,844,363, 6,303,238, and 5,707,745, which are incorporated herein by reference in their entirety.

The initial OLEDs used emissive molecules that emitted light from their singlet states ("fluorescence") as disclosed, for example, in U.S. Pat. No. 4,769,292, which is incorporated by reference in its entirety. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"), are incorporated by reference in their entireties. Phosphorescence is described in more detail in U.S. Pat. No. 7,279,704 at cols. 5-6, which are incorporated by reference.

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with F₄-TCNQ at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. A description of protective layers may be found in U.S. Patent Application Publication No. 2004/0174116, which is incorporated by reference in its entirety.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the present disclosure may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

Devices fabricated in accordance with embodiments of the present disclosure may
further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the present disclosure can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the present disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include flat panel displays, curved displays, computer monitors, medical monitors, televisions, billboards, lights for interior or exterior illumination and/or signaling, heads-up displays, fully or partially transparent displays, flexible displays, rollable displays, foldable displays, stretchable displays, laser printers, telephones, mobile phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theater or stadium screen, a light therapy device, and a sign. Various control mechanisms may be used to control devices fabricated in accordance with the present disclosure, including passive matrix and active matrix. Many of the devices are intended for use in a temperature range comfortable to humans, such as 18 degrees C. to 30 degrees C., and more preferably at room temperature (20-25 °C), but could be used outside this temperature range, for example, from -40 degree C to + 80 °C.

More details on OLEDs, and the definitions described above, can be found in U.S. Pat. No. 7,279,704, which is incorporated herein by reference in its entirety.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes.

In some embodiments, the OLED further comprises a layer comprising a delayed fluorescent emitter. In some embodiments, the OLED comprises a RGB pixel arrangement or white plus color filter pixel arrangement. In some embodiments, the OLED is a mobile device, a hand held device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

According to another aspect, a formulation comprising the compounds described herein is also disclosed.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

In yet another aspect of the present disclosure, a formulation that comprises the novel compound disclosed herein is described. The formulation can include one or more components selected from the group consisting of a solvent, a host, a hole injection material, hole transport material, electron blocking material, hole blocking material, and an electron transport material, disclosed herein.

The present disclosure encompasses any chemical structure comprising the novel compound of the present disclosure, or a monovalent or polyvalent variant thereof. In other words, the inventive compound, or a monovalent or polyvalent variant thereof, can be a part of a larger chemical structure. Such chemical structure can be selected from the group consisting of a monomer, a polymer, a macromolecule, and a supramolecule (also known as supermolecule). As used herein, a "monovalent variant of a compound" refers to a moiety that is identical to the compound except that one hydrogen has been removed and replaced with a bond to the rest of the chemical structure. As used herein, a "polyvalent variant of a compound" refers to a moiety that is identical to the compound except that more than one hydrogen has been removed and replaced with a bond or bonds to the rest of the chemical structure. In the instance of a supramolecule, the inventive compound can also be incorporated into the supramolecule complex without covalent bonds.

### F. Combination of the Compounds of the Present Disclosure with Other Materials

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

### a) Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

Non-limiting examples of the conductivity dopants that may be used in an OLED in combination with materials disclosed herein are exemplified below together with references that disclose those materials: EP01617493, EP01968131, EP2020694, EP2684932, US20050139810, US20070160905, US20090167167, US2010288362, WO06081780, WO2009003455, WO2009008277, WO2009011327, WO2014009310, US2007252140, US2015060804, US20150123047, and US2012146012.

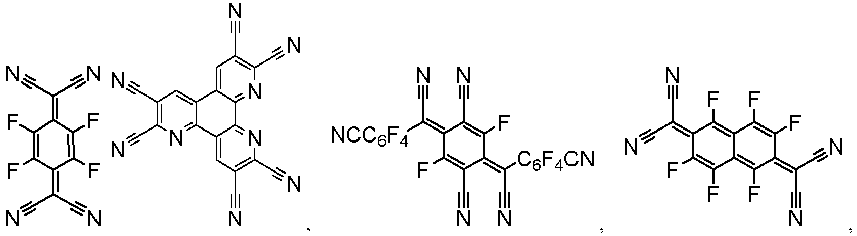

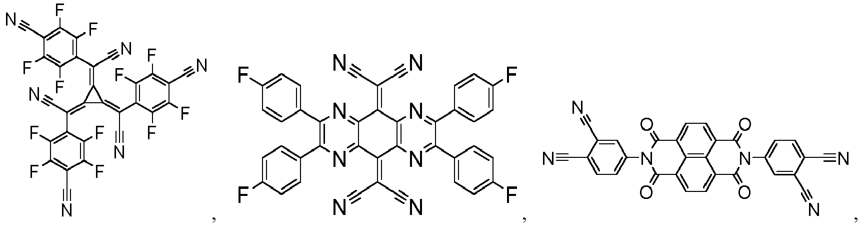

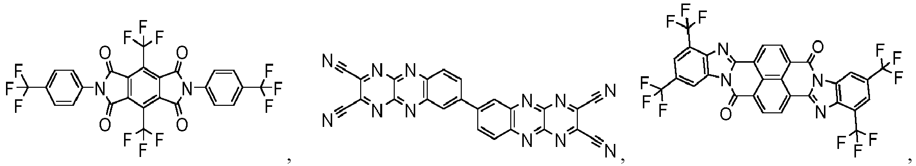

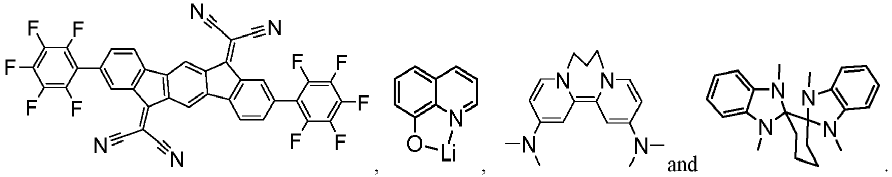

### b) HIL/HTL:

A hole injecting/transporting material to be used in the present disclosure is not particularly limited, and any compound may be used as long as the compound is typically used as a hole injecting/transporting material. Examples of the material include, but are not limited to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

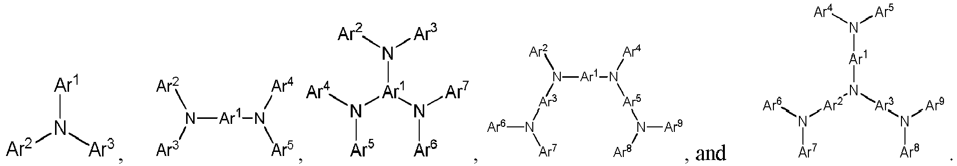

Each of Ar¹ to Ar⁹ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each Ar may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, Ar¹ to Ar⁹ is independently selected from the group consisting of: 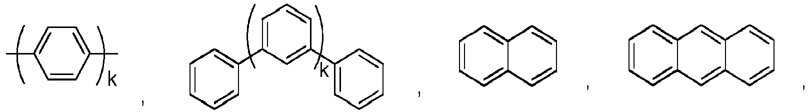 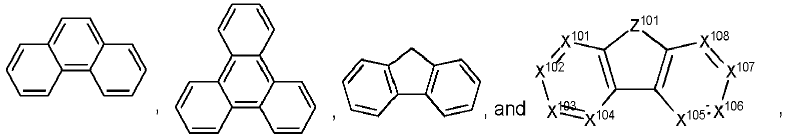 wherein k is an integer from 1 to 20; X¹⁰¹ to X¹⁰⁸ is C (including CH) or N; Z¹⁰¹ is NAr¹, O, or S; Ar¹ has the same group defined above.

Examples of metal complexes used in HIL or HTL include, but are not limited to the following general formula: 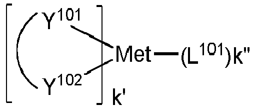 wherein Met is a metal, which can have an atomic weight greater than 40; (Y¹⁰¹-Y¹⁰²) is a bidentate ligand, Y¹⁰¹ and Y¹⁰² are independently selected from C, N, O, P, and S; L¹⁰¹ is an ancillary ligand; k' is an integer value from 1 to the maximum number of ligands that may be attached to the metal; and k'+k" is the maximum number of ligands that may be attached to the metal.

In one aspect, (Y¹⁰¹-Y¹⁰²) is a 2-phenylpyridine derivative. In another aspect, (Y¹⁰¹-Y¹⁰²) is a carbene ligand. In another aspect, Met is selected from Ir, Pt, Os, and Zn. In a further aspect, the metal complex has a smallest oxidation potential in solution vs. Fc⁺/Fc couple less than about 0.6 V.

Non-limiting examples of the HIL and HTL materials that may be used in an OLED in combination with materials disclosed herein are exemplified below together with references that disclose those materials: CN102702075, DE102012005215, EP01624500, EP01698613, EP01806334, EP01930964, EP01972613, EP01997799, EP02011790, EP02055700, EP02055701, EP1725079, EP2085382, EP2660300, EP650955, JP07-073529, JP2005112765, JP2007091719, JP2008021687, JP2014-009196, KR20110088898, KR20130077473, TW201139402, US06517957, US20020158242, US20030162053, US20050123751, US20060182993, US20060240279, US20070145888, US20070181874, US20070278938, US20080014464, US20080091025, US20080106190, US20080124572, US20080145707, US20080220265, US20080233434, US20080303417, US2008107919, US20090115320, US20090167161, US2009066235, US2011007385, US20110163302, US2011240968, US2011278551, US2012205642, US2013241401, US20140117329, US2014183517, US5061569, US5639914, WO05075451, WO07125714, WO08023550, WO08023759, WO2009145016, WO2010061824, WO2011075644, WO2012177006, WO2013018530, WO2013039073, WO2013087142, WO2013118812, WO2013120577, WO2013157367, WO2013175747, WO2014002873, WO2014015935, WO2014015937, WO2014030872, WO2014030921, WO2014034791, WO2014104514, WO2014157018.

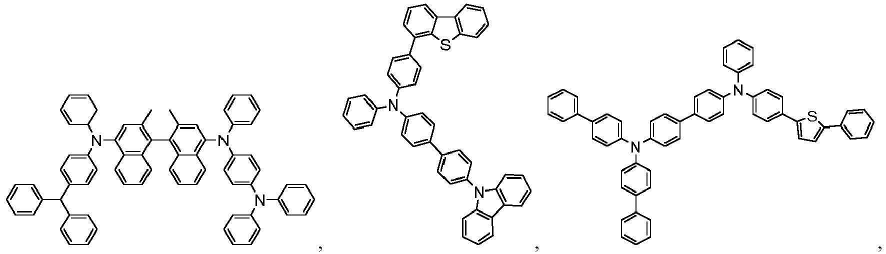

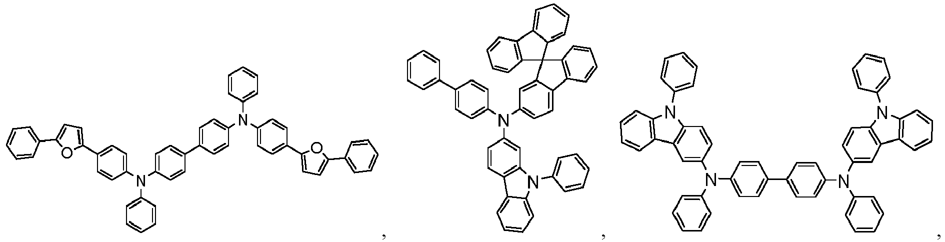

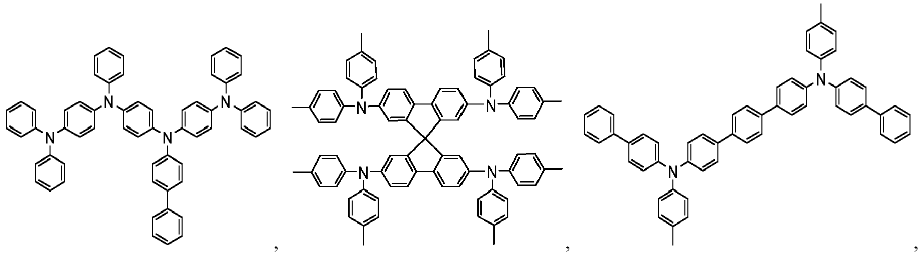

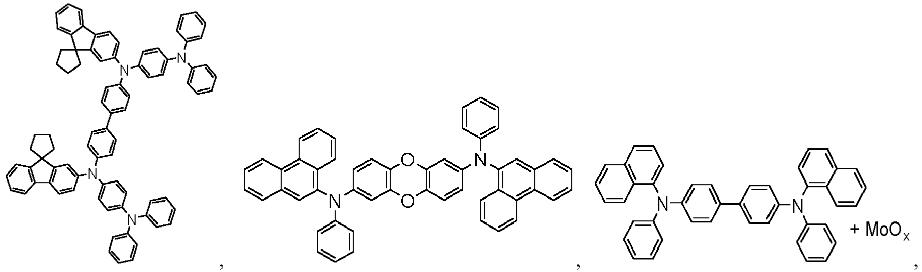

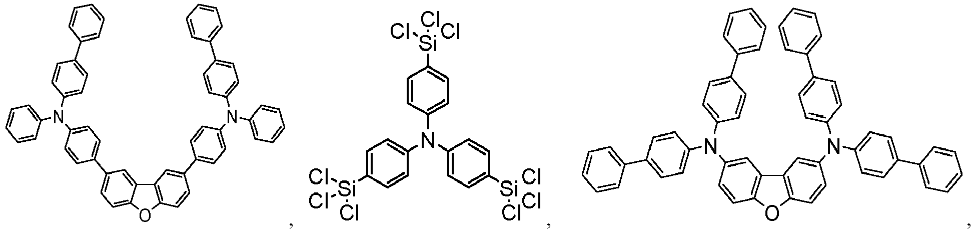

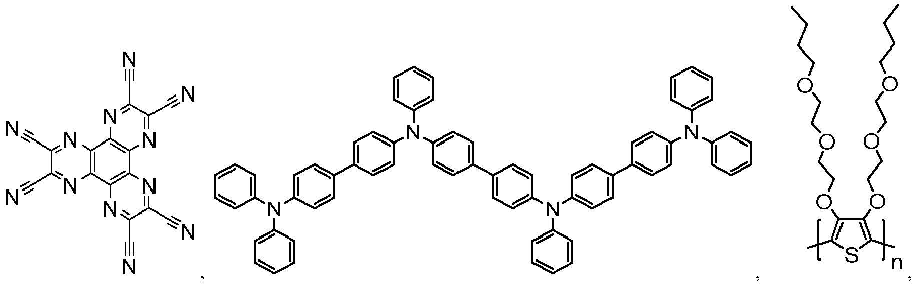

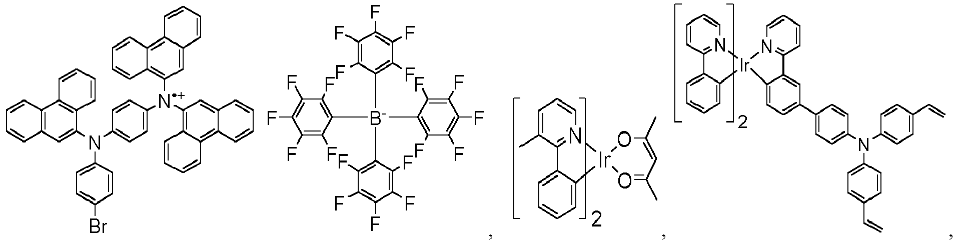

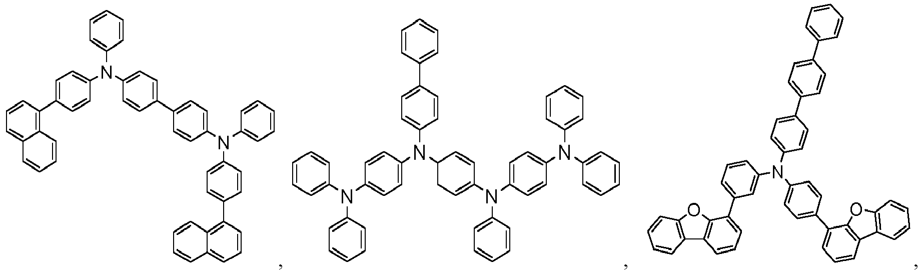

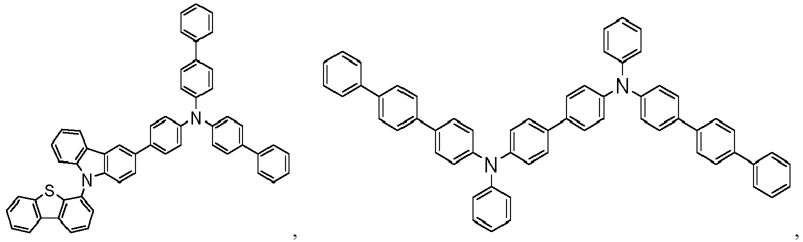

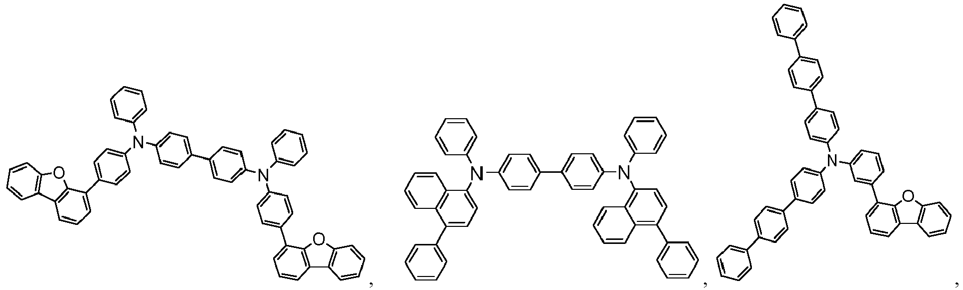

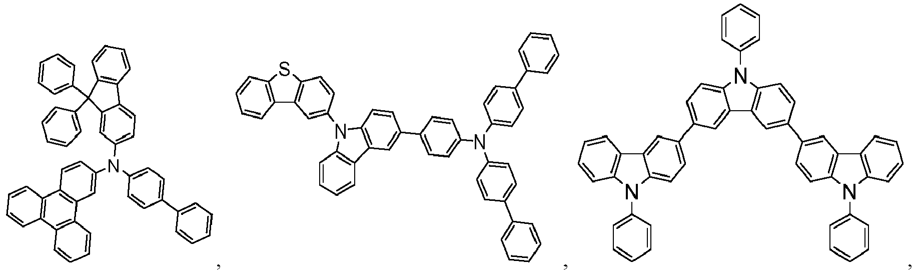

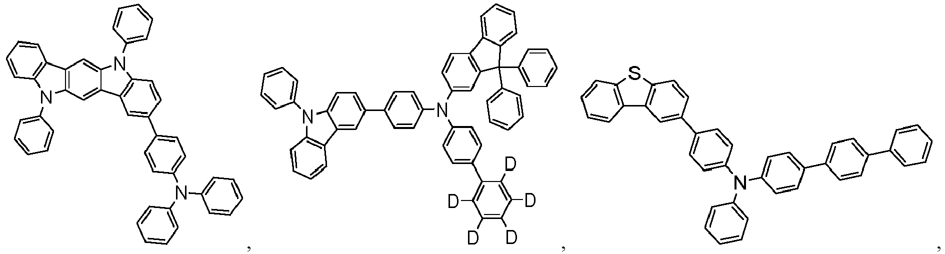

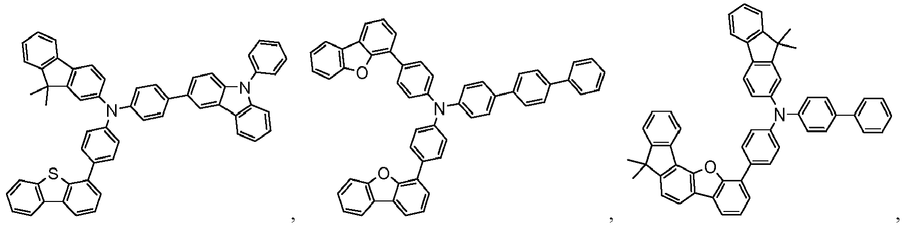

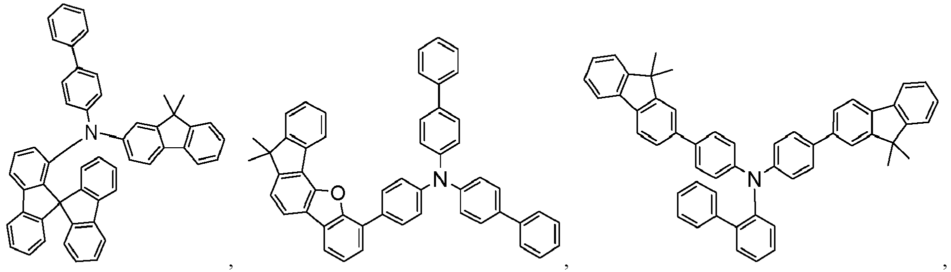

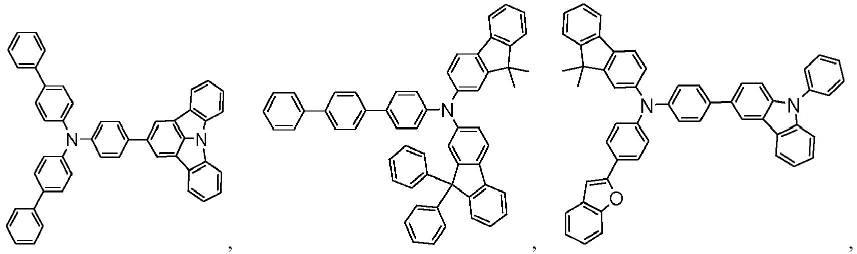

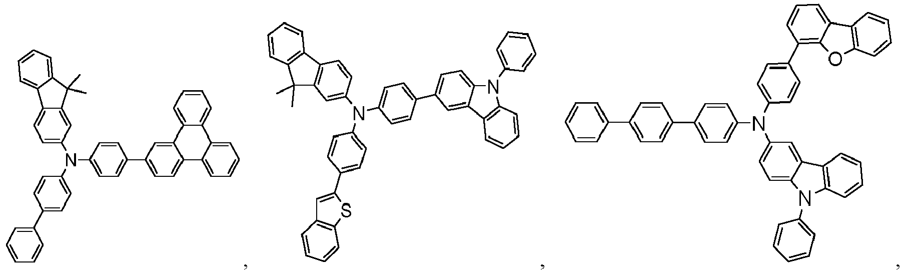

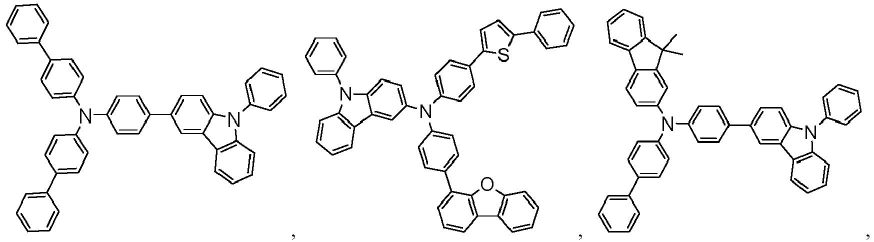

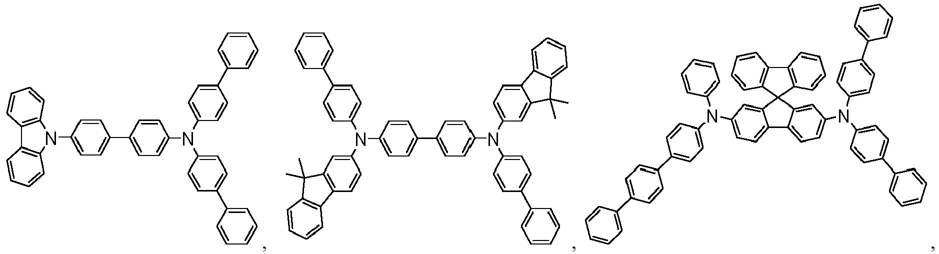

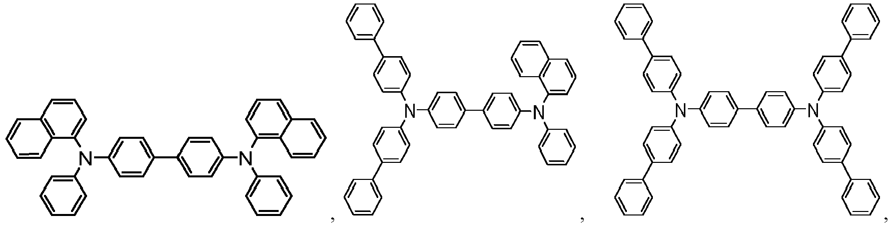

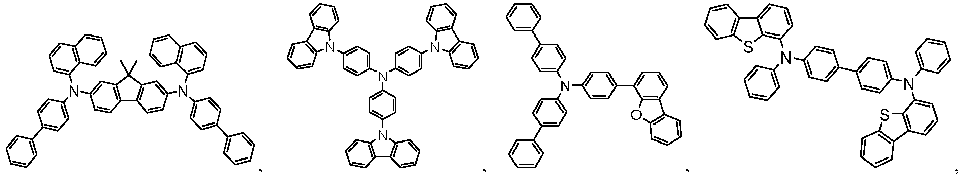

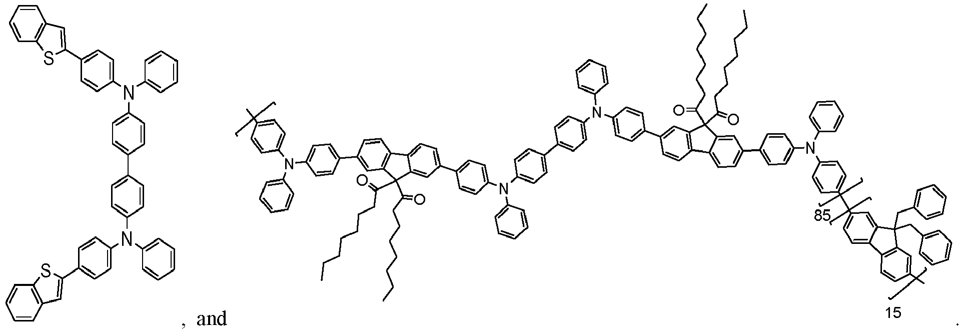

### c) EBL:

An electron blocking layer (EBL) may be used to reduce the number of electrons and/or excitons that leave the emissive layer. The presence of such a blocking layer in a device may result in substantially higher efficiencies, and/or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and/or higher triplet energy than one or more of the hosts closest to the EBL interface. In one aspect, the compound used in EBL contains the same molecule or the same functional groups used as one of the hosts described below.

### d) Hosts:

The light emitting layer of the organic EL device of the present disclosure preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

Examples of metal complexes used as host are preferred to have the following general formula: 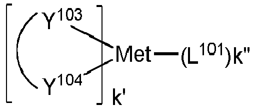 wherein Met is a metal; (Y¹⁰³-Y¹⁰⁴) is a bidentate ligand, Y¹⁰³ and Y¹⁰⁴ are independently selected from C, N, O, P, and S; L¹⁰¹ is another ligand; k' is an integer value from 1 to the maximum number of ligands that may be attached to the metal; and k'+k" is the maximum number of ligands that may be attached to the metal.

In one aspect, the metal complexes are: 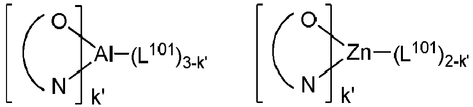 wherein (O-N) is a bidentate ligand, having metal coordinated to atoms O and N.

In another aspect, Met is selected from Ir and Pt. In a further aspect, (Y¹⁰³-Y¹⁰⁴) is a carbene ligand.

In one aspect, the host compound contains at least one of the following groups selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, the host compound contains at least one of the following groups in the molecule: 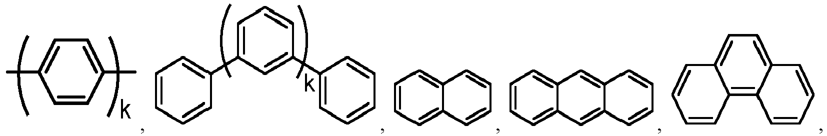 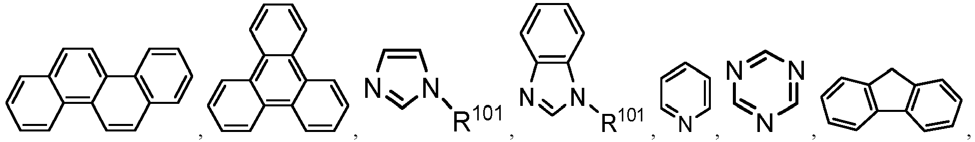 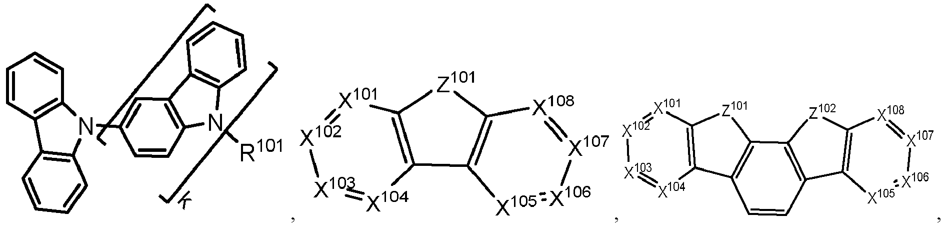 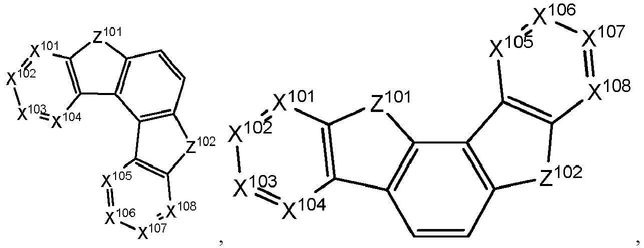 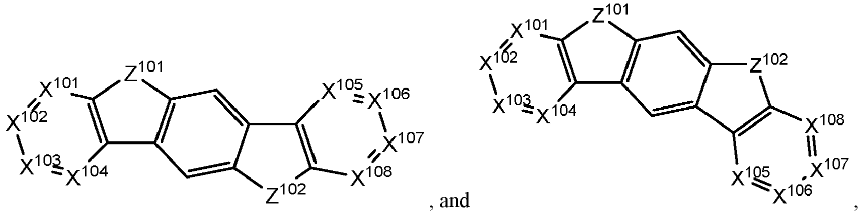 wherein R¹⁰¹ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, and when it is aryl or heteroaryl, it has the similar definition as Ar's mentioned above. k is an integer from 0 to 20 or 1 to 20. X¹⁰¹ to X¹⁰⁸ are independently selected from C (including CH) or N. Z¹⁰¹ and Z¹⁰² are independently selected from NR¹⁰¹, O, or S.

Non-limiting examples of the host materials that may be used in an OLED in combination with materials disclosed herein are exemplified below together with references that disclose those materials: EP2034538, EP2034538A, EP2757608, JP2007254297, KR20100079458, KR20120088644, KR20120129733, KR20130115564, TW201329200, US20030175553, US20050238919, US20060280965, US20090017330, US20090030202, US20090167162, US20090302743, US20090309488, US20100012931, US20100084966, US20100187984, US2010187984, US2012075273, US2012126221, US2013009543, US2013105787, US2013175519, US2014001446, US20140183503, US20140225088, US2014034914, US7154114, WO2001039234, WO2004093207, WO2005014551, WO2005089025, WO2006072002, WO2006114966, WO2007063754, WO2008056746, WO2009003898, WO2009021126, WO2009063833, WO2009066778, WO2009066779, WO2009086028, WO2010056066, WO2010107244, WO2011081423, WO2011081431, WO2011086863, WO2012128298, WO2012133644, WO2012133649, WO2013024872, WO2013035275, WO2013081315, WO2013191404, WO2014142472, US20170263869, US20160163995, US9466803,

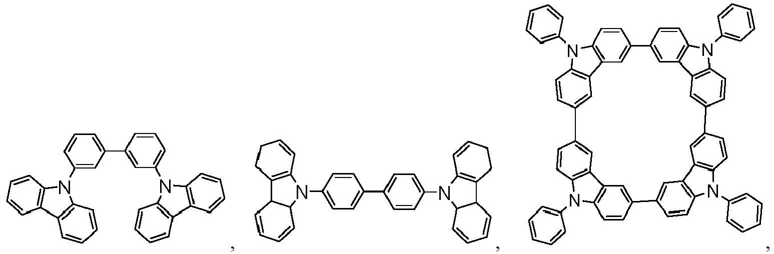

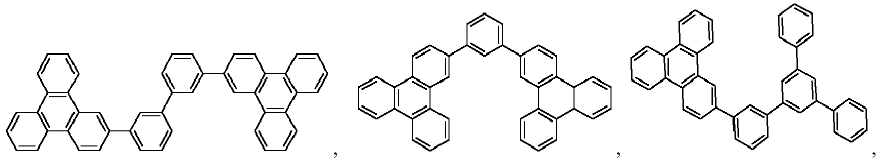

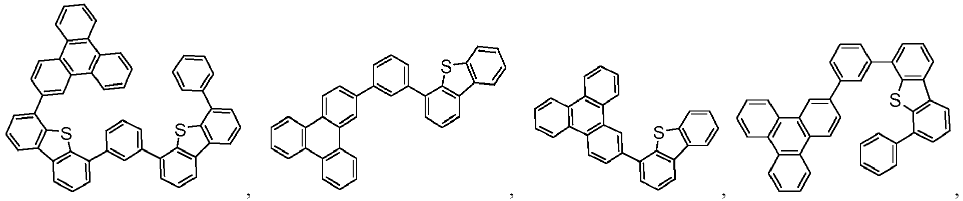

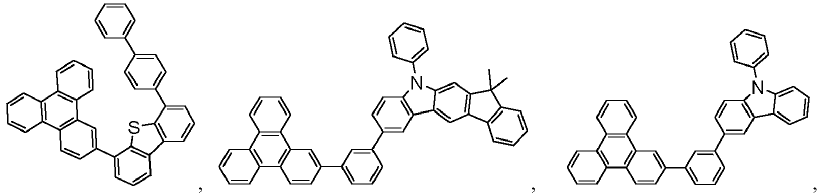

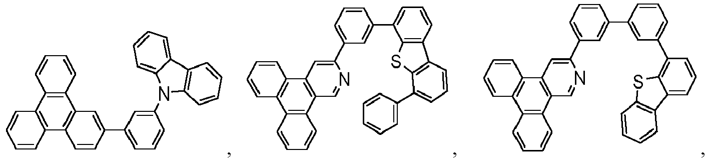

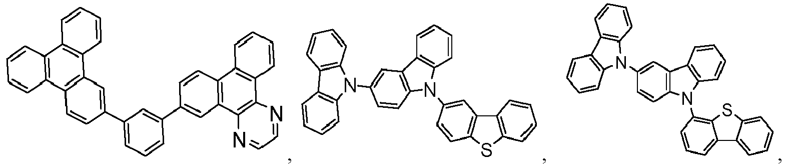

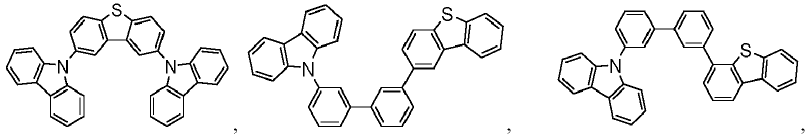

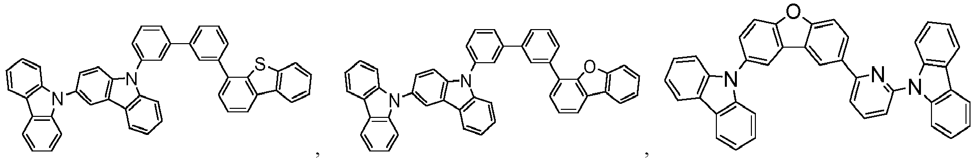

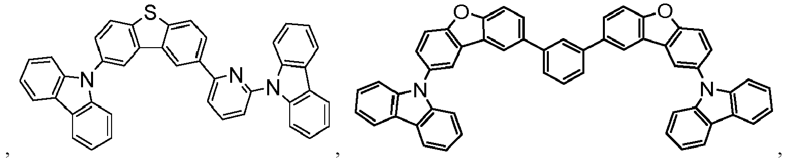

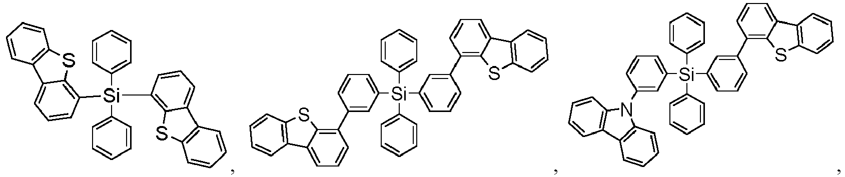

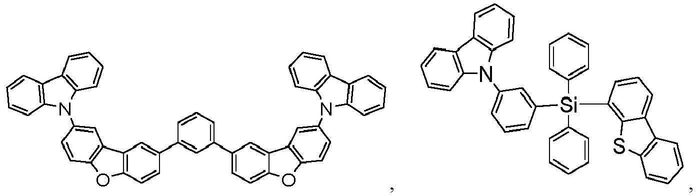

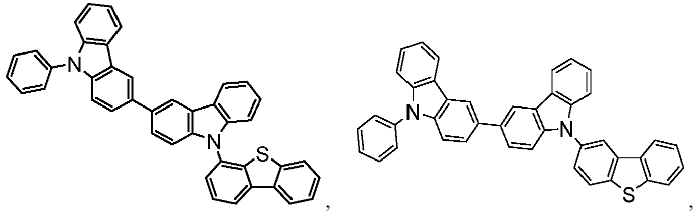

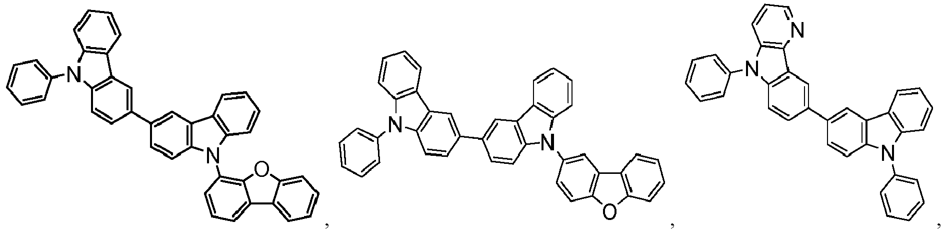

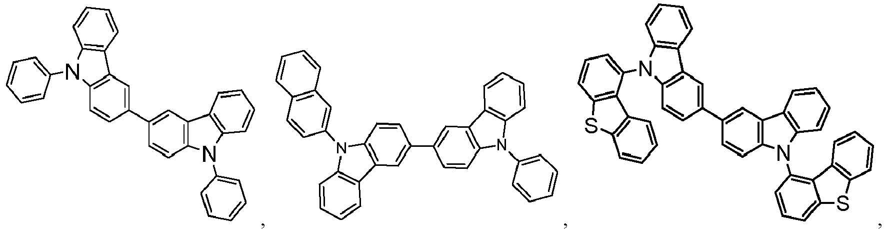

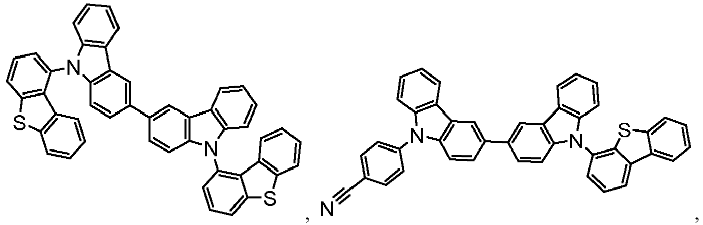

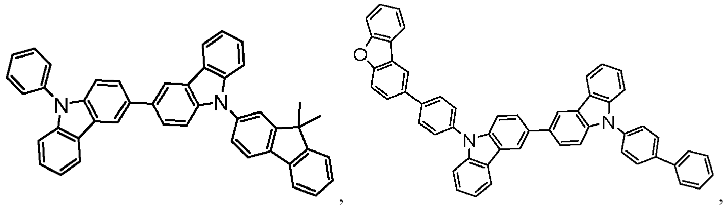

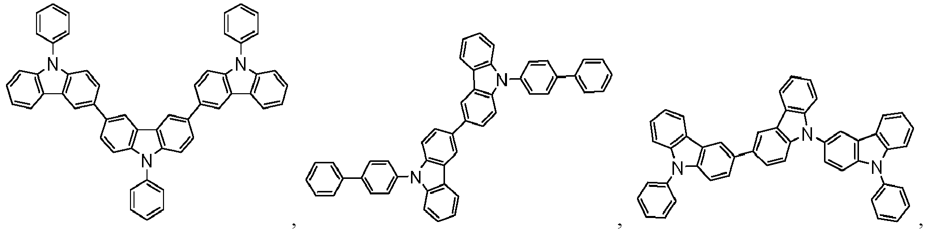

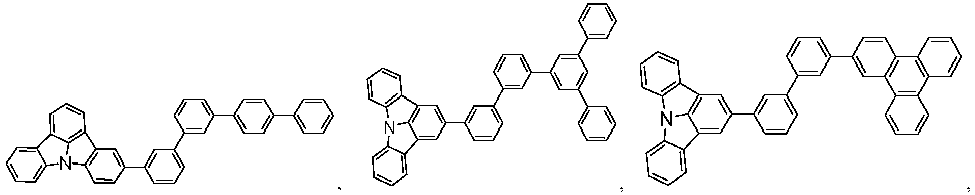

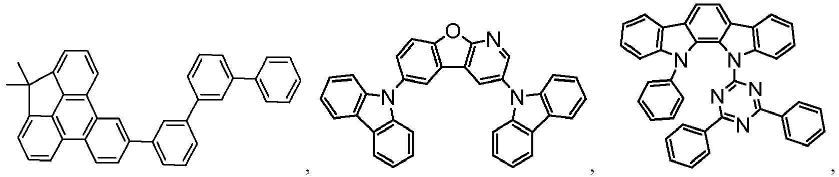

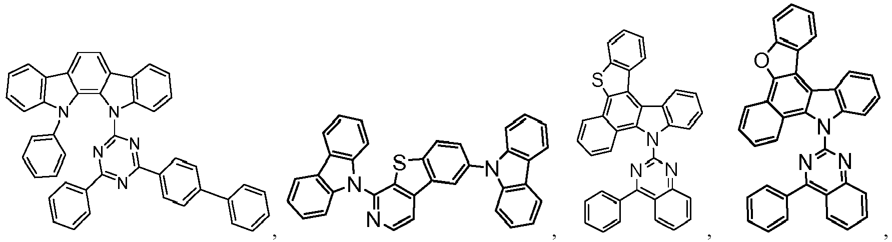

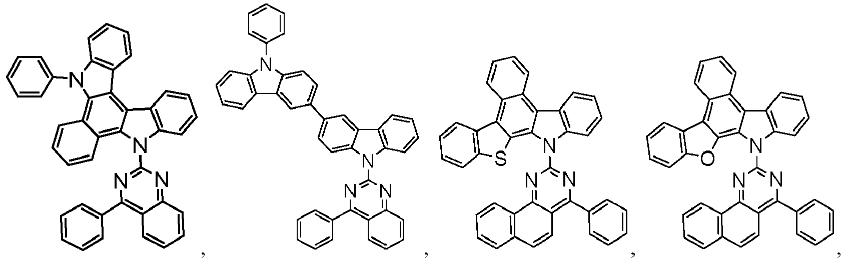

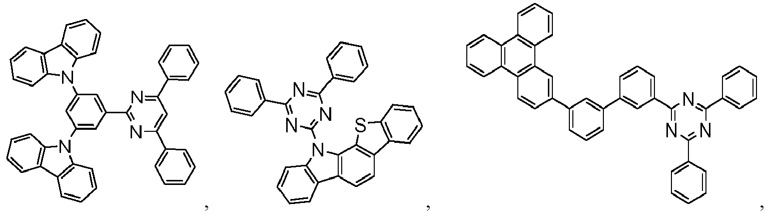

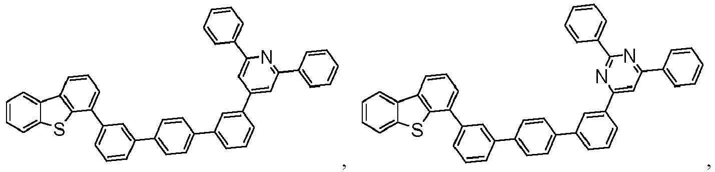

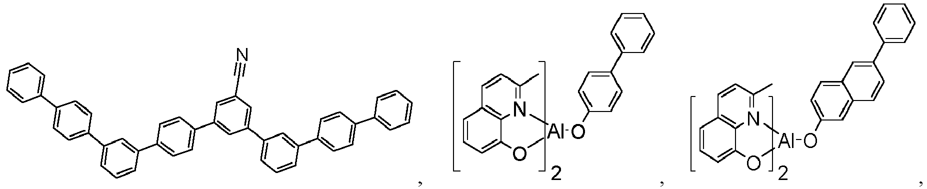

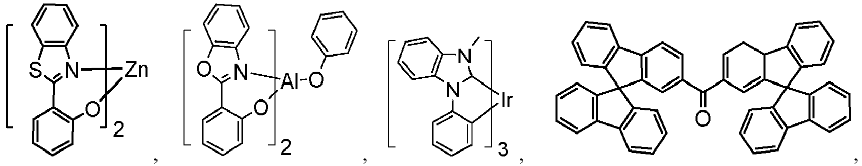

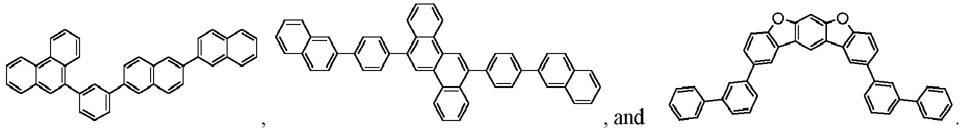

### e) Additional Emitters:

One or more additional emitter dopants may be used in conjunction with the compound of the present disclosure. Examples of the additional emitter dopants are not particularly limited, and any compounds may be used as long as the compounds are typically used as emitter materials. Examples of suitable emitter materials include, but are not limited to, compounds which can produce emissions via phosphorescence, fluorescence, thermally activated delayed fluorescence, i.e., TADF (also referred to as E-type delayed fluorescence), triplet-triplet annihilation, or combinations of these processes.
Non-limiting examples of the emitter materials that may be used in an OLED in combination with materials disclosed herein are exemplified below together with references that disclose those materials: CN103694277, CN1696137, EB01238981, EP01239526, EP01961743, EP1239526, EP1244155, EP1642951, EP1647554, EP1841834, EP1841834B, EP2062907, EP2730583, JP2012074444, JP2013110263, JP4478555, KR1020090133652, KR20120032054, KR20130043460, TW201332980, US06699599, US06916554, US20010019782, US20020034656, US20030068526, US20030072964, US20030138657, US20050123788, US20050244673, US2005123791, US2005260449, US20060008670, US20060065890, US20060127696, US20060134459, US20060134462, US20060202194, US20060251923, US20070034863, US20070087321, US20070103060, US20070111026, US20070190359, US20070231600, US2007034863, US2007104979, US2007104980, US2007138437, US2007224450, US2007278936, US20080020237, US20080233410, US20080261076, US20080297033, US200805851, US2008161567, US2008210930, US20090039776, US20090108737, US20090115322, US20090179555, US2009085476, US2009104472, US20100090591, US20100148663, US20100244004, US20100295032, US2010102716, US2010105902, US2010244004, US2010270916, US20110057559, US20110108822, US20110204333, US2011215710, US2011227049, US2011285275, US2012292601, US20130146848, US2013033172, US2013165653, US2013181190, US2013334521, US20140246656, US2014103305, US6303238, US6413656, US6653654, US6670645, US6687266, US6835469, US6921915, US7279704, US7332232, US7378162, US7534505, US7675228, US7728137, US7740957, US7759489, US7951947, US8067099, US8592586, US8871361, WO06081973, WO06121811, WO07018067, WO07108362, WO07115970, WO07115981, WO08035571, WO2002015645, WO2003040257, WO2005019373, WO2006056418, WO2008054584, WO2008078800, WO2008096609, WO2008101842, WO2009000673, WO2009050281, WO2009100991, WO2010028151, WO2010054731, WO2010086089, WO2010118029, WO2011044988, WO2011051404, WO2011107491, WO2012020327, WO2012163471, WO2013094620, WO2013107487, WO2013174471, WO2014007565, WO2014008982, WO2014023377, WO2014024131, WO2014031977, WO2014038456, WO2014112450. 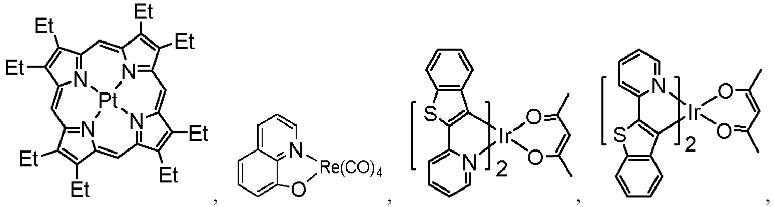 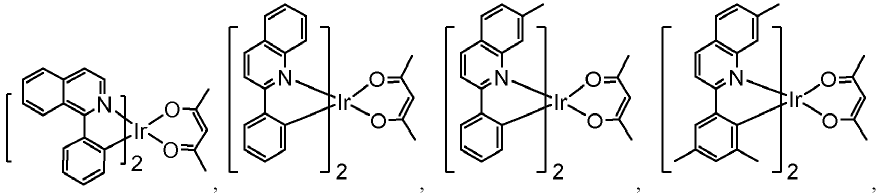 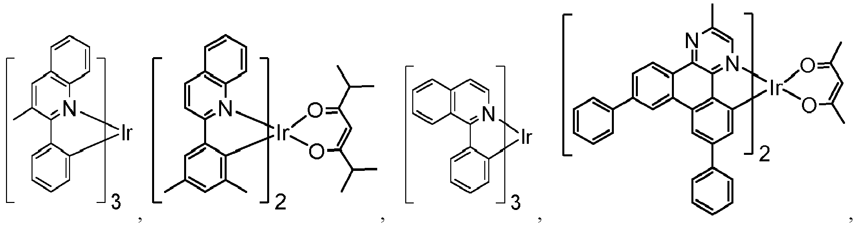 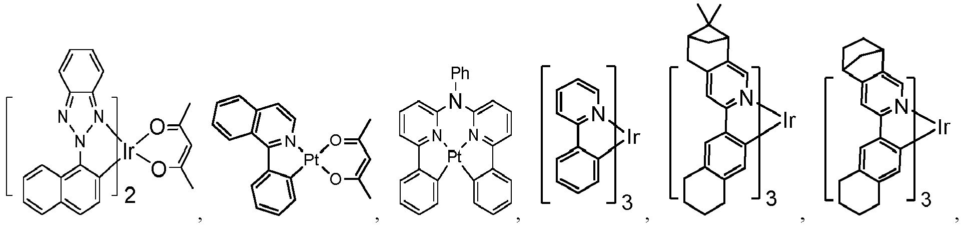 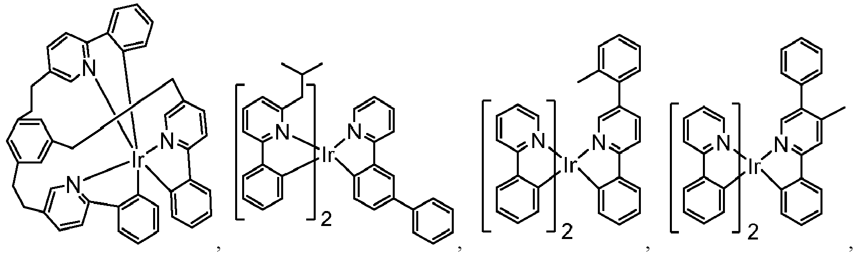 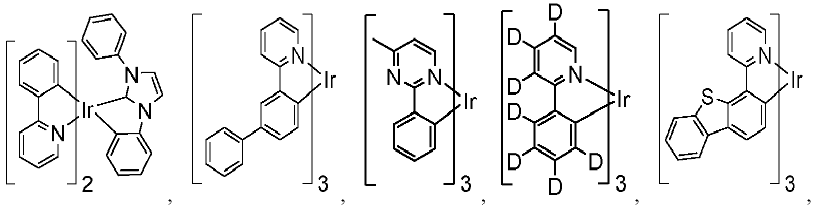 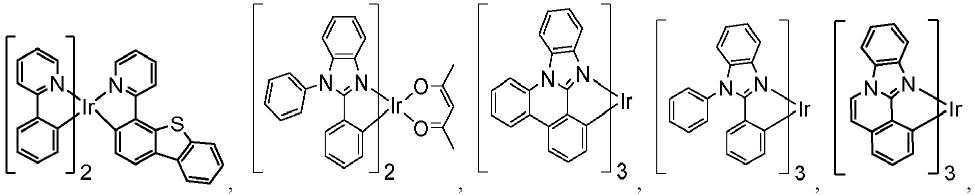 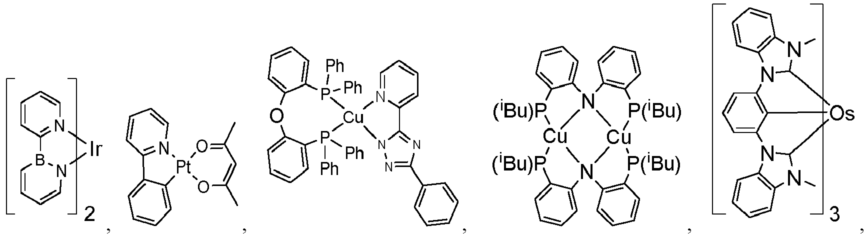 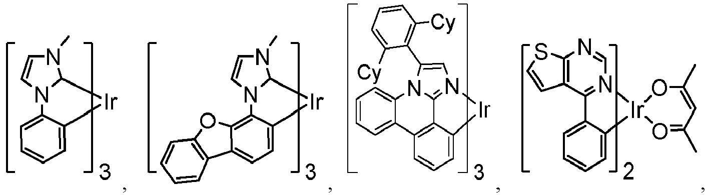 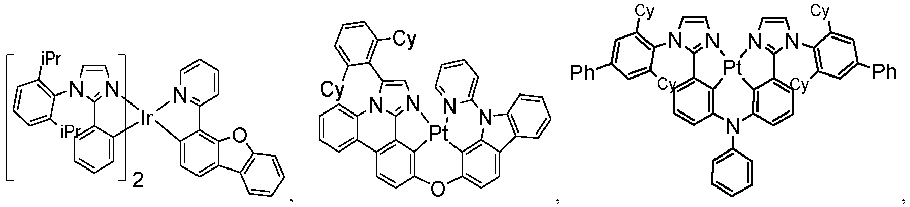 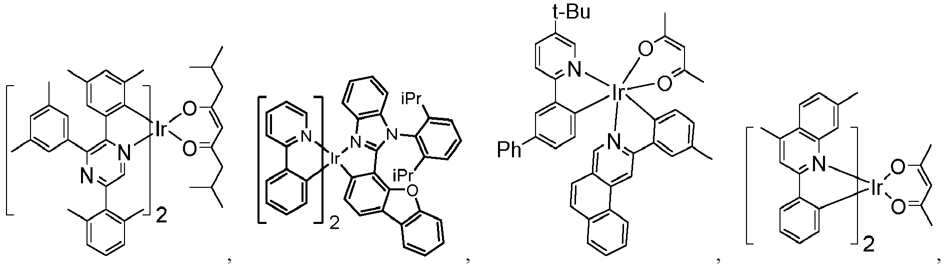 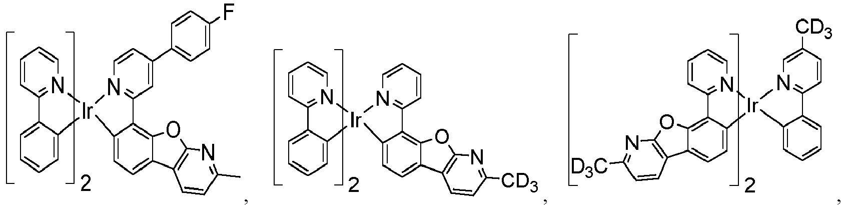 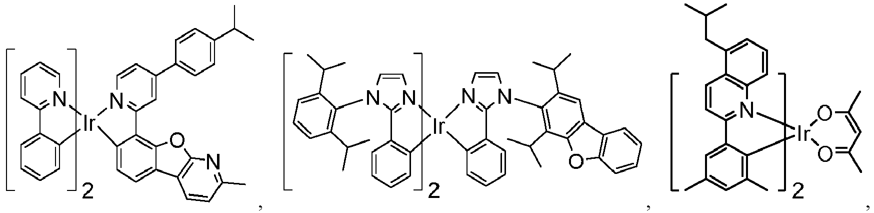 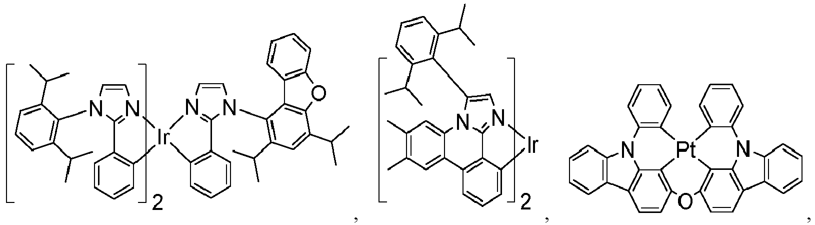 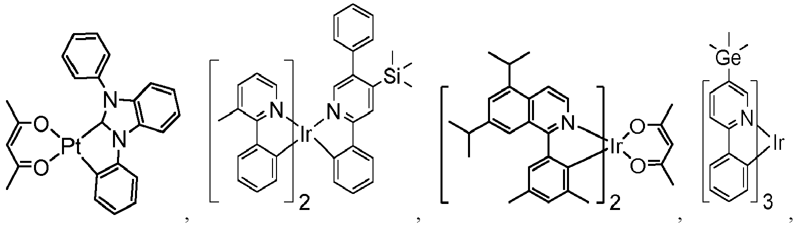 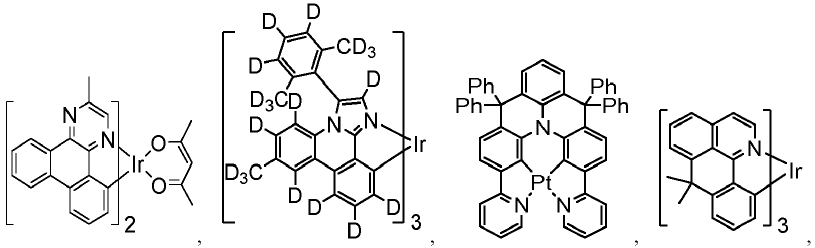 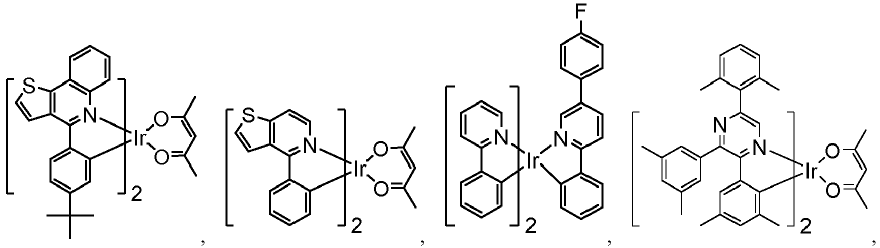 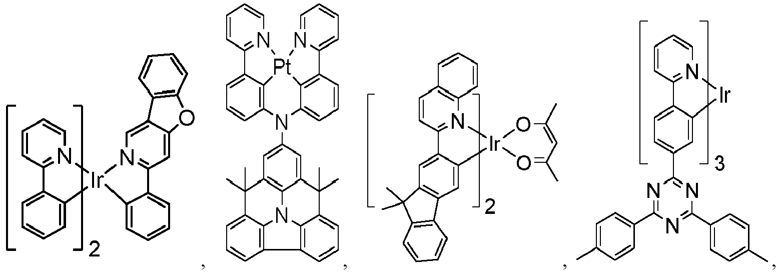 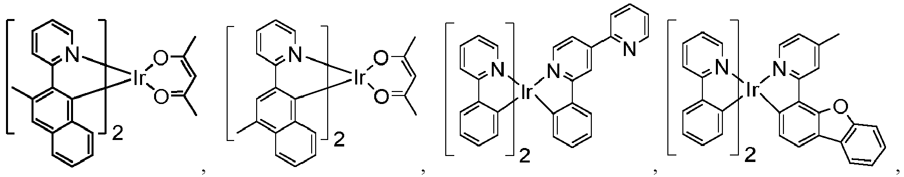 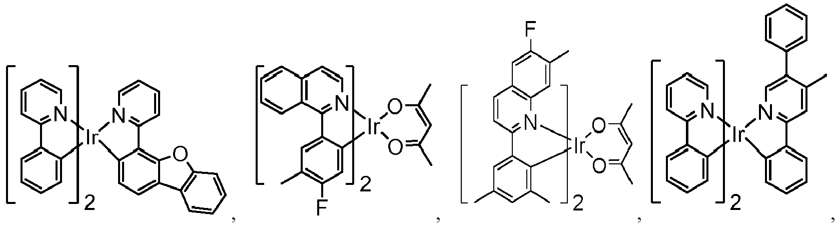 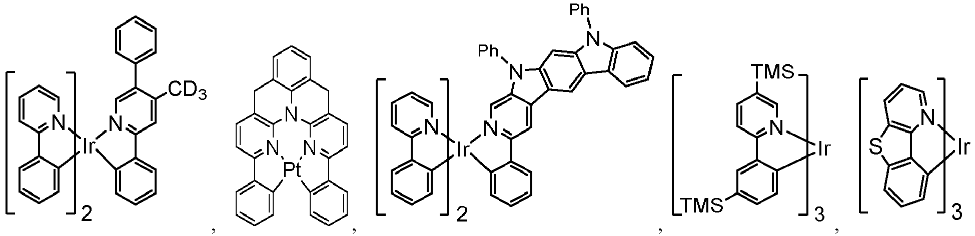 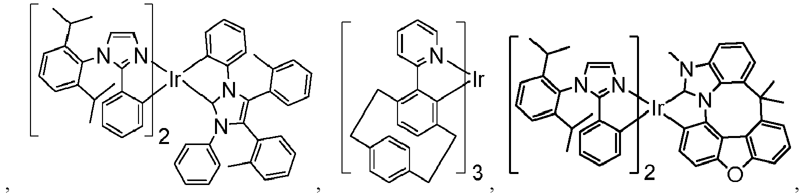 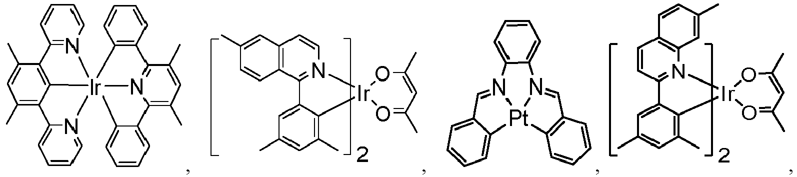 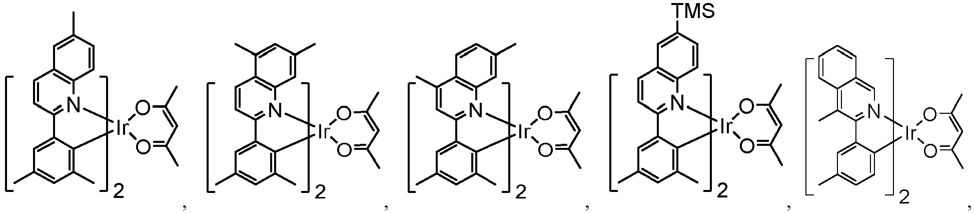 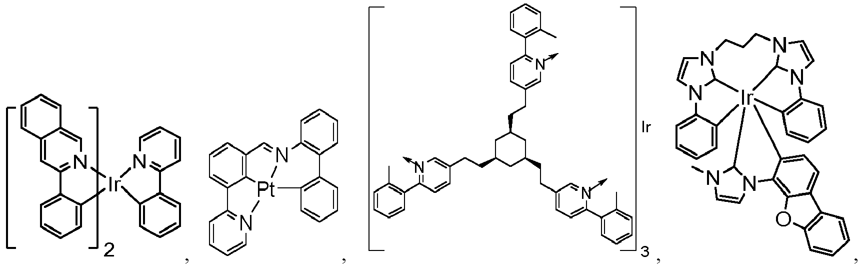 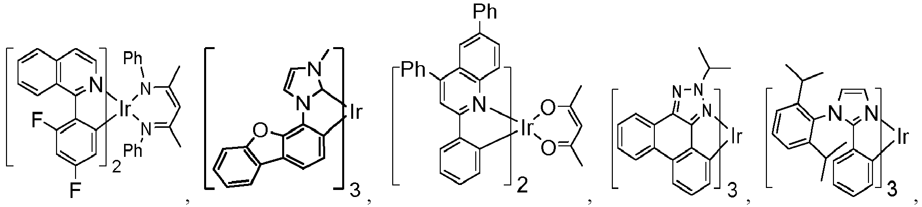 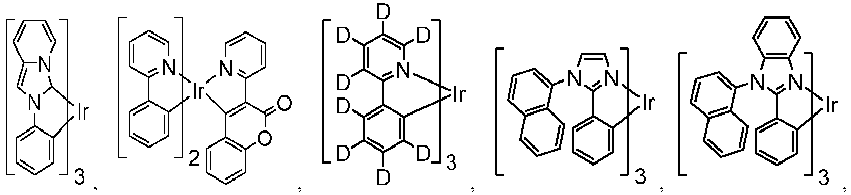 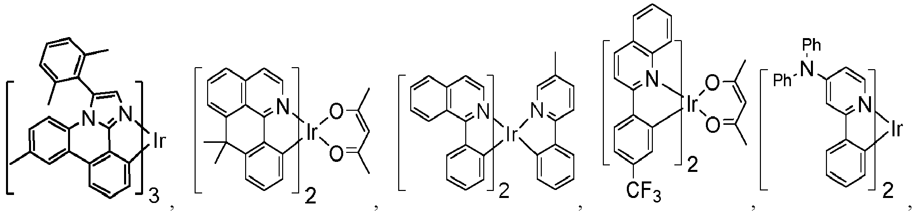 and

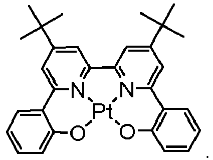

### f) HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and/or higher triplet energy than the emitter closest to the HBL interface. In some embodiments, the HBL material has a lower HOMO (further from the vacuum level) and/or higher triplet energy than one or more of the hosts closest to the HBL interface.

In one aspect, compound used in HBL contains the same molecule or the same functional groups used as host described above.

In another aspect, compound used in HBL contains at least one of the following groups in the molecule: 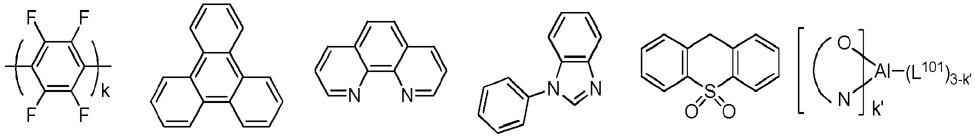 wherein k is an integer from 1 to 20; L¹⁰¹ is another ligand, k' is an integer from 1 to 3.

### g) ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule: 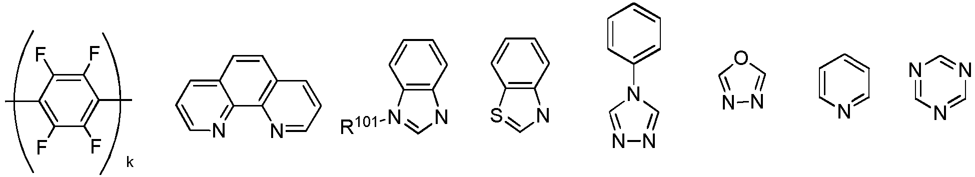 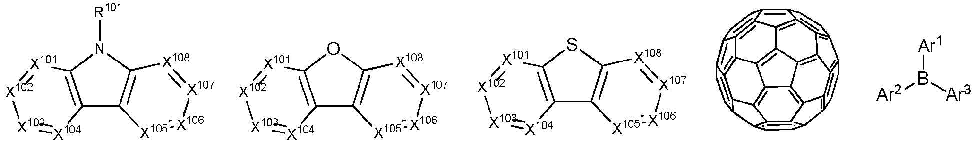 wherein R¹⁰¹ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, when it is aryl or heteroaryl, it has the similar definition as Ar's mentioned above. Ar¹ to Ar³ has the similar definition as Ar's mentioned above. k is an integer from 1 to 20. X¹⁰¹ to X¹⁰⁸ is selected from C (including CH) or N.

In another aspect, the metal complexes used in ETL contains, but not limit to the following general formula: 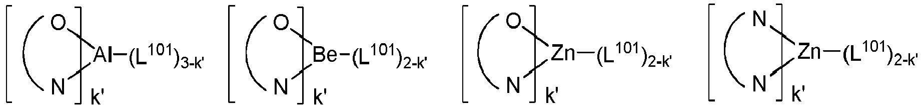 wherein (O-N) or (N-N) is a bidentate ligand, having metal coordinated to atoms O, N or N, N; L¹⁰¹ is another ligand; k' is an integer value from 1 to the maximum number of ligands that may be attached to the metal.

Non-limiting examples of the ETL materials that may be used in an OLED in combination with materials disclosed herein are exemplified below together with references that disclose those materials: CN103508940, EP01602648, EP01734038, EP01956007, JP2004-022334, JP2005149918, JP2005-268199, KR0117693, KR20130108183, US20040036077, US20070104977, US2007018155, US20090101870, US20090115316, US20090140637, US20090179554, US2009218940, US2010108990, US2011156017, US2011210320, US2012193612, US2012214993, US2014014925, US2014014927, US20140284580, US6656612, US8415031, WO2003060956, WO2007111263, WO2009148269, WO2010067894, WO2010072300, WO2011074770, WO2011105373, WO2013079217, WO2013145667, WO2013180376, WO2014104499, WO2014104535,

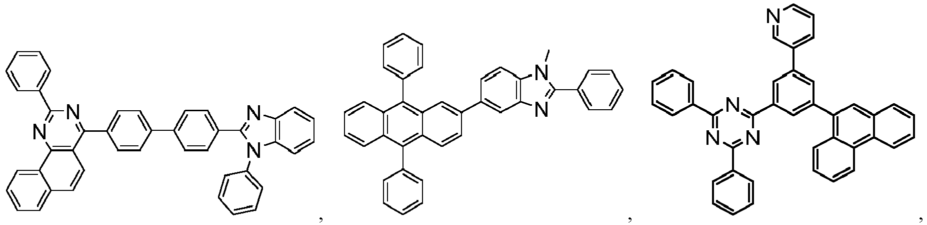

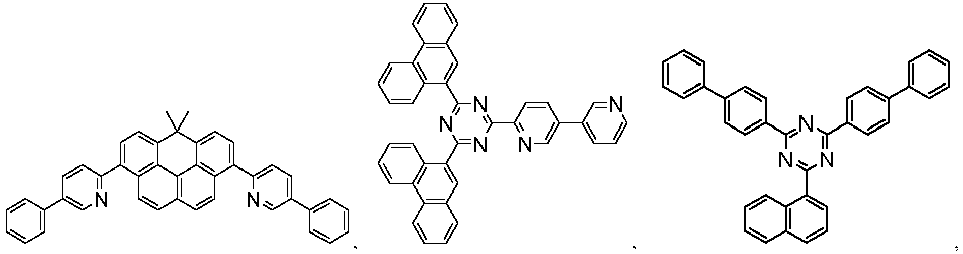

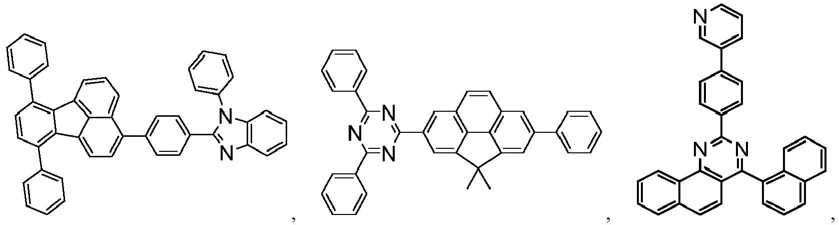

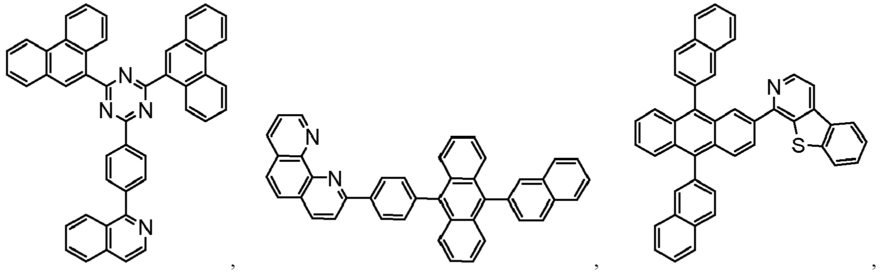

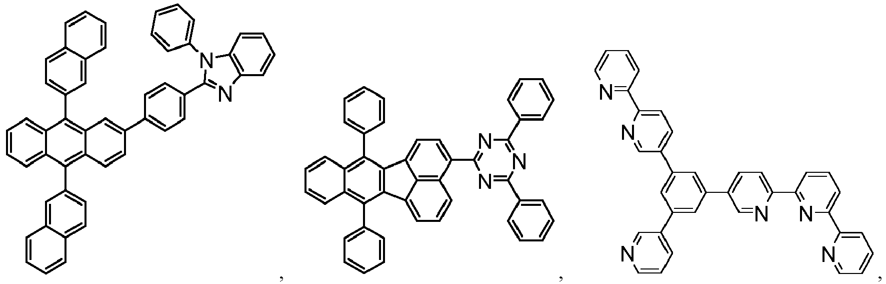

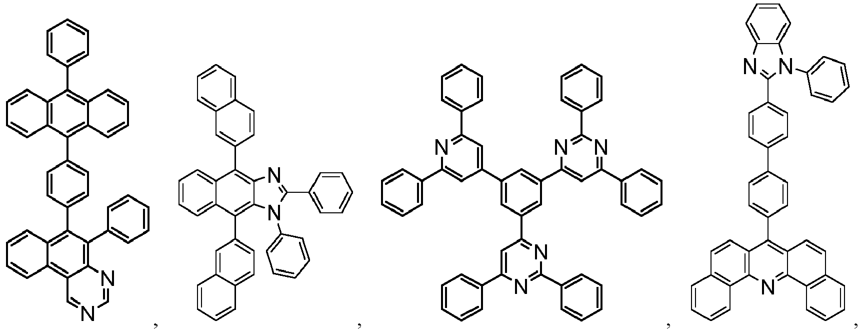

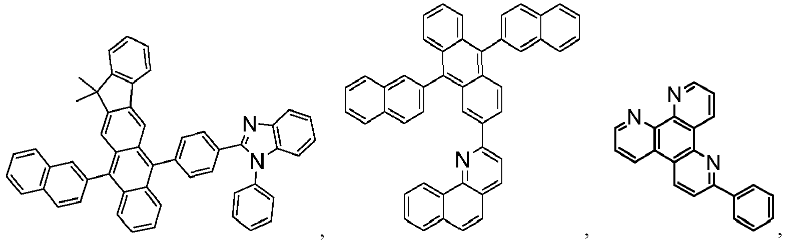

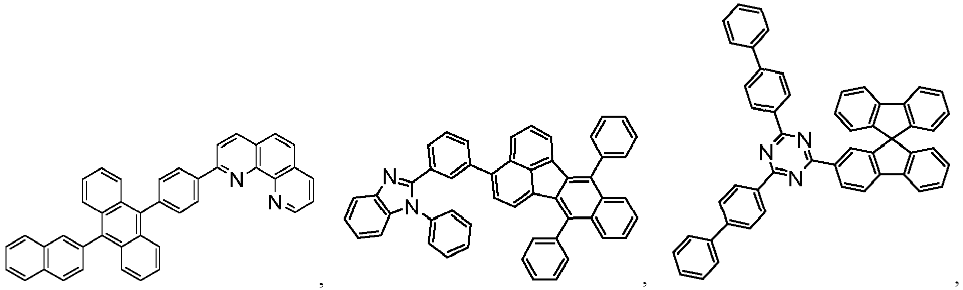

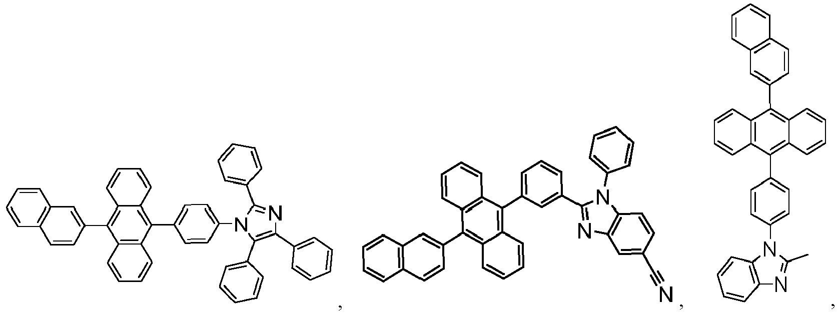

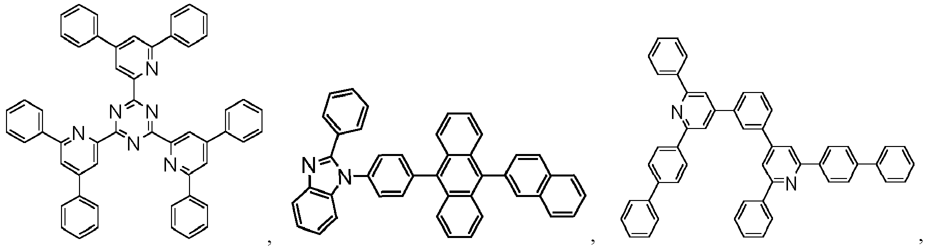

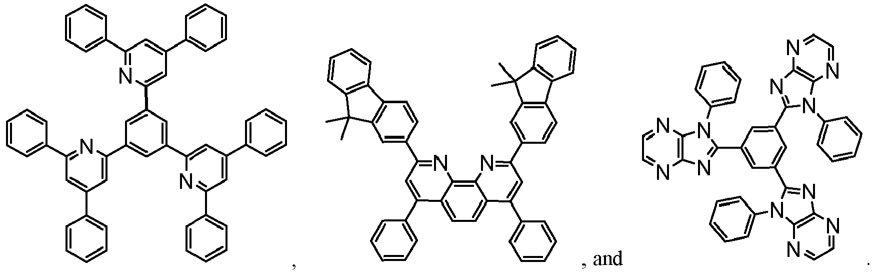

### h) Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any above-mentioned compounds used in each layer of the OLED device, the hydrogen atoms can be partially or fully deuterated. The minimum amount of hydrogen of the compound being deuterated is selected from the group consisting of 30%, 40%, 50%, 60%, 70%, 80%, 90%, 95%, 99%, and 100%. Thus, any specifically listed substituent such as, but not limited to, methyl, phenyl, pyridyl, etc. may be undeuterated, partially deuterated, and fully deuterated versions thereof. Similarly, classes of substituents such as, but not limited to, alkyl, aryl, cycloalkyl, heteroaryl, etc. also may be undeuterated, partially deuterated, and fully deuterated versions thereof.

It is understood that the various embodiments described herein are by way of example only and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

It should also be understood that embodiments of all the compounds and devices described herein may be interchangeable if those embodiments are also applicable under different aspects of the entire disclosure.

### E. Experimental Section

OLED devices were fabricated with the following material set.

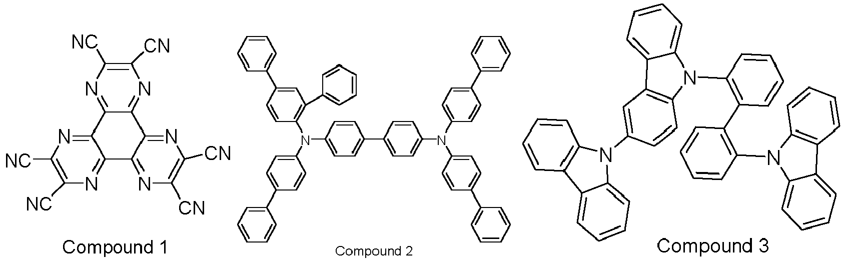

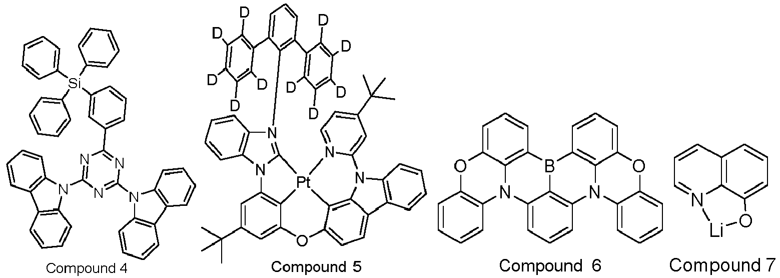

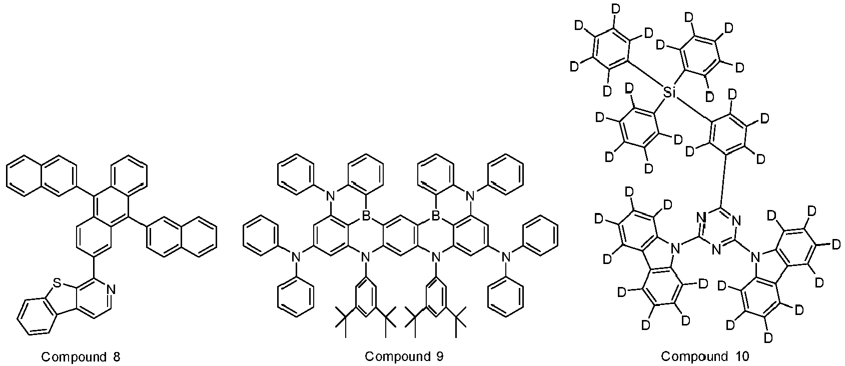

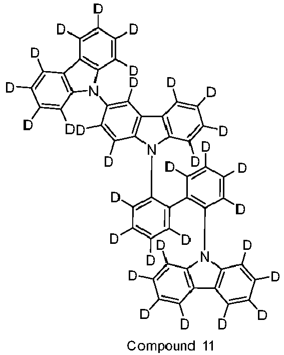

VDR test films for each of Compound 5, Compound 6, and Compound 9 as the emitter were fabricated via vacuum thermal evaporation of a 400Å thick film with a composition of 5% emitter in Host Compound A. 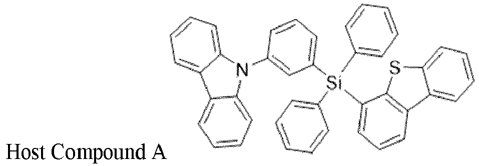 The measured VDR for Compound 5 is 0.33, the measured VDR for Compound 6 is 0.39, and the measured VDR for Compound 9 is 0.11.

Table 1 lists device results from blue phosphorescent OLEDs, with or without a green TADF acceptor. The plasmonic PHOLED data considers only energy that has been coupled into the plasmon mode of the enhancement layer and then subsequently converted to light. The ref. PHOLED data is for a conventional bottom emission device.

The plasmonic PHOLED data in Table 1 demonstrated an EL transient speed up over the ref. PHOLED based on conventional layer thicknesses meant to minimize plasmon coupling. The transient is further sped up when the acceptor is introduced into the system, supporting our claim that excited state lifetime (as measured by EL transient) is sped up by plasmon coupling and then further sped up by sensitization. This may have a compounding beneficial effect on device stability. While the ref. PHOLED excited state transient is also sped up when the acceptor is present, the excited state LT does not reach the level of the sensitized plasmonic PHOLED.
The fact that the wavelength shifts from blue to green indicates that the acceptor also coupled energy from S1 to the plasmon mode, as outlined in Figure 4.

OLEDs were grown on a glass substrate pre-coated with an indium-tin-oxide (ITO) layer having a sheet resistance of 15-Ω/sq. Prior to any organic layer deposition or coating, the substrate was degreased with solvents and then treated with an oxygen plasma for 1.5 minutes with 50W at 100 mTorr and with UV ozone for 5 minutes.
The devices in this work were fabricated in high vacuum (< 10⁻⁶ Torr) by thermal evaporation. The anode electrode was 750 Å of indium tin oxide (ITO).

The plasmonic PHOLED device examples had organic layers consisting of, sequentially, from the ITO surface, 100 Å thick Compound 1 (HIL), 250 Å layer of Compound 2 (HTL), 50 Å of Compound 3 (EBL), 100 Å of Compound 3 doped with 40% Compound 4 and doped with 12% of Compound 5 and doped with [0%, 1%] of Compound 6 (EML), 50 Å of Compound 4 (BL), 100 Å of Compound 7 doped with 35% of Compound 8 (ETL), 10 Å of Compound 7 (EIL), a silver cathode, and a nanoparticle based outcoupling scheme..

The reference PHOLED device examples had organic layers consisting of, sequentially, from the ITO surface, 100 Å thick Compound 1 (HIL), 250 Å layer of Compound 2 (HTL), 50 Å of Compound 3 (EBL), 300 Å of Compound 3 doped with 40% Compound 4 and doped with 12% of Compound 5 and doped with [0%, 1%] of Compound 6 (EML), 50 Å of Compound 4 (BL), 300 Å of Compound 7 doped with 35% of Compound 8 (ETL), 10 Å of Compound 7 (EIL), and 1000 Å of Al (Cath).

All devices were encapsulated with a glass lid sealed with an epoxy resin in a nitrogen glove box (<1 ppm of H₂O and O₂,) immediately after fabrication with a moisture getter incorporated inside the package. Doping percentages are in volume percent.

Spectral measurements (Instrument Systems CAS140D/TOP200) are taken at 10 mA/cm2. Electrical measurements are taken using a source-measure unit (Agilent B2902A). Measurements of the EL transient are taken using a fiber-coupled photomultiplier tube (Hamamatsu H10721-20) connected to an oscilloscope (National Instruments PXIe-5110). The OLED is driven by a square-wave function generator (National Instruments PXIe-5413) at 4 kHz with the forward bias set to give a specific current density and a reverse bias of-2 V. The current density is chosen by analyzing the curve of normalized EQE versus current density to choose a point between 90% and 95% of the peak EQE, intentionally avoiding any roll-off to prevent any bi-molecular interactions modifying the measured transient time. The 8,192-scan-averaged decay curve is then post-processed to ensure that all data are greater than zero, and subsequently normalized. A bi-exponential fit with baseline is applied to the lower ~85% of the data (to avoid fitting anomalies just after the voltage turn-off).

**Table 1**

| **Device** | **Acceptor present?** | **Peak emission wavelength (nm)** | **EL transient (ns)** | **Voltage (V)** |
|---|---|---|---|---|
| **Plasmonic PHOLED** | No | 468 | 529 | 3.4 |
| | Yes | 508 | 399 | 3.4 |
| **Ref. PHOLED** | No | 467 | 2030 | 4.2 |
| | Yes | 508 | 1430 | 4.2 |

Additionally, using a phosphorescent material with a nearly isotropic VDR with an acceptor with a highly horizontally aligned VDR resulted in a dramatic improvement in efficiency. Two devices were grown having organic layers consisting of, sequentially, from the ITO surface, 100 Å of Compound 1 (HIL), 250 Å of Compound 2 (HTL), 50 Å of Compound 3 (EBL), 300 Å Compound 11 doped with 50% of Compound 10, 12% of Compound 5 and either 0% or 0.8% of Compound 9 (EML), 50Å of EHost (BL), 300 Å of Compound 5 doped with 35% of Compound 6 (ETL), 10 Å of Compound 5 (EIL) followed by 1,000 Å of Al (Cathode). The emission characteristics and EQE are taken at 10mA/cm² and reported in Table 2. The EQE for Example 1 is reported relative to the values for Comparison 1.

**TABLE 2: Device Data**

| Device | With Acceptor | CIE | λmax (nm) | Relative EQE |
|---|---|---|---|---|
| Example 1 | Yes | (0.125, 0.137) | 470 | 1.38 |
| Comparison 1 | No | (0.139, 0.230) | 468 | 1.0 |

The above data shows that the sensitization of the low VDR acceptor with a high VDR phosphorescent sensitizer resulted in a large increase in EQE. The 38% increase in EQE is beyond any value that could be attributed to experimental error and the observed improvement is significant. Based on the fact that the device structures are similar with the only difference being the addition of 0.8% of the fluorescent acceptor, the significant performance improvement observed in the above data is unexpected. Without being bound by any theory, this improvement may be attributed to the fast energy transfer to the fluorescent acceptor, with its low VDR, resulting in reduced coupling to plasmon modes from the cathode.

The invention is further described by the following numbered aspects:
1. An organic light emitting device (OLED) comprising, sequentially: an anode; a hole transporting layer; an emissive region; an electron transporting layer; and a cathode; wherein the emissive region comprises: a compound S1; and a compound A1; wherein the compound S 1 is an organometallic sensitizer that transfers energy to the compound A1, and the compound A1 is an acceptor that is an emitter; wherein the compound S 1 has a vertical dipole ratio (VDR) value greater than or equal to 0.2; wherein the compound A1 has a VDR value less than or equal to 0.2; wherein if the compound S 1 is a tris-homoleptic Ir complex, then the compound S 1 comprises at least three Ir-N bonds; if the compound S 1 is a Pt complex, then the compound S 1 does not comprise both a carbene and a carbazole; and the compound S1 is not 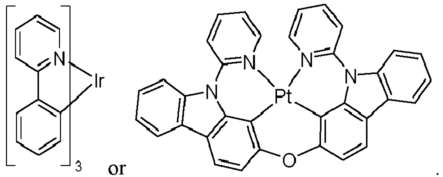
2. The OLED of aspect 1, wherein the emissive region comprises a compound H1 that is a first host and at least one of the compound S 1 and the compound A1 is doped in the first host; and/or wherein at least one of the compound S 1 and compound A1 comprises at least one deuterium; and/or wherein at least one of the compounds S1, A1, and H1 comprises at least one deuterium.
3. The OLED of any one of the previous aspects, wherein the compound S 1 comprises at least one moiety selected from the group consisting of dibenzofuran, dibenzothiophene, dibenzoselenophene, carbazole, aza-dibenzofuran, aza-dibenzothiophene, and aza-dibenzoselenophene; and/or wherein the compound A1 comprises a fused ring system containing five or more 5-membered or 6-membered carbocyclic or heterocyclic rings; and/or wherein the compound H1 comprises a moiety selected from biscarbazole, bicarbazole, indolocarbazole, 1-N indolocarbazole, triazine, pyrimidine, boryl, aza-dibenzoselenophene, aza-dibenzofuran, aza-dibenzothiophene, and triphenylene.
4. The OLED of any one of the previous aspects, wherein the compound A1 has a FWHM of ≤ 30 nm; and/or wherein S₁-T₁ of the compound A1 is ≤ 0.3eV; and/or wherein the emissive region further comprises a compound H2 as a second host, wherein the compound H2 has a HOMO, E_{HH2}, and E_{HA} - E_{HH2} < 0.25.
5. The OLED of any one of the previous aspects, wherein the compound S 1 has a HOMO level, E_{HS}, and the compound A1 has a HOMO level, E_{HA}, and E_{HS} > E_{HA;} and/or, wherein the compound A1 has a LUMO level, E_{LA}, and wherein the compound H1 has a LUMO level, E_{LH}, and E_{LH} < E_{LA}.
6. The OLED of any one of the previous aspects, wherein the compound H1 comprises a boryl group; and/or wherein the compound A1 comprises a boryl group.
7. The OLED of any one of the previous aspects, wherein the VDR value of the compound S 1 is > 0.25; and/or wherein the VDR value of the compound A1 is < 0.15.
8. The OLED of any one of the previous aspects, wherein a first thin film that contains only the compound S 1 and the compound A1 has a lower VDR than a second thin film that contains the compound A1 doped in Reference Host Compound A, wherein the compound A1 is the only emitter in the first thin film and the second thin film, wherein the Reference Host Compound A is 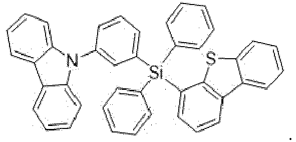
9. The OLED of any one of the previous aspects, wherein the metal M is Ir, Pt, or Pd and the compound S 1 has the formula of M(L¹)ₓ(L²)_{y}(L³)_{z}; wherein L¹, L², and L³ can be the same or different; wherein x is 1, 2, or 3;
   wherein y is 0, 1, or 2; wherein z is 0, 1, or 2; wherein x+y+z is the oxidation state of the metal M; wherein L¹ is selected from the group consisting of the structures of the LIGAND LIST as disclosed herein before;
   wherein L² and L³ are independently selected from the group consisting of 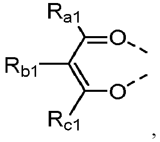 and the structures of the LIGAND LIST; wherein:
      T is selected from the group consisting of B, Al, Ga, and In;
      K^{1'} is a direct bond or is selected from the group consisting of NRₑ, PRₑ, O, S, and Se;
      each Y¹ to Y¹³ are independently selected from the group consisting of carbon and nitrogen;
      Y' is selected from the group consisting of BRₑ, NRₑ, PRₑ, O, S, Se, C=O, S=O, SO₂, CRₑR_{f}, SiRₑR_{f}, and GeRₑR_{f};
      Rₑ and R_{f} can be fused or joined to form a ring;
      each Rₐ, R_{b}, Rₑ, and R_{d} can independently represent from mono to the maximum possible number of substitutions, or no substitution;
      each Rₐ₁, R_{b1}, R_{c1}, R_{d1}, Rₐ, R_{b}, Rₑ, R_{d}, Rₑ, and R_{f} is independently a hydrogen or a substituent selected from the group consisting of the General Substituents as defined herein; and
   wherein any two of Rₐ₁, R_{b1}, R_{c1}, R_{d1}, Rₐ, R_{b}, R_{c}, and R_{d} can be fused or joined to form a ring or form a multidentate ligand.
10. The OLED of any one of the previous aspects, wherein the compound S1 has a formula selected from the group consisting of the compounds of the SENSITIZER LIST2 as described herein above; wherein: X⁹⁹ is C or N; each Y¹⁰⁰ is independently selected from the group consisting of a NR", O, S, and Se; L is independently selected from the group consisting of a direct bond, BR", BR"R‴, NR", PR", O, S, Se, C=O, C=S, C=Se, C=NR", C=CR"R‴, S=O, SO₂, CR", CR"R‴, SiR"R‴, GeR"R‴, alkyl, cycloalkyl, aryl, heteroaryl, and combinations thereof; X¹⁰⁰ for each occurrence is selected from the group consisting of O, S, Se, NR", and CR"R‴; each R^{10a}, R^{20a}, R^{30a}, R^{40a}, and R^{50a}, R^{A"}, R^{B"}, R^{C"}, R^{D"}, R^{E"}, and R^{F"} independently represents mono-, up to the maximum substitutions, or no substitutions; each of R, R', R", R‴, R^{10a}, R^{11a}, R^{12a}, R^{13a}, R^{20a}, R^{30a}, R^{40a}, R^{50a}, R⁶⁰, R⁷⁰, R⁹⁷, R⁹⁸, R⁹⁹, R^{A1'}, R^{A2'}, R^{A"}, R^{B"}, R^{C"}, R^{D"} R^{E"}, R^{F"}, R^{G"}, R^{H"}, R^{I"}, R^{J"}, R^{K"} R^{L"}, R^{M"}, and R^{N"} is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, combinations thereof.
11. The OLED of any one of the previous aspects, wherein the compound S1 has a formula selected from the group consisting of the compounds of SENSITIZER LIST 3.
12. A composition comprising: a compound S1; and a compound A1; wherein when the composition is formed into an emissive layer of an organic electroluminescent device, the compound S1 functions as an organometallic sensitizer that transfers energy to the compound A1 and the compound A1 is an acceptor that is an emitter; wherein the compound A1 has a vertical dipole ratio (VDR) value ≥ 0.33.
13. An organic electroluminescent device comprising a composition of aspect 12.
14. An organic light emitting device (OLED) comprising: a substrate; a first electrode; an organic emissive region disposed over the first electrode; an enhancement layer disposed over the organic emissive region opposite from the first electrode; wherein the emissive region comprises: a compound S 1; and a compound A1; wherein the compound S 1 is a sensitizer that transfers energy to the compound A1, and the compound A1 is an acceptor that is an emitter; wherein the enhancement layer comprises a plasmonic material exhibiting surface plasmon resonance that non-radiatively couples to the compound A1, compound S 1, or both compounds A1 and S 1, and transfers excited state energy from the compound A1, compound S 1, or from both compounds A1 and S1, to non-radiative mode energy of surface plasmon polaritons.
15. The OLED of aspect 14, wherein the enhancement layer is provided no more than a threshold distance away from the organic emissive region; wherein the compound A1 has a total non-radiative decay rate constant and a total radiative decay rate constant due to the presence of the enhancement layer, and the threshold distance is where the total non-radiative decay rate constant is equal to the total radiative decay rate constant; and/or wherein the enhancement layer is provided no more than a threshold distance away from the organic emissive region; and wherein the compound S1 has a total non-radiative decay rate constant and a total radiative decay rate constant due to the presence of the enhancement layer, and the threshold distance is where the total non-radiative decay rate constant is equal to the total radiative decay rate constant; and/or wherein the enhancement layer is provided no more than a threshold distance away from the organic emissive region; and wherein the organic emissive region has a total non-radiative decay rate constant and a total radiative decay rate constant due to the presence of the enhancement layer, and the threshold distance is where the total non-radiative decay rate constant is equal to the total radiative decay rate constant; and/or wherein an outcoupling layer is disposed over the enhancement layer, wherein the outcoupling layer scatters the non-radiative mode energy of the surface plasmon polaritons as photons to free space.
16. The OLED of aspect 14, wherein emission from the compound A1, has a smaller FWHM than emission from the compound S 1; and/or wherein emission peak maximum of the emission from the compound A1 is higher energy than emission peak maximum of the emission from the compound S 1; and/or wherein vertical dipole ratio (VDR) of the compound S1 is ≥ 0.25; and/or wherein the compound A1 has a VDR ≤ 0.33.
17. The OLED of aspect 14, wherein vertical dipole ratio (VDR) of the compound A1 is > VDR of the compound S 1; and/or wherein photoluminescence quantum yield (PLQY) of the compound A1 is > PLQY of the compound S 1; and/or wherein both the compound S 1 and the compound A1 have a VDR ≥ 0.33.
18. The OLED of aspect 14, wherein the OLED further comprises a hole transport layer (HTL) between the first electrode and the organic emissive region, wherein the compound S 1 is a phosphorescent sensitizer and the compound A1 is a fluorescent acceptor, and doping concentration of the compound A1 in the emissive region increases toward the HTL; and/or wherein the OLED further comprises an electron transport layer (ETL) between the second electrode and the organic emissive region, wherein the compound A1 is a fluorescent acceptor, and doping concentration of the compound A1 in the emissive region increases toward the ETL.
19. The OLED of aspect 14, wherein the compound S 1 is capable of phosphorescent emission or TADF emission at room temperature; and/or wherein emission contribution from the compound S 1 is ≤ 45% of total electroluminescence spectrum of the OLED or wherein the compound S 1 does not emit light; and/or wherein the compound S 1 is fully or partially deuterated; and/or wherein the compound A1 is fully or partially deuterated.
20. A consumer product comprising an OLED according to any one of aspects 14 to 19.

## Claims

1. An organic light emitting device (OLED) comprising, sequentially:
an anode;
a hole transporting layer;
an emissive region;
an electron transporting layer; and
a cathode; wherein the emissive region comprises:
a compound S1; and
a compound A1;
wherein the compound S1 is an organometallic sensitizer that transfers energy to the compound A1, and the compound A1 is an acceptor that is an emitter;
wherein the compound S 1 has a vertical dipole ratio (VDR) value greater than or equal to 0.2;
wherein the compound A1 has a VDR value less than or equal to 0.2;
wherein if the compound S 1 is a tris-homoleptic Ir complex, then the compound S 1 comprises at least three Ir-N bonds; if the compound S 1 is a Pt complex, then the compound S 1 does not comprise both a carbene and a carbazole; and the compound S1 is not

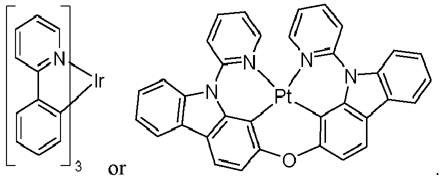

2. The OLED of claim 1, wherein the compound S 1 comprises at least one moiety selected from the group consisting of dibenzofuran, dibenzothiophene, dibenzoselenophene, carbazole, aza-dibenzofuran, aza-dibenzothiophene, and aza-dibenzoselenophene; and/or wherein the compound A1 comprises a fused ring system containing five or more 5-membered or 6-membered carbocyclic or heterocyclic rings; and/or wherein the compound H1 comprises a moiety selected from biscarbazole, bicarbazole, indolocarbazole, 1-N indolocarbazole, triazine, pyrimidine, boryl, aza-dibenzoselenophene, aza-dibenzofuran, aza-dibenzothiophene, and triphenylene.

3. The OLED of any one of the previous claims, wherein the compound A1 has a FWHM of ≤ 30 nm; and/or wherein S₁-T₁ of the compound A1 is ≤ 0.3eV; and/or wherein the emissive region further comprises a compound H2 as a second host, wherein the compound H2 has a HOMO, E_{HH2}, and E_{HA} - E_{HH2} < 0.25; and/or
the compound S 1 has a HOMO level, E_{HS}, and the compound A1 has a HOMO level, E_{HA}, and E_{HS} > E_{HA;} and/or, wherein the compound A1 has a LUMO level, E_{LA}, and wherein the compound H1 has a LUMO level, E_{LH}, and E_{LH} < E_{LA}.

4. The OLED of any one of the previous claims, wherein the VDR value of the compound S 1 is > 0.25; and/or wherein the VDR value of the compound A1 is < 0.15.

5. The OLED of any one of the previous claims, wherein the metal M is Ir, Pt, or Pd and the compound S 1 has the formula of M(L¹)ₓ(L²)_{y}(L³)_{z};
wherein L¹, L², and L³ can be the same or different;
wherein x is 1, 2, or 3;
wherein y is 0, 1, or 2;
wherein z is 0, 1, or 2;
wherein x+y+z is the oxidation state of the metal M;
wherein L¹ is selected from the group consisting of the structures of the following LIGAND LIST: 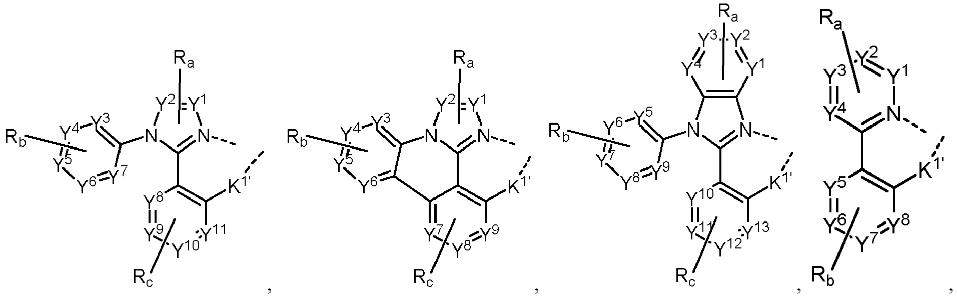 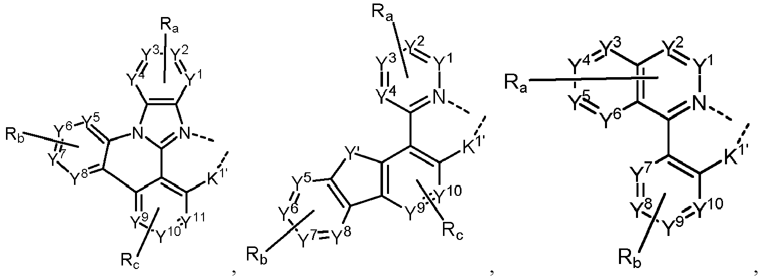 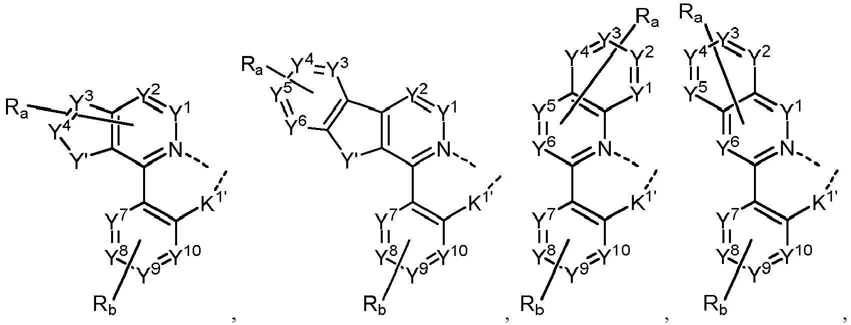 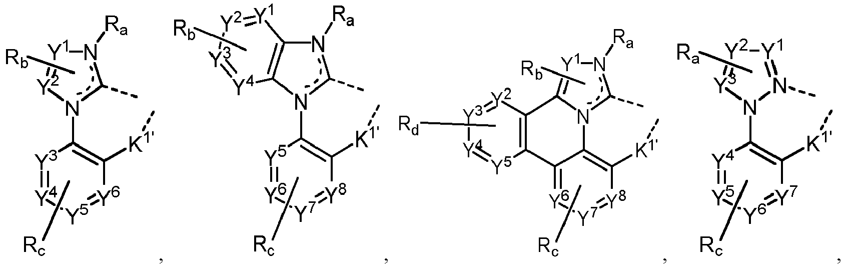 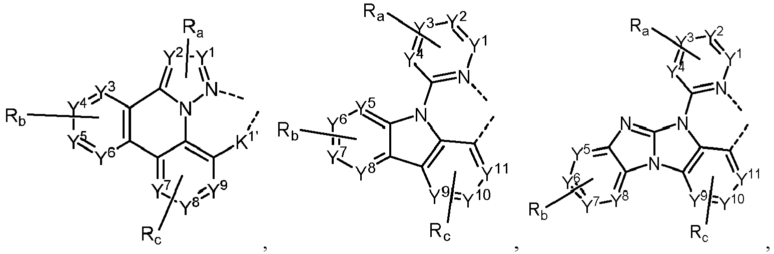 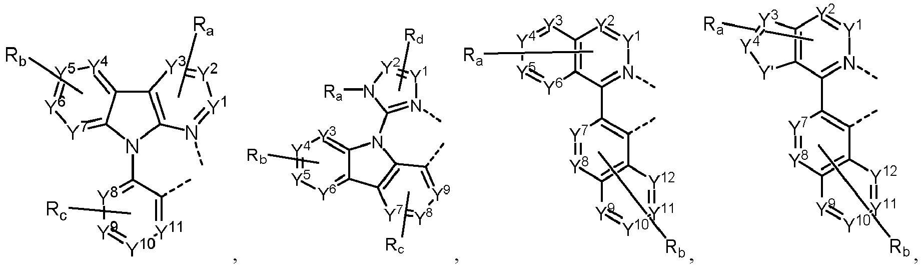 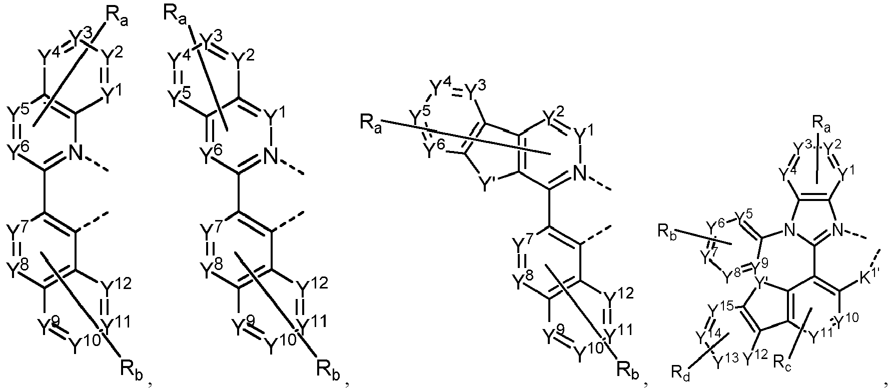 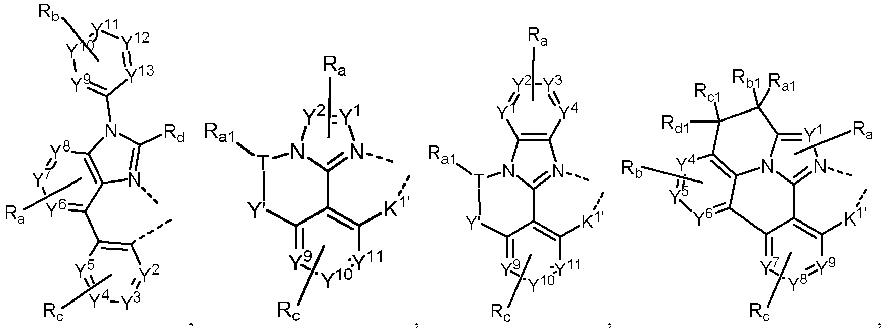 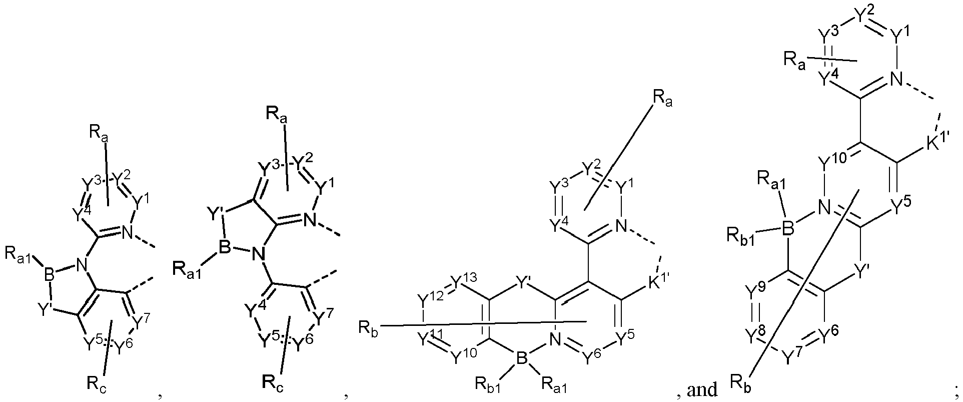
wherein L² and L³ are independently selected from the group consisting of 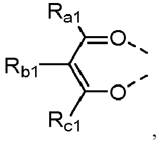 and the structures of the LIGAND LIST; wherein:
T is selected from the group consisting of B, Al, Ga, and In;
K^{1'} is a direct bond or is selected from the group consisting of NRₑ, PRₑ, O, S, and Se;
each Y¹ to Y¹³ are independently selected from the group consisting of carbon and nitrogen;
Y' is selected from the group consisting of BRₑ, NRₑ, PRₑ, O, S, Se, C=O, S=O, SO₂, CRₑR_{f}, SiRₑR_{f}, and GeRₑR_{f};
Rₑ and R_{f} can be fused or joined to form a ring;
each Rₐ, R_{b}, R_{c}, and R_{d} can independently represent from mono to the maximum possible number of substitutions, or no substitution;
each Rₐ₁, R_{b1}, R_{c1}, R_{d1}, Rₐ, R_{b}, R_{c}, R_{d}, Rₑ, and R_{f} is independently a hydrogen or a substituent selected from the group consisting of the General Substituents as defined herein; and
wherein any two of Rₐ₁, R_{b1}, R_{c1}, R_{d1}, Rₐ, R_{b}, R_{c}, and R_{d} can be fused or joined to form a ring or form a multidentate ligand.

6. The OLED of any one of the previous claims, wherein the compound S 1 has a formula selected from the group consisting of: 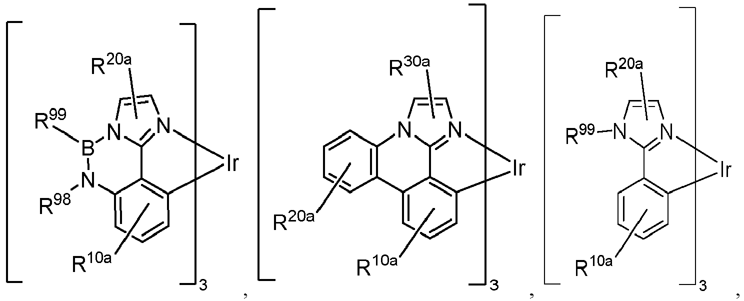 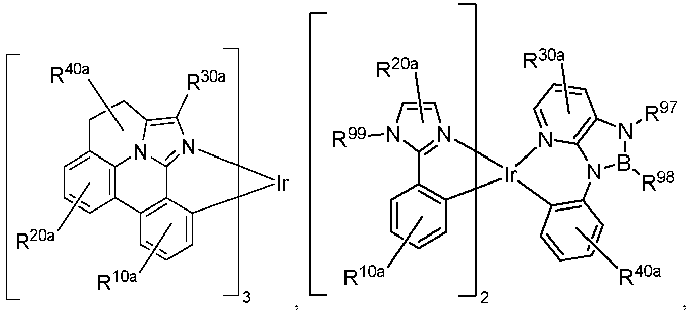 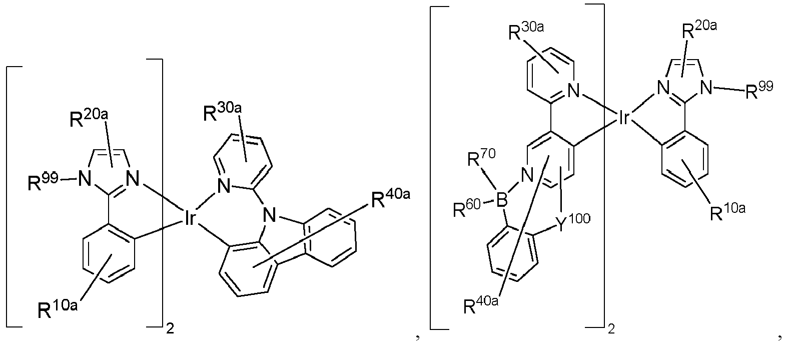 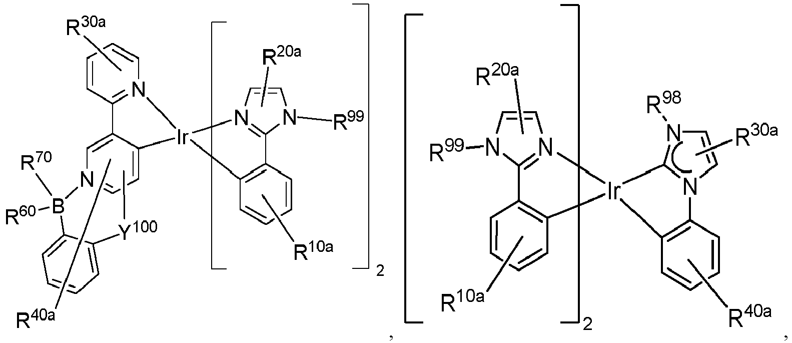 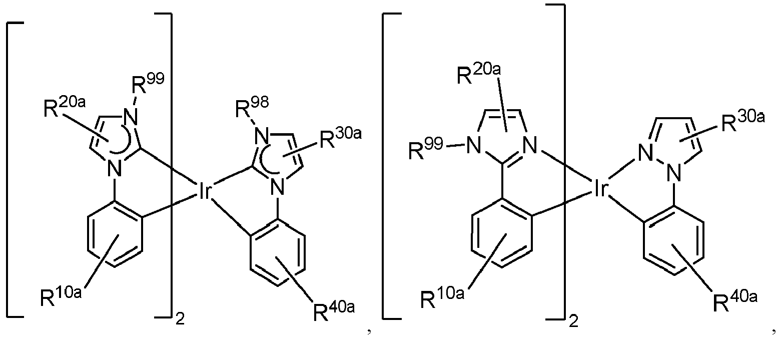 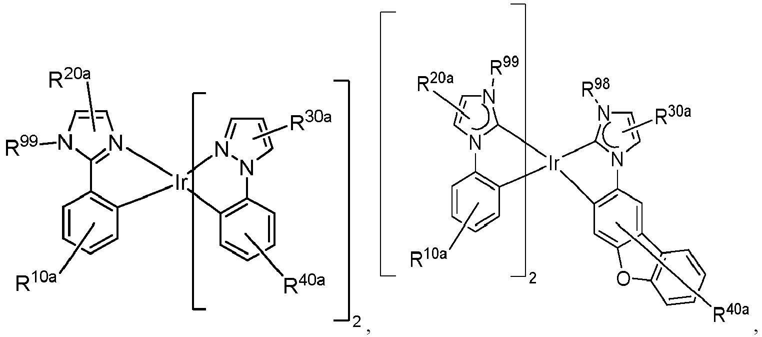 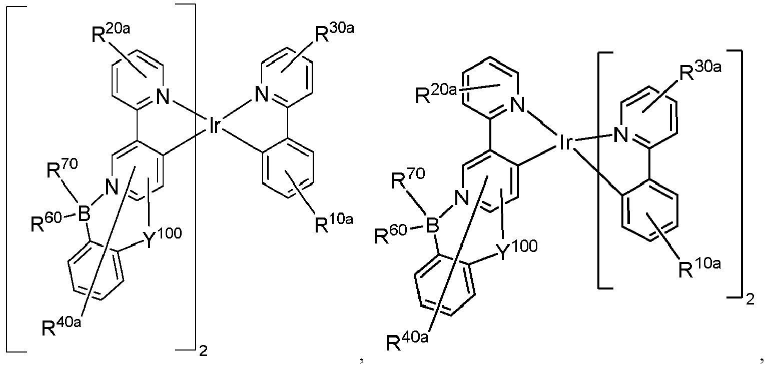 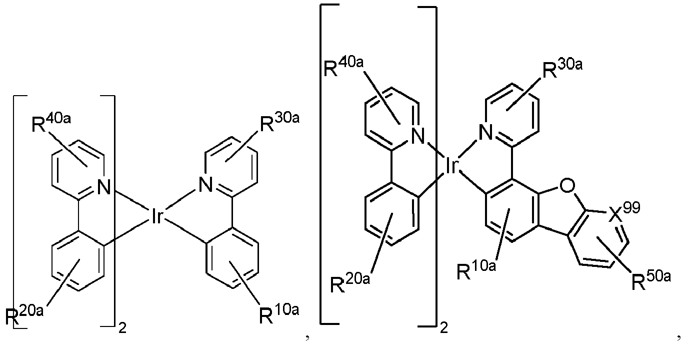 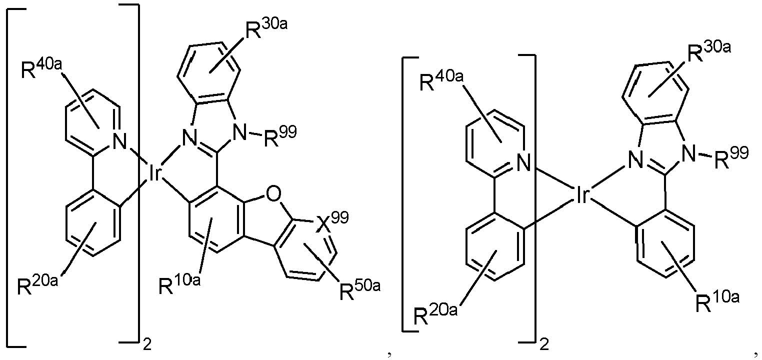 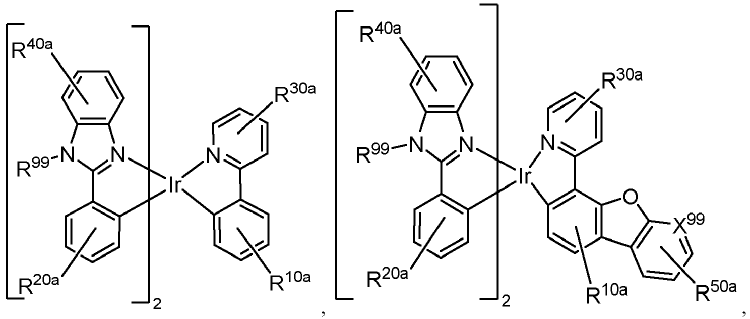 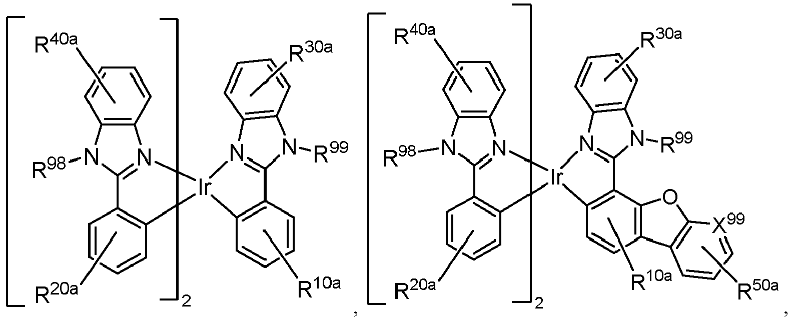 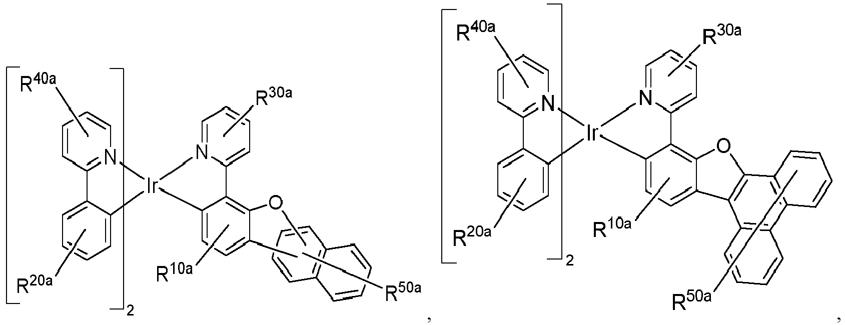 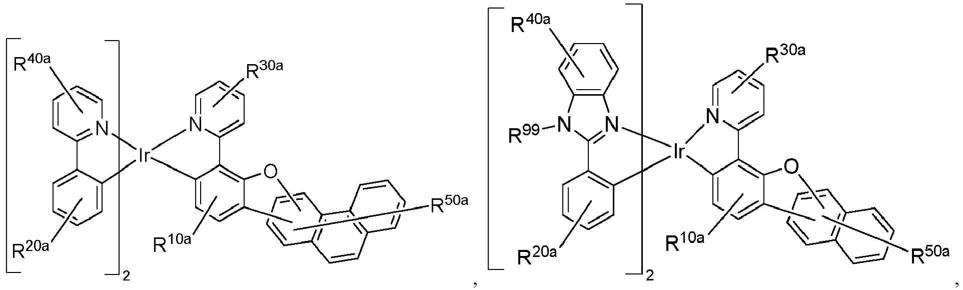 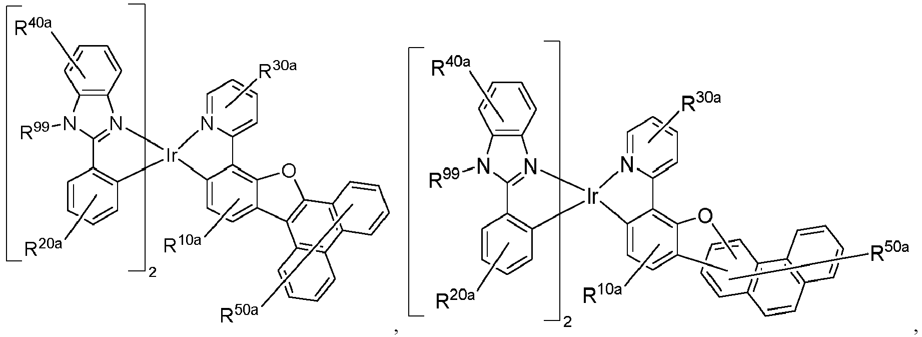 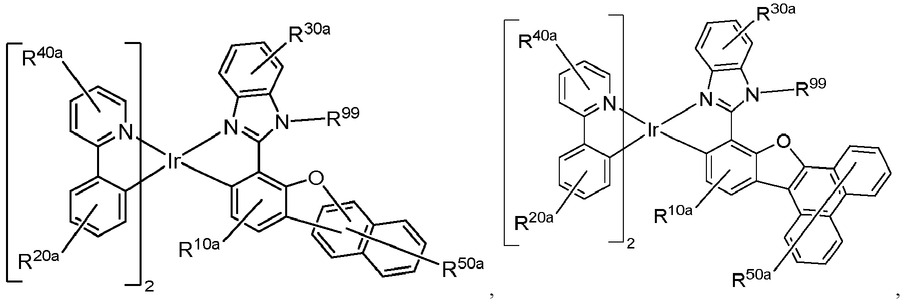 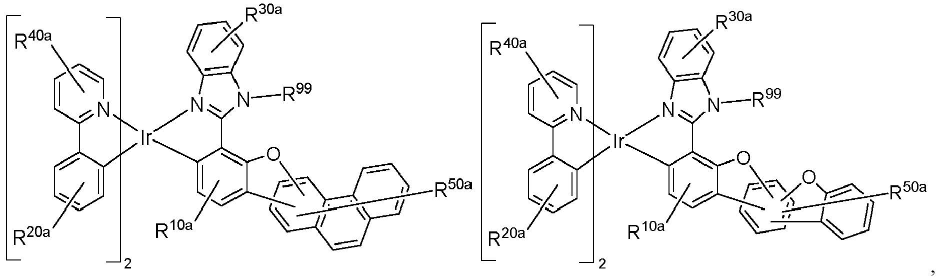 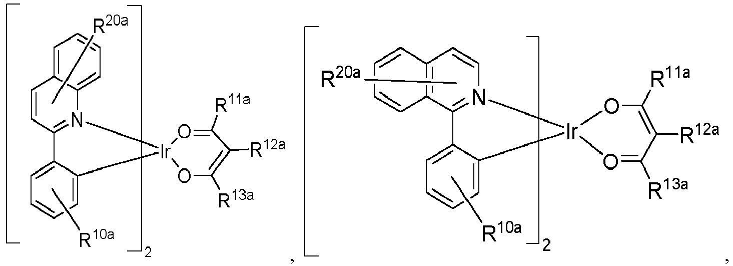 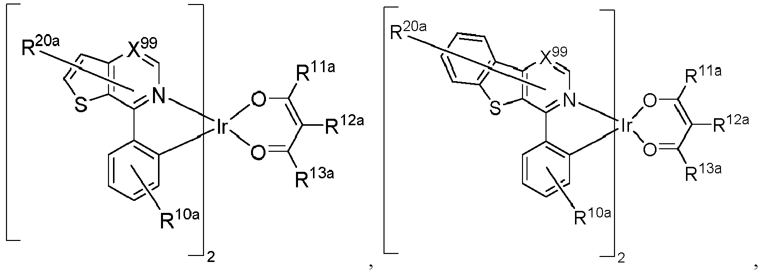 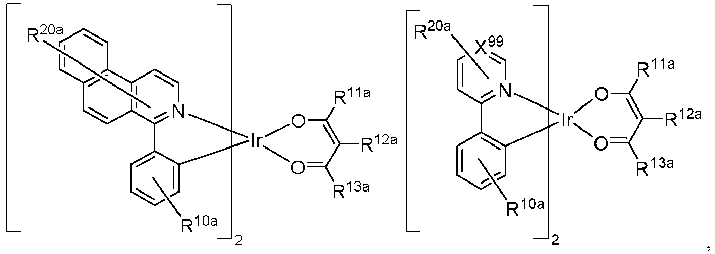 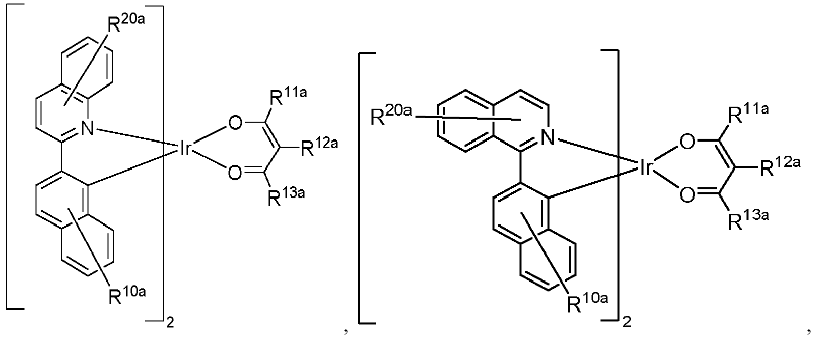 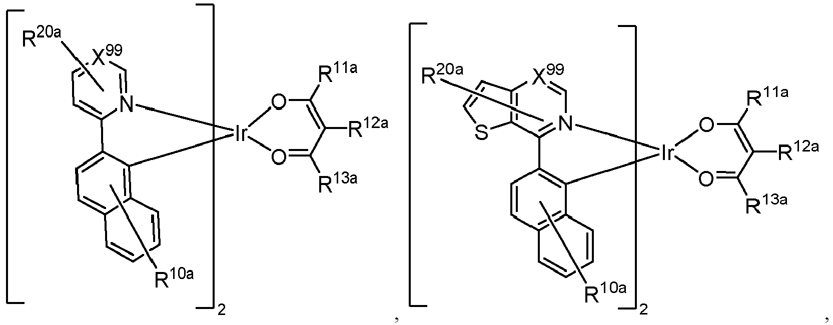 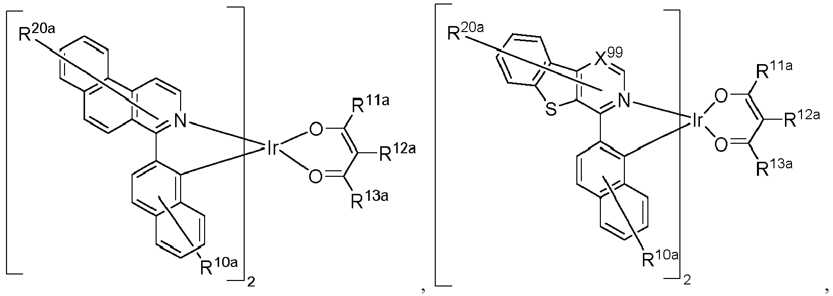 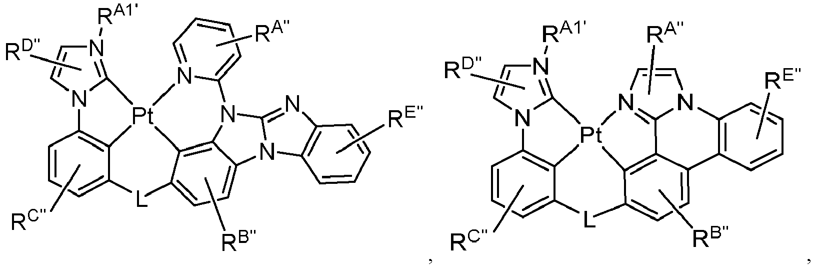 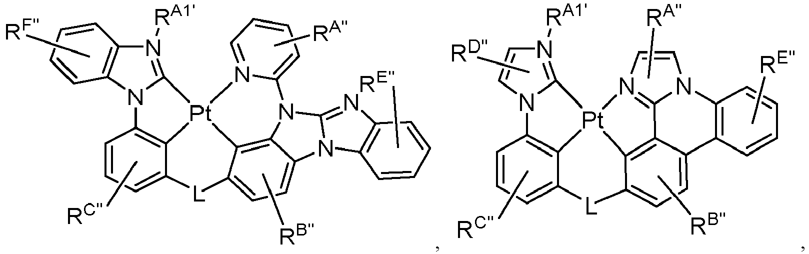 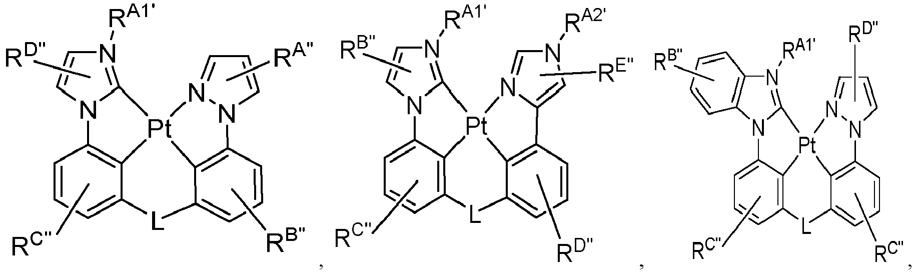 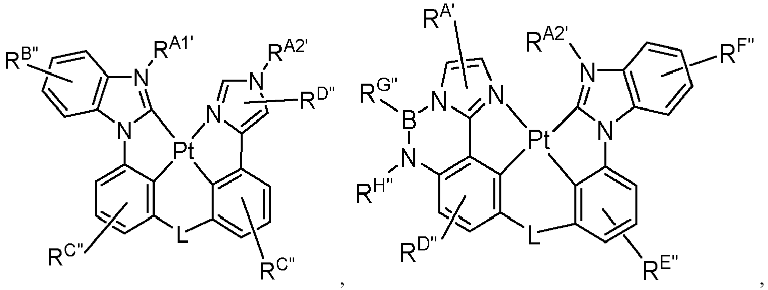 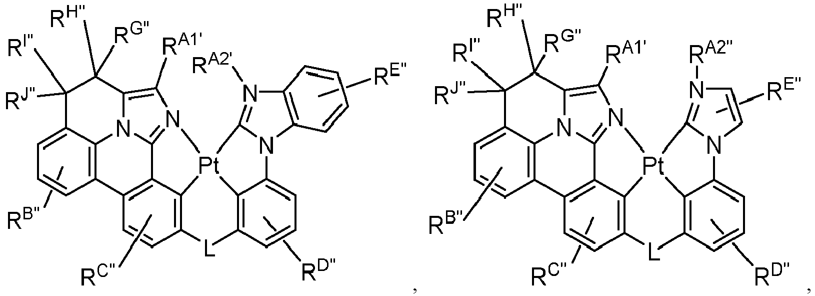 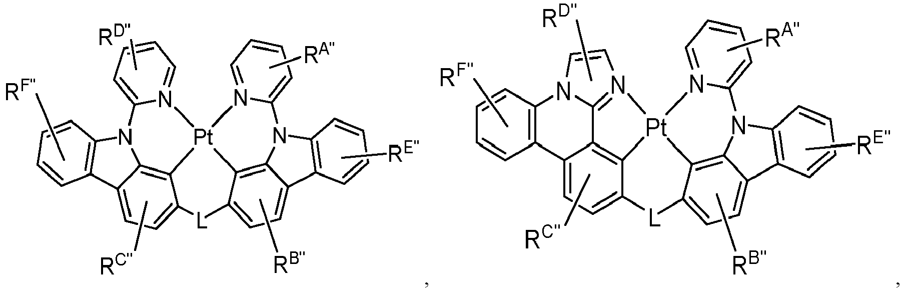 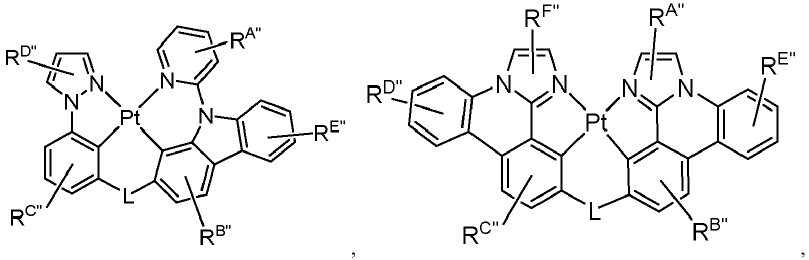 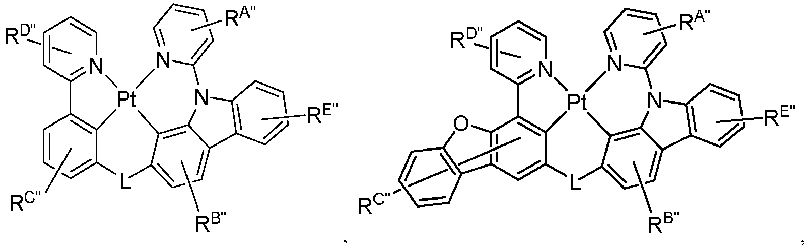 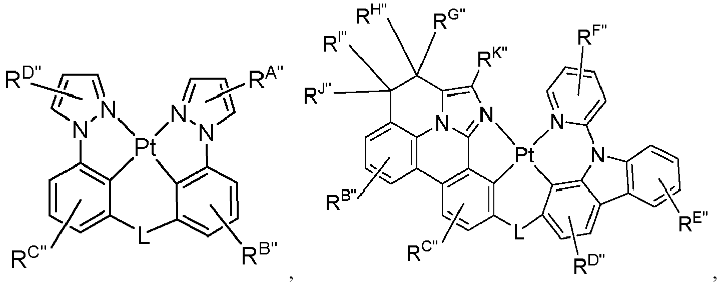 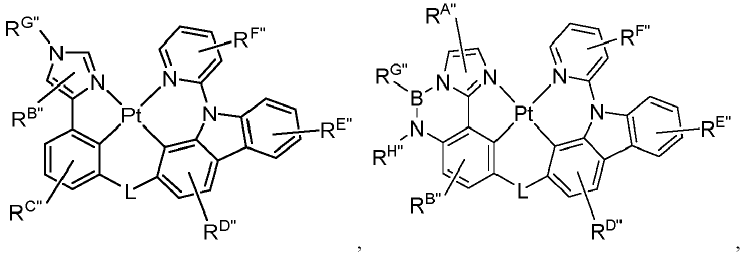 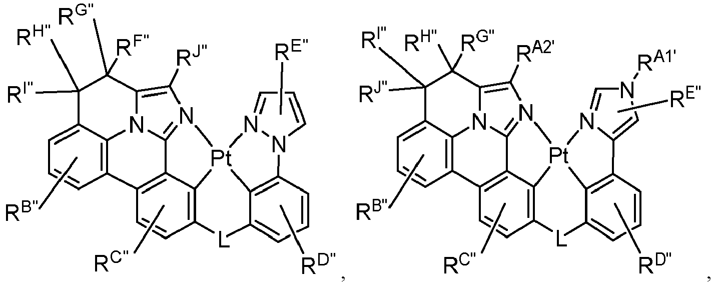 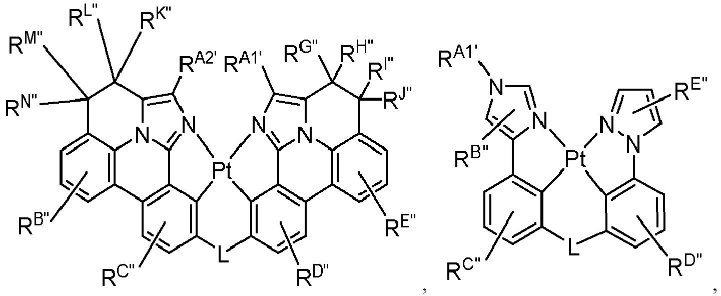 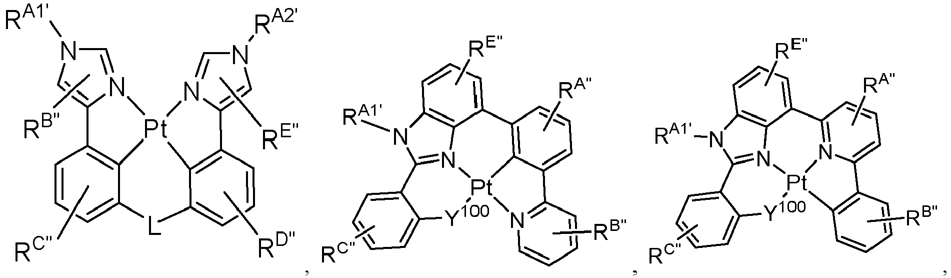 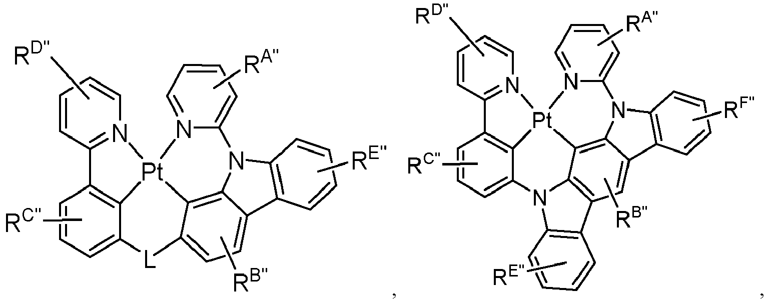 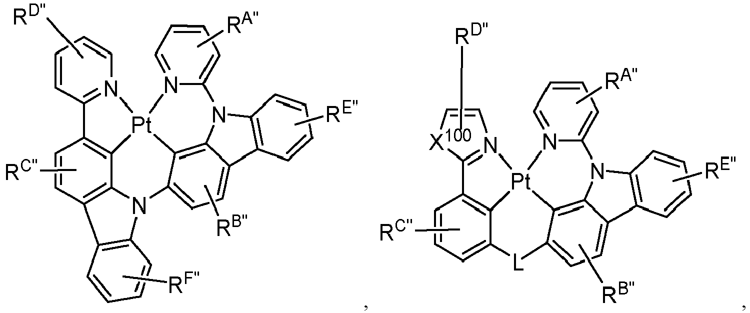 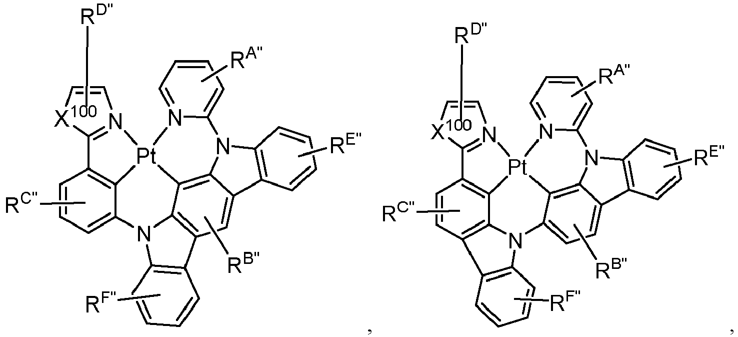 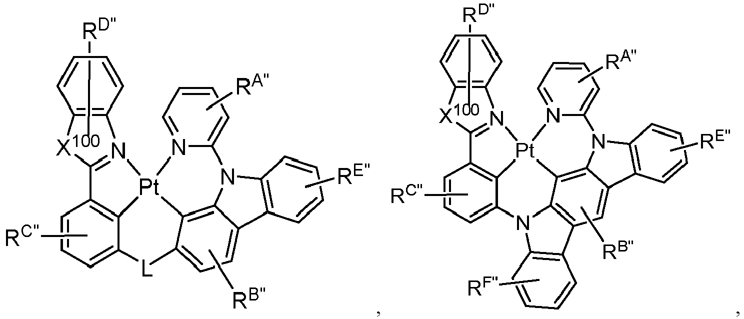 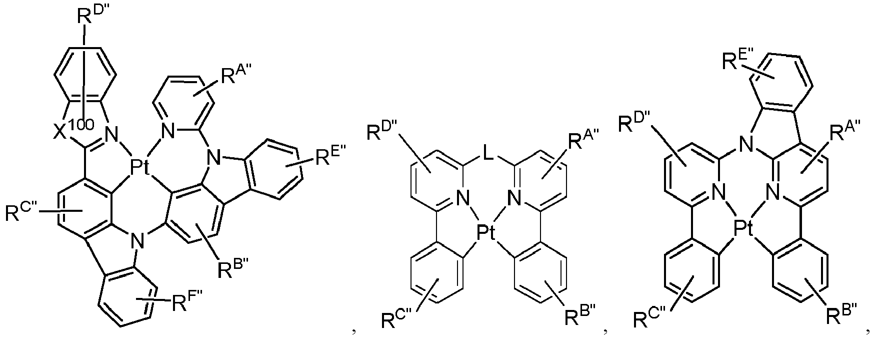 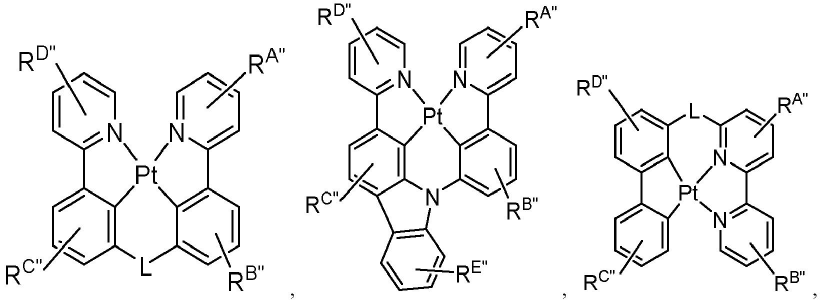 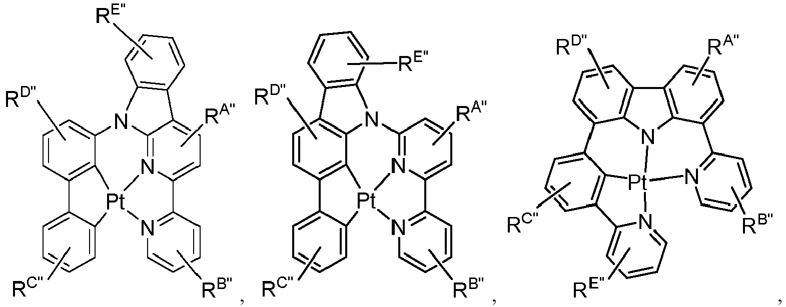 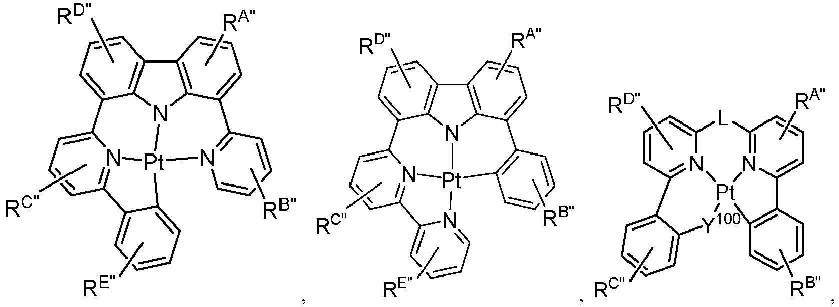 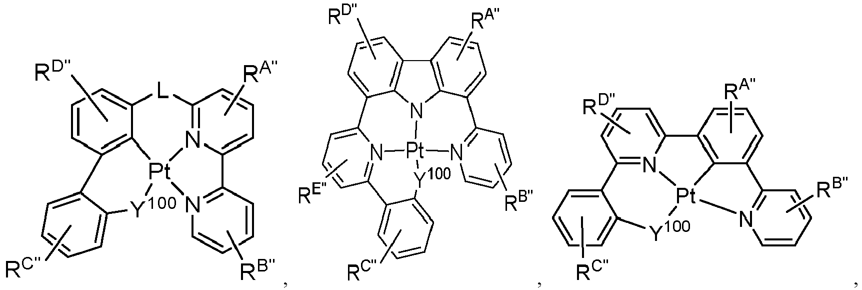 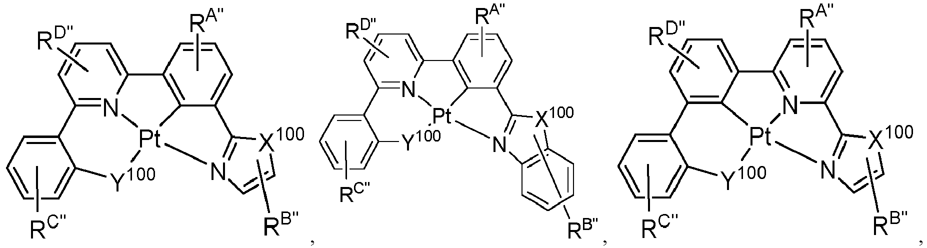 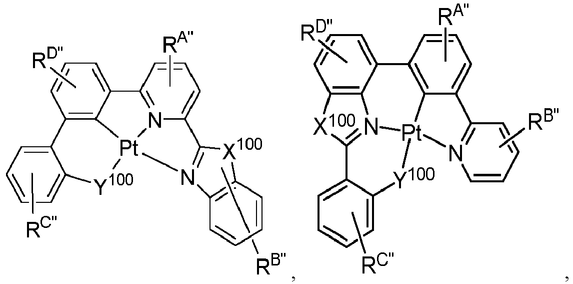 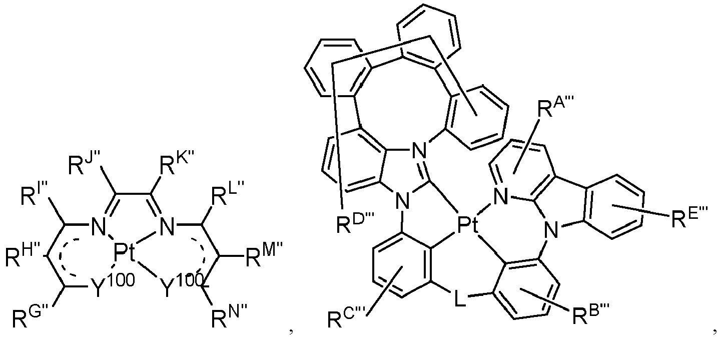 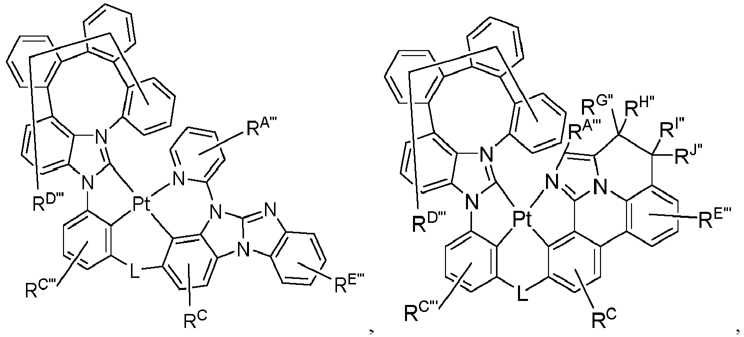 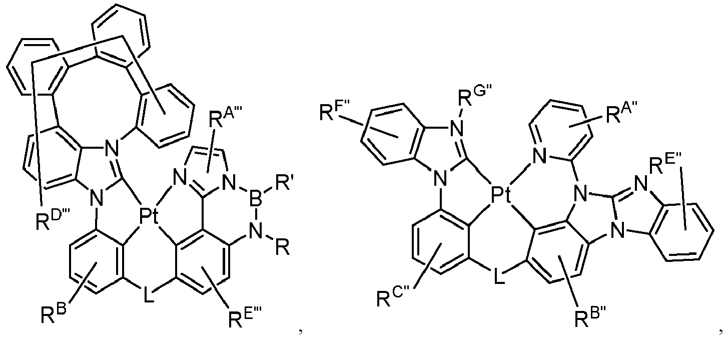 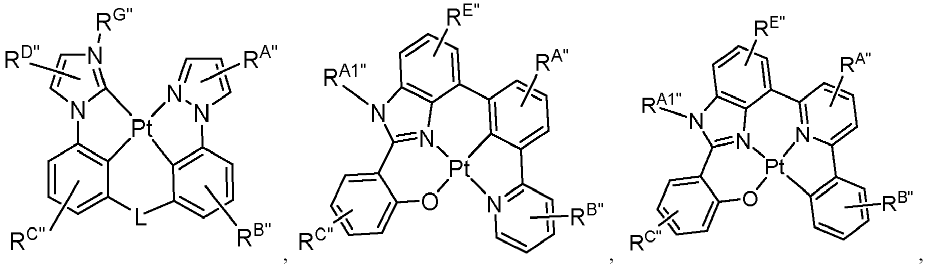 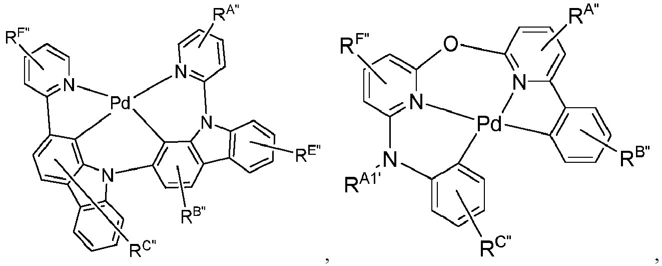 and 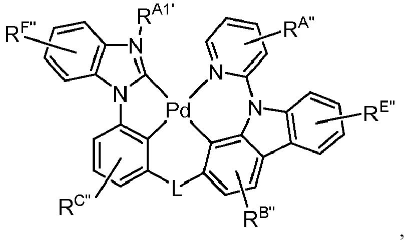 wherein:
X⁹⁹ is CorN;
each Y¹⁰⁰ is independently selected from the group consisting of a NR", O, S, and Se;
L is independently selected from the group consisting of a direct bond, BR", BR"R‴, NR", PR", O, S, Se, C=O, C=S, C=Se, C=NR", C=CR"R‴, S=O, SO₂, CR", CR"R‴, SiR"R‴, GeR"R‴, alkyl, cycloalkyl, aryl, heteroaryl, and combinations thereof;
X¹⁰⁰ for each occurrence is selected from the group consisting of O, S, Se, NR", and CR"R‴;
each R^{10a}, R^{20a}, R^{30a}, R^{40a}, and R^{50a}, R^{A"}, R^{B"}, R^{C"}, R^{D"}, R^{E"}, and R^{F"} independently represents mono-, up to the maximum substitutions, or no substitutions;
each of R, R', R", R‴, R^{10a}, R^{11a}, R^{12a}, R^{13a}, R^{20a}, R^{30a}, R^{40a}, R^{50a}, R⁶⁰, R⁷⁰, R⁹⁷, R⁹⁸, R⁹⁹, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, combinations thereof.

7. A composition comprising:
a compound S1; and
a compound A1;
wherein when the composition is formed into an emissive layer of an organic electroluminescent device, the compound S1 functions as an organometallic sensitizer that transfers energy to the compound A1 and the compound A1 is an acceptor that is an emitter;
wherein the compound A1 has a vertical dipole ratio (VDR) value ≥ 0.33.

8. An organic electroluminescent device comprising a composition of claim 7.

9. An organic light emitting device (OLED) comprising:
a substrate;
a first electrode;
an organic emissive region disposed over the first electrode;
an enhancement layer disposed over the organic emissive region opposite from the first electrode;
wherein the emissive region comprises:
a compound S1; and
a compound A1;
wherein the compound S 1 is a sensitizer that transfers energy to the compound A1, and the compound A1 is an acceptor that is an emitter;
wherein the enhancement layer comprises a plasmonic material exhibiting surface plasmon resonance that non-radiatively couples to the compound A1, compound S 1, or both compounds A1 and S1, and transfers excited state energy from the compound A1, compound S 1, or from both compounds A1 and S1, to non-radiative mode energy of surface plasmon polaritons.

10. The OLED of claim 9, wherein the enhancement layer is provided no more than a threshold distance away from the organic emissive region;
wherein the compound A1 has a total non-radiative decay rate constant and a total radiative decay rate constant due to the presence of the enhancement layer, and the threshold distance is where the total non-radiative decay rate constant is equal to the total radiative decay rate constant; and/or wherein the enhancement layer is provided no more than a threshold distance away from the organic emissive region; and wherein the compound S 1 has a total non-radiative decay rate constant and a total radiative decay rate constant due to the presence of the enhancement layer, and the threshold distance is where the total non-radiative decay rate constant is equal to the total radiative decay rate constant; and/or wherein the enhancement layer is provided no more than a threshold distance away from the organic emissive region; and wherein the organic emissive region has a total non-radiative decay rate constant and a total radiative decay rate constant due to the presence of the enhancement layer, and the threshold distance is where the total non-radiative decay rate constant is equal to the total radiative decay rate constant; and/or wherein an outcoupling layer is disposed over the enhancement layer, wherein the outcoupling layer scatters the non-radiative mode energy of the surface plasmon polaritons as photons to free space.

11. The OLED of claim 9 or 10, wherein emission from the compound A1, has a smaller FWHM than emission from the compound S1; and/or wherein emission peak maximum of the emission from the compound A1 is higher energy than emission peak maximum of the emission from the compound S1; and/or wherein vertical dipole ratio (VDR) of the compound S1 is ≥ 0.25; and/or wherein the compound A1 has a VDR ≤ 0.33.

12. The OLED of any one of claims 9 to 11, wherein vertical dipole ratio (VDR) of the compound A1 is > VDR of the compound S1; and/or wherein photoluminescence quantum yield (PLQY) of the compound A1 is > PLQY of the compound S1; and/or wherein both the compound S1 and the compound A1 have a VDR ≥ 0.33.

13. The OLED of any one of claims 9 to 12, wherein the OLED further comprises a hole transport layer (HTL) between the first electrode and the organic emissive region, wherein the compound S1 is a phosphorescent sensitizer and the compound A1 is a fluorescent acceptor, and doping concentration of the compound A1 in the emissive region increases toward the HTL; and/or wherein the OLED further comprises an electron transport layer (ETL) between the second electrode and the organic emissive region, wherein the compound A1 is a fluorescent acceptor, and doping concentration of the compound A1 in the emissive region increases toward the ETL.

14. The OLED of any one of claims 9 to 13, wherein the compound S1 is capable of phosphorescent emission or TADF emission at room temperature; and/or wherein emission contribution from the compound S1 is ≤ 45% of total electroluminescence spectrum of the OLED or wherein the compound S1 does not emit light; and/or wherein the compound S1 is fully or partially deuterated; and/or wherein the compound A1 is fully or partially deuterated.

15. A consumer product comprising an OLED according to claim 14.
